(19) Europäisches Patentamt / European Patent Office / Office européen des brevets

(11) EP 3 957 701 A1

(12) EUROPEAN PATENT APPLICATION

(43) Date of publication:
23.02.2022 Bulletin 2022/08

(21) Application number: 21192189.5

(22) Date of filing: 19.08.2021

(51) International Patent Classification (IPC):
*C09K 11/00* (2006.01) *H01L 51/50* (2006.01)
*C07F 15/00* (2006.01)

(52) Cooperative Patent Classification (CPC):
**C07F 15/0086; C09K 11/06; H01L 51/0087;**
C09K 2211/185; H01L 51/5016

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 21.08.2020 KR 20200105532

(71) Applicant: **Samsung Electronics Co., Ltd.**
**Suwon-si, Gyeonggi-do 16677 (KR)**

(72) Inventors:
- **YI, Jeoungin**
  **16678 Gyeonggi-do (KR)**
- **KWAK, Seungyeon**
  **16678 Gyeonggi-do (KR)**
- **KWAK, Yoonhyun**
  **16678 Gyeonggi-do (KR)**
- **KIM, Juhyun**
  **16678 Gyeonggi-do (KR)**
- **PARK, Sangho**
  **16678 Gyeonggi-do (KR)**
- **SIM, Myungsun**
  **16678 Gyeonggi-do (KR)**
- **LEE, Sunyoung**
  **16678 Gyeonggi-do (KR)**

(74) Representative: **Elkington and Fife LLP**
**Prospect House**
**8 Pembroke Road**
**Sevenoaks, Kent TN13 1XR (GB)**

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(57) Provided are an organometallic compound represented by Formula 1 below, an organic light-emitting device including the organometallic compound, and an electronic apparatus including the organic light-emitting device:

Formula 1

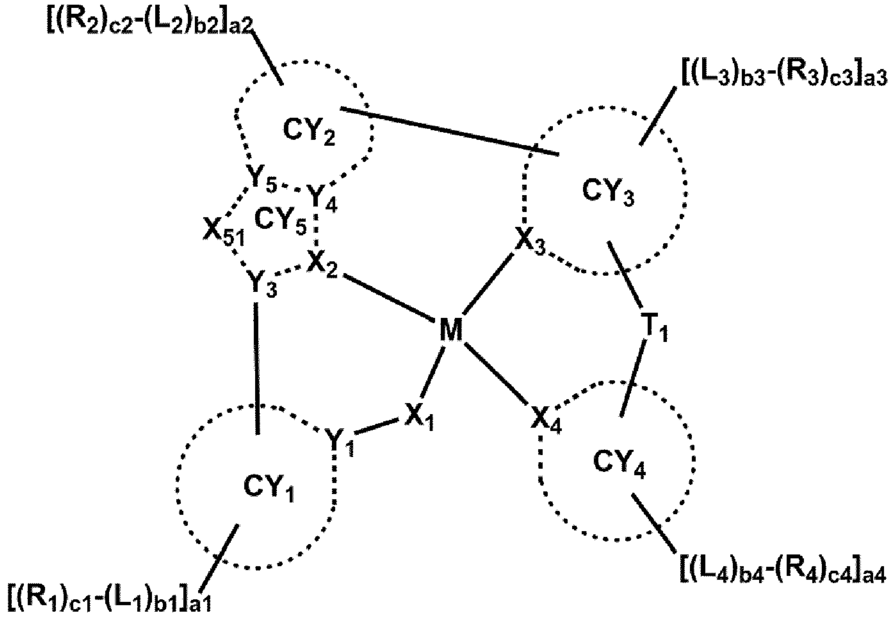

The detailed description of Formula 1 is the same as described in the present specification.

# FIGURE

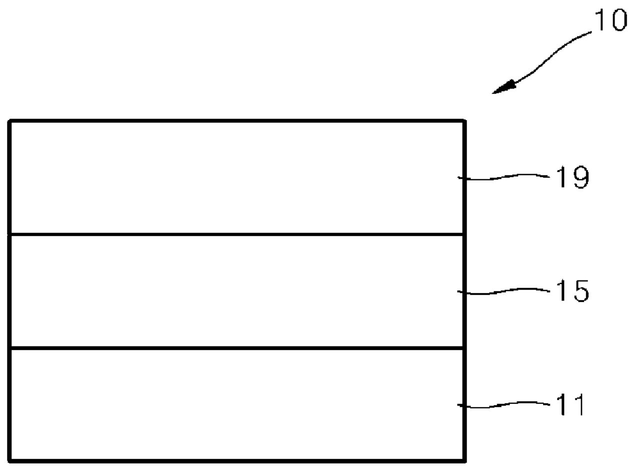

## Description

### FIELD OF THE INVENTION

One or more embodiments relate to an organometallic compound, an organic light-emitting device including the same, and an electronic apparatus including the organic light-emitting device.

### BACKGROUND OF THE INVENTION

Organic light-emitting devices are self-emissive devices, which have improved characteristics in terms of viewing angles, response time, brightness, driving voltage, and response speed, and produce full-color images.

In an example, an organic light-emitting device includes an anode, a cathode, and an organic layer between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

### SUMMARY OF THE INVENTION

One or more embodiments relate to an organometallic compound, an organic light-emitting device including the same, and an electronic apparatus including the organic light-emitting device.

Additional aspects will be set forth in part in the description, which follows and, in part, will be apparent from the description, or may be learned by practice of the presented embodiments of the disclosure.

An aspect of the present disclosure provides an organometallic compound represented by Formula 1:

Formula 1

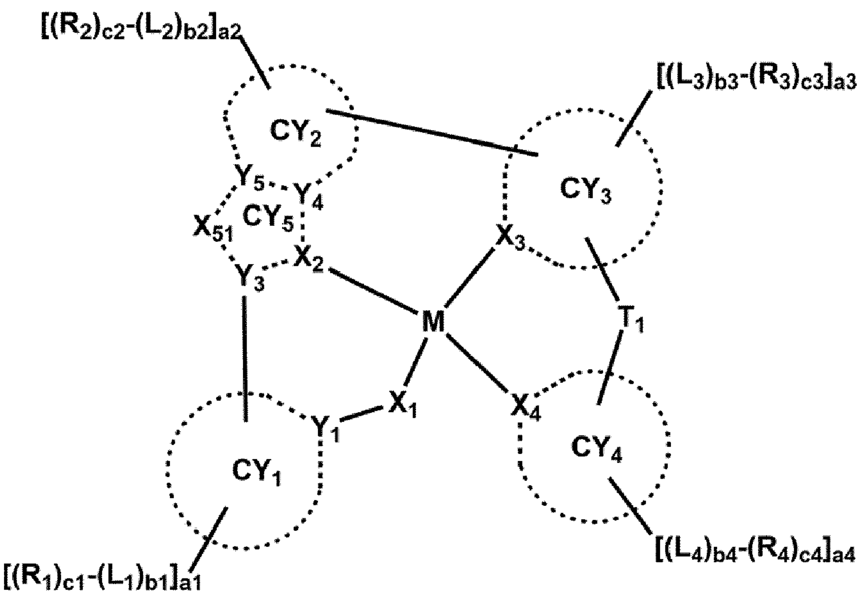

wherein, in Formula 1,

M may be a transition metal,

$X_1$ may be a chemical bond, O, S, N(R'), P(R'), B(R'), C(R')(R"), or Si(R')(R"), and when $X_1$ is a chemical bond, $Y_1$ is directly bonded to M,

$X_2$ to $X_4$ may each independently be C or N,

a bond between $X_1$ or $Y_1$ and M may be a covalent bond, one bond selected from a bond between $X_2$ and M, a bond between $X_3$ and M, and a bond between $X_4$ and M may be a covalent bond, and the remaining two bonds may be coordinate bonds,

$Y_1$ and $Y_3$ to $Y_5$ may each independently be C or N,
among pairs of $X_2$ and $Y_3$, $X_2$ and $Y_4$, $Y_4$ and $Y_5$, $X_{51}$ and $Y_3$, and $X_{51}$ and $Y_5$, components of each pair may be linked to each other via a chemical bond,
ring $CY_1$ to ring $CY_4$ may each independently be a $C_5$-$C_{30}$ carbocyclic group or a $C_1$-$C_{30}$ heterocyclic group, and at least one of ring $CY_1$ to ring $CY_4$ may each independently be a condensed cyclic group in which two or more rings are condensed with each other,
a cyclometallated ring formed by ring $CY_5$, ring $CY_2$, ring $CY_3$, and M is a 6-membered ring,
$T_1$ may be a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*', *-C(=S)-*' or *-C≡C-*', and each of * and *' is a binding site to a neighboring atom,
$X_{51}$ may be N-[$(L_7)_{b7}$-$(R_7)_{c7}$],
$L_1$ to $L_4$ and $L_7$ may each independently be a single bond, a $C_5$-$C_{30}$carbocyclic group that is unsubstituted or substituted with at least one $R_{10a}$, or a $C_1$-$C_{30}$ heterocyclic group that is unsubstituted or substituted with at least one $R_{10a}$,
b1 to b4 and b7 may each independently be 1, 2, 3, 4, or 5,
$R_1$ to $R_7$, R', and R" may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted C1-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or - P($Q_8$)($Q_9$),
c1 to c4 and c7 may each independently be 1, 2, 3, 4, or 5,
at least one of $R_7$ in number of c7 is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,
a1 to a4 may each independently be 0, 1, 2, 3, 4, or 5,
two or more of a plurality of $R_1$(s) may optionally be linked to each other to form a $C_5$-$C_{30}$carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_2$(s) may optionally be linked to each other to form a $C_5$-$C_{30}$carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_3$(s) may optionally be linked to each other to form a $C_5$-$C_{30}$carbocyclic group that is unsubstituted or substituted with at least one $R_{10a}$ or a $C_1$-$C_{30}$ heterocyclic group that is unsubstituted or substituted with at least one $R_{10a}$,
two or more of a plurality of $R_4$(s) may optionally be linked to each other to form a $C_5$-$C_{30}$carbocyclic group that is unsubstituted or substituted with at least one $R_{10a}$ or a $C_1$-$C_{30}$ heterocyclic group that is unsubstituted or substituted with at least one $R_{10a}$,
two or more of $R_1$ to $R_4$ may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
$R_{10a}$ is the same as explained in connection with $R_1$, and
the substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a

sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group,
a $C_1$-$C_{60}$ alkyl group, a $C_2$-$C_{60}$ alkenyl group, a $C_2$-$C_{60}$ alkynyl group, or a C1-$C_{60}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a C1-C10 heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-Ge(Q_{13})(Q_{14})(Q_{16})$, $-B(Q_{16})(Q_{17})$, $-P(=O)(Q_{18})(Q_{19})$, - $P(Q_{16})(Q_{19})$, or a combination thereof,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, - $B(Q_{26})(Q_{27})$, $-P(=O)(Q_{28})(Q_{29})$, $-P(Q_{28})(Q_{29})$, or a combination thereof,
$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, - $P(=O)(Q_{38})(Q_{39})$, or $-P(Q_{38})(Q_{39})$, or a combination thereof,
wherein $Q_1$ to $Q_9$, $Q_{11}$ to $Q_{19}$, $Q_{21}$ to $Q_{29}$, and $Q_{31}$ to $Q_{39}$ are each independently hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group which is unsubstituted or substituted with deuterium, -F, a $C_1$-$C_{60}$ alkyl group, a $C_6$-$C_{60}$ aryl group, or a combination thereof, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a C1-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group which is unsubstituted or substituted with deuterium, -F, a $C_1$-$C_{60}$ alkyl group, a $C_6$-$C_{60}$ aryl group, or a combination thereof, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, and
wherein Formula 1 satisfies at least one of Condition A, Condition B, Condition C and Condition D:

Condition A
a group represented by $*-[(L_7)_{b7}-(R_7)_{c7}]$ in $N-[(L_7)_{b7}-(R_7)_{c7}]$ is a group represented by Formula N51:

Formula N51

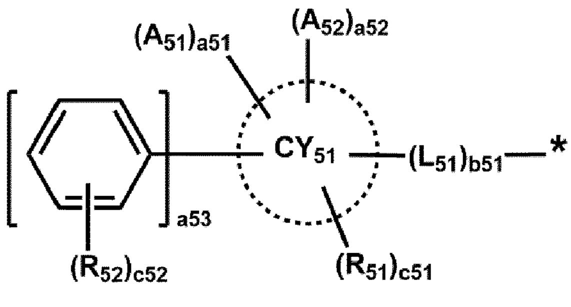

wherein, in Formula N51,

ring $CY_{51}$ is a $C_5$-$C_{30}$ carbocyclic group or a $C_1$-$C_{30}$ heterocyclic group,
$L_{51}$, b51, $R_{51}$, and c51 are each as described in connection with $L_7$, $b_7$, $R_7$, and c7,
$R_{52}$ and c52 are each as described in connection with $R_7$ and c7,

$A_{51}$ is a $C_1$-$C_{60}$ alkyl group,
$A_{52}$ is a deuterated $C_1$-$C_{60}$ alkyl group,
a51 and a52 are each independently an integer from 0 to 10, and the sum of a51 and a52 is an integer of 1 or more,
a53 is an integer from 1 to 10, and
* indicates a binding site to a neighboring nitrogen atom,

Condition B
the ring $CY_1$ is a condensed cyclic group wherein two or more rings are condensed with each other,

Condition C

the ring $CY_3$ is a condensed cyclic group wherein two or more rings are condensed with each other,
a4 is 1, 2, 3, 4, or 5, and
at least one of $R_4$ in number of c4 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

Condition D

the ring $CY_4$ is a condensed cyclic group wherein two or more rings are condensed with each other,
a3 is 1, 2, 3, 4, or 5, and
at least one of $R_3$ in number of c3 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

According to another aspect, provided is an organic light-emitting device including a first electrode, a second electrode, and an organic layer including an emission layer located between the first electrode and the second electrode, wherein the organic layer includes at least one organometallic compound represented by Formula 1.
The organometallic compound contained in the emission layer of the organic layer may act as a dopant.
Another aspect of the present disclosure provides an electronic apparatus including the organic light-emitting device.

BRIEF DESCRIPTION OF THE DRAWING

The above and other aspects, features, and advantages of certain embodiments of the disclosure will be more apparent from the following description taken in conjunction with
FIGURE which shows a schematic cross-sectional view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.
The organometallic compound may be represented by Formula 1

Formula 1

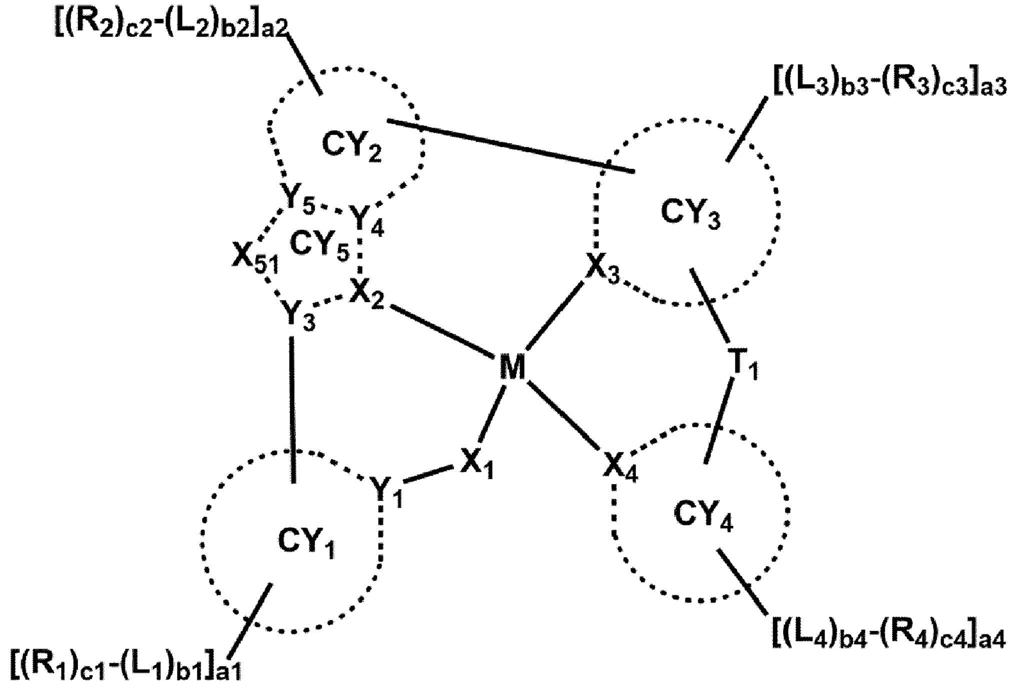

M in Formula 1 may be a transition metal.

In an embodiment, M may be cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In an embodiment, M may be Pt, Pd, or Au.

$X_1$ in Formula 1 may be a chemical bond (for example, a covalent bond, a coordinate bond, or the like), O, S, N(R'), P(R'), B(R'), C(R')(R"), or Si(R')(R"). R' and R" are the same as described above. When $X_1$ is a chemical bond, $Y_1$ and M may directly be linked to each other.

In an embodiment, $X_1$ in Formula 1 may be O or S.

$X_2$ to $X_4$ in Formula 1 may each independently be C or N.

In an embodiment, two of the $X_2$ to $X_4$ may be N, and the other one may be C.

In an embodiment, in Formula 1, $X_2$ and $X_4$ may each be N and $X_3$ may be C.

A bond between $X_1$ or $Y_1$ and M in Formula 1 may be a covalent bond, one bond selected from a bond between $X_2$ and M, a bond between $X_3$ and M, and a bond between $X_4$ and M may be a covalent bond, and the remaining two bonds may be coordinate bonds. Thus, the organometallic compound represented by Formula 1 may be electrically neutral.

In an embodiment, in Formula 1, a bond between $X_1$ or $Y_1$ and M and a bond between $X_3$ and M may each be a covalent bond, and a bond between $X_2$ and M and a bond between $X_4$ and M may be a coordinate bond.

In one or more embodiments, in Formula 1,

i) $X_2$ and $X_4$ are each N, $X_3$ is C, a bond between $X_2$ and M and a bond between $X_4$ and M are each a coordinate bond, and a bond between $X_3$ and M is a covalent bond,

i) $X_2$ and $X_3$ may each be N, $X_4$ may be C, a bond between $X_2$ and M and a bond between $X_3$ and M may each be a coordinate bond, and a bond between $X_4$ and M may be a covalent bond, or

iii) $X_3$ and $X_4$ may each be N, $X_2$ may be C, a bond between $X_3$ and M and a bond between $X_4$ and M may each be a coordinate bond, and a bond between $X_2$ and M may be a covalent bond.

$Y_1$ and $Y_3$ to $Y_5$ in Formula 1 may each independently be C or N.

For example, $Y_1$ and $Y_3$ to $Y_5$ in Formula 1 may be C.

among pairs of $X_2$ and $Y_3$, $X_2$ and $Y_4$, $Y_4$ and $Y_5$, $X_{51}$ and $Y_3$, and $X_{51}$ and $Y_5$ in Formula 1, components of each pair may be linked to each other via a chemical bond. Accordingly, ring $CY_5$ in the Formula 1 may be a 5-membered ring condensed with ring $CY_2$.

ring $CY_1$ to ring $CY_4$ in Formula 1 may each independently be a $C_5$-$C_{30}$ carbocyclic group or a $C_1$-$C_{30}$ heterocyclic group, and at least one of ring $CY_1$ to ring $CY_4$ may each independently be a condensed cyclic group in which two or

more rings are condensed with each other.

For example, ring $CY_1$ to ring $CY_4$ may each independently be selected from, i) a first ring, ii) a second ring, iii) a condensed ring in which two or more first rings are condensed with each other, iv) a condensed ring in which two or more second rings are condensed with each other, and v) a condensed ring in which one or more first rings and one or more second rings are condensed with each other,

at least one of ring $CY_1$ to ring $CY_4$ may each independently be iii) a condensed cyclic group in which two or more first rings are condensed with each other, iv) a condensed cyclic group in which two or more second rings are condensed with each other, or v) a condensed cyclic group in which at least one first ring is condensed with at least one second ring,

the first ring may be a cyclopentane group, a cyclopentadiene group, a furan group, a thiophene group, a pyrrole group, a silole group, a germole group, a borole group, a phosphole group, a selenophene group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaphosphole group, or an azaselenophene group, and

the second ring may be an adamantane group, a norbornane group, a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In an embodiment, ring $CY_1$ to ring $CY_4$ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, an adamantane group, a norbornane group, a norbornene group, a benzene group condensed with a cyclohexane group, a benzene group condensed with an adamantane group, a benzene group condensed with a norbornane group, a 5,6,7,8-tetrahydroisoquinoline group, a 5,6,7,8-tetrahydroquinoline group, a pyridine

group condensed with an adamantane group, or a pyridine group condensed with a norbornane group.

In one or more embodiments, at least one of ring $CY_1$ to ring $CY_4$ (for example, at least one of ring $CY_1$, $CY_3$, and $CY_4$) may each independently be a naphthalene group, an anthracene group, a phenanthrene group, a triphenylene group, a pyrene group, a chrysene group, a 1,2,3,4-tetrahydronaphthalene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a benzene group condensed with a cyclohexane group, a benzene group condensed with an adamantane group, a benzene group condensed with a norbornane group, a 5,6,7,8-tetrahydroisoquinoline group, a 5,6,7,8-tetrahydroquinoline group, a pyridine group condensed with an adamantane group, or a pyridine group condensed with a norbornane group.

In one or more embodiments, at least one of ring $CY_1$ to ring $CY_4$ (for example, at least one of ring $CY_1$, ring $CY_3$, and ring $CY_4$) may each independently be a naphthalene group, an anthracene group, a phenanthrene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenbenzosilole group, an azanaphthobenbenzoborole group, an azanaphthobenbenzophosphole group, an azanaphthobenbenzogermole group, an azanaphthobenbenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthroabenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, a quinoline group, an isoquinoline group, a quinoxaline

group, a quinazoline group, a benzoquinoline group, a benzoisoquinoline group, a benzoquinoxaline group, a benzoquinazoline group, a phenanthroline group, a phenanthridine group, a benzene group condensed with a cyclohexane group, a benzene group condensed with an adamantane group, a benzene group condensed with a norbornane group, a 5,6,7,8-tetrahydroisoquinoline group, a 5,6,7,8-tetrahydroquinoline group, a pyridine group condensed with an adamantane group, or a pyridine group condensed with a norbornane group.

In one or more embodiments,

ring $CY_1$ may be a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,
ring $CY_3$ may be a benzene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and
ring $CY_4$ may be a pyridine group, an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group.

In one or more embodiments,

ring $CY_1$ may be a benzene group, a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,
ring $CY_3$ may be a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and
ring $CY_4$ may be a pyridine group, an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group.
In one or more embodiments,
ring $CY_1$ may be a benzene group, a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,
ring $CY_3$ may be a benzene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and
ring $CY_4$ may be an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group.

In one or more embodiments, ring $CY_1$ in Formula 1 may not be a fluorene group and a carbazole group.

In one or more embodiments, ring $CY_4$ in Formula 1 may not be a benzimidazole group.

A cyclometalated ring formed by ring $CY_5$, ring $CY_2$, ring $CY_3$, and M in Formula 1 may be a 6-membered ring.

$T_1$ in Formula 1 may be a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*', *-C(=S)-*', or *-C≡C-*'. * and *' each indicate a binding site to a neighboring atom. $R_5$ and $R_6$ are the same as described above. $R_5$ and $R_6$ may optionally be linked to each other via a single bond, a double bond, *-N($R_{5a}$)-*', *-B($R_{5a}$)-*', *-P($R_{5a}$)-*', *-C($R_{5a}$)($R_{6a}$)-*', *-Si($R_{5a}$)($R_{6a}$)-*', *-Ge($R_{5a}$)($R_{6a}$)-*', *-S-*', *-Se-*', *-O-*', *-C(=O)-*', *-S(=O)-*', *-S(=O)$_2$-*', *-C($R_{5a}$)=*', *=C($R_{5a}$)-*', *-C($R_{5a}$)=C($R_{6a}$)-*', *-C(=S)-*', or *-C≡C-*' to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. $R_{5a}$ and $R_{6a}$ are the same as described in connection with $R_5$ and $R_6$, and $R_{10a}$ is the same as described in connection with $R_1$.

For example, $T_1$ may be a single bond.

$X_{51}$ in Formula 1 may be N-[($L_7$)$_{b7}$-($R_7$)$_{c7}$].

In Formula 1, $L_1$ to $L_4$ and $L_7$ may each independently be a single bond, a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$. $R_{10a}$ is the same as described in connection with $R_1$

For example, $L_1$ to $L_4$ and $L_7$ in Formula 1 may each independently be:

a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with at least one $R_{10a}$.

In an embodiment, $L_1$ to $L_4$ and $L_7$ in Formula 1 may each independently be

a single bond; or
a benzene group that is unsubstituted or substituted with at least one $R_{10a}$.

In one or more embodiments, $L_1$ to $L_4$ and $L_7$ in Formula 1 may each independently be:

a single bond; or
a benzene group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.
b1 to b4 and b7 in Formula 1 indicate numbers of $L_1$ to $L_4$ and $L_7$, respectively, and may each independently be 1, 2, 3, 4, or 5. When b1 is 2 or more, two or more of $L_1$(s) may be identical to or different from each other, when b2 is 2 or more, two or more of $L_2$(s) may be identical to or different from each other, when b3 is 2 or more, two or more of $L_3$(s) may be identical to or different from each other, when b4 is 2 or more, two or more of $L_4$(s) may be identical to or different from each other, and when b7 is 2 or more, two or more of $L_7$(s) may be identical to or different from each other.

For example, b1 to b4 and b7 in Formula 1 may each independently be 1, 2, or 3.

$R_1$ to $R_7$, R', and R" in Formula 1 may each independently be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted C1-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted C1-$C_{10}$heterocycloalkenyl group, a substituted or unsubstituted $C_6$-$C_{60}$ aryl group, a substituted or unsubstituted $C_6$-$C_{60}$ aryloxy group, a substituted

or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$). $Q_1$ to $Q_9$ are the same as described in the present specification.

For example, $R_1$ to $R_7$, R', and R" may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C1-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a deuterated phenyl group, a ($C_1$-$C_{20}$ alkyl)phenyl group, a biphenyl group, a deuterated biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or - $P(Q_8)(Q_9)$,
wherein $Q_1$ to $Q_9$ may each independently be:
$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.
c1 to c4 and c7 in Formula 1 indicate numbers of $R_1$ to $R_4$ and $R_7$, respectively, and may each independently be 1, 2, 3, 4 or 5. When c1 is 2 or more, two or more of $R_1$(s) may be identical to or different from each other, when c2 is 2 or more, two or more of $R_2$(s) may be identical to or different from each other, when c3 is 2 or more, two or more of $R_3$(s) may be identical to or different from each other, when c4 is 2 or more, two or more of $R_4$(s) may be identical to or different from each other, and when c7 is 2 or more, two or more of $R_7$(s) may be identical to or different from each other. For example, c1 to c4 and c7 may each independently be 1 or 2.

At least one of $R_7$ in number of c7 may be a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

For example, $R_7$ may be hydrogen; deuterium; a $C_1$-$C_{20}$ alkyl group; a deuterated $C_1$-$C_{20}$ alkyl group; or a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof, and at least one of $R_7$ in number of c7 may be a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

Regarding Formula 1, a1 to a4 respectively indicate numbers of $*-[(L_1)_{b1}-(R_1)_{c1}]$, $*-[(L_2)_{b2}-(R_2)_{c2}]$, $*-[(L_3)_{b3}-(R_3)_{c3}]$, and $*-[(L_4)_{b4}-(R_4)_{c4}]$, and may each independently be 0, 1, 2, 3, 4, or 5. When a1 is 2 or more, two or more $*-[(L_1)_{b1}-(R_1)_{c1}]$ may be identical to or different from each other, when a2 is 2 or more, two or more $*-[(L_2)_{b2}-(R_2)_{c2}]$ may be identical to or different from each other, when a3 is 2 or more, two or more $*-[(L_3)_{b3}-(R_3)_{c3}]$ may be identical to or different from each other, and when a4 is 2 or more, two or more $*-[(L_4)_{b4}-(R_4)_{c4}]$ may be identical to or different from each other.

In one or more embodiments, in Formula 1,

a) $L_1$ to $L_4$ and $L_7$ may each independently be:

a single bond; or
a benzene group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof,

b) b1 to b4 and b7 may each independently be 1, 2, or 3,
c) $R_1$ and $R_2$ may each independently be hydrogen, deuterium, a $C_1$-$C_{20}$ alkyl group, or a deuterated $C_1$-$C_{20}$ alkyl group,
d) $R_3$ and $R_4$ may each independently be:

hydrogen, deuterium, a $C_1$-$C_{20}$ alkyl group, or a deuterated $C_1$-$C_{20}$ alkyl group;
a $C_1$-$C_{20}$ alkyl group substituted with at least one phenyl group; or
a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof,

e) $R_7$ in $N-[(L_7)_{b7}-(R_7)_{c7}]$ number of c7 may be hydrogen; deuterium; a $C_1$-$C_{20}$ alkyl group; a deuterated $C_1$-$C_{20}$ alkyl group; or a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof, and at least one of $R_7$ in number of c7 may be a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof,
f) c1 to c4 and c7 may each independently be 1, 2, or 3, and
g) a1 to a4 may each independently be 0, 1, 2, or 3.

In an embodiment, Formula 1 may satisfy at least one of Condition A, Condition B, Condition C and Condition D:

Condition A

A group represented by $*-[(L_7)_{b7}-(R_7)_{c7}]$ in $N-[(L_7)_{b7}-(R_7)_{c7}]$ is a group represented by Formula N51.

Condition B

the ring $CY_1$ is a condensed cyclic group wherein two or more rings are condensed with each other,

Condition C

the ring $CY_3$ is a condensed cyclic group wherein two or more rings are condensed with each other,
a4 is 1, 2, 3, 4, or 5, and
at least one of $R_4$ in number of c4 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

Condition D

the ring $CY_4$ is a condensed cyclic group wherein two or more rings are condensed with each other,
a3 is 1, 2, 3, 4, or 5, and
at least one of $R_3$ in number of c3 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

Formula N51

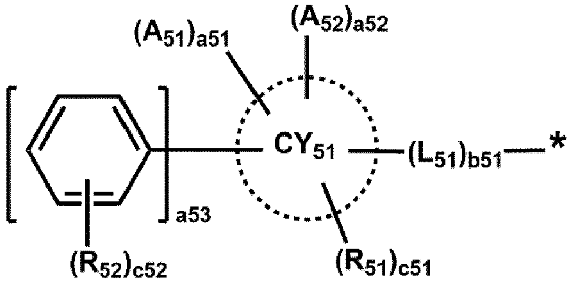

Ring $CY_{51}$ in Formula N51 may be a $C_5$-$C_{30}$ carbocyclic group or a $C_1$-$C_{30}$ heterocyclic group. Ring $CY_{51}$ may be understood by referring to relative description provided herein or may be the same as described in connection with ring $CY_3$. For example, ring $CY_{51}$ may be a benzene group.
$L_{51}$, b51, $R_{51}$ and c51 in Formula N51 are the same as described in connection with $L_7$, b7, $R_7$, and c7, and $R_{52}$ and c52 are the same as described in connection with $R_7$ and c7.
$A_{51}$ in Formula N51 may be a $C_1$-$C_{60}$ alkyl group. For example, $A_{51}$ may be a $C_1$-$C_{20}$ alkyl group or a $C_4$-$C_{20}$ alkyl group.
$A_{52}$ in Formula N51 may be a deuterated $C_1$-$C_{69}$ alkyl group. In an embodiment, $A_{52}$ may be a hydrogen-free deuterated $C_1$-$C_{20}$ alkyl group.

In an embodiment, Formula 1 may satisfy <Condition A>. When Formula 1 satisfies <Condition A>, an angle between a plane including the transition dipole moment of the organometallic compound and a plane including four atoms of the tetradentate ligand bonded to metal (M) of Formula 1 may be 10° or less. In one or more embodiments, the horizontal orientation ratio of the transition dipole moment of the organometallic compound represented by Formula 1 may be from about 80% to about 100%.

For example, an angle between a plane including the transition dipole moment of the organometallic compound and a plane including four atoms of the tetradentate ligand bonded to metal (or platinum) of Formula 1 may be from 0° to 10°, from 0° to 9°, from 0° to 8°, from 0° to 7°, from 0° to 6°, from 0° to 5°, from 0° to 4°, from 0° to 3°, from 0° to 2° or 0° to 1°. Since the angle between the plane including the transition dipole moment of the organometallic compound

represented by Formula 1 and the plane including four atoms bonded to metal of Formula 1 is within these ranges, the organometallic compound may have excellent planarity. Accordingly, a thin film formed using the organometallic compound may have excellent electrical properties.

In an embodiment, the horizontal orientation rate of the transition dipole moment of the organometallic compound may be, for example, from 80% to 100%, from 81% to 100%, from 82% to 100%, from 83% to 100%, from 84% to 100%, from 85% to 100%, from 86% to 100%, from 87% to 100%, from 88% to 100%, from 89% to 100%, from 90% to 100%, from 91% to 100%, from 92% to 100%, from 93% to 100%, from 94% to 100%, from 95% to 100%, from 96% to 100%, from 97% to 100%, from 98% to 100%, from 99% to 100%, or 100%.

In this regard, the horizontal orientation ratio of the transition dipole moment refers to the ratio of the organometallic compound having a transition dipole moment which is horizontal to the film compared to the total organometallic compound in the film including the organometallic compound.

The horizontal orientation ratio of the transition dipole moment may be evaluated using an angle-dependent PL measurement apparatus. For a description of the angle-dependent PL measurement apparatus, reference may be made to, for example, the angle-dependent PL measurement apparatus described in Korean Patent Application No. 2013-0150834.

Since the organometallic compound has a high horizontal orientation ratio of the transition dipole moment as described above, a large horizontal orientation transition dipole moment (that is, a large horizontal optical orientation) may be obtained. Accordingly, a large amount of electric field traveling in a direction which is perpendicular to the film containing the organometallic compound may be emitted. The light emitted according to this mechanism may have high external extraction efficiency (that is, the external extraction efficiency of light emitted from the organometallic compound from a device (for example, an organic light-emitting device) including a film (for example, an emission layer to be described later) containing the organometallic compound). Accordingly, an electronic device including the organometallic compound, for example, an organic light-emitting device including the organometallic compound may have high luminescence efficiency.

In an embodiment, $A_{51}$ may be a linear or branched $C_4$-$C_{10}$ alkyl group, and $A_{52}$ may be a hydrogen-free deuterated $C_1$-$C_{10}$ alkyl group.

In one or more embodiments, $A_{51}$ may be an n-butyl group, a sec-butyl group, an isobutyl group, a tert-butyl group, an n-pentyl group, a tert-pentyl group, a neopentyl group, an isopentyl group, a sec-pentyl group, a 3-pentyl group, or a sec-isopentyl group, and $A_{52}$ may be a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, or a sec-isopentyl group, each substituted with at least one deuterium, (or, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, or a sec-isopentyl group, each substituted with at least one deuterium and being hydrogen-free).

In one or more embodiments, Formula 1 may satisfy <Condition A>, and the group represented by $*-[(L_7)_{b7}-(R_7)_{c7}]$ may be a phenyl group simultaneously substituted with 1) at least one $C_4$-$C_{10}$ alkyl group and 2) at least one phenyl group.

In one or more embodiments, Formula 1 may satisfy <Condition A>, and the group represented by $*-[(L_7)_{b7}-(R_7)_{c7}]$ may be a phenyl group simultaneously substituted with 1) at least one tert-butyl group and 2) at least one phenyl group.

a51 and a52 in Formula N51 respectively indicate the number of $A_{51}$(s) and the number of $A_{52}$(s), and may each independently be an integer from 0 to 10. When a51 is 2 or more, two or more of $A_{51}$(s) may be identical to or different from each other, and when a52 is 2 or more, two or more of $A_{52}$(s) may be identical to or different from each other.

For example, a51 and a52 in Formula N51 may each independently be 0, 1, 2, 3, 4, 5, or 6.

The sum of a51 and a52 in Formula N51 may be 1 or more. That is, ring $CY_{51}$ in Formula N51 may be essentially substituted with a group represented by $A_{51}$, a group represented by $A_{52}$, or a combination thereof. As such, although not intended to be limited by a particular theory, since ring $CY_{51}$ is essentially substituted with at least one electron-donating group, an electronic device, for example, an organic light-emitting device, including the organometallic compound represented by Formula 1 including the group represented by Formula N51 may have increased luminescence efficiency and lifespan.

For example, the sum of a51 and a52 may be 1, 2, or 3. In an embodiment, the sum of a51 and a52 may be 1.

a53 in Formula N51 indicates the number of groups represented by

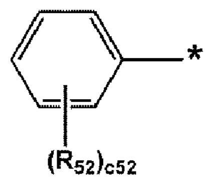

,

and may be an integer from 1 to 10. That is, since a53 in Formula N51 is not 0, ring $CY_{51}$ in Formula N51 may be essentially substituted with at least one group represented by

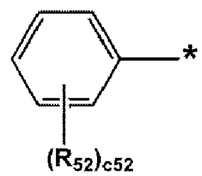

. As such, although not intended to be limited by a particular theory, due to the resonance effect of the group represented by

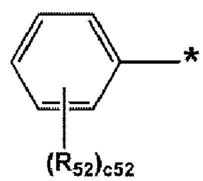

,

an electronic device, for example, an organic light-emitting device, including the organometallic compound represented by Formula 1 satisfying <Condition A> may have increased luminescence efficiency and lifespan. Also, although not intended to be limited by a particular theory, since due to the group represented by

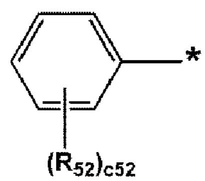

,

a group represented by

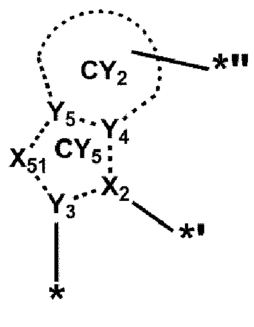

,

for example, a benzimidazole group in Formula 1 satisfying <Condition A> may be protected from electrons, heat, or the like, an electronic device, for example, an organic light-emitting device, including the organometallic compound represented by Formula 1 may have improved luminescence efficiency and lifespan.

In an embodiment, a51 and a52 in Formula N51 may each independently be 0, 1, or 2 (for example, 0 or 1), the sum of a51 and a52 may be 1 or 2 (for example, 1), and a53 may be 1 or 2 (for example, 1).

**[0069]** * in Formula N51 indicates a binding site to a neighboring atom.

In an embodiment, a group represented by

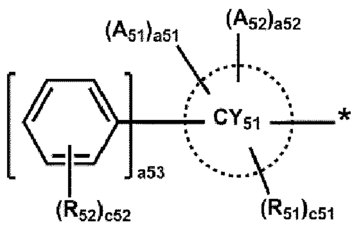

in Formula N51 may be a group represented by one of Formulae 51-1 to 51-20:

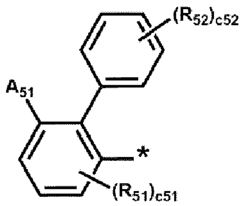
51-1

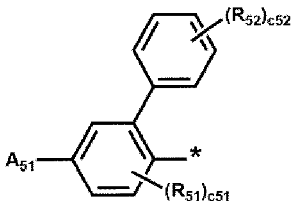
51-2

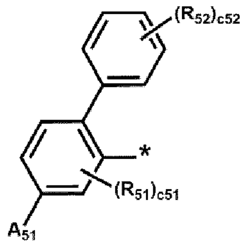
51-3

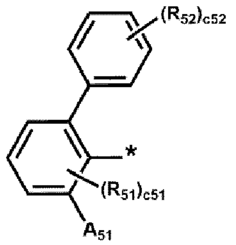
51-4

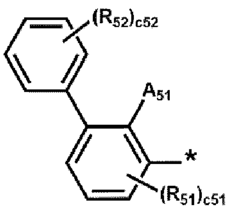
51-5

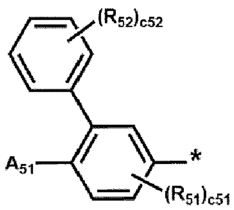
51-6

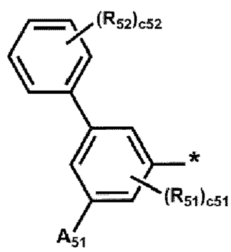
51-7

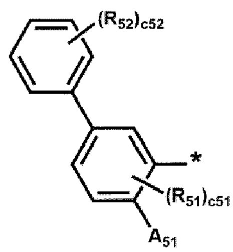
51-8

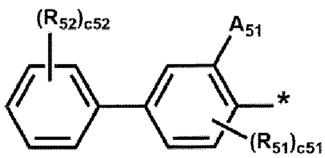
51-9

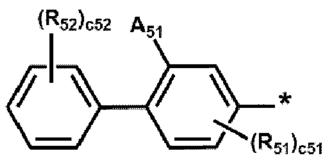
51-10

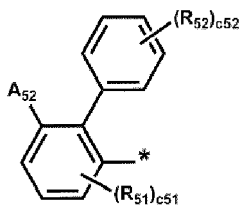
51-11

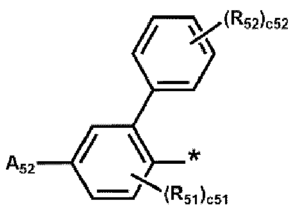
51-12

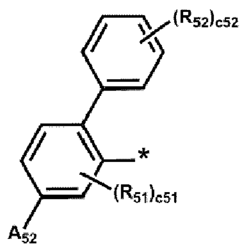
51-13

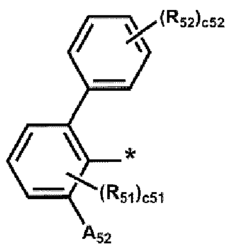
51-14

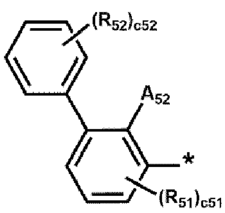
51-15

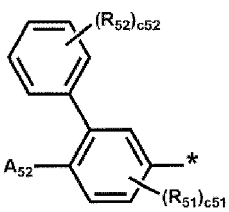
51-16

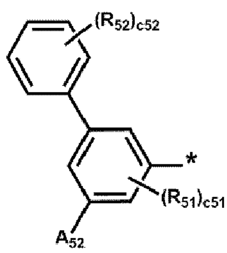
51-17

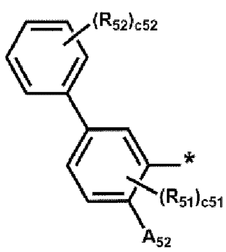
51-18

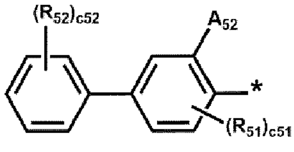

51-19

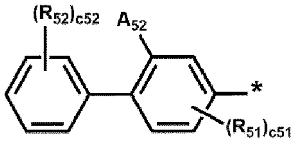

51-20

.

$R_{51}$, $R_{52}$, c51, c52, $A_{51}$, and $A_{52}$ in Formulae 51-1 to 51-20 are the same as described in the present specification, and * indicates a binding site to $L_{51}$.
In an embodiment, Formula 1 may satisfy <Condition B>.
In an embodiment, Formula 1 may satisfy <Condition B> and ring $CY_1$ may not be a fluorene group and a carbazole group.
In one or more embodiments, Formula 1 may satisfy Condition B and ring $CY_1$ may be a naphthalene group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group.
In one or more embodiments, Formula 1 may satisfy Condition C. In one or more embodiments,

i) Formula 1 may satisfy Condition C,
ii) ring $CY_3$ may be a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group,
iii) a4 may be 1, 2, or 3, and
iv) at least one of $R_4$ may be:

a $C_1$-$C_{20}$ alkyl group substituted with at least one phenyl group; or
a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In one or more embodiments, Formula 1 may satisfy Condition D.
In one or more embodiments,

i) Formula 1 may satisfy Condition D,
ii) ring $CY_4$ may be an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group,
iii) a3 may be 1, 2, or 3, and
iv) at least one of $R_3$ may be:

a $C_1$-$C_{20}$ alkyl group substituted with at least one phenyl group; or
a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In one or more embodiments, Formula 1 may be i) Condition A and ii) one of Condition B, Condition C and Condition D, simultaneously. For example, Compound 149 is a compound satisfying Condition A and Condition B and Compound 339 is a compound satisfying Condition A and Condition C.
In an embodiment, a3 in Formula 1 may be 1, 2, 3, or 4, and the group represented by $*-(L_3)_{b3}-(R_3)_{c3}$ may not be hydrogen.
In one or more embodiments, a4 in Formula 1 may be 1, 2, 3, or 4, and the group represented by $*-(L_4)b_4-(R_4)_{c4}$ may not be hydrogen.
In one or more embodiments, a3 and a4 in Formula 1 may each independently be 1, 2, 3, or 4, and the group

represented by *-$(L_3)_{b3}$-$(R_3)_{c3}$ and group represented by *-$(L_4)_{b4}$-$(R_4)_{c4}$ may not be hydrogen.

In one or more embodiments, regarding Formula 1,

a3 may be 1, 2, 3, 4, or 5,
$L_3$ may be a single bond, and
$R_3$ may be a substituted or unsubstituted $C_1$-$C_{60}$ alkyl group. In this regard, detailed examples of the $R_3$ may be understood by referring to the description provided in the present specification.

In one or more embodiments, regarding Formula 1,

a3 may be 1, 2, 3, 4, or 5,
at least one of a plurality of $R_3$(s) may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted C1-$C_{60}$ heteroaryl group, a substituted or unsubstituted monovalent non-aromatic condensed polycyclic group, or a substituted or unsubstituted monovalent non-aromatic condensed heteropolycyclic group. In this regard, detailed examples of the $R_3$ may be understood by referring to the description provided in the present specification.

In one or more embodiments, regarding Formula 1,

a4 may be 1, 2, 3, 4, or 5, and
at least one of a plurality of $R_4$(s) may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted C1-$C_{60}$ heteroaryl group, a substituted or unsubstituted monovalent non-aromatic condensed polycyclic group, or a substituted or unsubstituted monovalent non-aromatic condensed heteropolycyclic group. In this regard, detailed examples of the $R_4$ may be understood by referring to the description provided in the present specification.

In an embodiment, $R_1$ to $R_7$, R', and R" in Formulae 1 may each independently be hydrogen, deuterium, -F, a cyano group, a nitro group, $-SF_5$, $-CH_3$, $-CD_3$, $-CD_2H$, - $CDH_2$, $-CF_3$, $-CF_2H$, $-CFH_2$, $-OCH_3$, $-OCDH_2$, $-OCD_2H$, $-OCD_3$, $-SCH_3$, $-SCDH_2$, - $SCD_2H$, $-SCD_3$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-236, a group represented by one of Formulae 9-201 to 9-236 in which at least one hydrogen is substituted with deuterium, a group represented by one of Formulae 9-201 to 9-236 in which at least one hydrogen is substituted with -F, a group represented by one of Formulae 10-1 to 10-132, a group represented by one of Formulae 10-1 to 10-132 in which at least one hydrogen is substituted with deuterium, a group represented by one of Formulae 10-1 to 10-132 in which at least one hydrogen is substituted with -F, a group represented by one of Formulae 10-201 to 10-353, a group represented by one of Formulae 10-201 to 10-353 in which at least one hydrogen is substituted with deuterium, a group represented by one of Formulae 10-201 to 10-353 in which at least one hydrogen is substituted with -F, $-Si(Q_3)(Q_4)(Q_5)$, or $-Ge(Q_3)(Q_4)(Q_5)$(where $Q_3$ to $Q_5$ are the same as described in the present specification).

In one or more embodiments, $A_{51}$ in Formula N51 may be a group represented by one of Formulae 9-4 to 9-39.

In one or more embodiments, $A_{52}$ in Formula N51 may be $-CD_3$, $-CD_2H$, $-CDH_2$, or a group represented by one of Formulae 9-1 to 9-39 in which at least one hydrogen is substituted with deuterium (or, $-CD_3$ or a group represented by one of Formulae 9-1 to 9-39 in which all hydrogen is substituted with deuterium).

In one or more embodiments, the group represented by

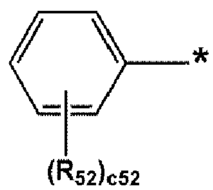

in Formula N51 may be a group represented by one of Formulae 10-12 to 10-205.

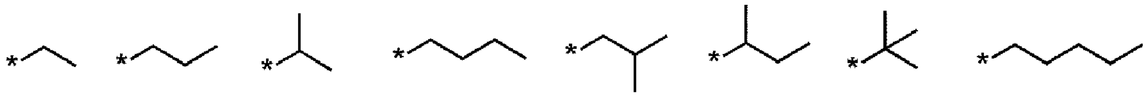

9-1 9-2 9-3 9-4 9-5 9-6 9-7 9-8

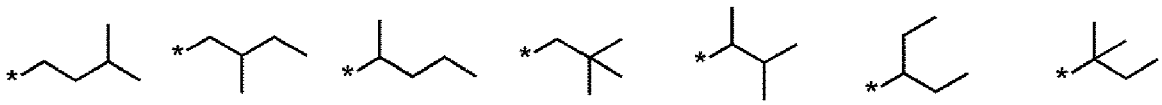

9-9 9-10 9-11 9-12 9-13 9-14 9-15

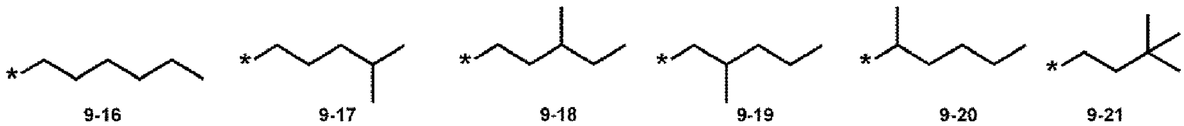

9-16 9-17 9-18 9-19 9-20 9-21

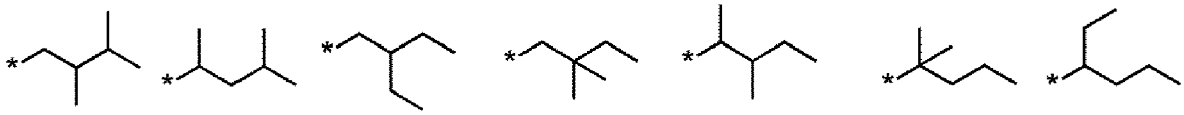

9-22 9-23 9-24 9-25 9-26 9-27 9-28

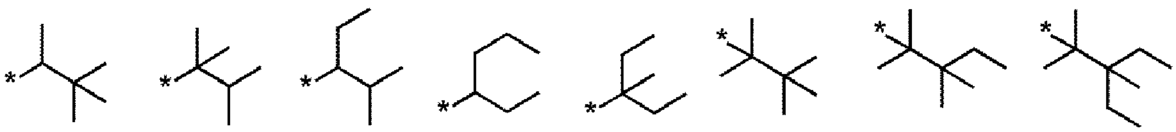

9-29 9-30 9-31 9-32 9-33 9-34 9-35 9-36

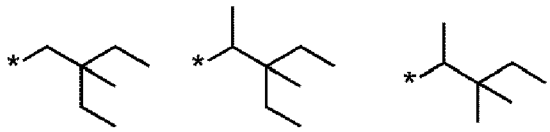

9-37 9-38 9-39

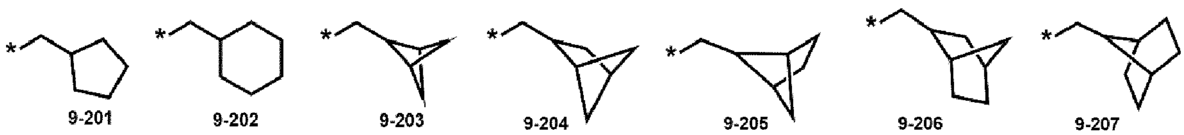

9-201 9-202 9-203 9-204 9-205 9-206 9-207

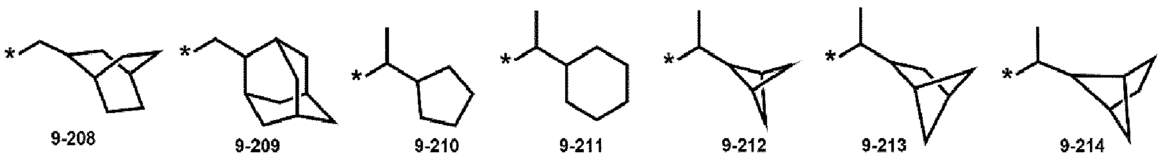

9-208 9-209 9-210 9-211 9-212 9-213 9-214

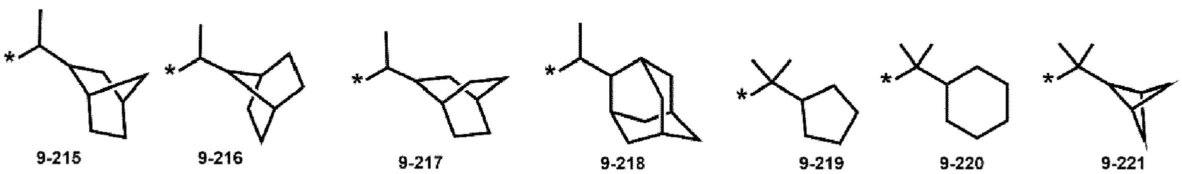

9-215 9-216 9-217 9-218 9-219 9-220 9-221

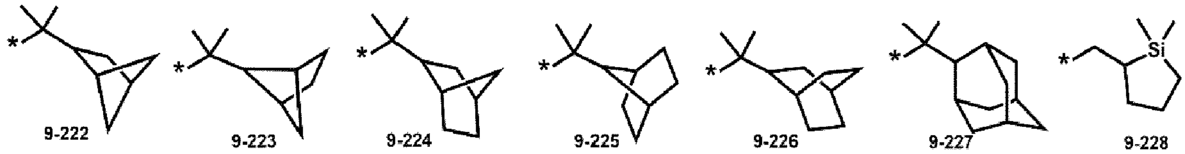

9-222 9-223 9-224 9-225 9-226 9-227 9-228

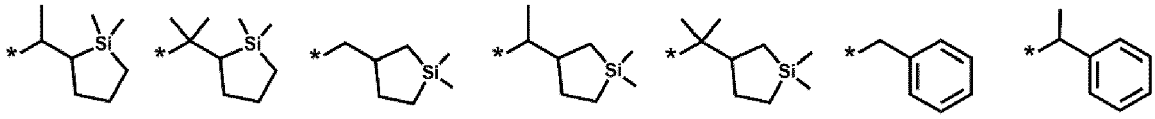

9-229 9-230 9-231 9-232 9-233 9-234 9-235

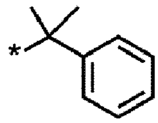

9-236

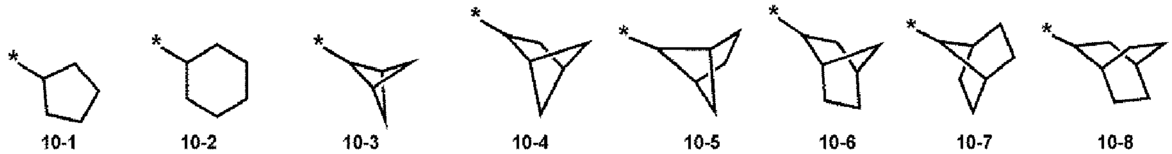

10-1 10-2 10-3 10-4 10-5 10-6 10-7 10-8

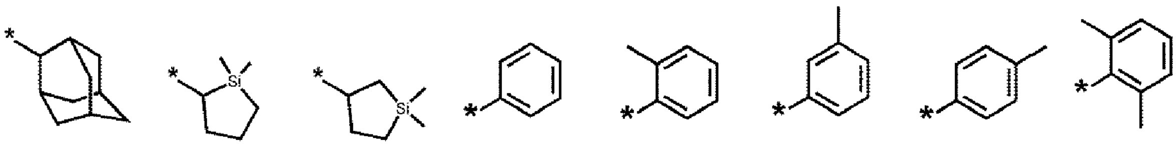

10-9 10-10 10-11 10-12 10-13 10-14 10-15 10-16

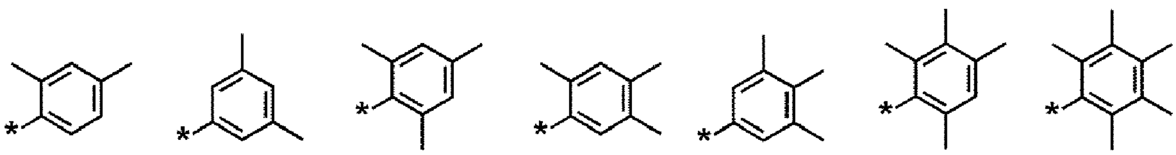

10-17 10-18 10-19 10-20 10-21 10-22 10-23

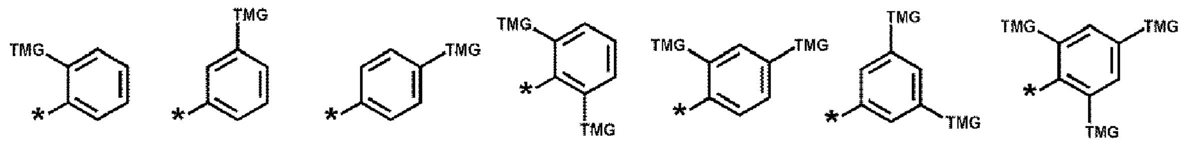

10-24 10-25 10-26 10-27 10-28 10-29 10-30

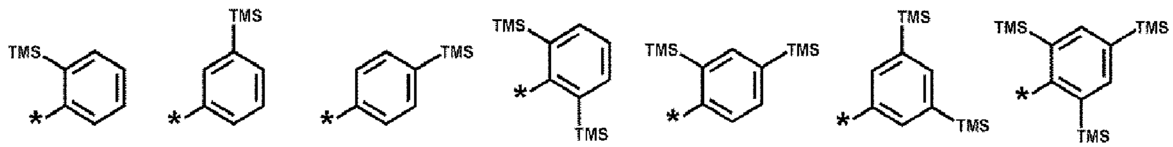

10-31 10-32 10-33 10-34 10-35 10-36 10-37

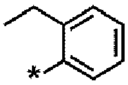
10-38

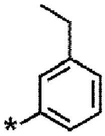
10-39

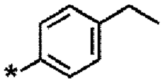
10-40

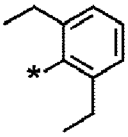
10-41

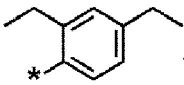
10-42

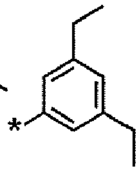
10-43

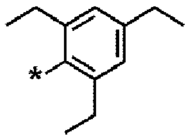
10-44

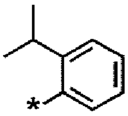
10-45

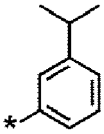
10-46

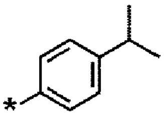
10-47

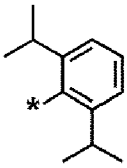
10-48

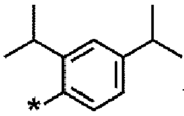
10-49

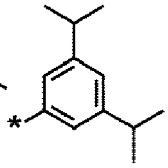
10-50

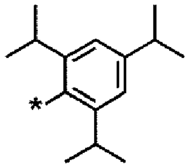
10-51

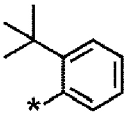
10-52

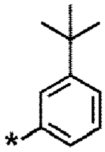
10-53

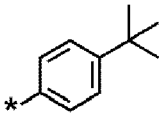
10-54

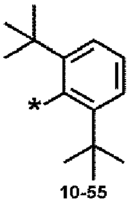
10-55

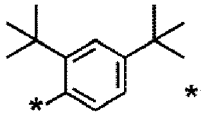
10-56

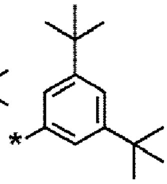
10-57

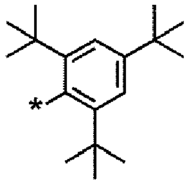
10-58

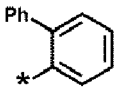
10-59

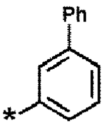
10-60

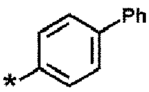
10-61

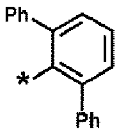
10-62

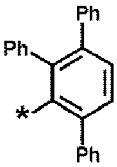
10-63

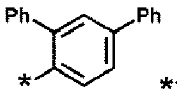
10-64

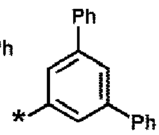
10-65

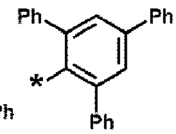
10-66

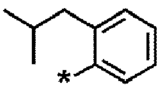
10-67

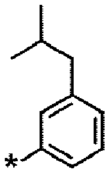
10-68

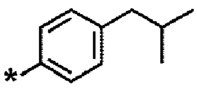
10-69

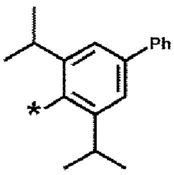
10-70

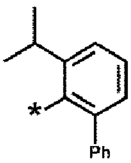
10-71

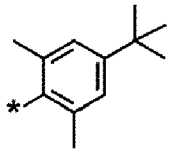
10-72

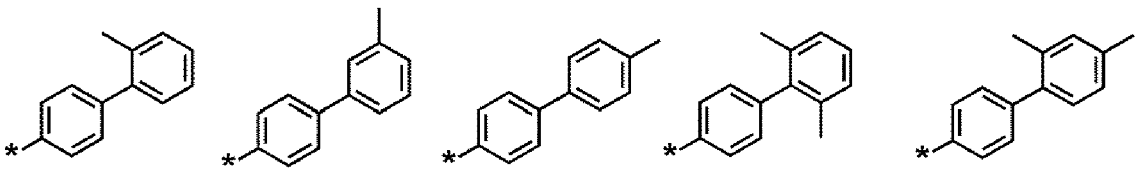
10-73 10-74 10-75 10-76 10-77

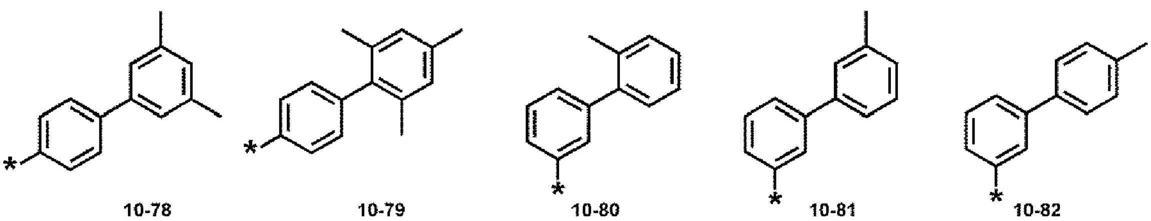
10-78 10-79 10-80 10-81 10-82

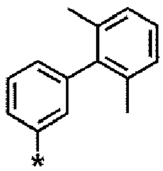
10-83

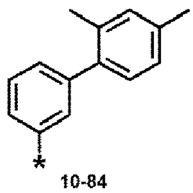
10-84

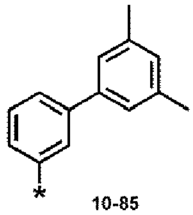
10-85

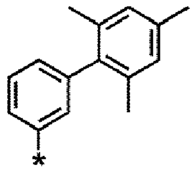
10-86

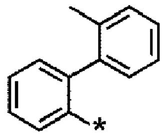
10-87

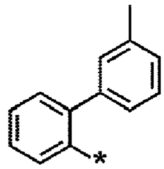
10-88

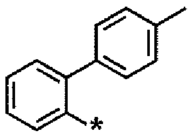
10-89

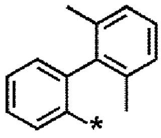
10-90

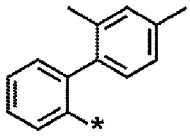
10-91

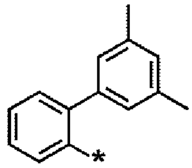
10-92

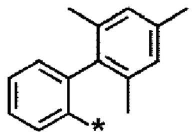
10-93

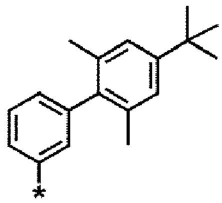
10-94

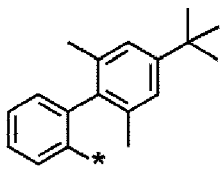
10-95

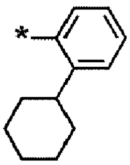
10-96

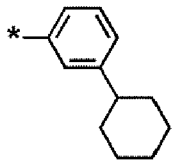
10-97

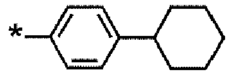
10-98

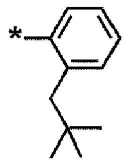
10-99

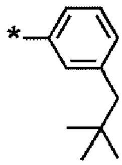
10-100

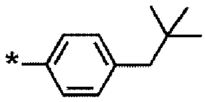
10-101

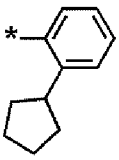
10-102

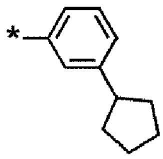
10-103

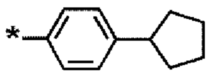
10-104

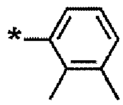
10-105

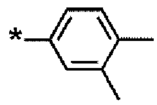
10-106

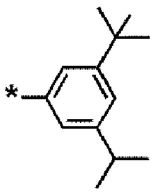
10-107

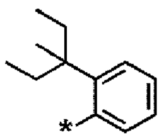
10-108

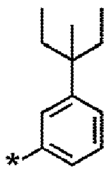
10-109

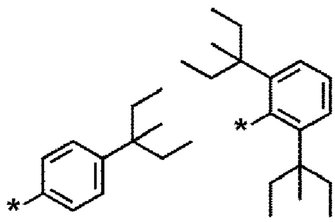
10-110 10-111

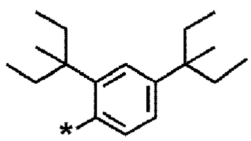
10-112

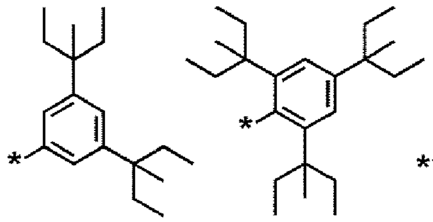
10-113 10-114

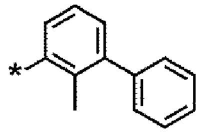
10-115

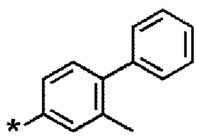
10-116

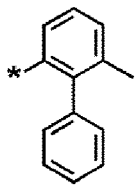
10-117

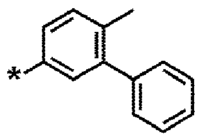
10-118

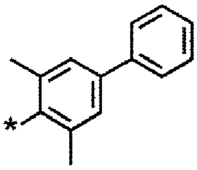
10-119

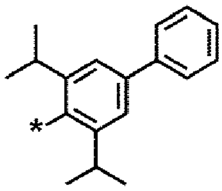
10-120

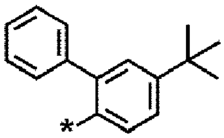
10-121

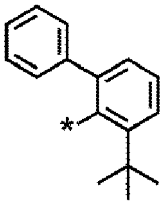
10-122

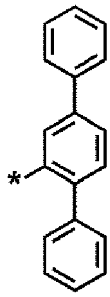
10-123

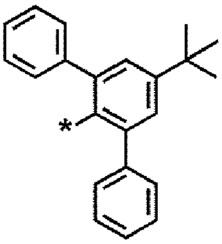
10-124

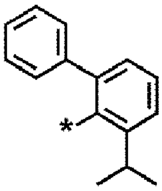
10-125

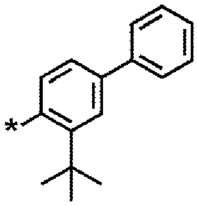
10-126

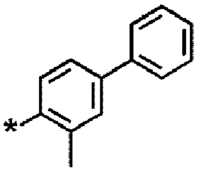
10-127

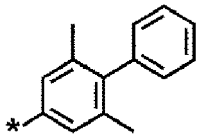
10-128

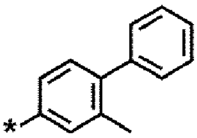
10-129

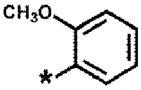
10-130

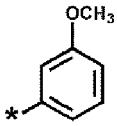
10-131

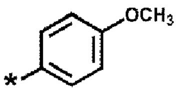
10-132

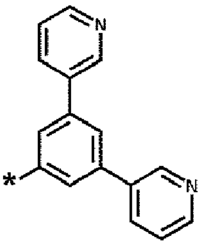
10-201

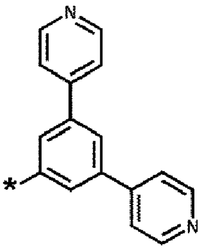
10-202

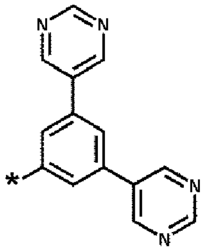
10-203

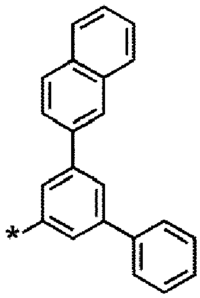
10-204

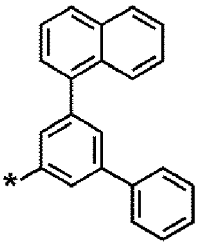
10-205

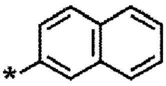
10-206

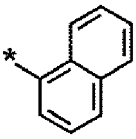
10-207

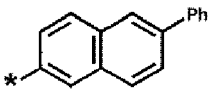
10-208

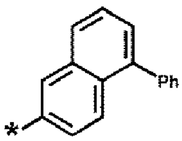
10-209

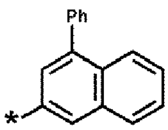
10-210

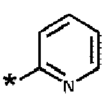
10-211

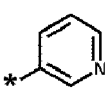
10-212

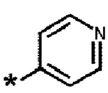
10-213

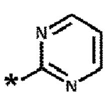
10-214

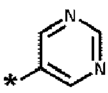
10-215

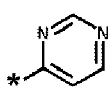
10-216

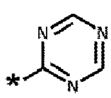
10-217

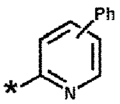
10-218
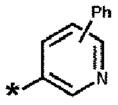
10-219
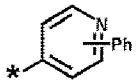
10-220
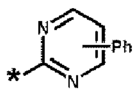
10-221
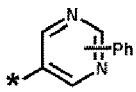
10-222
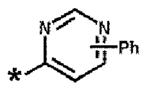
10-223
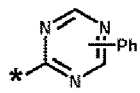
10-224

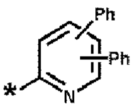
10-225
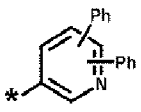
10-226
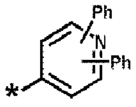
10-227
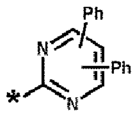
10-228
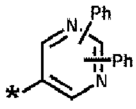
10-229
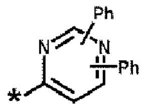
10-230
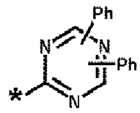
10-231

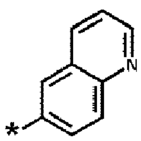
10-232
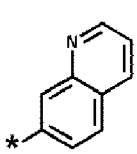
10-233
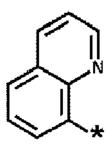
10-234
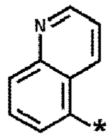
10-235
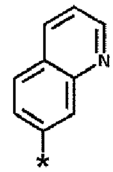
10-236
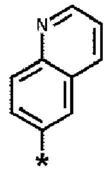
10-237

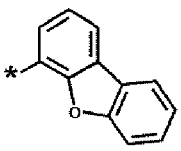
10-238
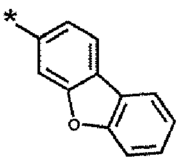
10-239
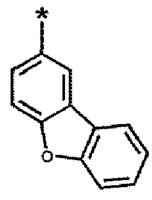
10-240
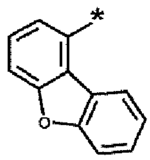
10-241
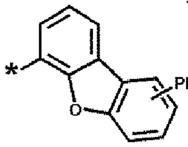
10-242
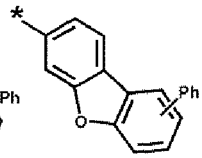
10-243

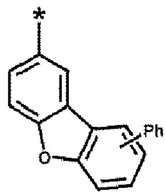
10-244
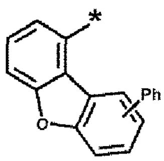
10-245
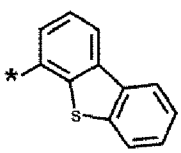
10-246
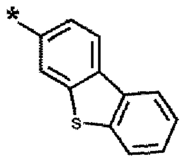
10-247
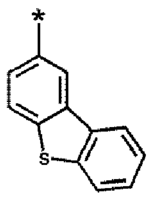
10-248
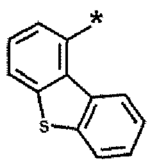
10-249

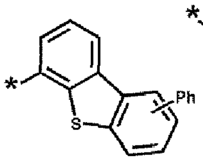
10-250
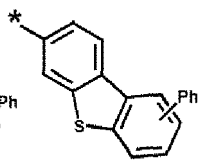
10-251
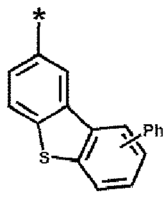
10-252
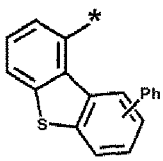
10-253
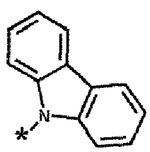
10-254
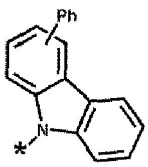
10-255

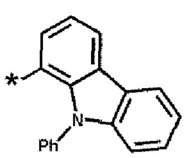
10-256
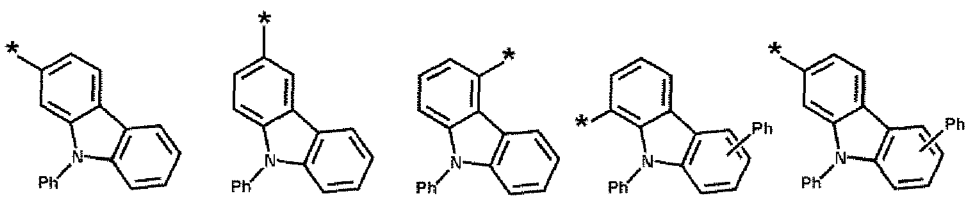
10-257
10-258
10-259
10-260
10-261

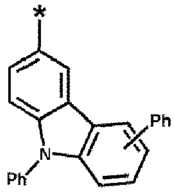
10-262
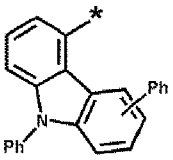
10-263
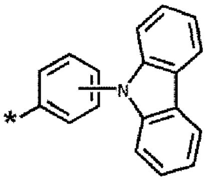
10-264
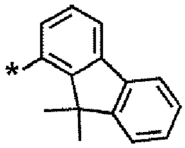
10-265
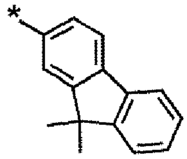
10-266
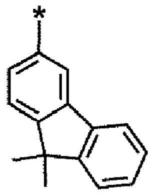
10-267
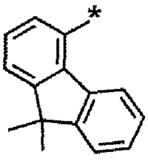
10-268
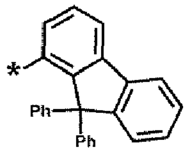
10-269
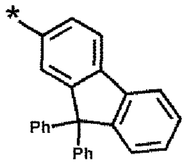
10-270
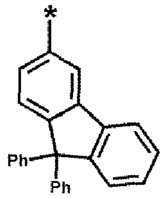
10-271
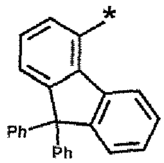
10-272
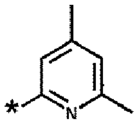
10-273
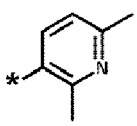
10-274
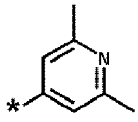
10-275
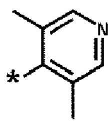
10-276
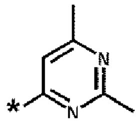
10-277
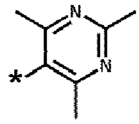
10-278
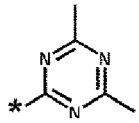
10-279
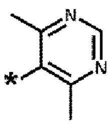
10-280
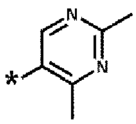
10-281
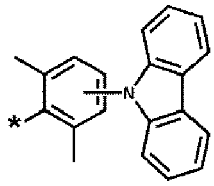
10-282
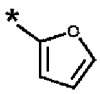
10-283
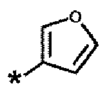
10-284
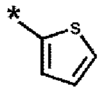
10-285
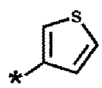
10-286
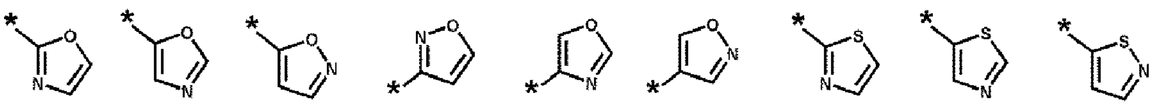
10-287 10-288 10-289 10-290 10-291 10-292 10-293 10-294 10-295
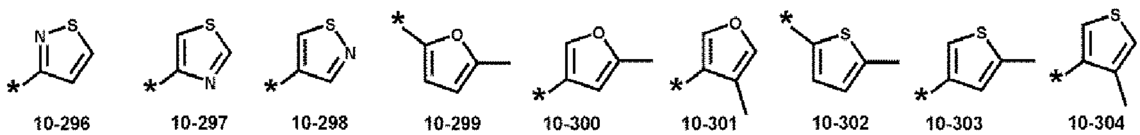
10-296 10-297 10-298 10-299 10-300 10-301 10-302 10-303 10-304
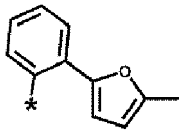
10-305
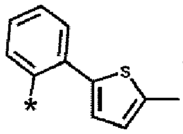
10-306
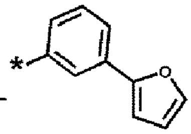
10-307
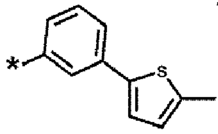
10-308
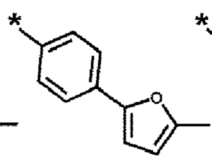
10-309
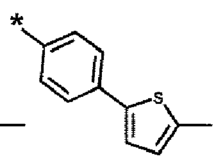
10-310

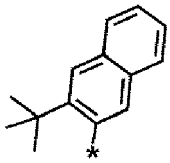
10-311
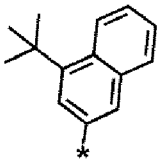
10-312
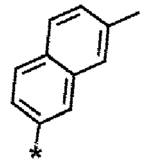
10-313
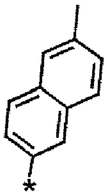
10-314
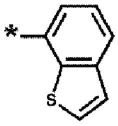
10-315
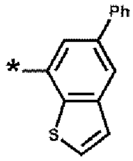
10-316
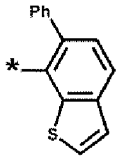
10-317

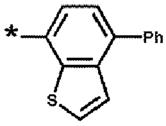
10-318
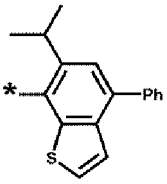
10-319
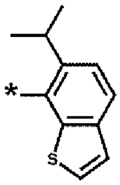
10-320
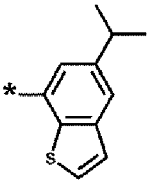
10-321
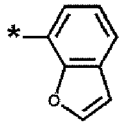
10-322
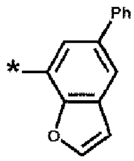
10-323
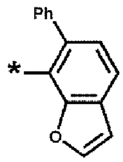
10-324

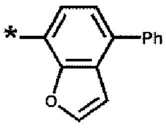
10-325
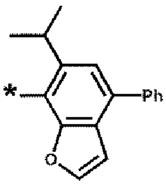
10-326
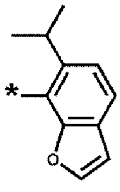
10-327
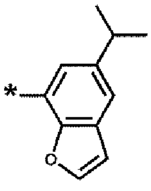
10-328
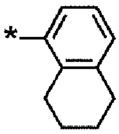
10-329
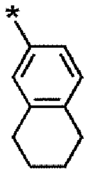
10-330
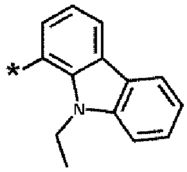
10-331

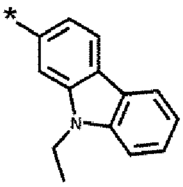
10-332
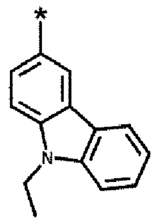
10-333
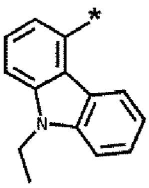
10-334
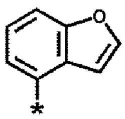
10-335
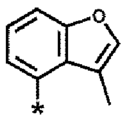
10-336
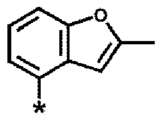
10-337

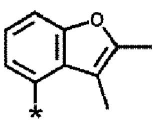
10-338
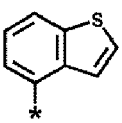
10-339
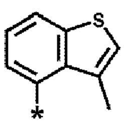
10-340
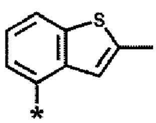
10-341
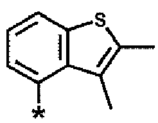
10-342
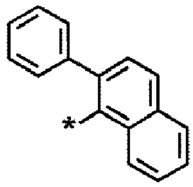
10-343

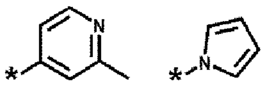
10-344
10-345
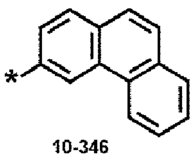
10-346
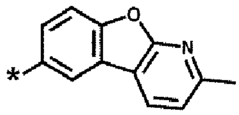
10-347
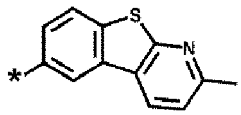
10-348

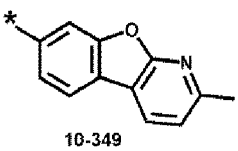
10-349
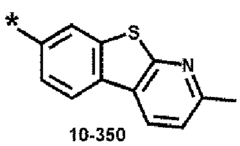
10-350
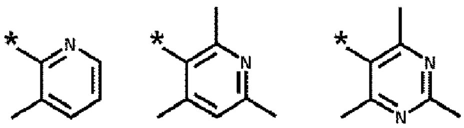
10-351
10-352
10-353

In Formulae 9-1 to 9-39, 9-201 to 9-236, 10-1 to 10-132, and 10-201 to 10-353, * indicates a binding site to a neighboring atom, Ph is a phenyl group, TMS is a trimethylsilyl group, TMG is a trimethylgermyl group, and OMe is a

methoxy group.

The "group represented by one of Formulae 9-1 to 9-39 in which at least one hydrogen is substituted with deuterium" and the "group represented by one of Formulae 9-201 to 9-236 in which at least one hydrogen is substituted with deuterium" may be, for example, a group represented by one of Formulae 9-501 to 9-514 and 9-601 to 9-635:

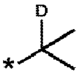
9-501
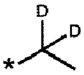
9-502
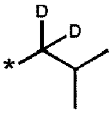
9-503
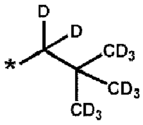
9-504
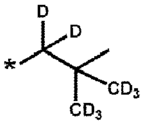
9-505
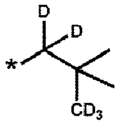
9-506
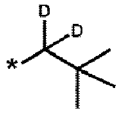
9-507

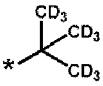
9-508
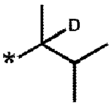
9-509
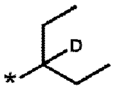
9-510
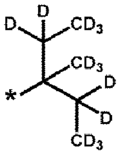
9-511
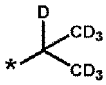
9-512
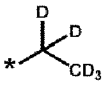
9-513
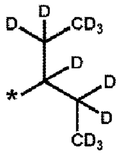
9-514

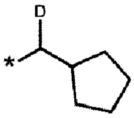
9-601
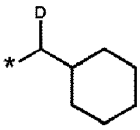
9-602
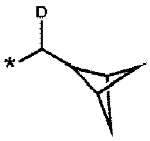
9-603
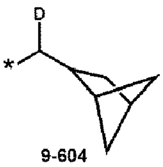
9-604
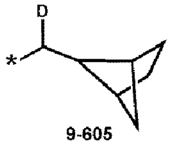
9-605
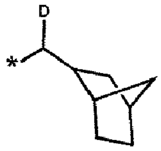
9-606
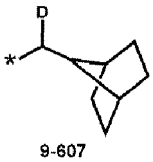
9-607

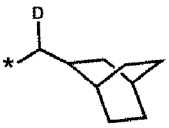
9-608
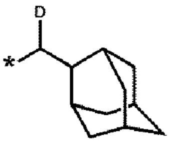
9-609
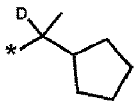
9-610
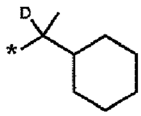
9-611
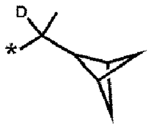
9-612
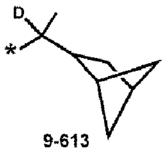
9-613

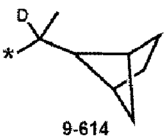
9-614
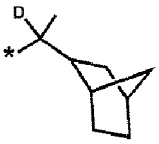
9-615
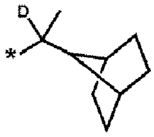
9-616
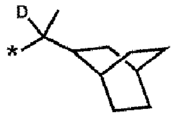
9-617
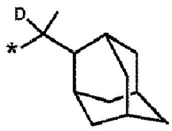
9-618
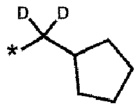
9-619

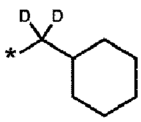
9-620
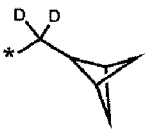
9-621
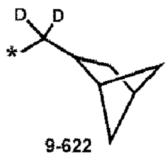
9-622
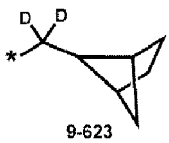
9-623
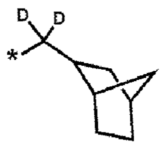
9-624
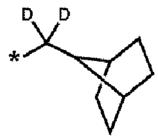
9-625

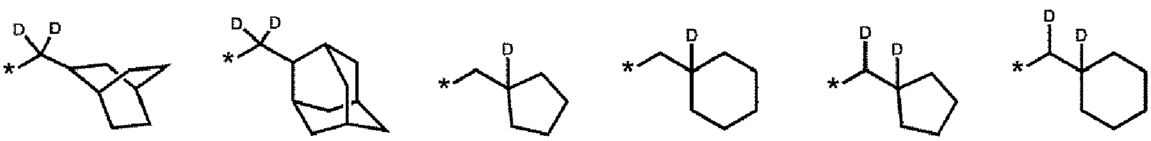
9-626 9-627 9-628 9-629 9-630 9-631

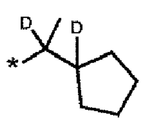 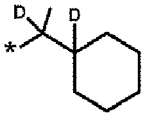 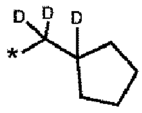 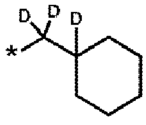

9-632 9-633 9-634 9-635

The "group represented by one of Formulae 9-1 to 9-39 in which at least one hydrogen is substituted with -F" and the "group represented by one of Formulae 9-201 to 9-236 in which at least one hydrogen is substituted with -F" may be, for example, a group represented by one of Formulae 9-701 to 9-710:

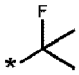 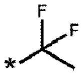 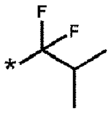 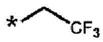 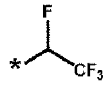 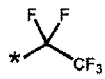 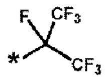

9-701 9-702 9-703 9-704 9-705 9-706 9-707

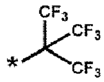 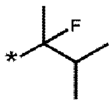 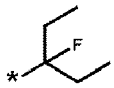

9-708 9-709 9-710

The "group represented by one of Formulae 10-1 to 10-132 in which at least one hydrogen is substituted with deuterium" and the "group represented by one of Formulae 10-201 to 10-353 in which at least one hydrogen is substituted with deuterium" may be, for example, a group represented by one of Formulae 10-501 to 10-553:

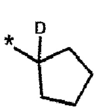 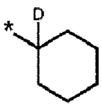 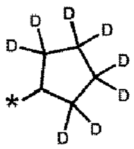 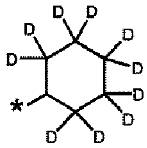 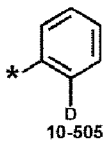 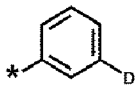 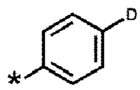 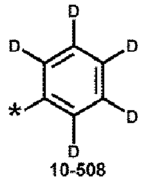

10-501 10-502 10-503 10-504 10-505 10-506 10-507 10-508

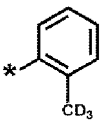 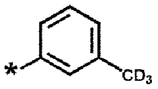 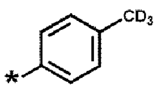 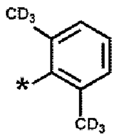 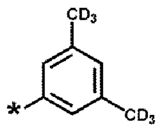 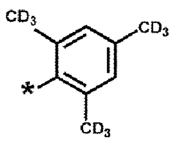 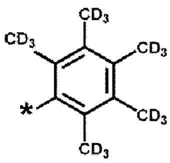

10-509 10-510 10-511 10-512 10-513 10-514 10-515

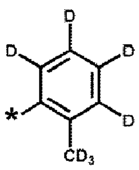 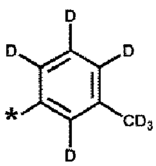 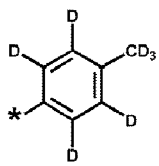 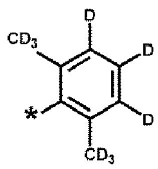 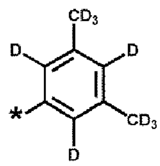 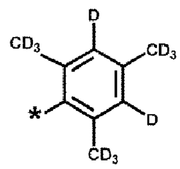

10-516 10-517 10-518 10-519 10-520 10-521

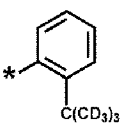 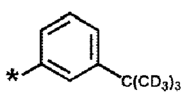 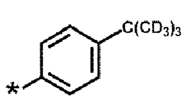 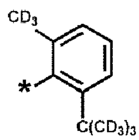 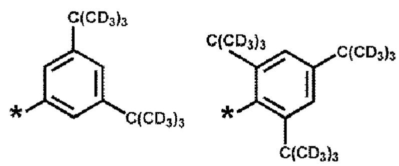

10-522 10-523 10-524 10-525 10-526 10-527

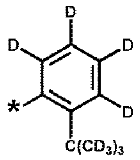
10-528
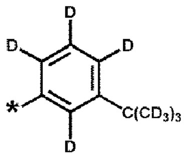
10-529
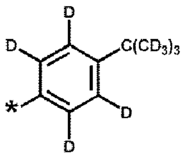
10-530
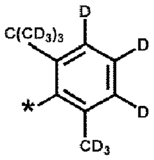
10-531
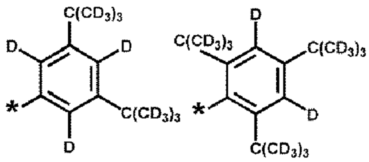
10-532 10-533

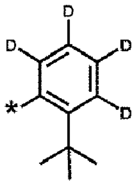
10-534
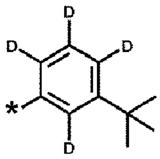
10-535
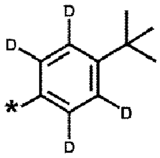
10-536
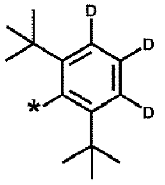
10-537
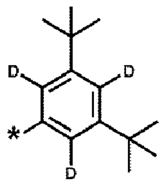
10-538
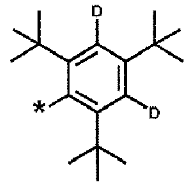
10-540

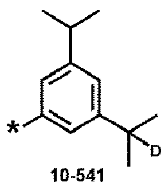
10-541
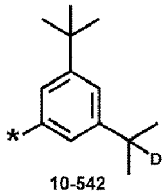
10-542
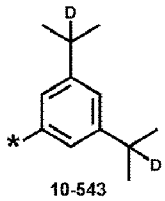
10-543
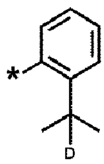
10-544
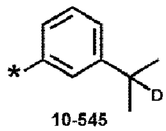
10-545
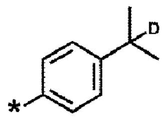
10-546

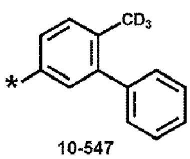
10-547
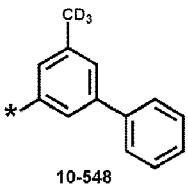
10-548
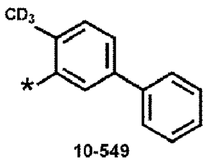
10-549
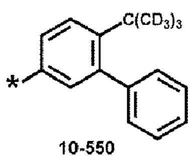
10-550
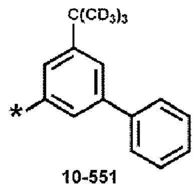
10-551

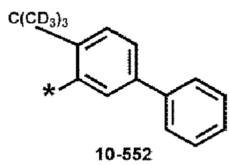
10-552
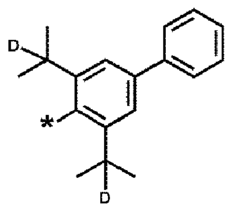
10-553

The "group represented by one of Formulae 10-1 to 10-132 in which at least one hydrogen is substituted with -F" and the "group represented by one of Formulae 10-201 to 10-353 in which at least one hydrogen is substituted with -F" may be, for example, a group represented by one of Formulae 10-601 to 10-620:

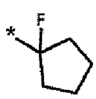
10-601
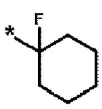
10-602
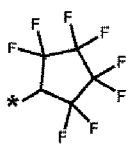
10-603
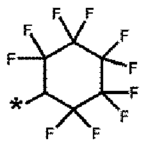
10-604
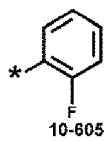
10-605
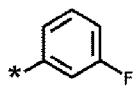
10-606
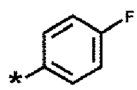
10-607
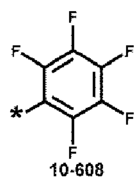
10-608

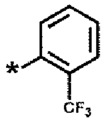
10-609
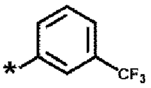
10-610
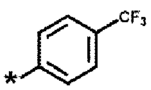
10-611
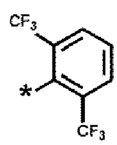
10-612
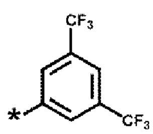
10-613
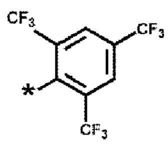
10-614
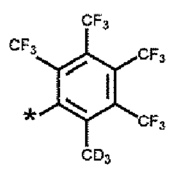
10-615

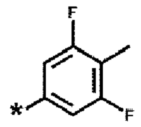

10-616

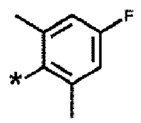

10-617

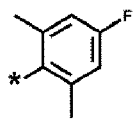

10-618

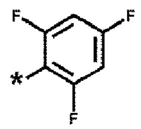

10-619

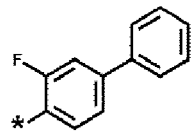

10-620

In Formula 1, i) two or more of a plurality of $R_1$(s) may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, ii) two or more of a plurality of $R_2$(s) may optionally be linked together to form a $C_5$-$C_{30}$carbocyclic group that is unsubstituted or substituted with at least one $R_{10a}$ or a $C_1$-$C_{30}$ heterocyclic group that is unsubstituted or substituted with at least one $R_{10a}$, iii) two or more of a plurality of $R_3$(s) may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, iv) two or more of a plurality of $R_4$(s) may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, and v) two or more of $R_1$ to $R_4$ may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. $R_{10a}$ is the same as described in connection with $R_1$.

In an embodiment, the organometallic compound may be represented by Formula 1-1:

Formula 1-1

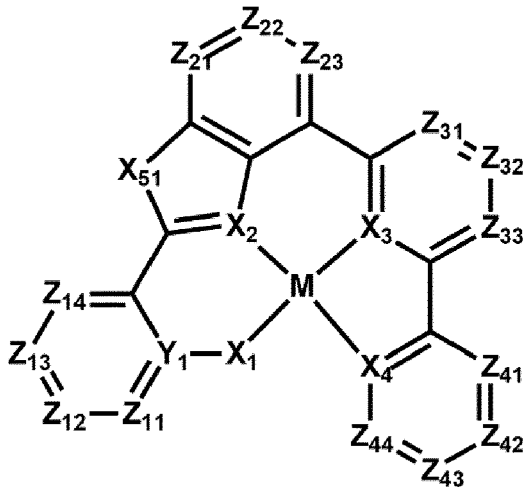

wherein, in Formula 1-1,

M, $X_1$ to $X_4$, $Y_1$ and $X_{51}$ are each the same as described in the present specification,
$Z_{11}$ may be N or C-[$(L_{11})_{b11}$-$(R_{11})_{c11}$], $Z_{12}$ may be N or C-[$(L_{12})_{b12}$-$(R_{12})_{c12}$], $Z_{13}$ may be N or C-[$(L_{13})_{b13}$-$(R_{13})_{c13}$], and $Z_{14}$ may be N or C-[$(L_{14})_{b14}$-$(R_{14})_{c14}$],
$L_{11}$ to $L_{14}$, b11 to b14, $R_{11}$ to $R_{14}$, and c11 to c14 are the same as described in connection with $L_1$, b1, $R_1$, and c1, respectively,
$Z_{21}$ may be N or C-[$(L_{21})_{b21}$-$(R_{21})_{c21}$], $Z_{22}$ may be N or C-[$(L_{22})_{b22}$-$(R_{22})_{c22}$], and $Z_{23}$ may be N or C-[$(L_{23})_{b23}$-$(R_{23})_{c23}$],
$L_{21}$ to $L_{23}$, b21 to b23, $R_{21}$ to $R_{23}$, and c21 to c23 are the same as described in connection with $L_2$, b2, $R_2$, and c2, respectively,
$Z_{31}$ may be N or C-[$(L_{31})_{b31}$-$(R_{31})_{c31}$], $Z_{32}$ may be N or C-[$(L_{32})_{b32}$-$(R_{32})_{c32}$], and $Z_{33}$ may be N or C-[$(L_{33})_{b33}$-$(R_{33})_{c33}$],
$L_{31}$ to $L_{33}$, b31 to b33, $R_{31}$ to $R_{33}$, and c31 to c33 are the same as described in connection with $L_3$, b3, $R_3$, and c3, respectively,
$Z_{41}$ may be N or C-[$(L_{41})_{b41}$-$(R_{41})_{c41}$], $Z_{42}$ may be N or C-[$(L_{42})_{b42}$-$(R_{42})_{c42}$], $Z_{43}$ may be N or C-[$(L_{43})_{b43}$-$(R_{43})_{c43}$], and $Z_{44}$ may be N or C-[$(L_{44})_{b44}$-$(R_{44})_{c44}$],
$L_{41}$ to $L_{44}$, b41 to b44, $R_{41}$ to $R_{44}$, and c41 to c44 are the same as described in connection with $L_4$, b4, $R_4$, and c4, respectively,
two or more of $R_{11}$ to $R_{14}$ may optionally be linked together to form a $C_5$-$C_{30}$ carbocyclic group that is unsubstituted

or substituted with at least one $R_{10a}$ or a $C_1$-$C_{30}$ heterocyclic group that is unsubstituted or substituted with at least one $R_{10a}$,

two or more of $R_{21}$ to $R_{23}$ may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of $R_{31}$ to $R_{33}$ may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of $R_{41}$ to $R_{44}$ may optionally be linked together to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, and

each of i) two or more of $R_{11}$ to $R_{14}$, ii) two or more of $R_{21}$ to $R_{23}$, iii) two or more of $R_{31}$ to $R_{33}$, and iv) two or more of $R_{41}$ to $R_{44}$ may be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$.

In an embodiment, the organometallic compound may be represented by Formula 1-1A, 1-1B or 1-1C:

Formula 1-1A

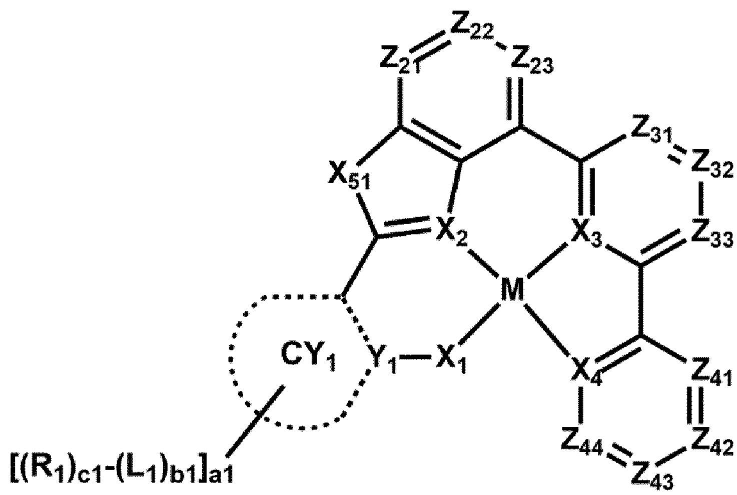

Formula 1-1B

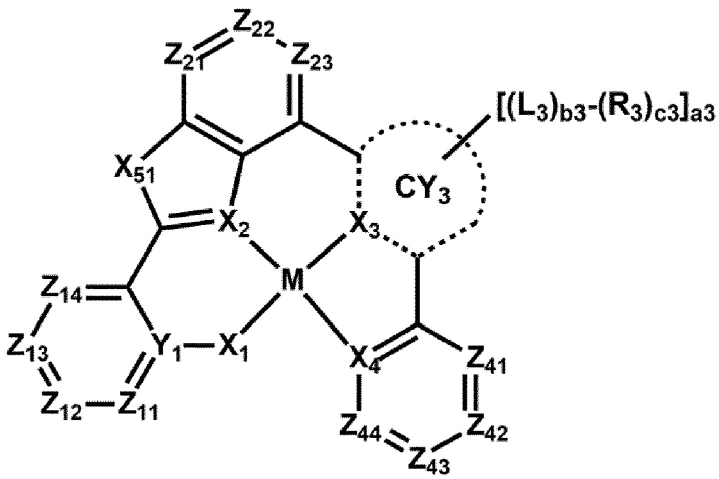

Formula 1-1C

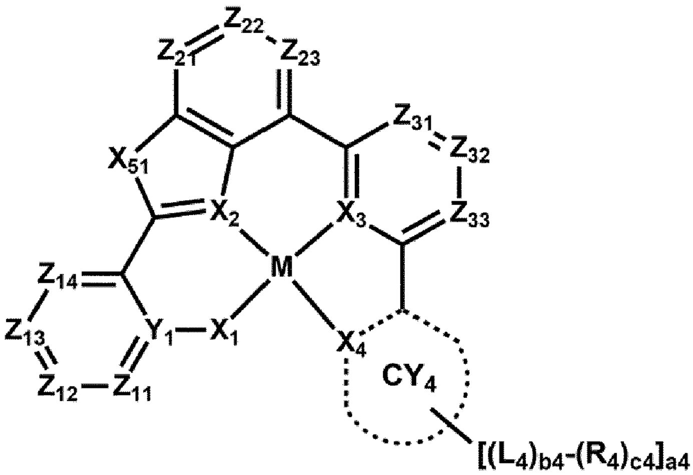

wherein, in Formulae 1-1A, 1-1B and 1-1C,

M, $X_1$ to $X_4$, $Y_1$, $X_{51}$, $Z_{11}$ to $Z_{14}$, $Z_{21}$ to $Z_{23}$, $Z_{31}$ to $Z_{33}$, $Z_{41}$ to $Z_{44}$, $L_1$, $L_3$, $L_4$, b1, b3, b4, $R_1$, $R_3$, $R_4$, c1, c3, c4, a1, a3 and a4are each the same as described in the present specification, and
ring $CY_1$, ring $CY_3$ and ring $CY_4$ may each independently be a condensed cyclic group in which two or more rings are condensed with each other as described in the present specification.

All descriptions for Formula 1 described herein are applicable to Formulae 1-1, 1-1A, 1-1B and 1-1C.
In one or more embodiments, Formulae 1-1A, 1-1B and 1-1C, $L_1$, $L_3$, $L_4$, $L_{21}$ to $L_{23}$, $L_{31}$ to $L_{33}$, $L_{41}$ to $L_{44}$ and $L_7$ may each independently be:

a single bond; or
a benzene group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In one or more embodiments, Formulae 1-1A, 1-1B and 1-1C, b1, b3, b4, b21 to b23, b31 to b33, b41 to b44 and b7 may each independently be 1, 2, or 3.
In one or more embodiments, Formulae 1-1A, 1-1B and 1-1C, $R_1$, $R_2$, $R_{11}$ to $R_{14}$ and $R_{21}$ to $R_{23}$ may each independently be hydrogen, deuterium, a $C_1$-$C_{20}$ alkyl group, or a deuterated $C_1$-$C_{20}$ alkyl group.
In one or more embodiments, Formulae 1-1A, 1-1B and 1-1C, c1, c2, c11 to c14 and c21 to c23 may each independently be 1, 2 or 3.
In one or more embodiments, Formulae 1-1A, 1-1B and 1-1C, $R_3$, $R_4$, $R_{31}$ to $R_{33}$ and $R_{41}$ to $R_{44}$ may each independently be:

hydrogen, deuterium, a $C_1$-$C_{20}$ alkyl group, or a deuterated $C_1$-$C_{20}$ alkyl group;
a $C_1$-$C_{20}$ alkyl group substituted with at least one phenyl group; or
a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In one or more embodiments, Formulae 1-1A, 1-1B and 1-1C, c3, c4, c31 to c33 and c41 to c44 may each independently be 1, 2 or 3.
In one or more embodiments, Formulae 1-1A, 1-1B and 1-1C, a1, a3, and a4 may each independently be 0, 1, 2 or 3.
In one or more embodiments, Formulae 1-1A, 1-1B and 1-1C may satisfy Condition A.
In one or more embodiments, at least one of $R_{41}$ to $R_{44}$ in Formula 1-1 B may be:

a $C_1$-$C_{20}$ alkyl group substituted with at least one phenyl group; or

a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In one or more embodiments, at least one of $R_{31}$ to $R_{34}$ in Formula 1-1C may be:

a $C_1$-$C_{20}$ alkyl group substituted with at least one phenyl group; or
a phenyl group that is unsubstituted or substituted with deuterium, a $C_1$-$C_{20}$ alkyl group, a deuterated $C_1$-$C_{20}$ alkyl group, a phenyl group, a deuterated phenyl group, a biphenyl group, a deuterated biphenyl group, or a combination thereof.

In an embodiment, a group represented by

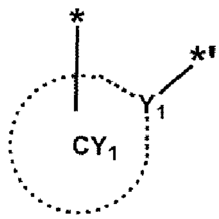

in Formula 1 may be a group represented by one of Formulae CY1-1 to CY1-48 and a group represented by

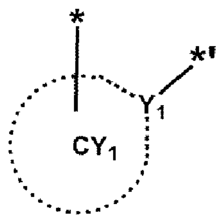

in Formula 1-1A may be a group represented by one of Formulae CY1-9 to CY1-48.

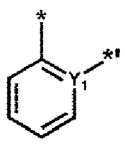
CY1-1
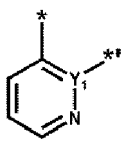
CY1-2
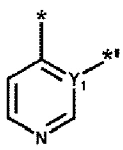
CY1-3
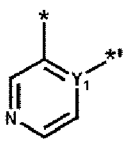
CY1-4
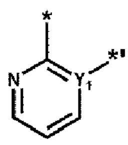
CY1-5
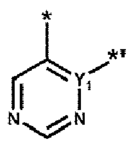
CY1-6
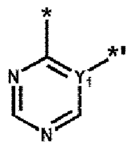
CY1-7
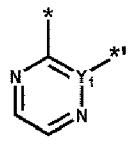
CY1-8

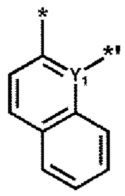
CY1-9
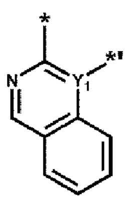
CY1-10
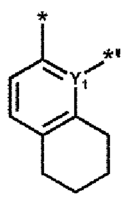
CY1-11
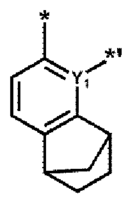
CY1-12
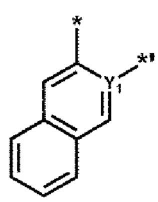
CY1-13
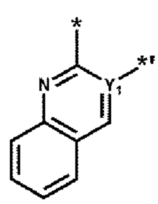
CY1-14
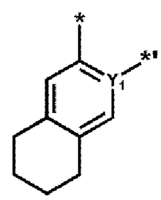
CY1-15

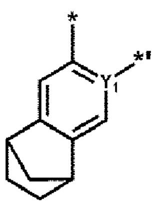
CY1-16
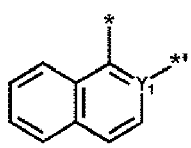
CY1-17
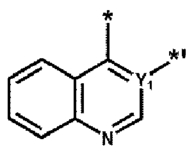
CY1-18
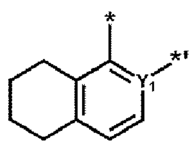
CY1-19
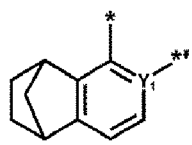
CY1-20
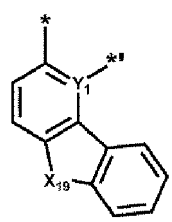
CY1-21

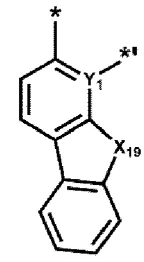
CY1-22
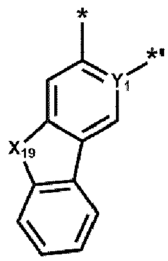
CY1-23
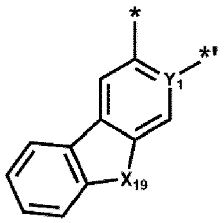
CY1-24
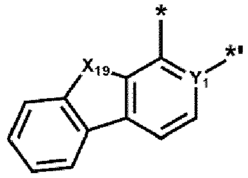
CY1-25
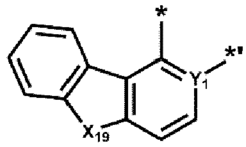
CY1-26

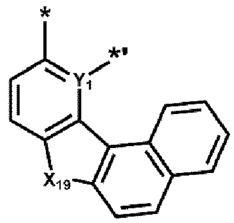
CY1-27
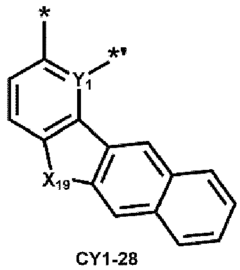
CY1-28
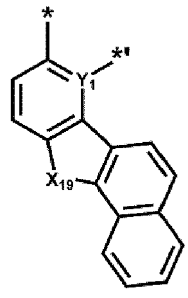
CY1-29
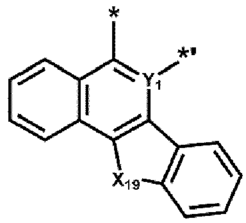
CY1-30

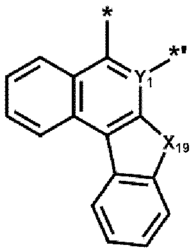
CY1-31
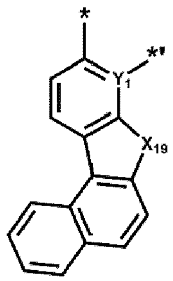
CY1-32
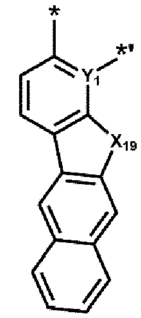
CY1-33
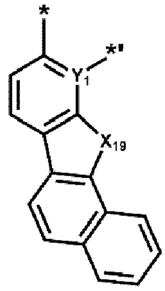
CY1-34
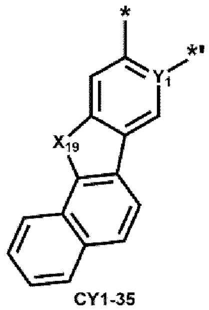
CY1-35
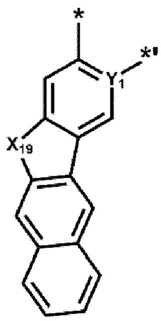
CY1-36

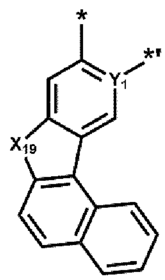
CY1-37
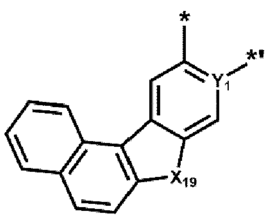
CY1-38
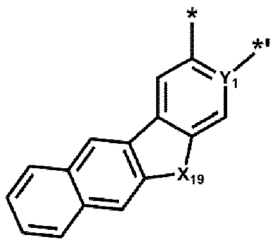
CY1-39
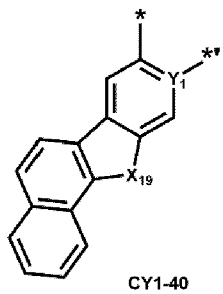
CY1-40

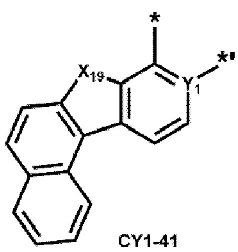
CY1-41
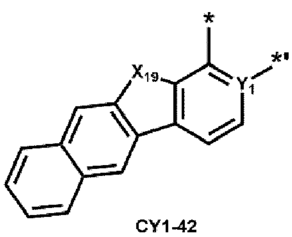
CY1-42
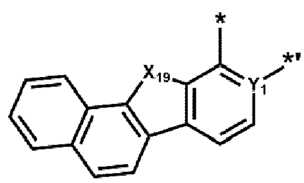
CY1-43
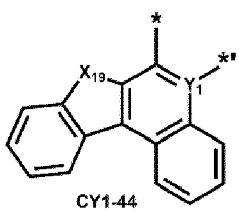
CY1-44

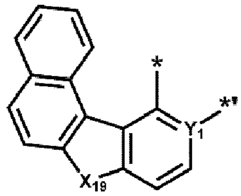

CY1-45

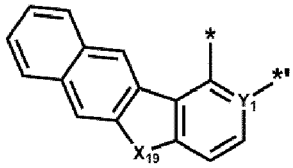

CY1-46

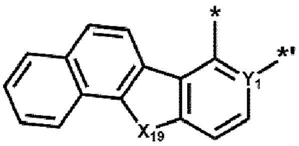

CY1-47

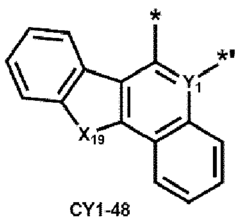

CY1-48

wherein, in Formulae CY1-1 to CY1-48,

$Y_1$ is the same as described above,
$X_{19}$ is $C(R_{19a})(R_{19b})$, $N[(L_{19})_{b19}-(R_{19})_{c19}]$, O, S, or $Si(R_{19a})(R_{19b})$,
$L_{19}$ may be the same as explained in connection with $L_1$;
b19 and c19 are the same as described in connection with b1 and c1,
$R_{19}$, $R_{19a}$, and $R_{19b}$ are the same as described in connection with $R_1$,
*' indicates a binding site to $X_1$ or M in Formula 1, and
* indicates a binding site to ring $CY_5$ in Formula 1.

In one or more embodiments, the group represented by

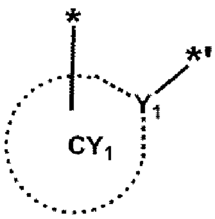

in Formulae 1 and 1-1A may be a group represented by one of Formulae CY1-9, CY1-10, CY1-13, CY1-14, CY1-17, CY1-18, and CY1-21 to CY1-48.

In one or more embodiments, the group represented by

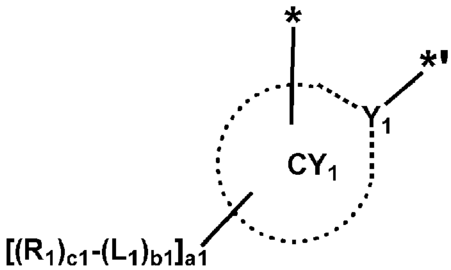

in Formula 1 and a group represented by

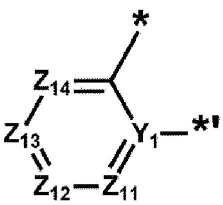

in Formulae 1-1, 1-1B and 1-1C may be a group represented by one of Formulae CY1(1) to CY1(22):

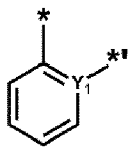
CY1(1)

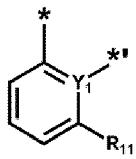
CY1(2)

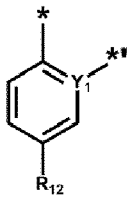
CY1(3)

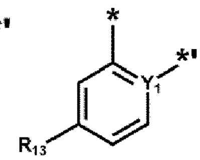
CY1(4)

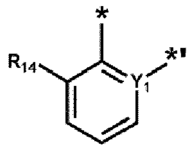
CY1(5)

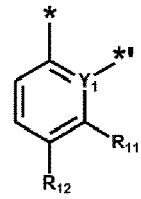
CY1(6)

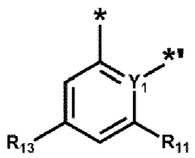
CY1(7)

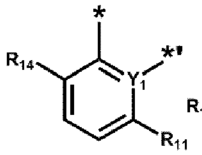
CY1(8)

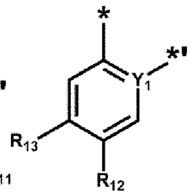
CY1(9)

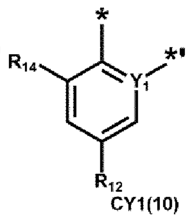
CY1(10)

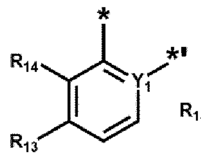
CY1(11)

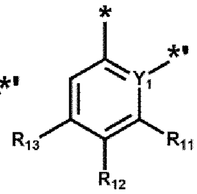
CY1(12)

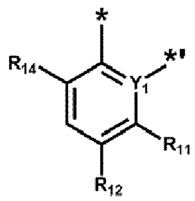
CY1(13)

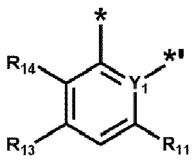
CY1(14)

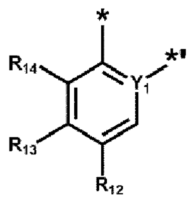
CY1(15)

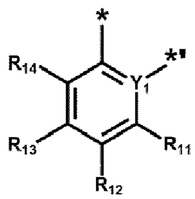
CY1(16)

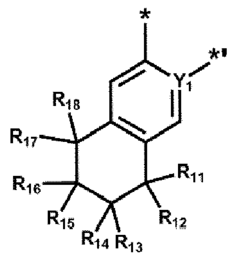
CY1(17)

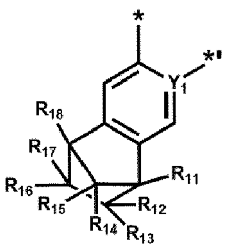
CY1(18)

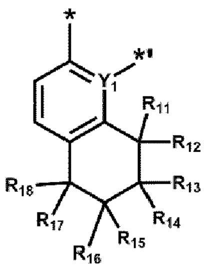
CY1(19)

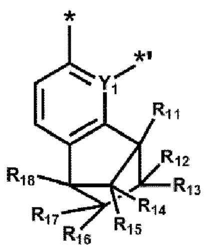
CY1(20)

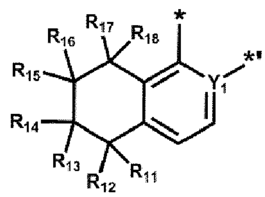
CY1(21)

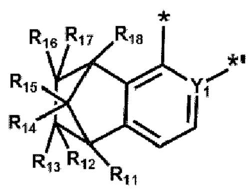
CY1(22)

wherein, in Formulae CY1(1) to CY1(22),

$Y_1$ is the same as described above,
$R_{11}$ to $R_{18}$ are the same as described in connection with $R_1$, and each of $R_{11}$ to $R_{14}$ in Formula CY1(1) to CY1(16) may not be hydrogen,
*' in Formulae CY1(1) to CY1(22) is a binding site to $X_1$ or M in Formula 1, and
* in Formulae CY1(1) to CY1(22) indicates a binding site to ring $CY_5$ in Formula 1.

In one or more embodiments, a group represented by

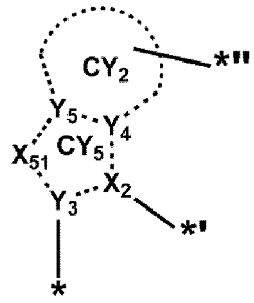

in Formula 1 and a group represented by

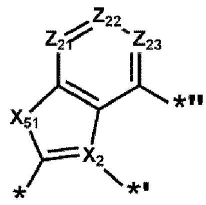

in Formulae 1-1, 1-1A, 1-1B, and 1-1C may be a group represented by one of Formulae CY2-1 to CY2-20:

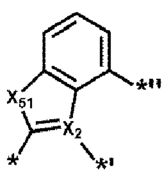
CY2-1

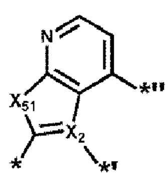
CY2-2

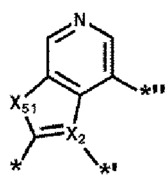
CY2-3

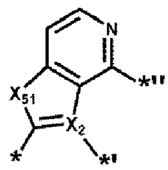
CY2-4

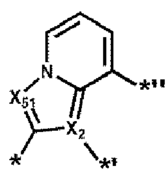
CY2-5

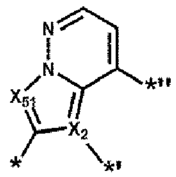
CY2-6

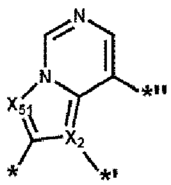
CY2-7

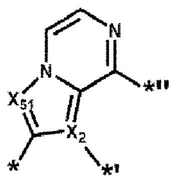
CY2-8

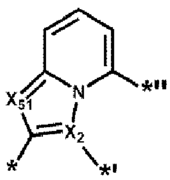
CY2-9

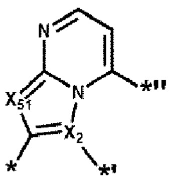
CY2-10

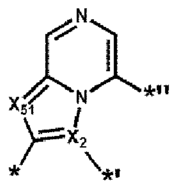
CY2-11

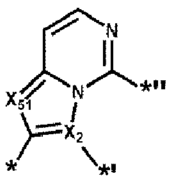
CY2-12

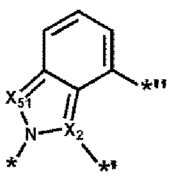
CY2-13

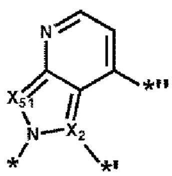
CY2-14

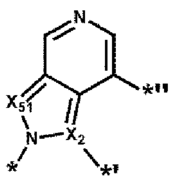
CY2-15

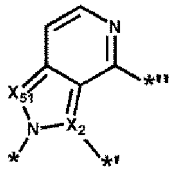
CY2-16

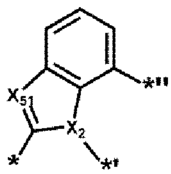
CY2-17

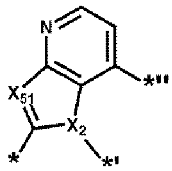
CY2-18

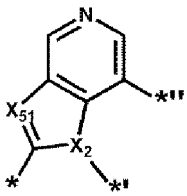
CY2-19

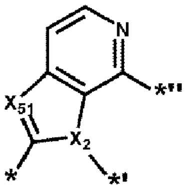
CY2-20

wherein, in Formulae CY2-1 to CY2-20,

$X_2$ and $X_{51}$ are the same as described in the present specification,
* indicates a binding site to ring $CY_1$ in Formula 1,
*' indicates a binding site to M in Formula 1, and
*" indicates a binding site to ring $CY_3$ in Formula 1.

In one or more embodiments, a group represented by

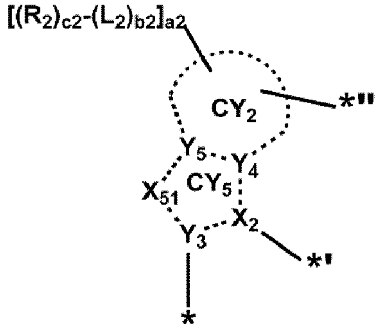

in Formula 1 and a group represented by

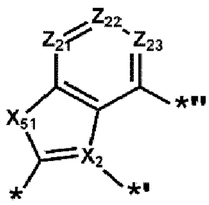

in Formulae 1-1, 1-1A, 1-1B, and 1-1C may be a group represented by one of Formulae CY2(1) to CY2(20):

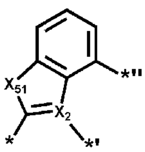
CY2(1)

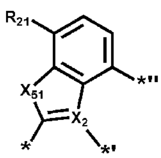
CY2(2)

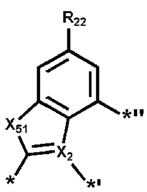
CY2(3)

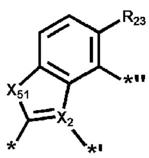
CY2(4)

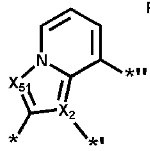
CY2(5)

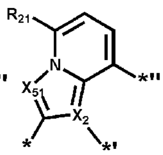
CY2(6)

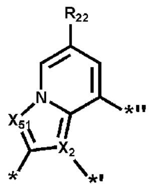
CY2(7)

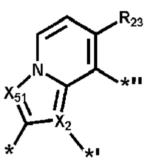
CY2(8)

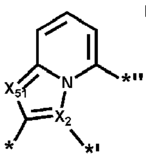
CY2(9)

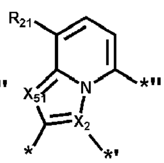
CY2(10)

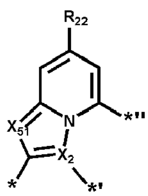
CY2(11)

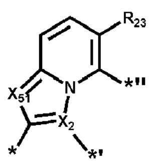
CY2(12)

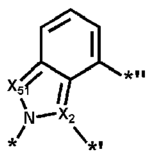
CY2(13)

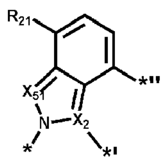
CY2(14)

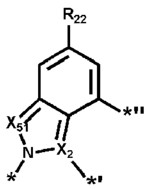
CY2(15)

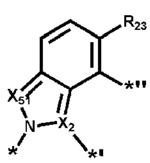
CY2(16)

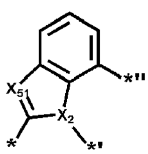
CY2(17)

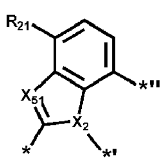
CY2(18)

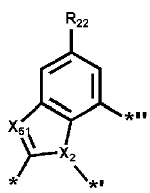
CY2(19)

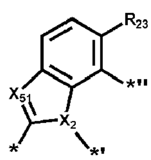
CY2(20)

wherein, in Formulae CY2(1) to CY2(20),

$X_2$ and $X_{51}$ are the same as described in the present specification,
$R_{21}$ to $R_{23}$ are the same as described in connection with $R_2$, and each of $R_{21}$ to $R_{23}$ may not be hydrogen,
* indicates a binding site to ring $CY_1$ in Formula 1,
*' indicates a binding site to M in Formula 1, and
*" indicates a binding site to ring $CY_3$ in Formula 1.

In one or more embodiments, a group represented by

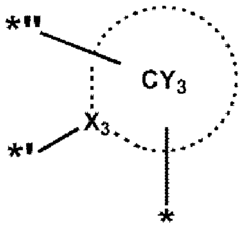

in Formula 1 may be a group represented by one of Formulae CY3-1 to CY3-26 and a group represented by

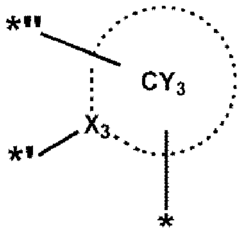

in Formula 1-1B may be a group represented by one of Formulae CY3-5 to CY3-26.

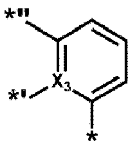
CY3-1

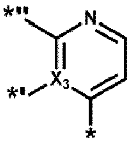
CY3-2

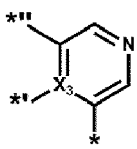
CY3-3

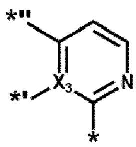
CY3-4

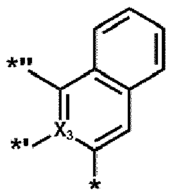
CY3-5

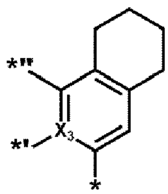
CY3-6

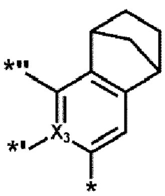
CY3-7

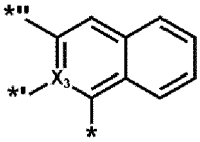
CY3-8

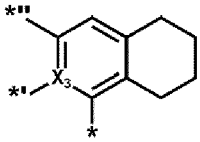
CY3-9

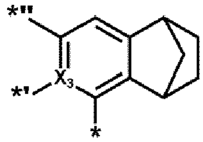
CY3-10

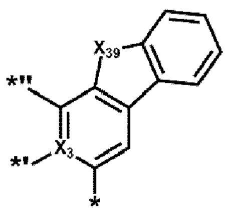
CY3-11

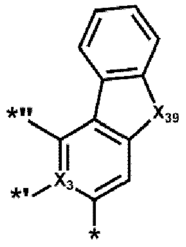
CY3-12

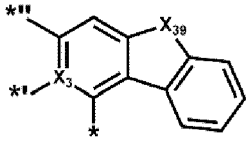
CY3-13

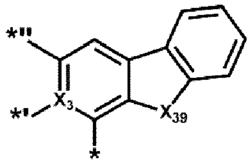
CY3-14

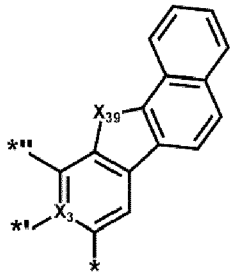
CY3-15

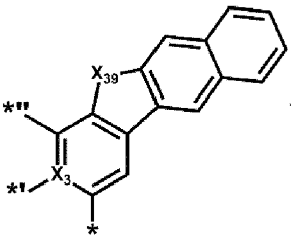
CY3-16

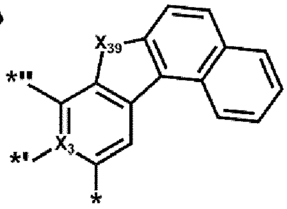
CY3-17

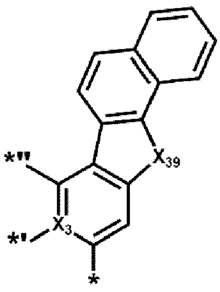
CY3-18

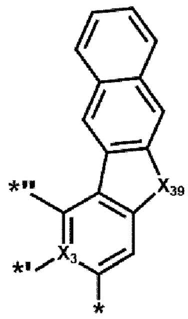
CY3-19

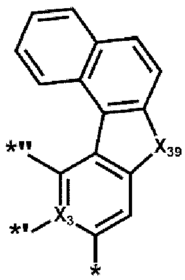
CY3-20

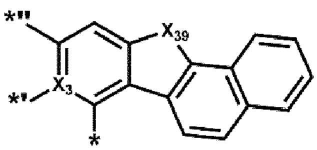
CY3-21

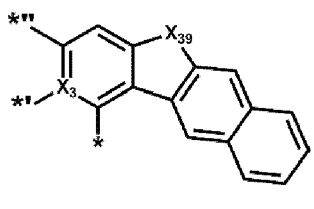
CY3-22

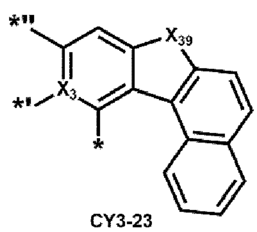
CY3-23

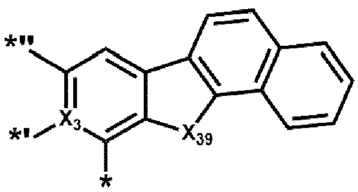
CY3-24

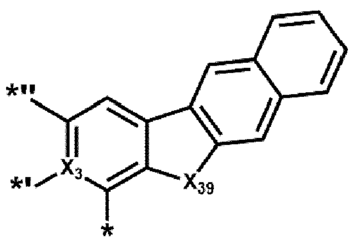
CY3-25

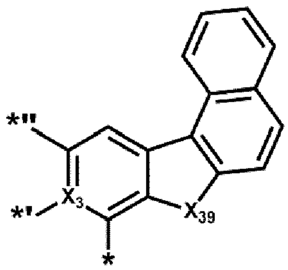
CY3-26

wherein, in Formulae CY3-1 to 3-26,

$X_3$ is the same as described in the present specification,
$X_{39}$ may be $C(R_{39a})(R_{39b})$, $N[(L_{39})_{b39}-(R_{39})_{c39}]$, O, S, or $Si(R_{39a})(R_{39b})$,
$L_{39}$ may be the same as explained in connection with $L_3$,
b39 and c39 may be the same as described in connection with b3 and c3,
$R_{39}$, $R_{39a}$, and $R_{39b}$ are each the same as described in connection with $R_3$,
* indicates a binding site to $T_1$ in Formula 1,
*' indicates a binding site to M in Formula 1, and
*" indicates a binding site to ring $CY_2$ in Formula 1.

In one or more embodiments, a group represented by

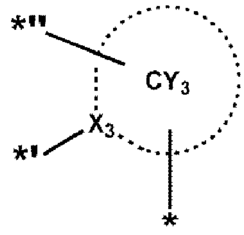

in Formulae 1 and 1-1 B may be a group represented by one of Formulae CY3-5, CY3-8 and CY3-11 to CY3-26.

In one or more embodiments, a group represented by

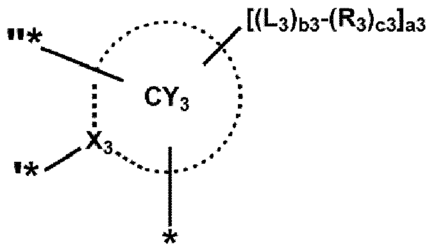

in Formula 1 and a group represented by

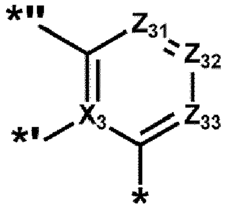

in Formulae 1-1, 1-1A and 1-1C may be a group represented by one of Formulae CY3(1) to CY3(12):

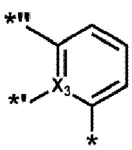
CY3(1)

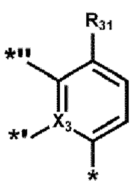
CY3(2)

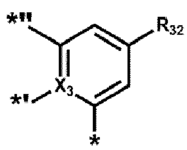
CY3(3)

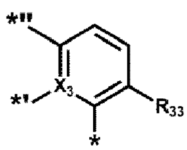
CY3(4)

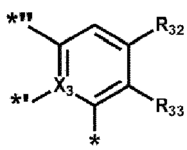
CY3(5)

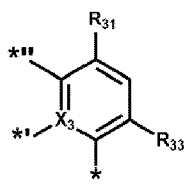
CY3(6)

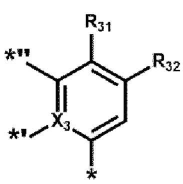
CY3(7)

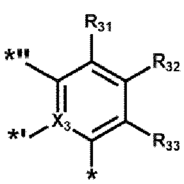
CY3(8)

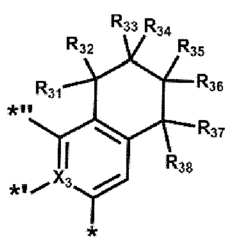
CY3(9)

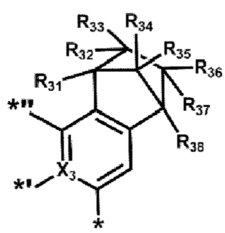
CY3(10)

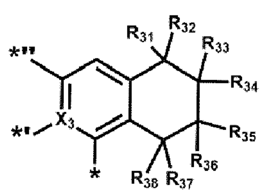
CY3(11)

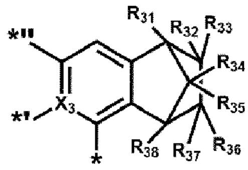

CY3(12)

wherein, in CY3(1) to CY3(12),

$X_3$ is the same as described in the present specification,
$R_{31}$ to $R_{38}$ are each the same as described in connection with $R_3$, and each of $R_{31}$ to $R_{34}$ in CY3(1) to CY3(8) may not be hydrogen,
* indicates a binding site to $T_1$ in Formula 1,
*' indicates a binding site to M in Formula 1, and
*" indicates a binding site to ring $CY_2$ in Formula 1.

In one or more embodiments, a group represented by

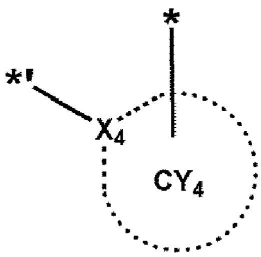

in Formula 1 may be a group represented by one of Formulae CY4-1 to CY4-48 and a group represented by

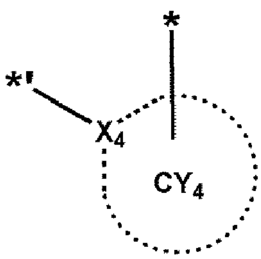

in Formula 1-1C may be a group represented by one of Formulae CY4-9 to CY4-48:

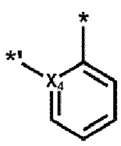
CY4-1
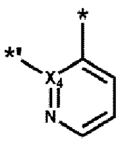
CY4-2
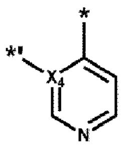
CY4-3
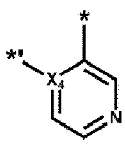
CY4-4
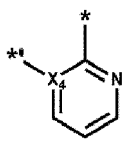
CY4-5
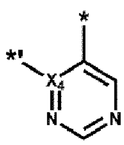
CY4-6
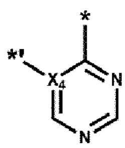
CY4-7
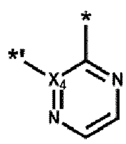
CY4-8

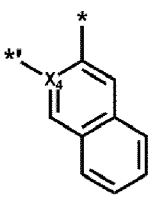
CY4-9
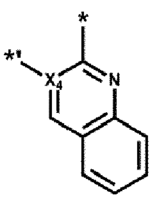
CY4-10
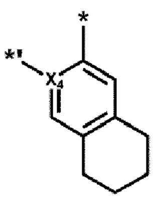
CY4-11
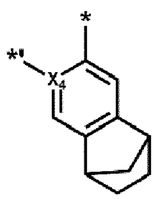
CY4-12
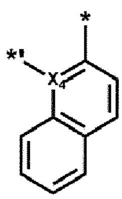
CY4-13
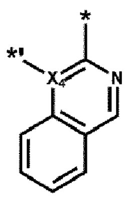
CY4-14
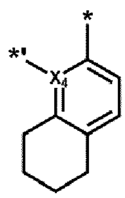
CY4-15

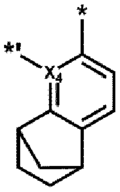
CY4-16

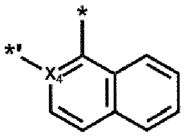
CY4-17

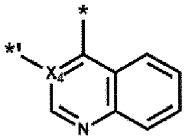
CY4-18

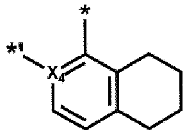
CY4-19

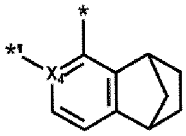
CY4-20

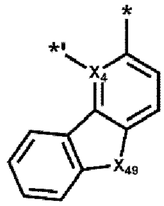
CY4-21

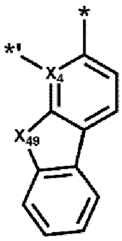
CY4-22

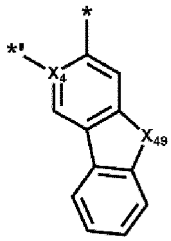
CY4-23

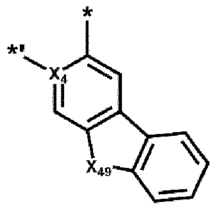
CY4-24

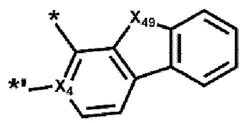
CY4-25

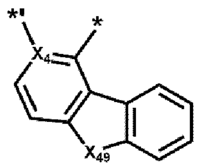
CY4-26

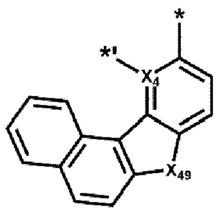
CY4-27

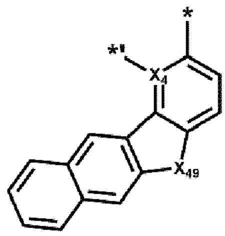
CY4-28

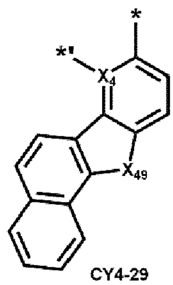
CY4-29

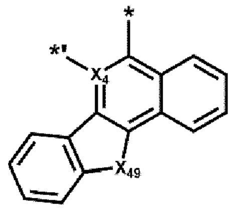
CY4-30

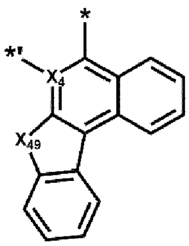
CY4-31

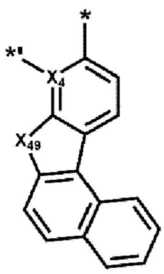
CY4-32

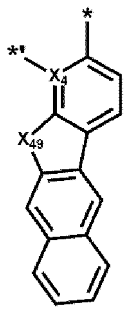
CY4-33

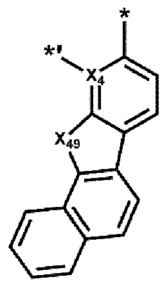
CY4-34

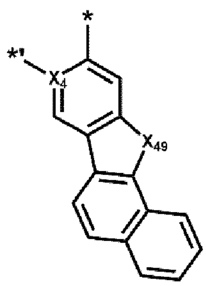
CY4-35

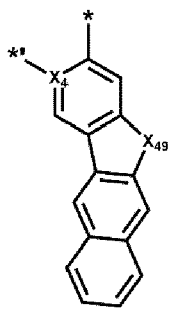
CY4-36

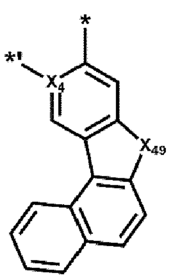
CY4-37

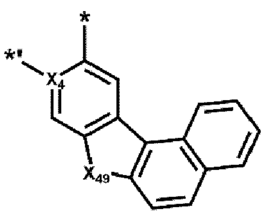
CY4-38

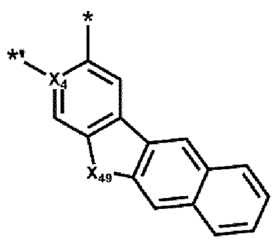
CY4-39

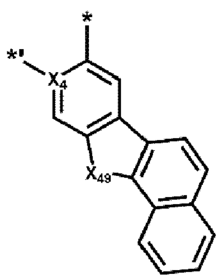
CY4-40

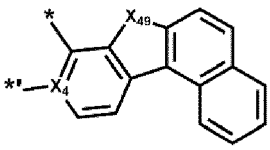
CY4-41
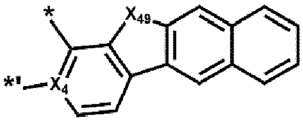
CY4-42
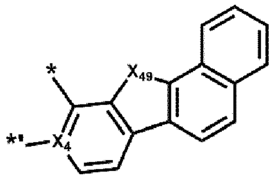
CY4-43
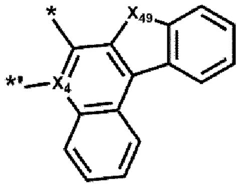
CY4-44

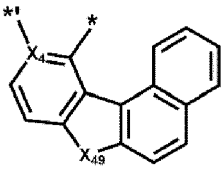
CY4-45
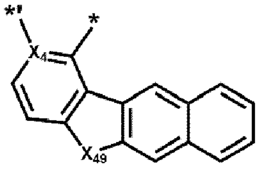
CY4-46
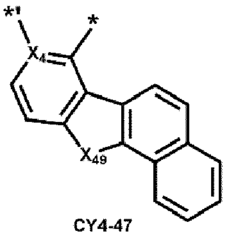
CY4-47
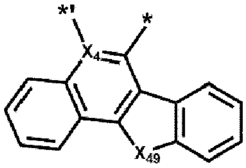
CY4-48

wherein, in Formulae CY4-1 to 4-48,

$X_4$ is the same as described in the present specification,
$X_{49}$ is $C(R_{49a})(R_{49b})$, $N[(L_{49})_{b49}-(R_{49})_{c49}]$, O, S, or $Si(R_{49a})(R_{49b})$,
$L_{49}$ is the same as explained in connection with $L_4$,
b49 and c49 are each the same as described in connection with b4 and c4,
$R_{49}$, $R_{49a}$, and $R_{49b}$ are each the same as described in connection with $R_4$,
* indicates a binding site to $T_1$ in Formula 1,
*' indicates a binding site to M in Formula 1.

In one or more embodiments, the group represented by

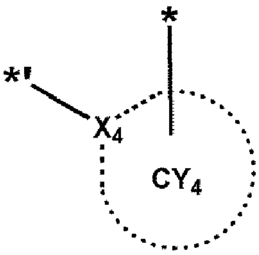

in Formula 1 and 1-1C may be a group represented by one of Formulae CY4-9, CY4-10, CY4-13, CY4-14, CY4-17, CY4-18, and CY4-21 to CY4-48.

In one or more embodiments, the group represented by

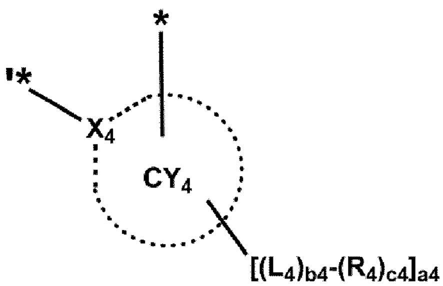

in Formula 1 and a group represented by

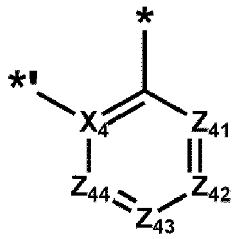

in Formulae 1-1, 1-1A and 1-1B may be a group represented by one of Formulae CY4(1) to CY4(22):

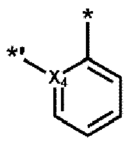

CY4(1)

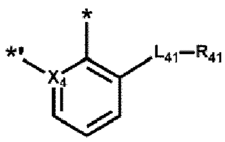

CY4(2)

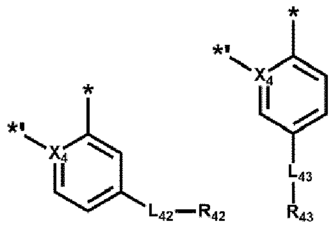

CY4(3) CY4(4)

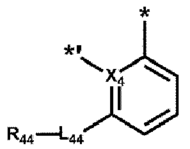

CY4(5)

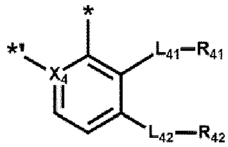

CY4(6)

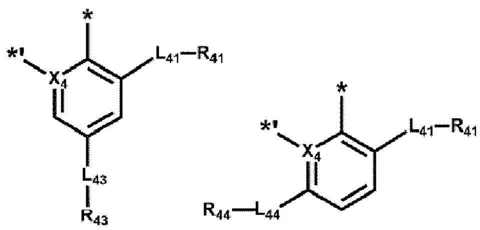

CY4(7) CY4(8)

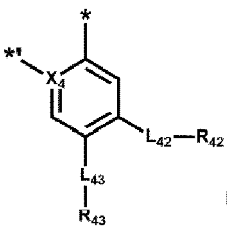

CY4(9)

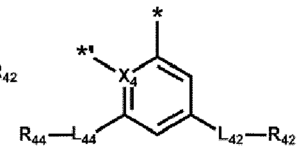

CY4(10)

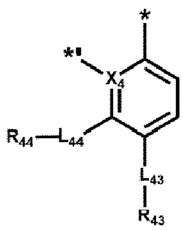

CY4(11)

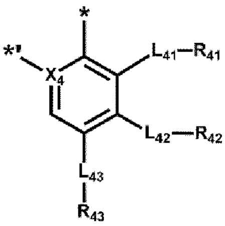

CY4(12)

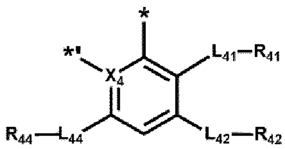

CY4(13)

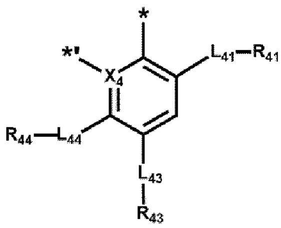

CY4(14)

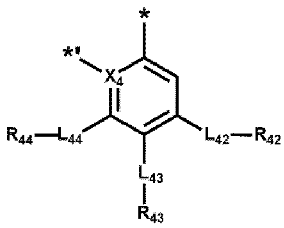

CY4(15)

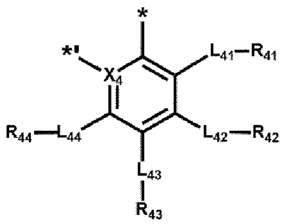

CY4(16)

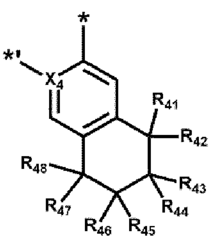

CY4(17)

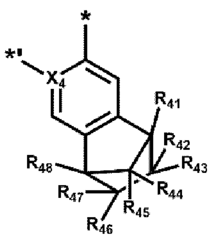

CY4(18)

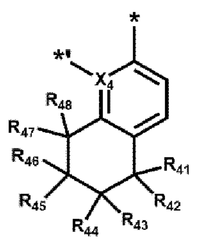

CY4(19)

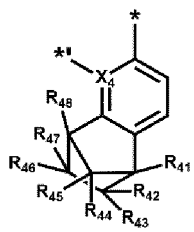

CY4(20)

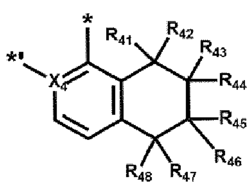

CY4(21)

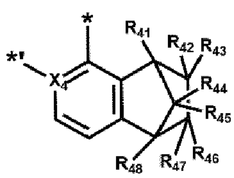

CY4(22)

wherein, in Formulae CY4(1) to CY4(22),

$X_4$ is the same as described in the present specification,
$L_{41}$ to $L_{44}$ are each the same as described in connection with $L_4$,
$R_{41}$ to $R_{48}$ are each the same as described in connection with $R_4$, and each of $R_{41}$ to $R_{44}$ in Formulae CY4(1) to CY4(16) may not be hydrogen,
* indicates a binding site to $T_1$ in Formula 1, and
*' indicates a binding site to M in Formula 1.

In one or more embodiments, the organometallic compound represented by Formula 1 may satisfy at least one of <Condition 1> to <Condition 3>:

Condition 1
the group represented by

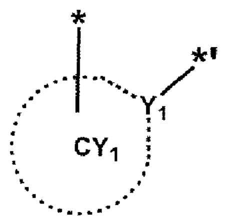

in Formula 1 is a group represented by one of Formulae CY1-9 to CY1-48;
Condition 2
the group represented by

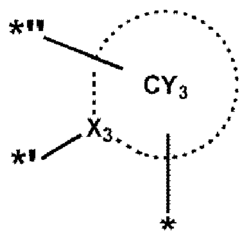

in Formula 1 is a group represented by one of Formulae CY3-5 to CY3-26; and
Condition 3
the group represented by

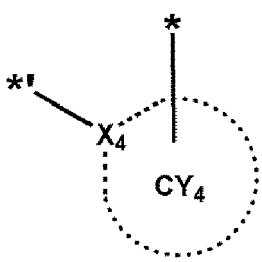

in Formula 1 is a group represented by one of Formulae CY4-9 to CY4-48.

In one or more embodiments, the organometallic compound represented by Formula 1 may satisfy at least one of: <Condition 1A> or <Condition 1B>; <Condition 2A> or <Condition 2B>; and <Condition 3A> or <Condition 3B>:

Condition 1A
the group represented by

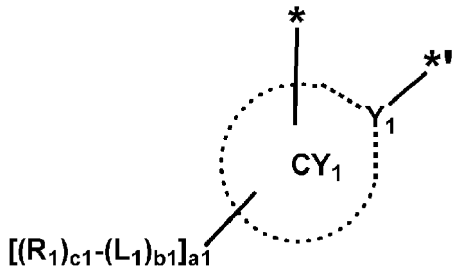

in Formula 1 is a group represented by one of Formulae CY1(17) to CY1(22);
Condition 1B
the group represented by

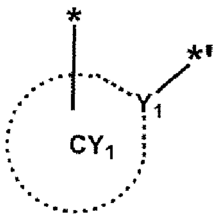

in Formula 1 is a group represented by one of Formulae CY1-9, CY1-10, CY1-13, CY1-14, CY1-17, CY1-18, and CY1-21 to CY1-48;
Condition 2A
the group represented by

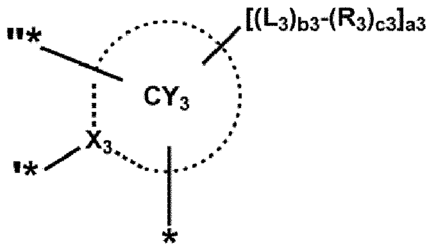

in Formula 1 is a group represented by one of Formulae CY3(9) to CY3(12);
Condition 2B
the group represented by

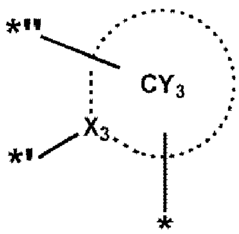

in Formula 1 is a group represented by one of Formulae CY3-5, CY3-8, and CY3-11 to CY3-26;
Condition 3A
the group represented by

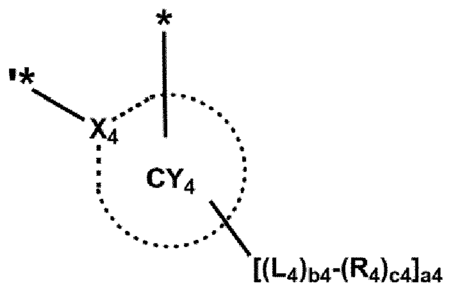

in Formula 1 may be a group represented by one of Formulae CY4(17) to CY4(22); and

Condition 3B

the group represented by

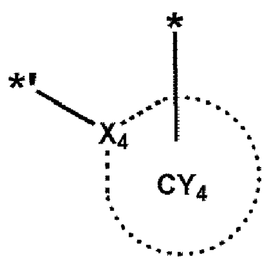

in Formula 1 may be a group represented by one of Formulae CY4-9, CY4-10, CY4-13, CY4-14, CY4-17, CY4-18, and CY4-21 to CY4-48.

In one or more embodiments, the organometallic compound represented by Formula 1 may include at least one deuterium.

The organometallic compound represented by Formula 1 may be one of Compounds 1 to 804:

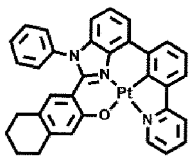

1

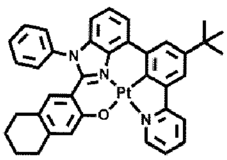

2

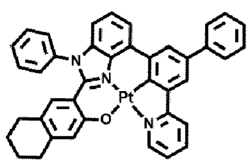

3

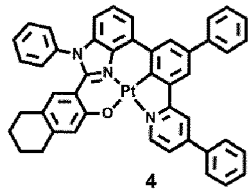

4

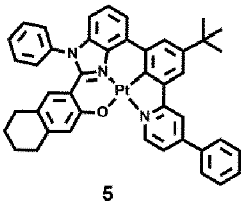

5

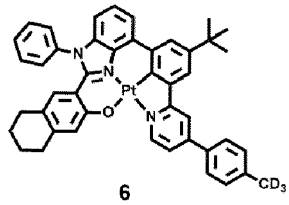

6

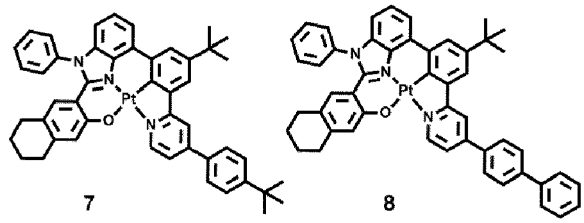

7

8

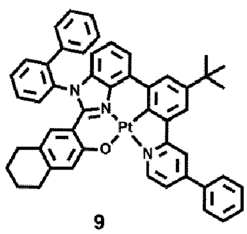

9

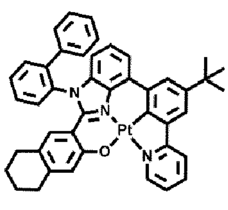

10

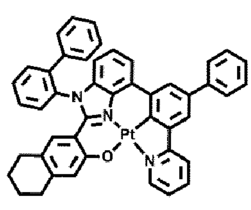

11

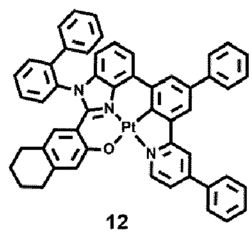

12

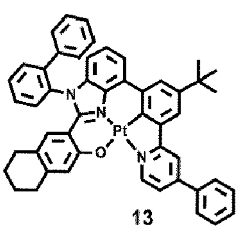

13

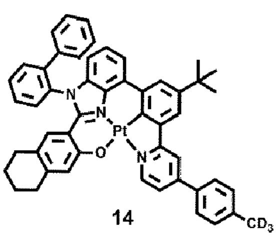

14

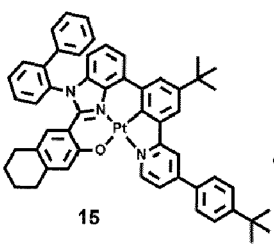

15

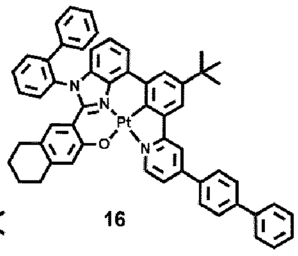

16

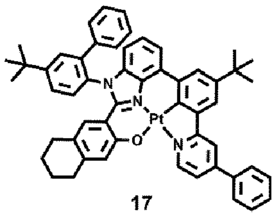

17

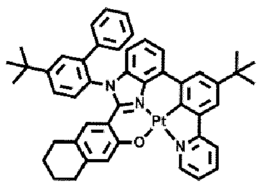

18

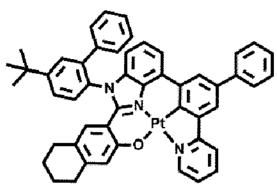

19

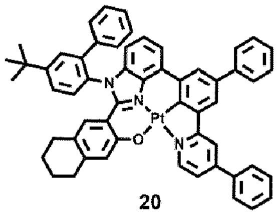

20

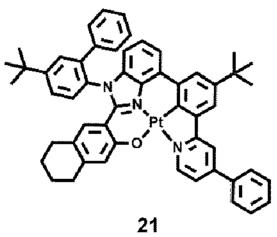

21

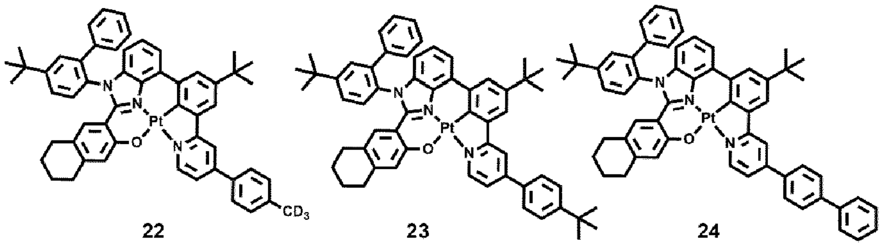

22

23

24

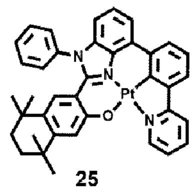

25

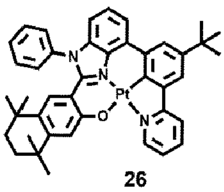

26

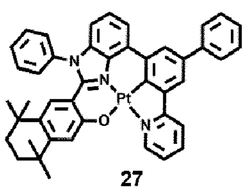

27

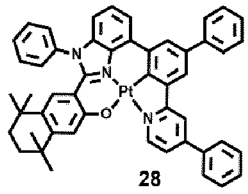

28

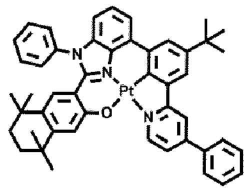

29

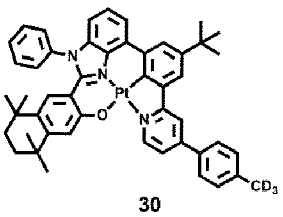

30

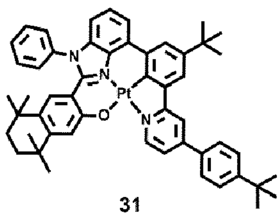

31

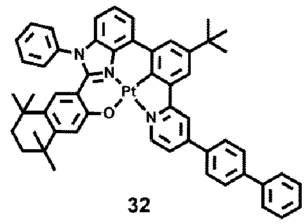

32

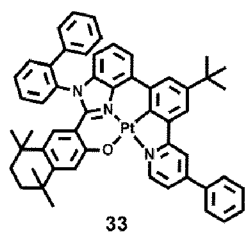

33

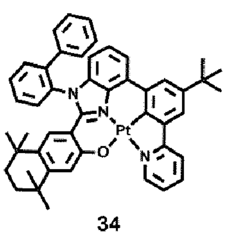

34

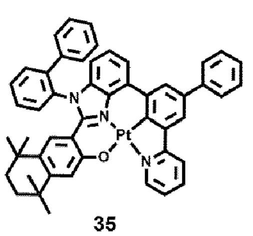

35

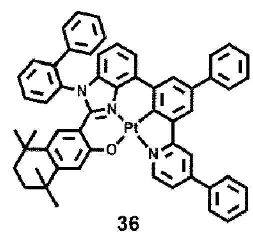

36

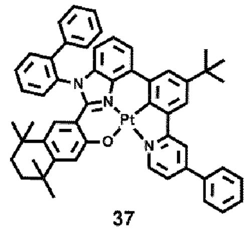
37

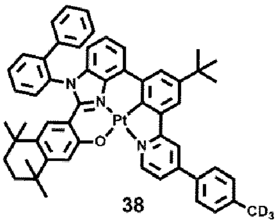
38

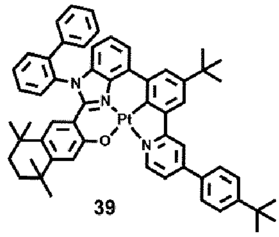
39

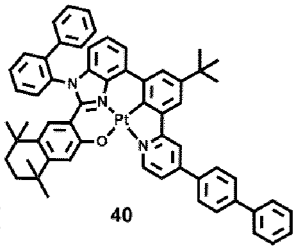
40

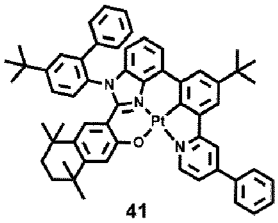
41

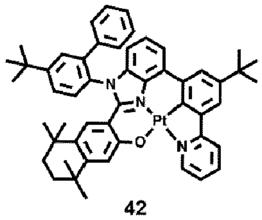
42

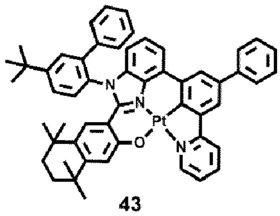
43

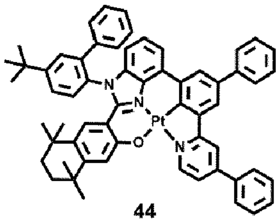
44

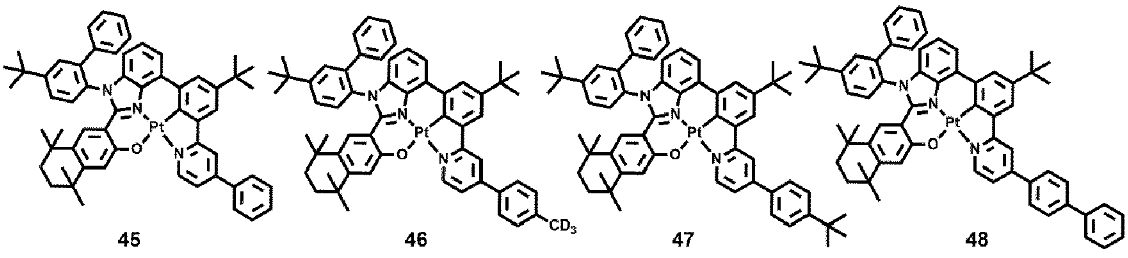
45

46

47

48

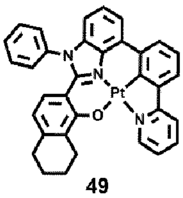
49

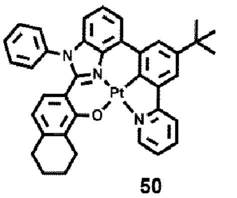
50

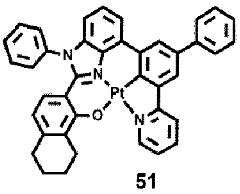
51

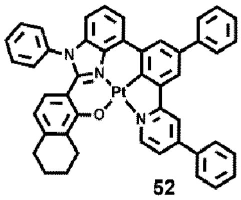
52

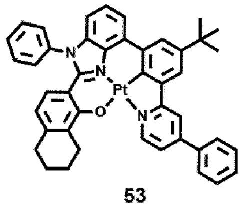
53

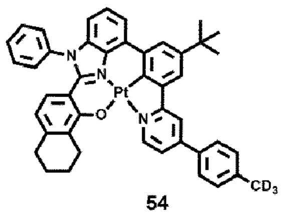
54

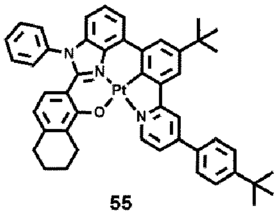
55

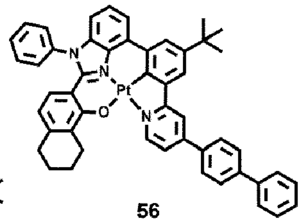
56

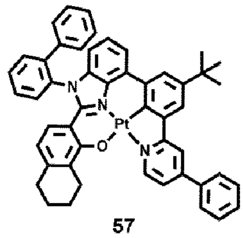
57

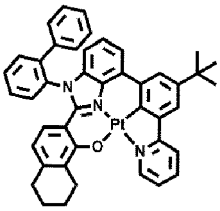
58

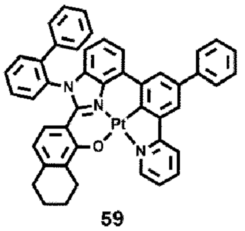
59

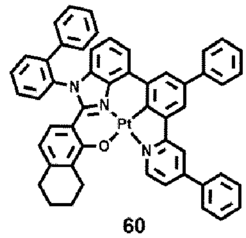
60

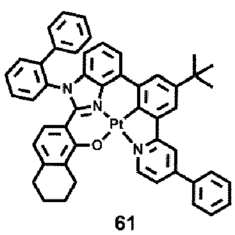

61

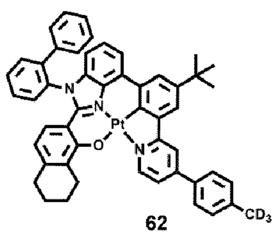

62

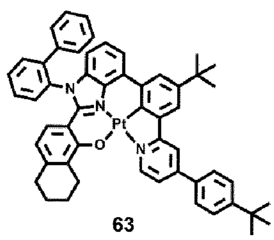

63

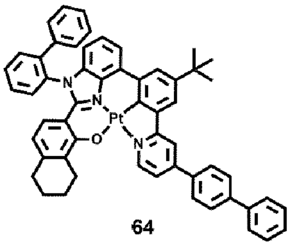

64

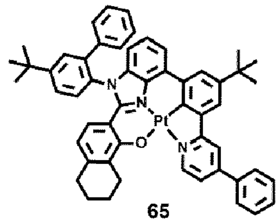

65

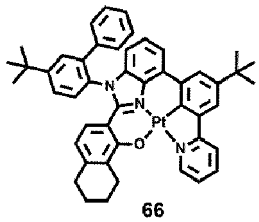

66

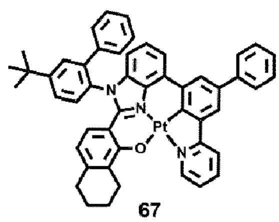

67

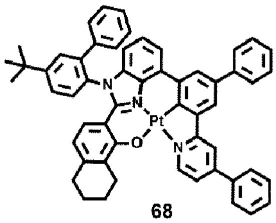

68

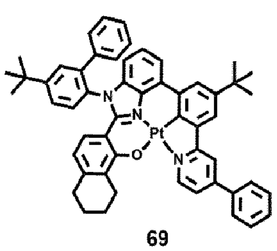

69

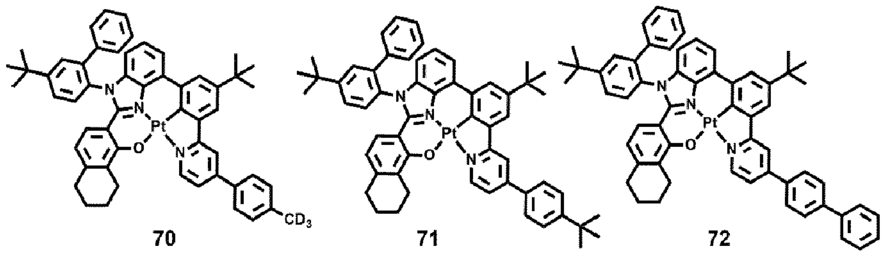

70

71

72

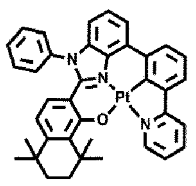

73

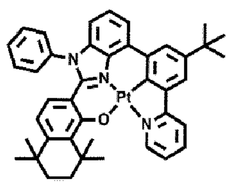

74

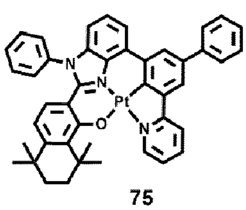

75

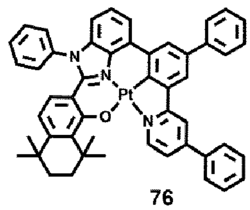

76

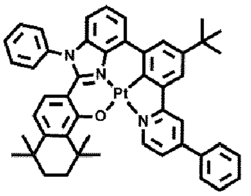

77

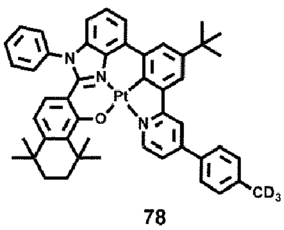

78

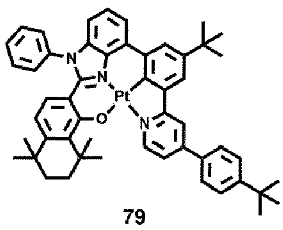

79

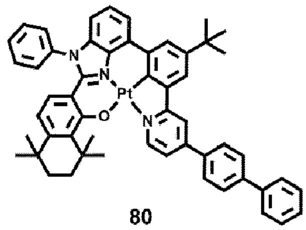

80

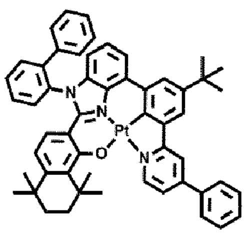

81

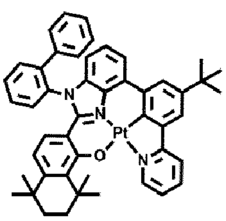

82

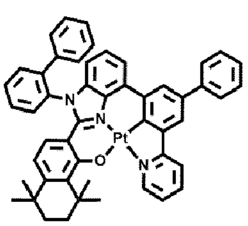

83

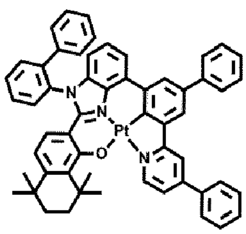

84

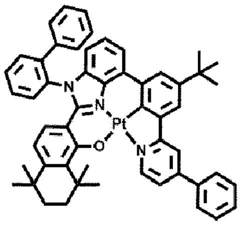

85

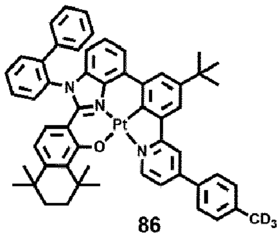

86

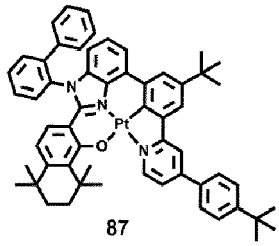

87

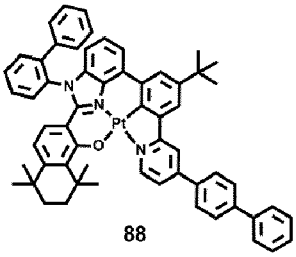

88

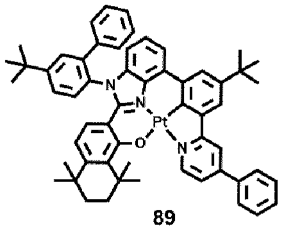

89

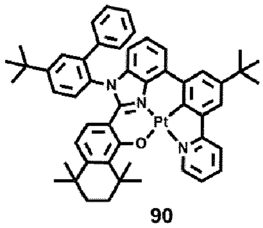

90

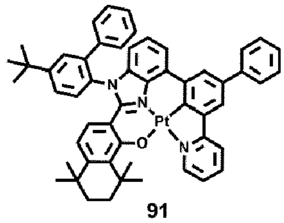

91

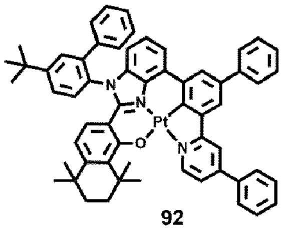

92

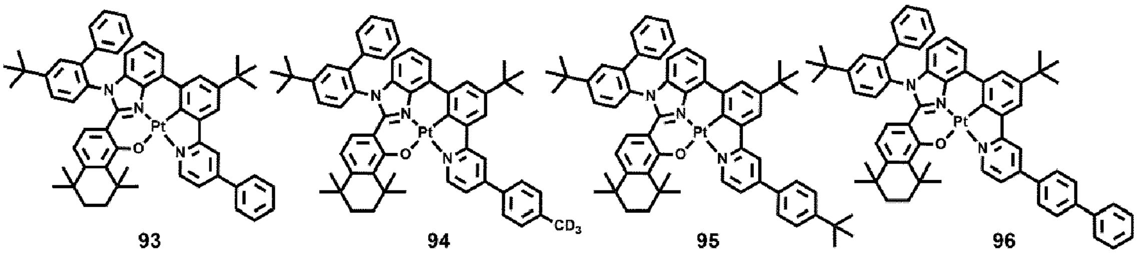

93

94

95

96

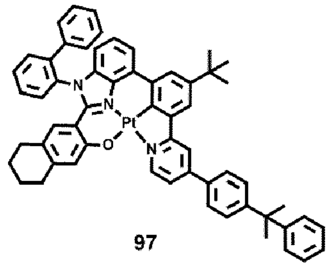

97

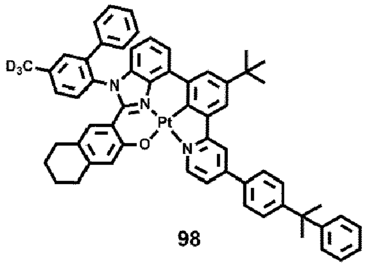

98

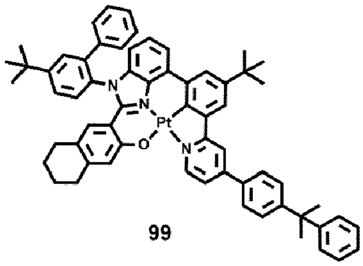

99

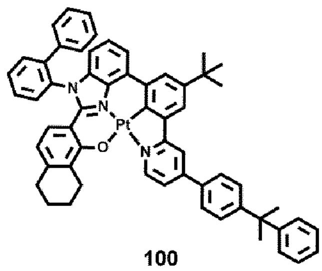

100

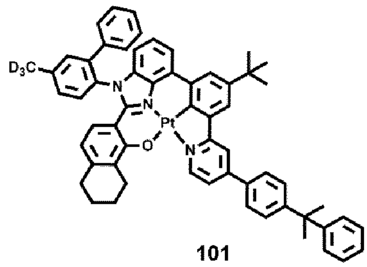

101

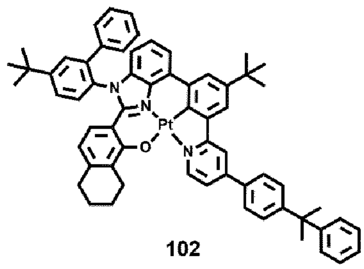

102

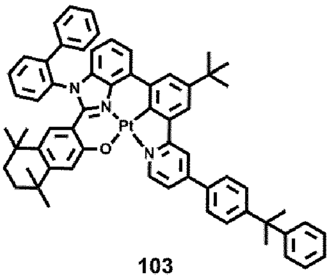
103

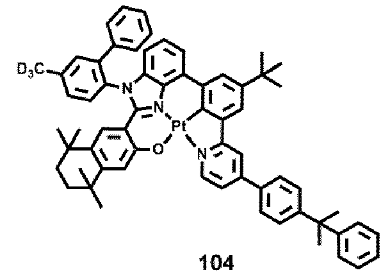
104

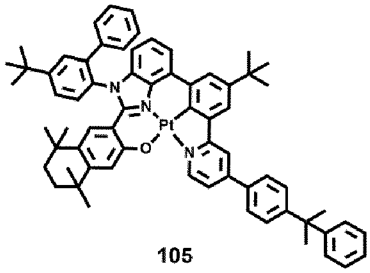
105

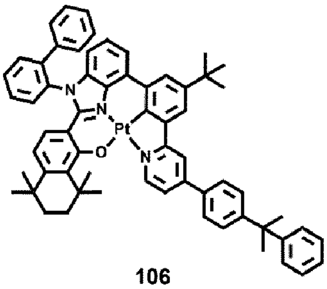
106

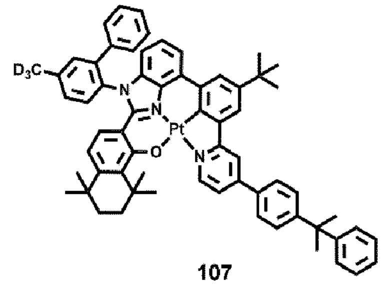
107

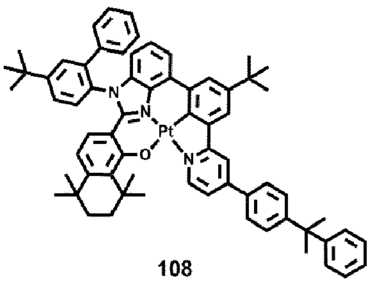
108

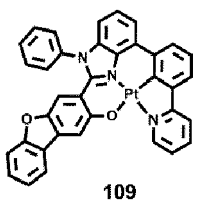
109

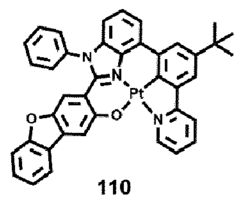
110

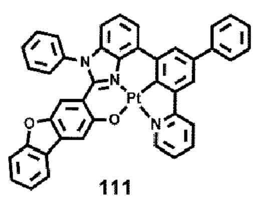
111

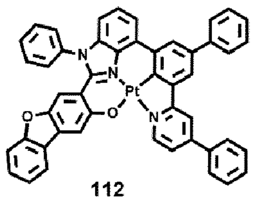
112

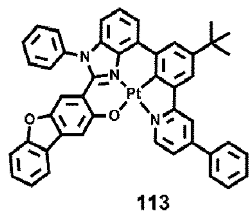
113

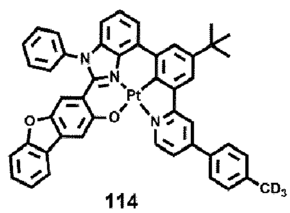
114

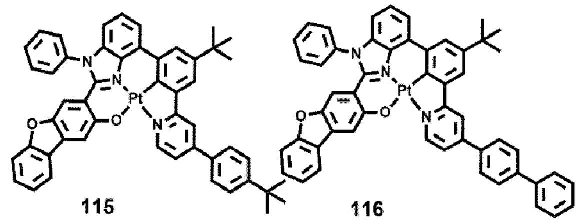
115

116

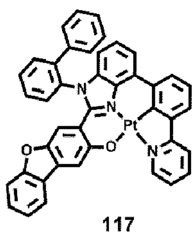
117

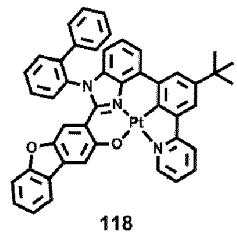
118

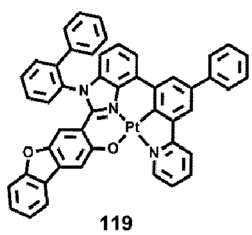
119

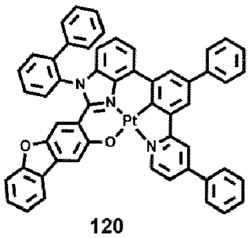
120

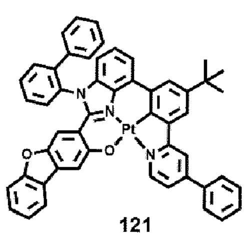
121

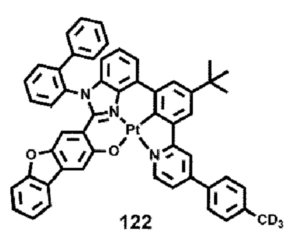
122

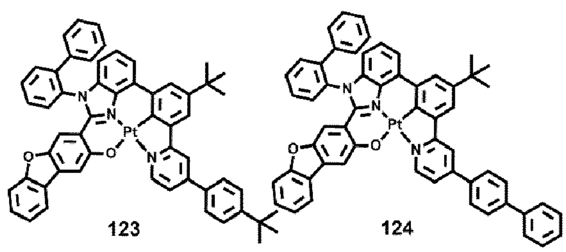
123

124

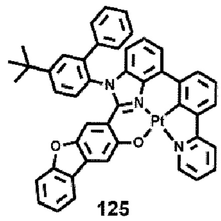
125
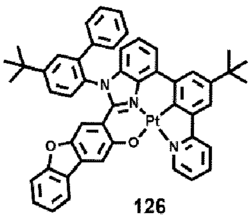
126
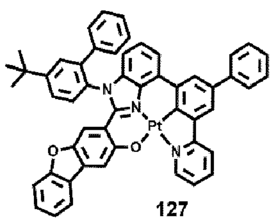
127
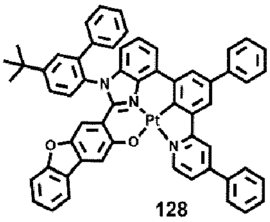
128

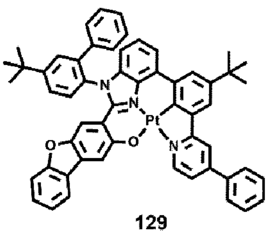
129
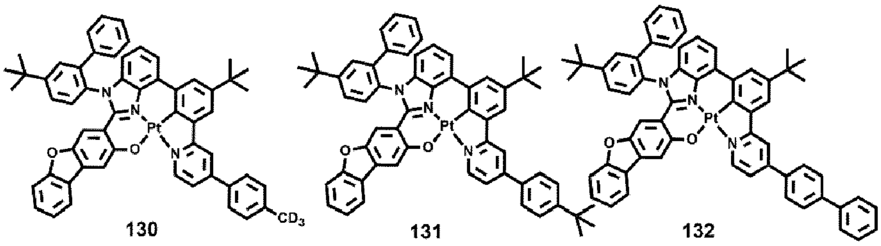
130
131
132

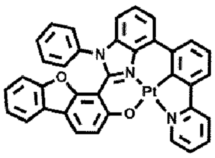
133
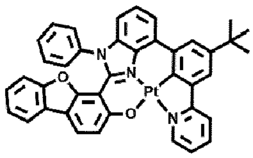
134
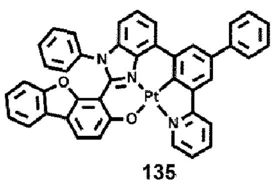
135
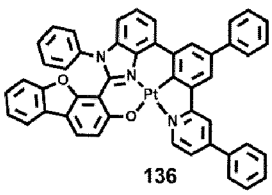
136

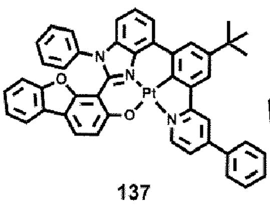
137
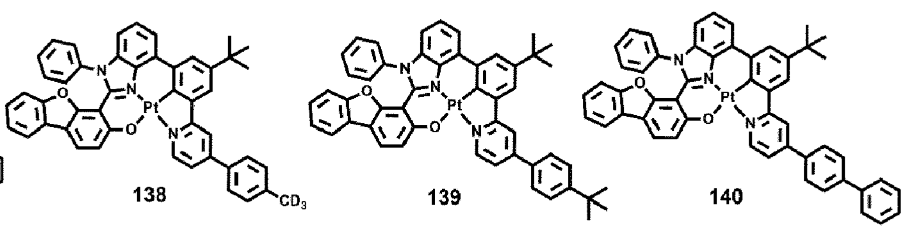
138
139
140

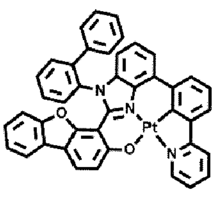
141
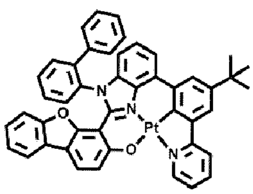
142
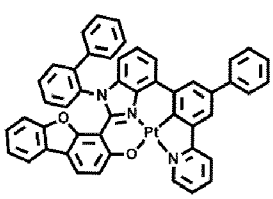
143
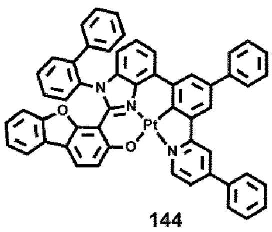
144

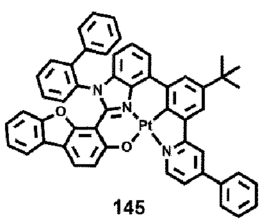
145
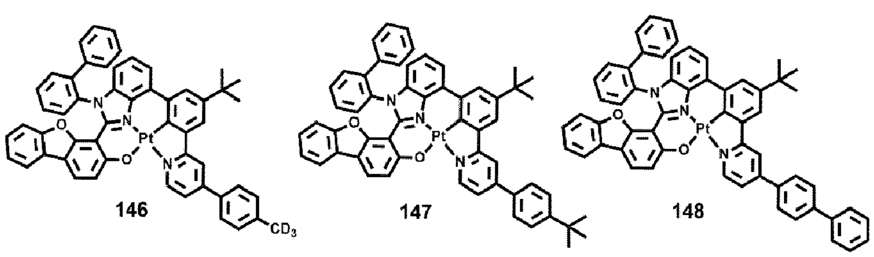
146
147
148

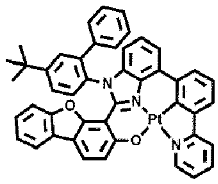
149
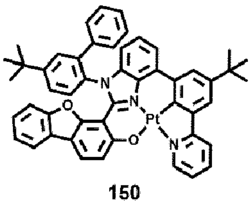
150
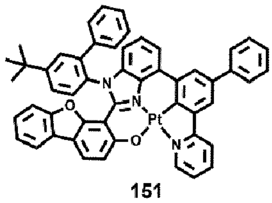
151
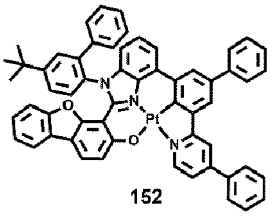
152
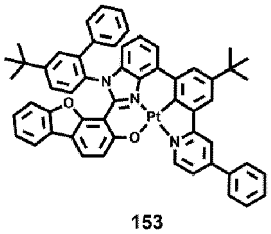
153
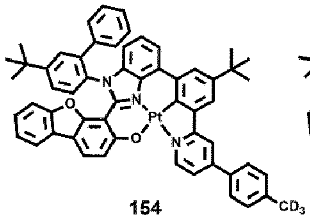
154
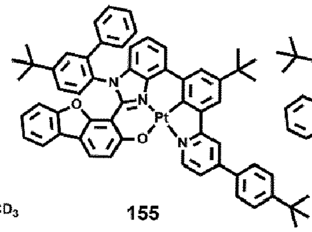
155
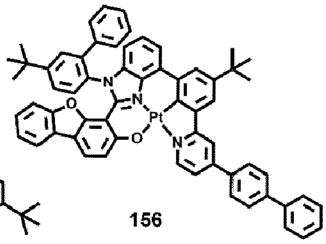
156
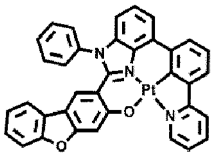
157
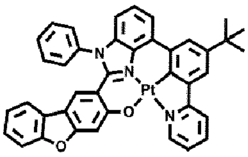
158
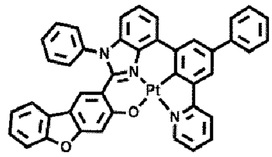
159
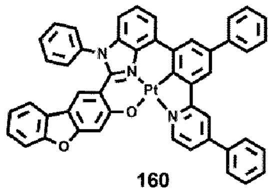
160
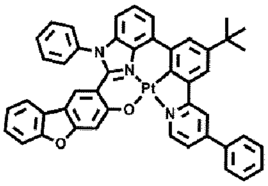
161
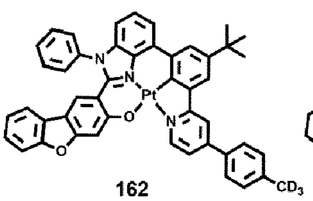
162
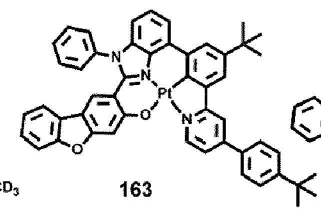
163
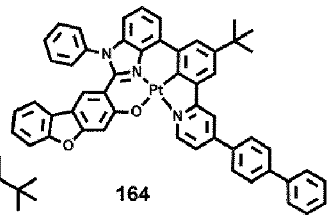
164
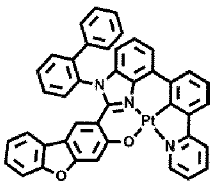
165
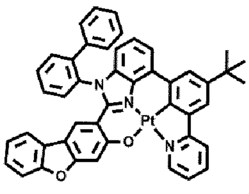
166
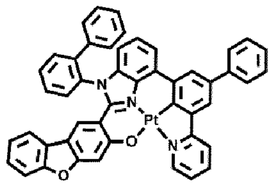
167
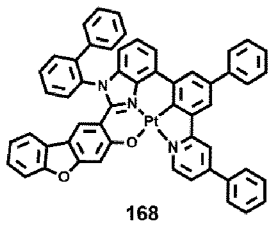
168
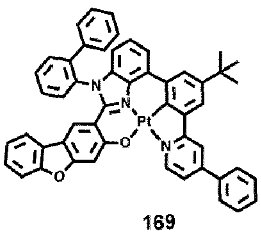
169
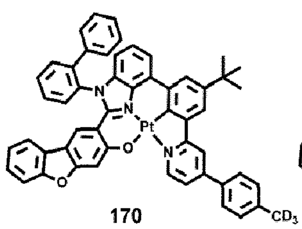
170
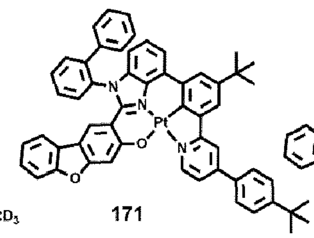
171
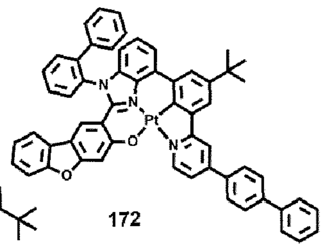
172

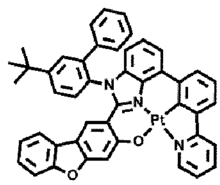
173
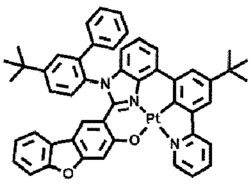
174
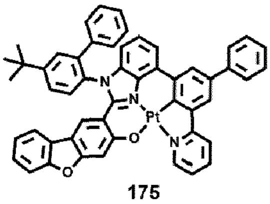
175
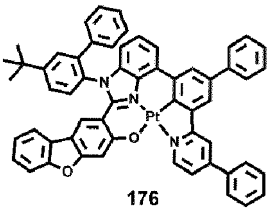
176

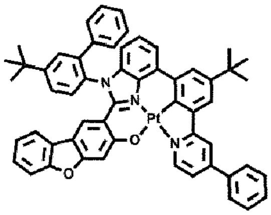
177
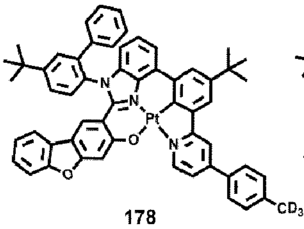
178
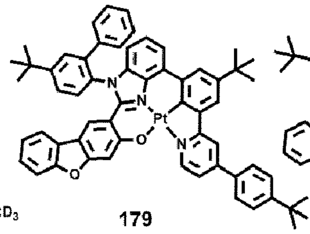
179
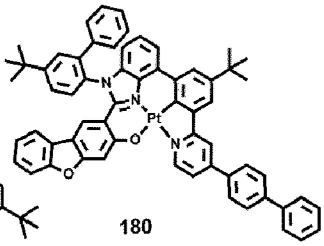
180

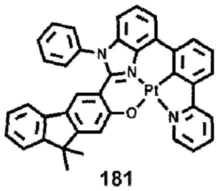
181
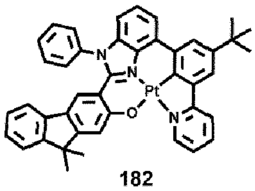
182
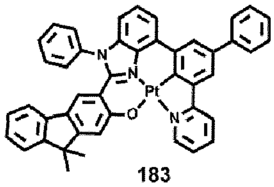
183
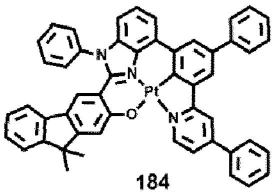
184

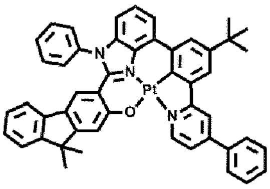
185
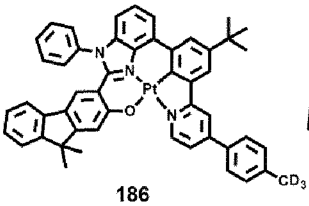
186
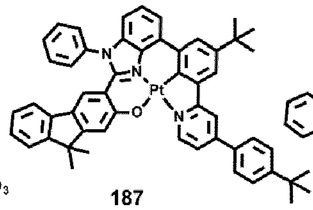
187
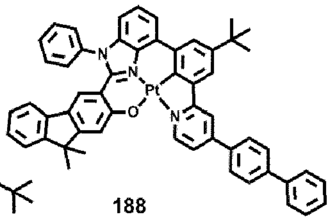
188

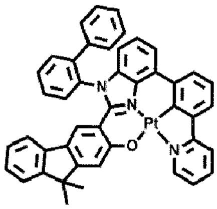
189
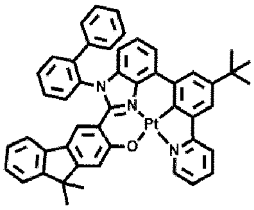
190
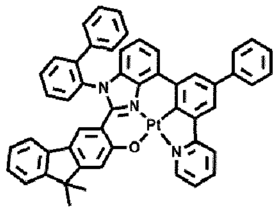
191
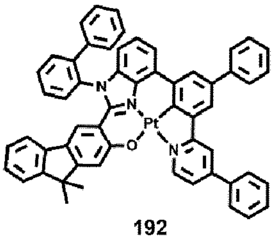
192

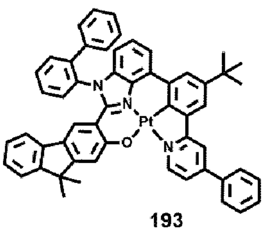
193
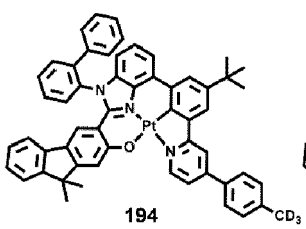
194
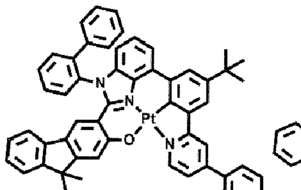
195
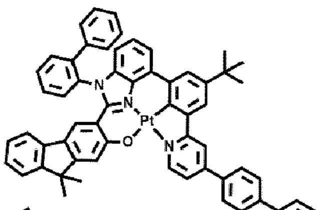
196

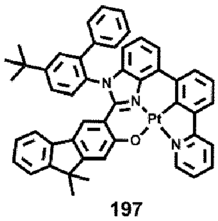
197

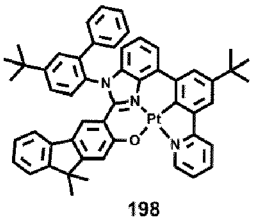
198

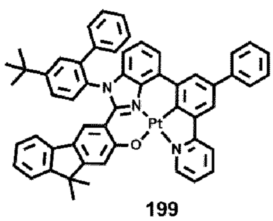
199

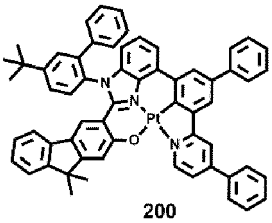
200

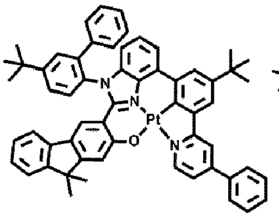
201

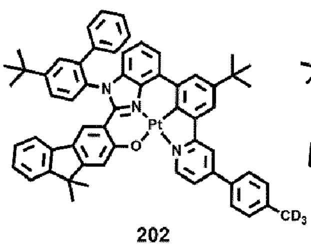
202

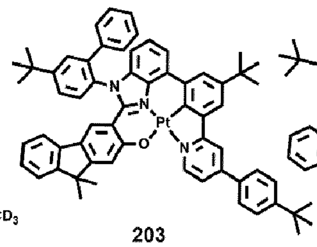
203

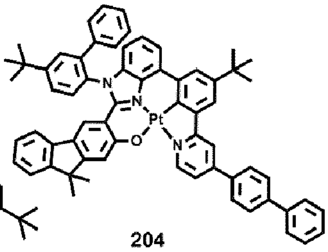
204

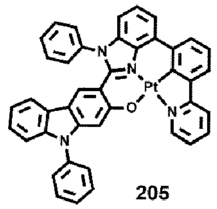
205

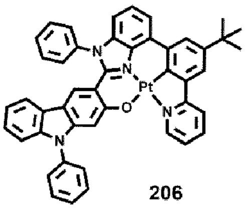
206

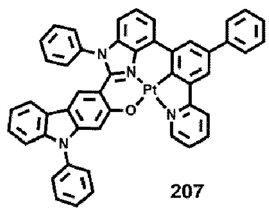
207

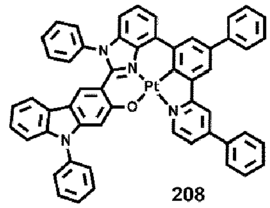
208

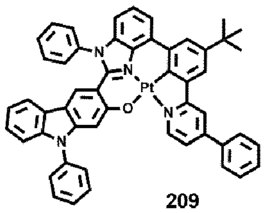
209

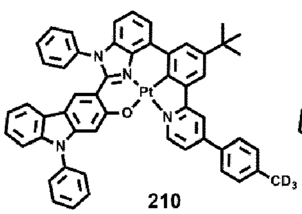
210

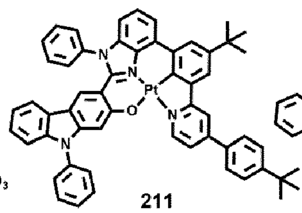
211

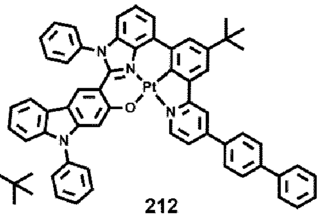
212

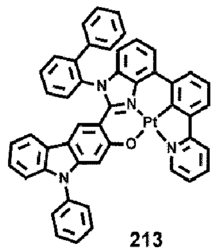
213

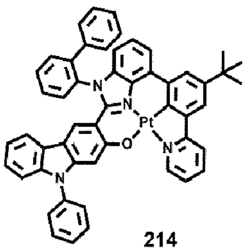
214

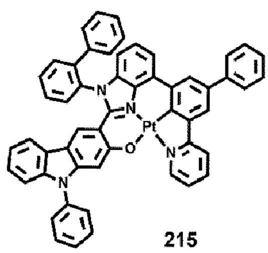
215

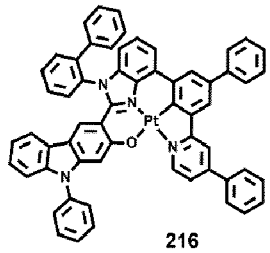
216

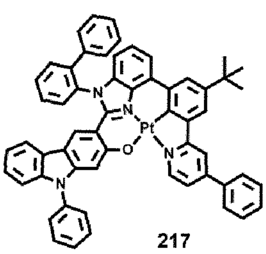
217

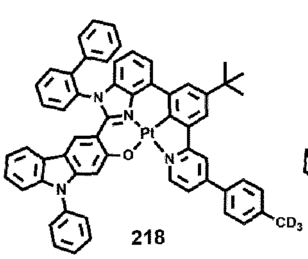
218

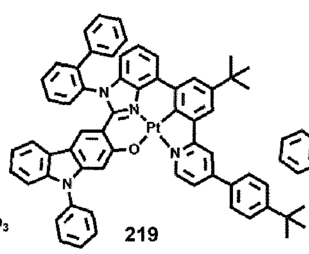
219

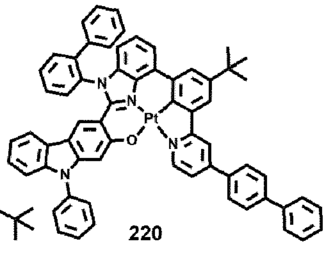
220

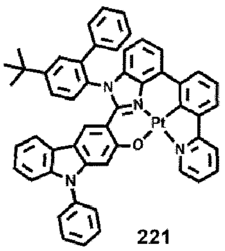
221
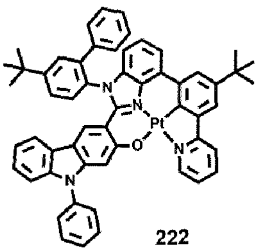
222
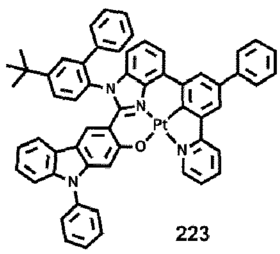
223
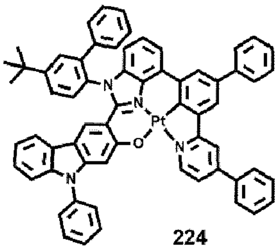
224

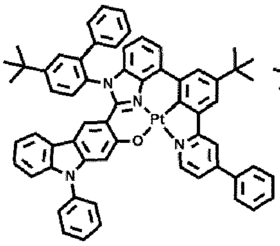
225
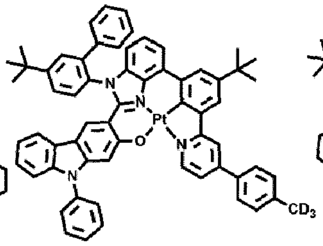
226
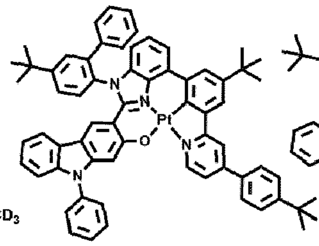
227
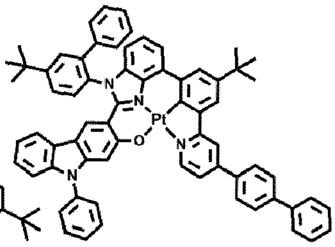
228

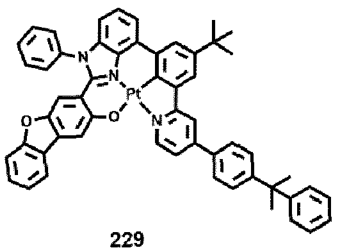
229
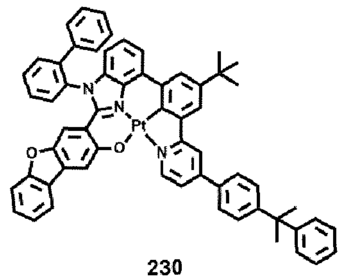
230
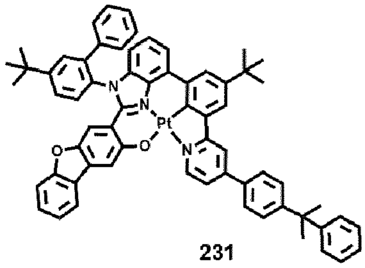
231

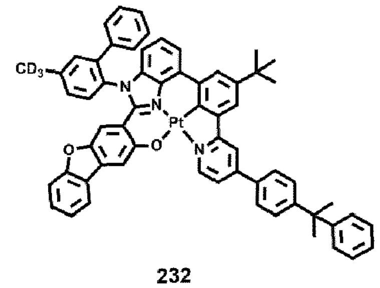
232
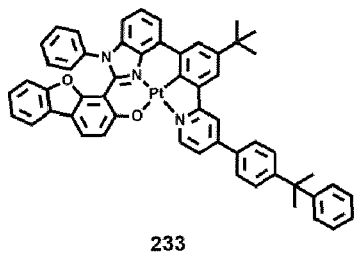
233
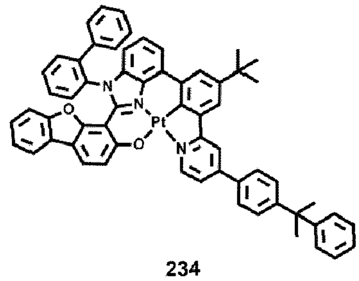
234

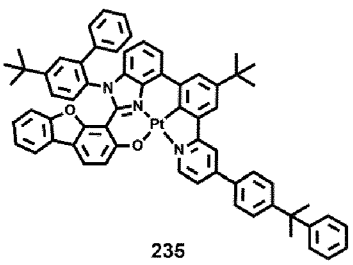
235
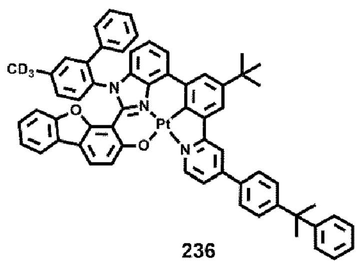
236
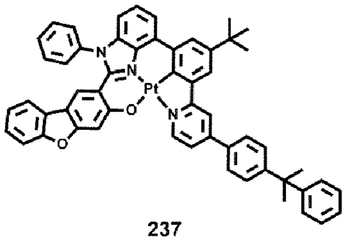
237

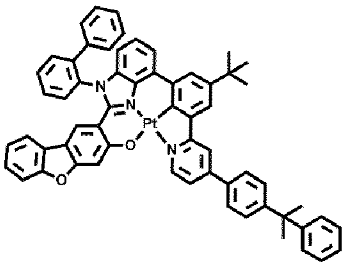
238
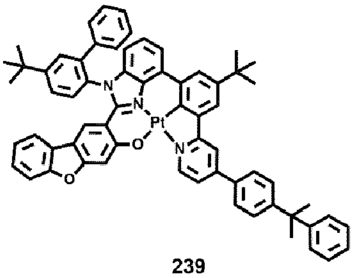
239
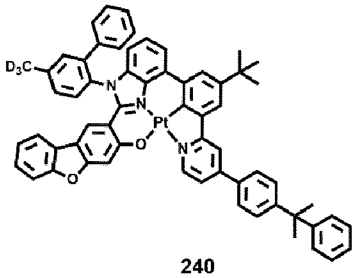
240

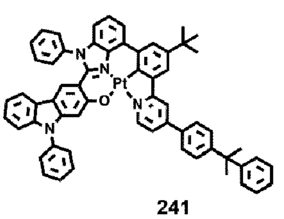
241
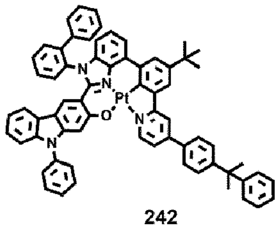
242
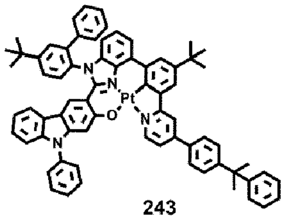
243
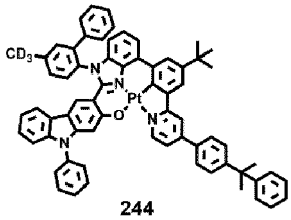
244

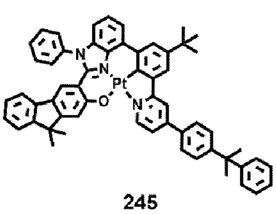
245
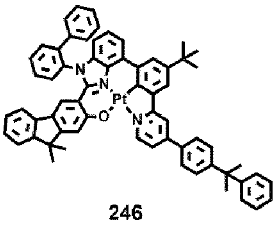
246
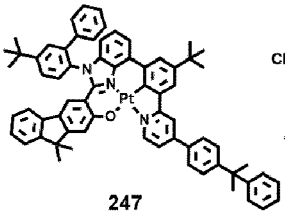
247
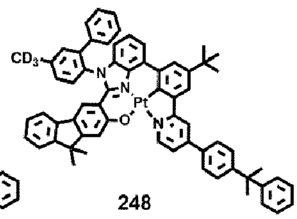
248

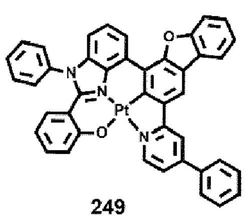
249
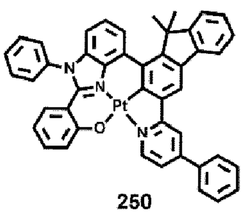
250
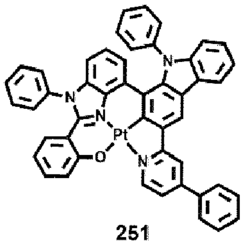
251
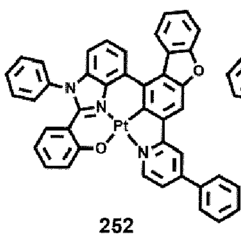
252
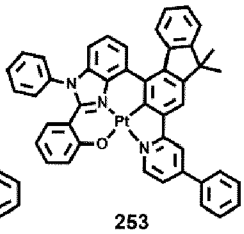
253

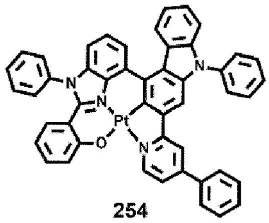
254
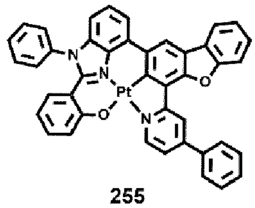
255
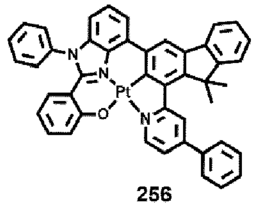
256
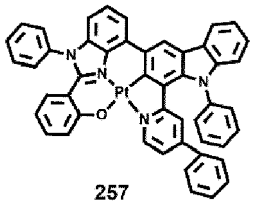
257

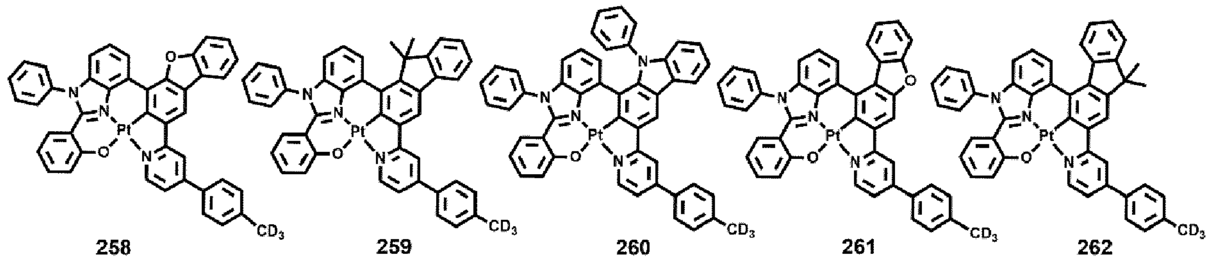
258 259 260 261 262

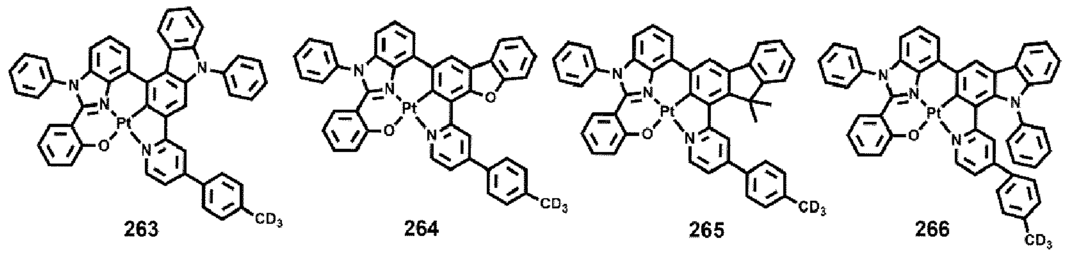

263 264 265 266

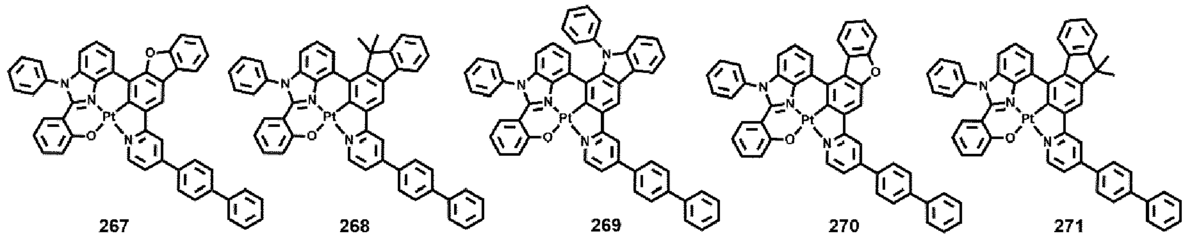

267 268 269 270 271

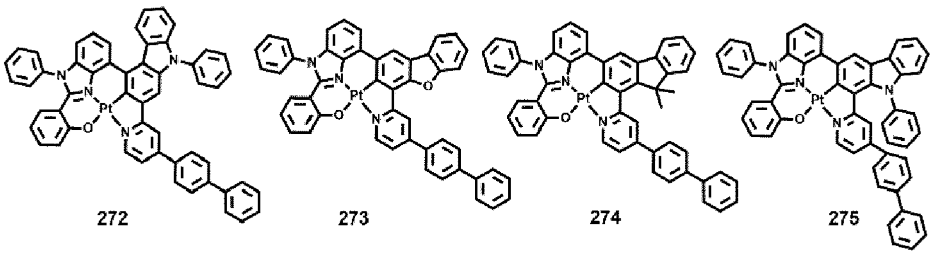

272 273 274 275

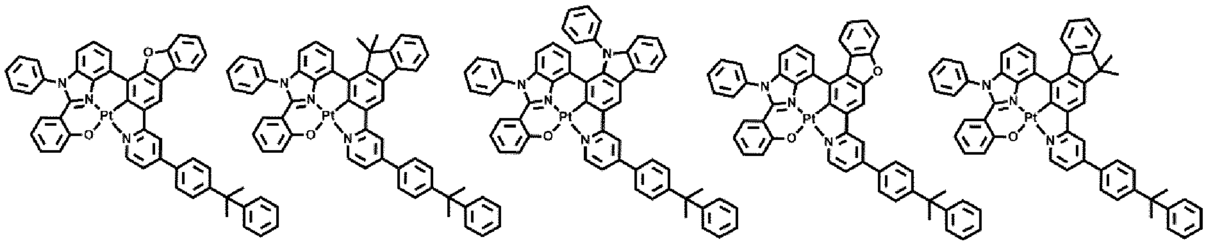

276 277 278 279 280

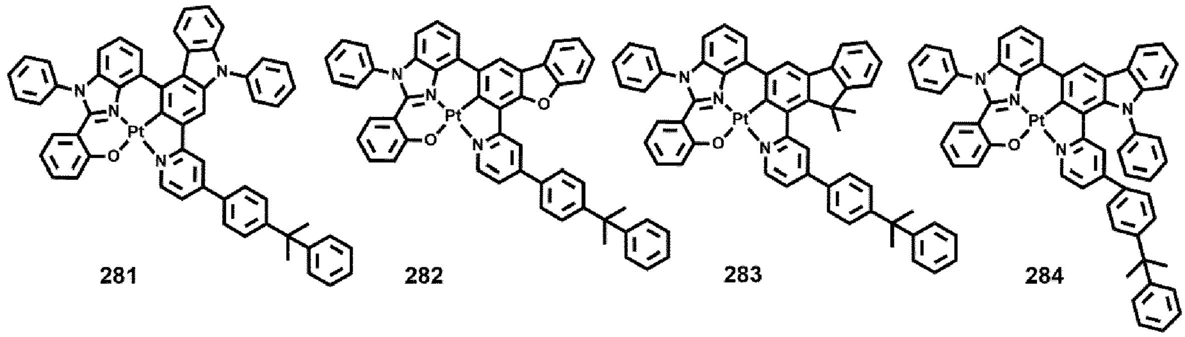

281 282 283 284

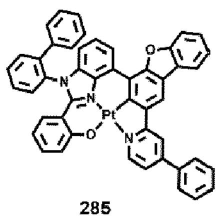
285
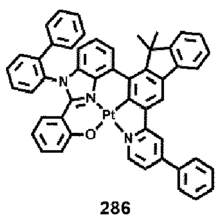
286
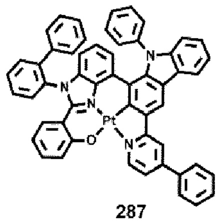
287
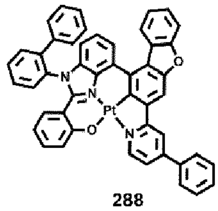
288
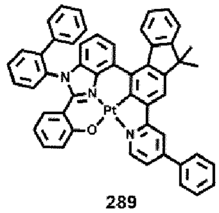
289

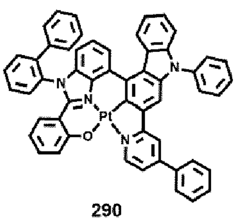
290
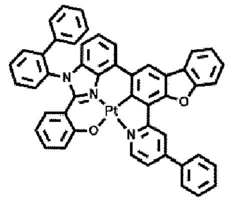
291
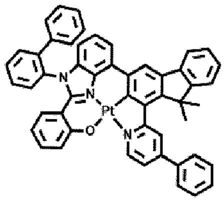
292
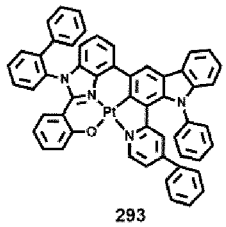
293

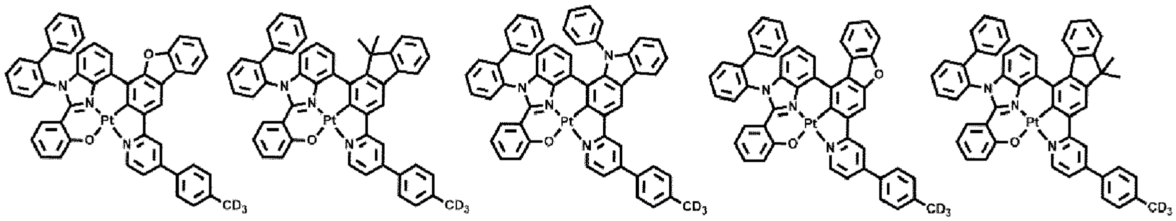
294 295 296 297 298

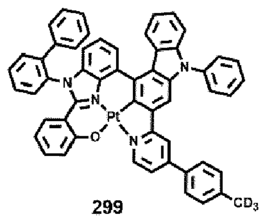
299
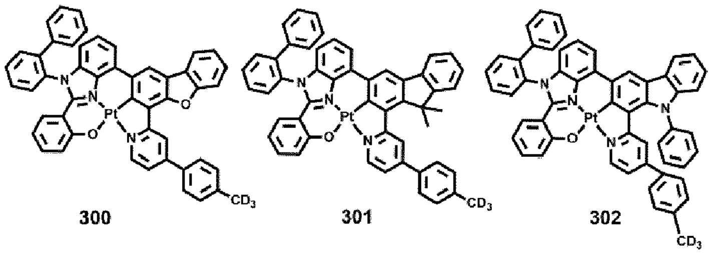
300 301 302

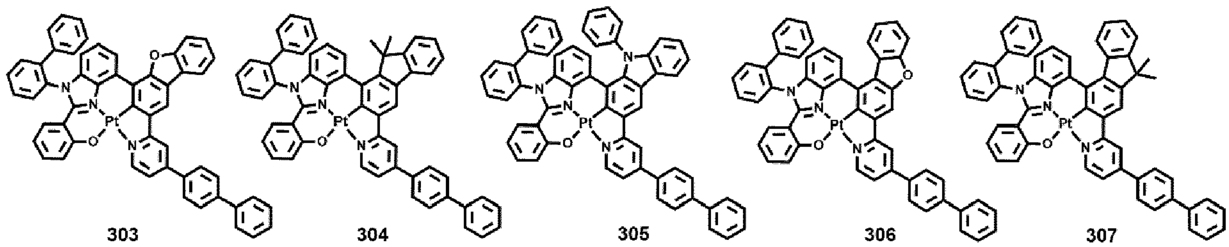
303 304 305 306 307

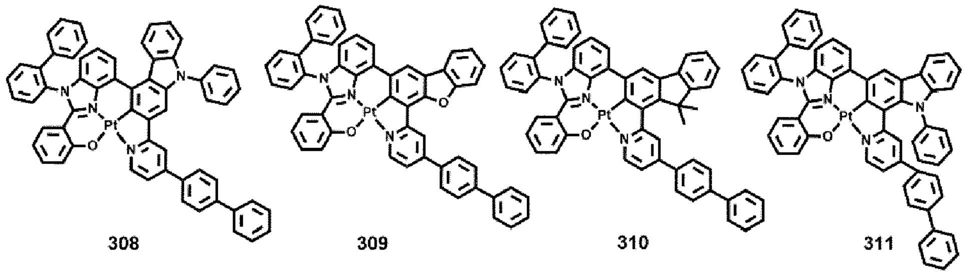
308 309 310 311

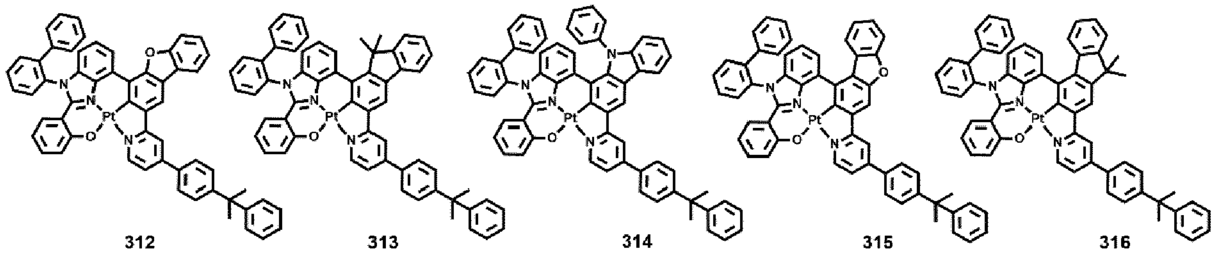

312 313 314 315 316

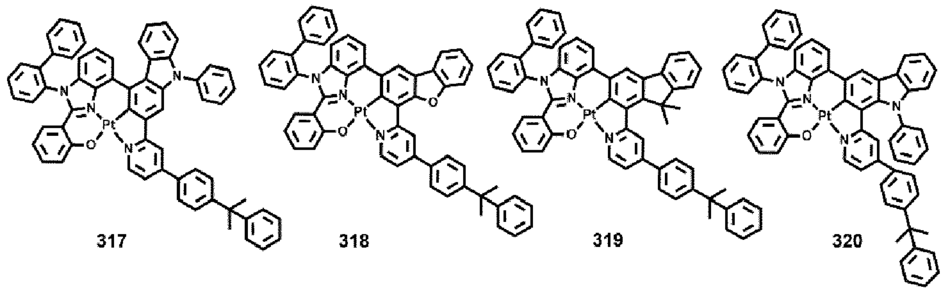

317 318 319 320

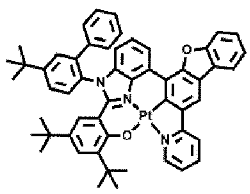

321

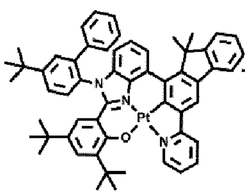

322

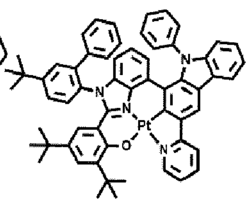

323

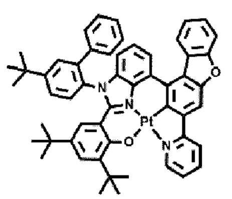

324

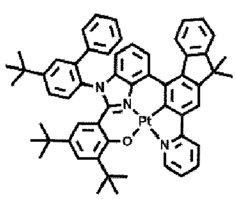

325

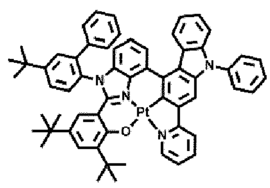

326

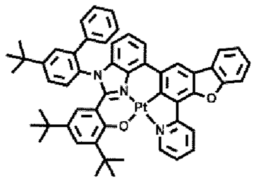

327

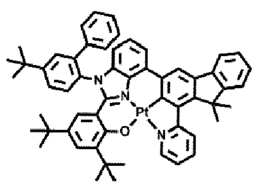

328

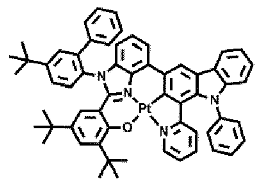

329

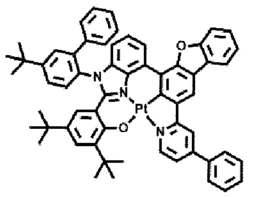

330

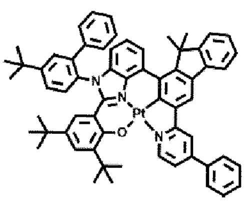

331

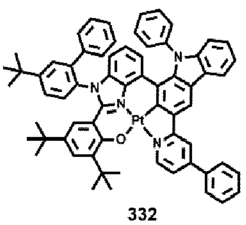

332

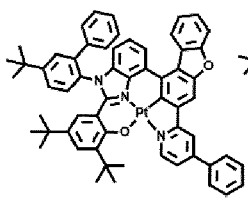

333

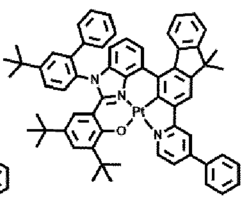

334

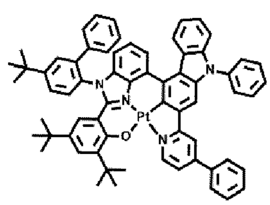

335

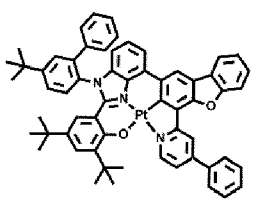

336

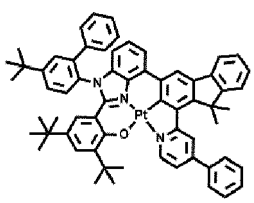

337

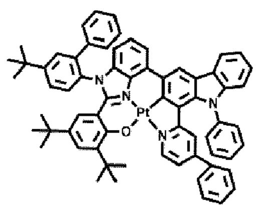

338

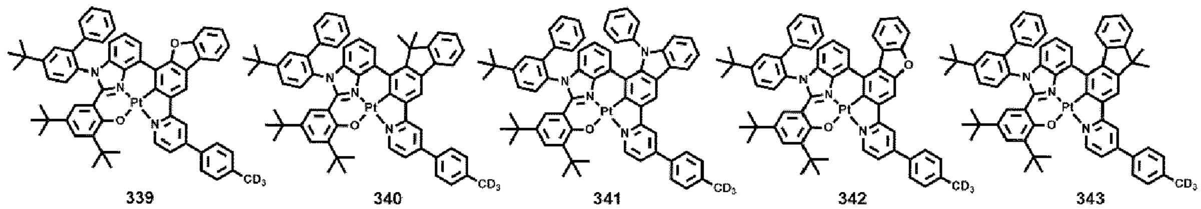

339 340 341 342 343

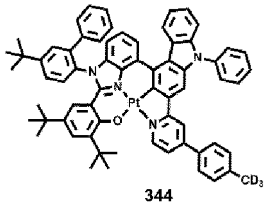

344

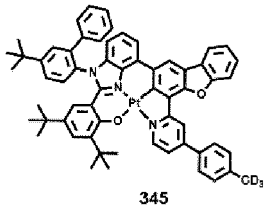

345

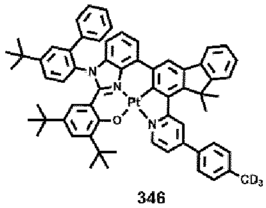

346

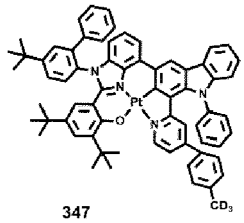

347

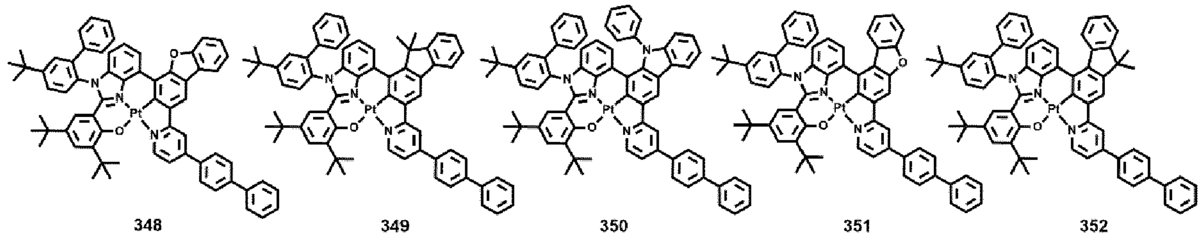

348 349 350 351 352

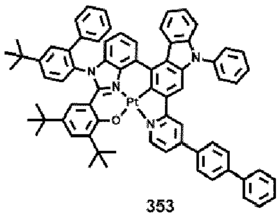

353

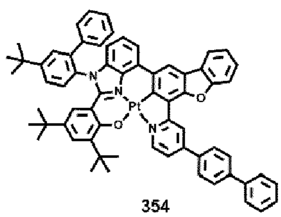

354

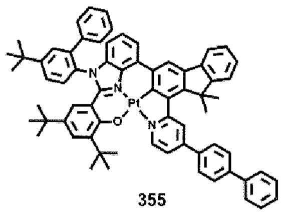

355

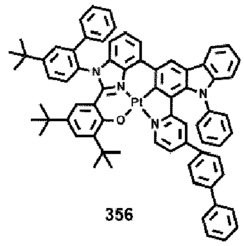

356

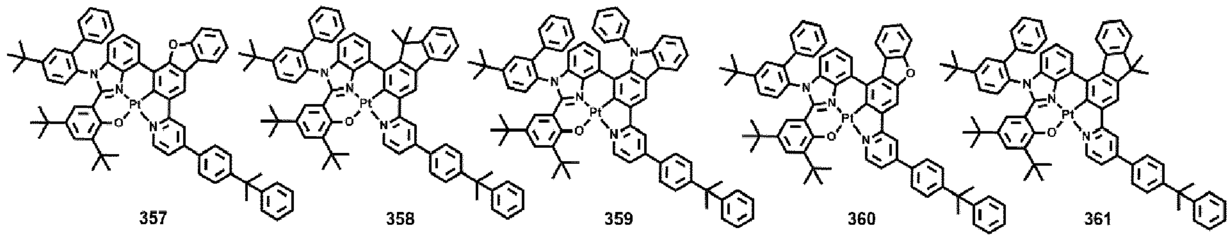

357 358 359 360 361

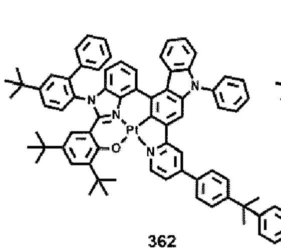

362

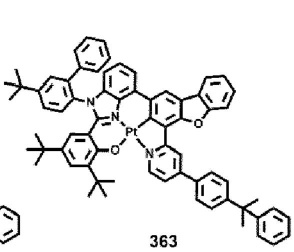

363

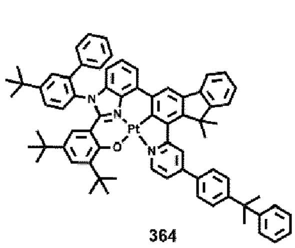

364

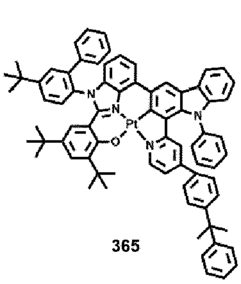

365

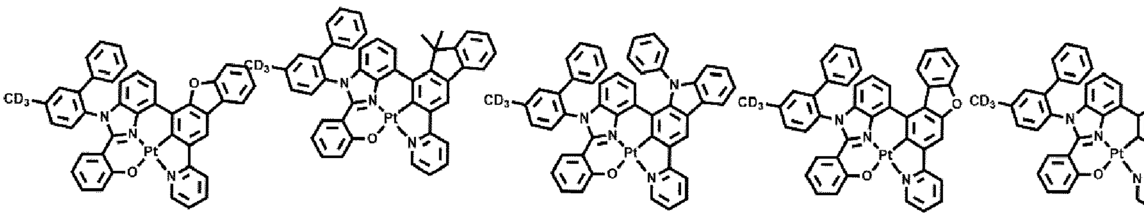

366 367 368 369 370

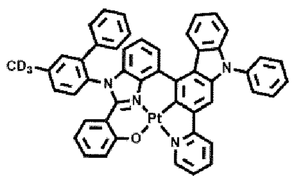

371

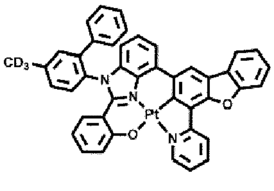

372

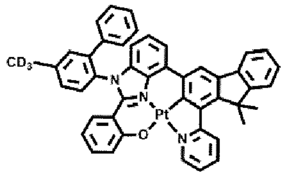

373

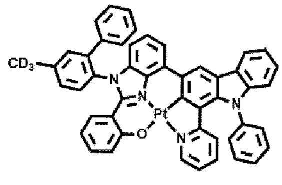

374

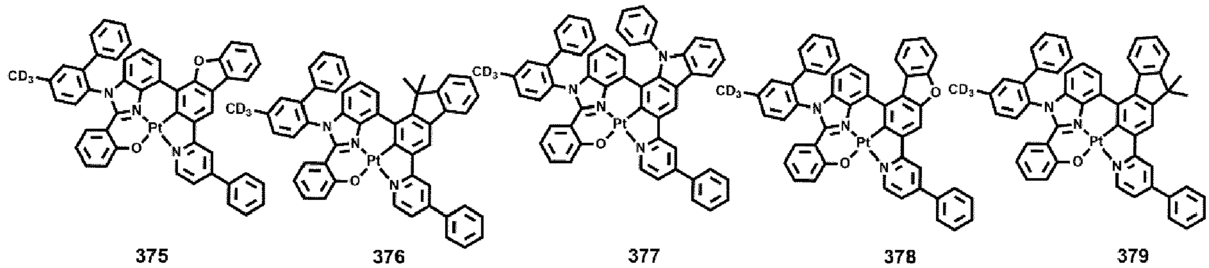

375 376 377 378 379

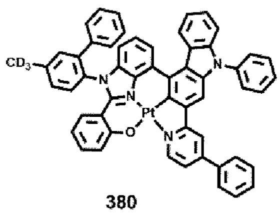

380

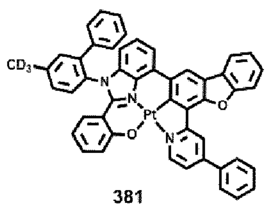

381

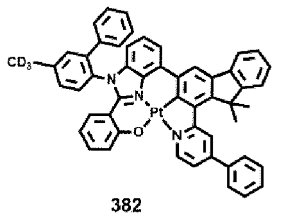

382

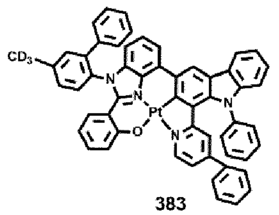

383

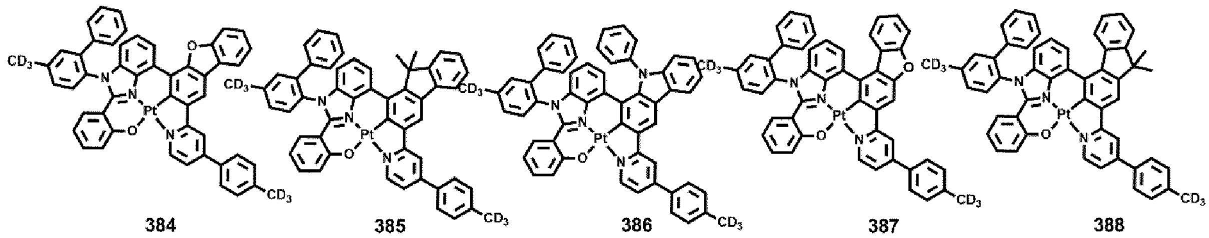

384 385 386 387 388

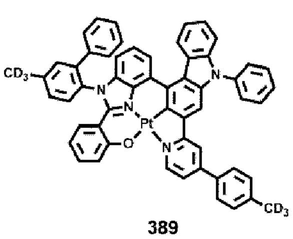

389

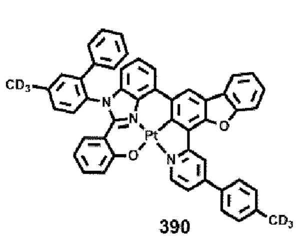

390

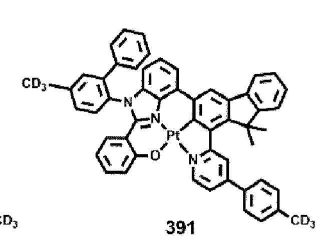

391

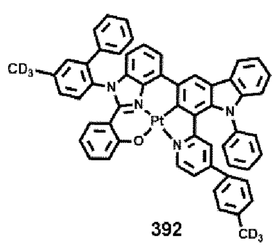

392

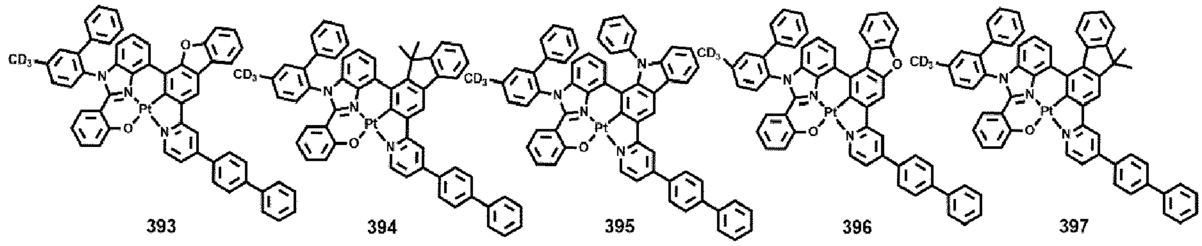

393 394 395 396 397

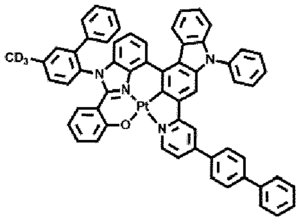

398

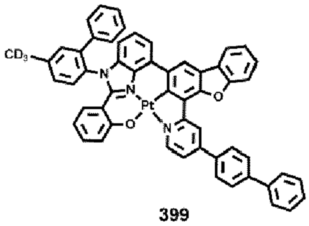

399

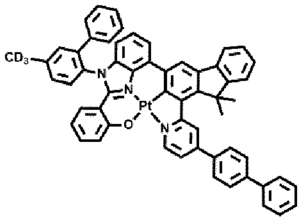

400

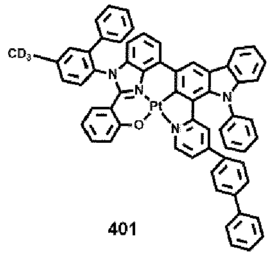

401

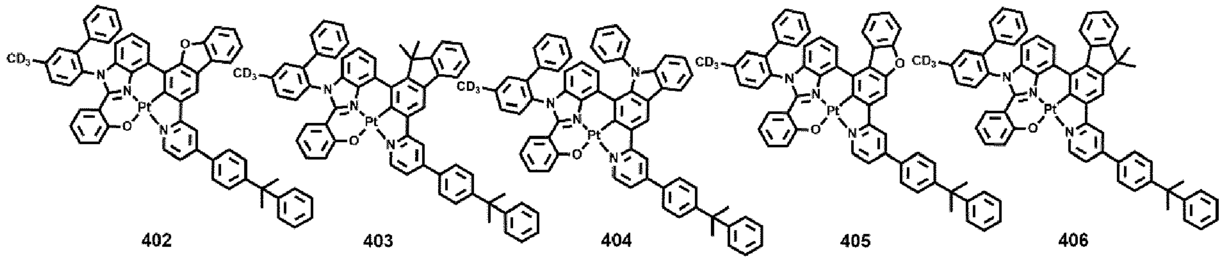

402 403 404 405 406

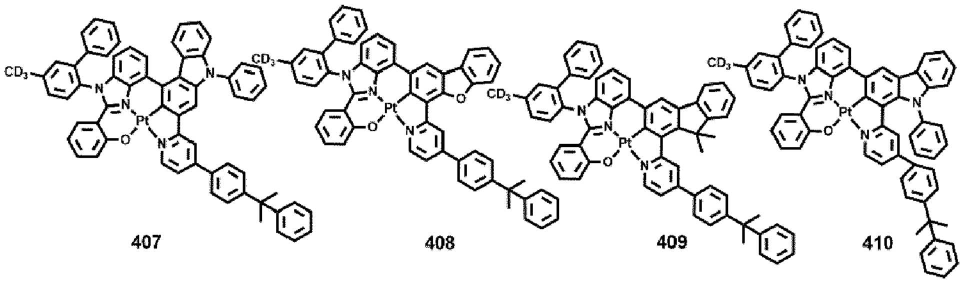

407 408 409 410

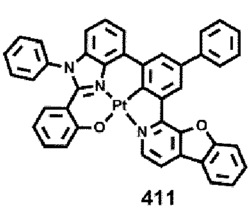

411

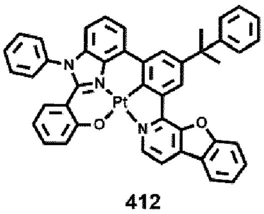

412

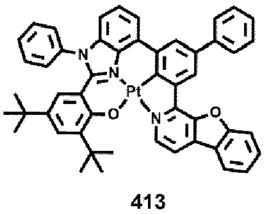

413

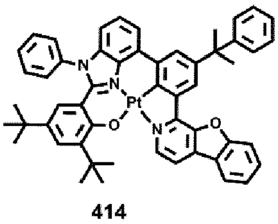

414

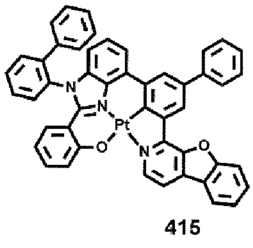

415

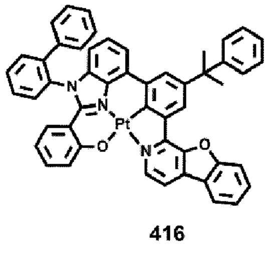

416

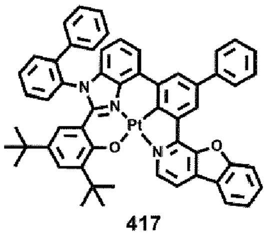

417

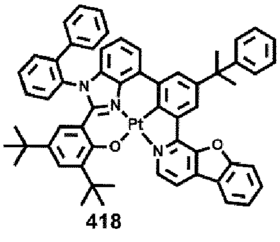

418

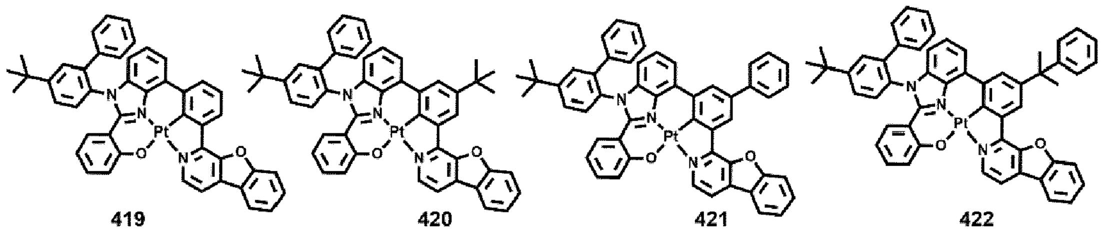

419 420 421 422

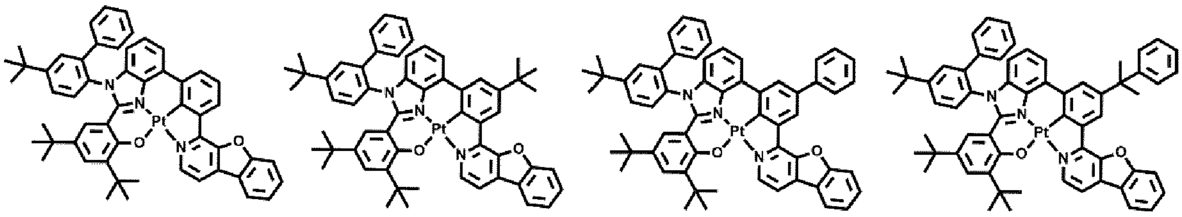

423 424 425 426

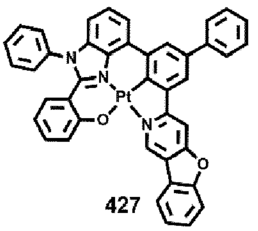

427

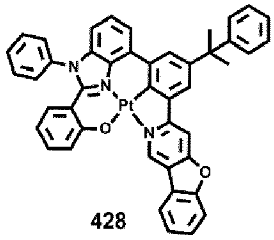

428

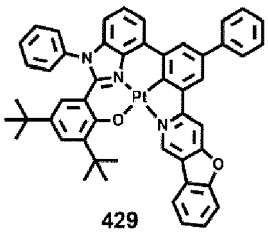

429

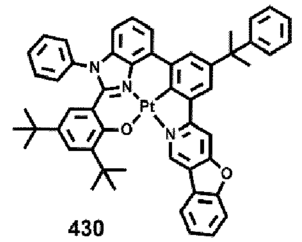

430

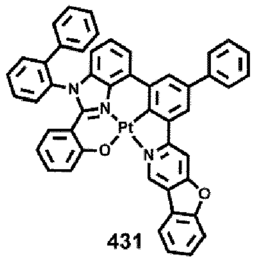

431

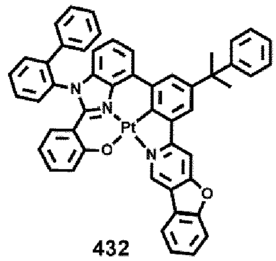

432

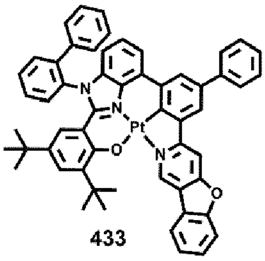

433

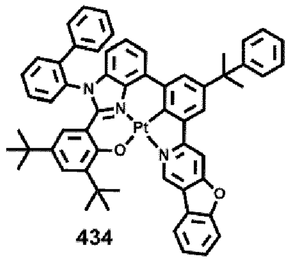

434

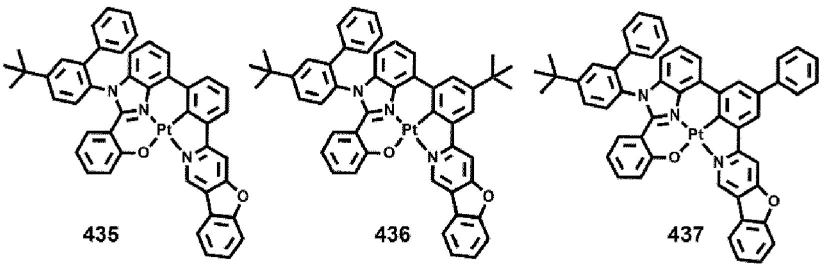

435 436 437

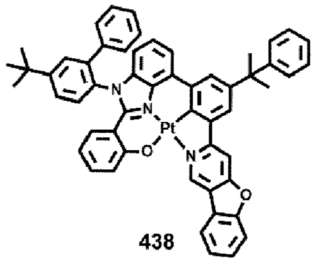

438

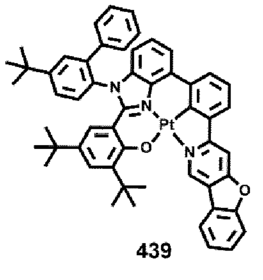

439

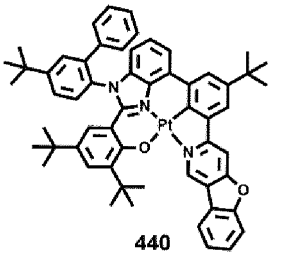

440

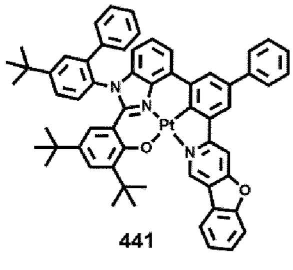

441

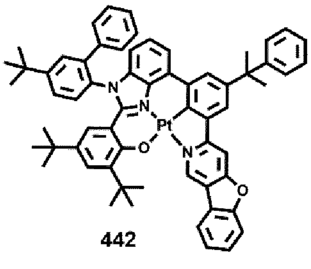

442

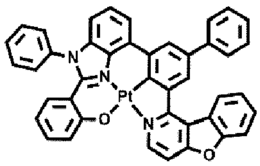
443

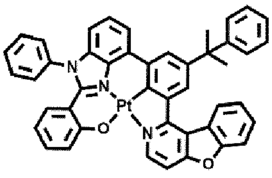
444

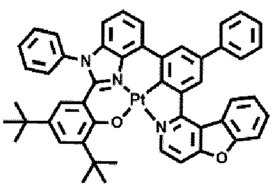
445

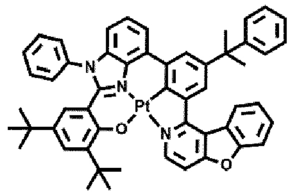
446

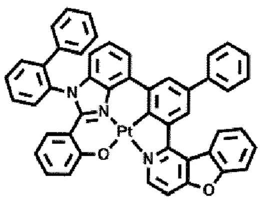
447

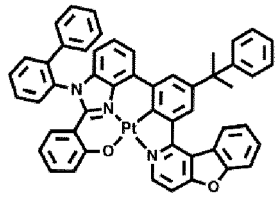
448

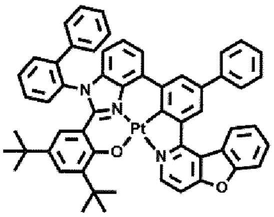
449

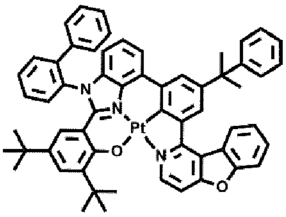
450

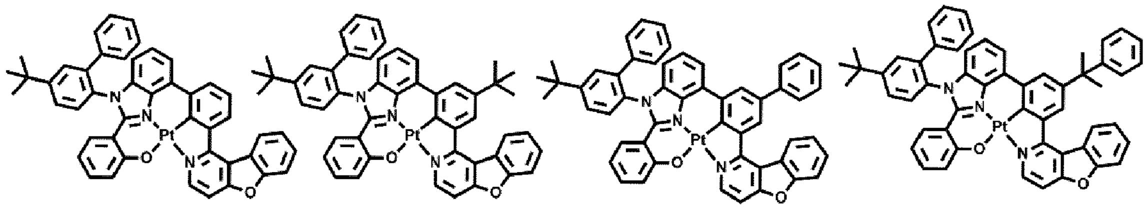
451

452

453

454

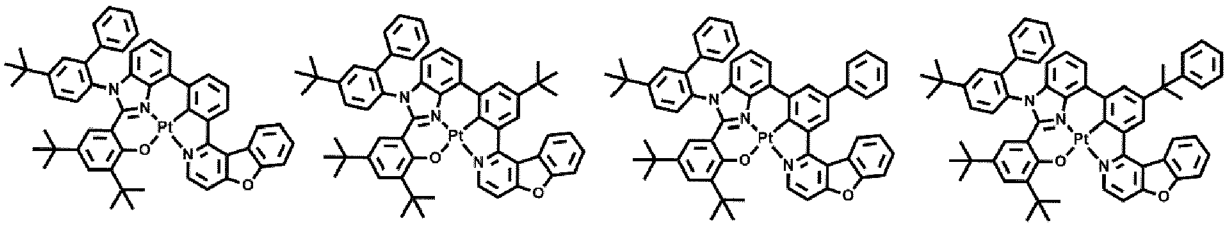
455

456

457

458

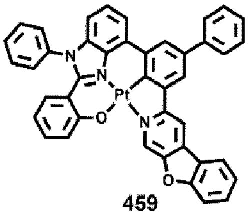
459

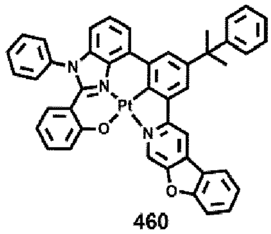
460

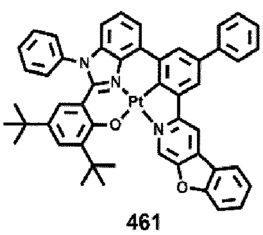
461

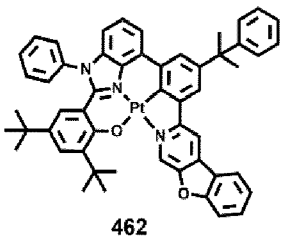
462

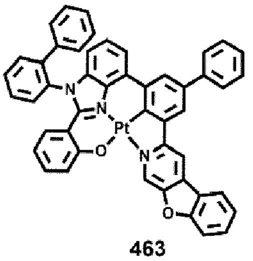
463

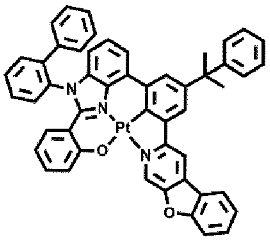
464

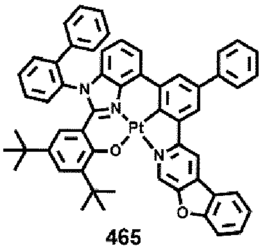
465

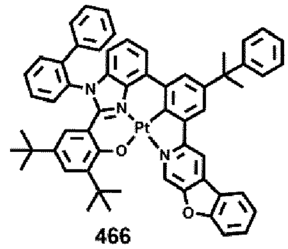
466

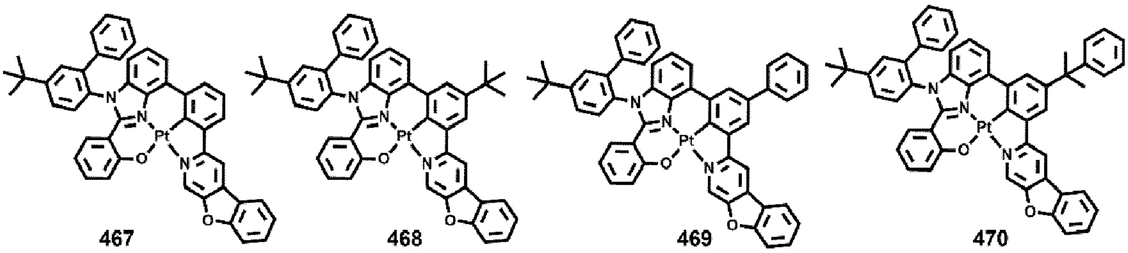

467 468 469 470

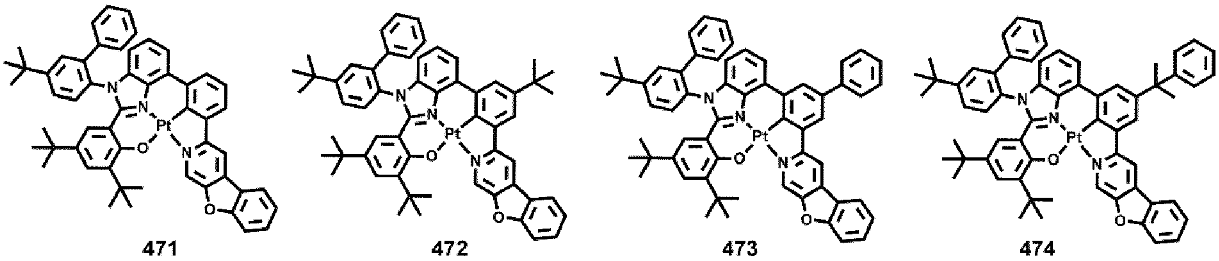

471 472 473 474

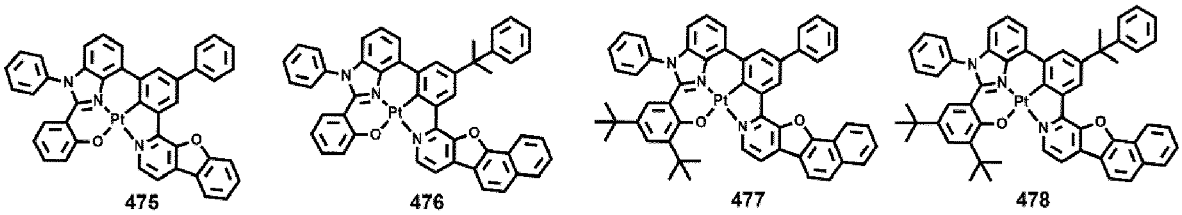

475 476 477 478

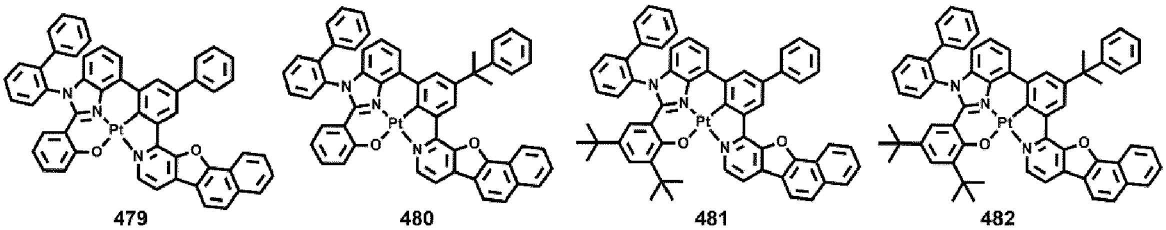

479 480 481 482

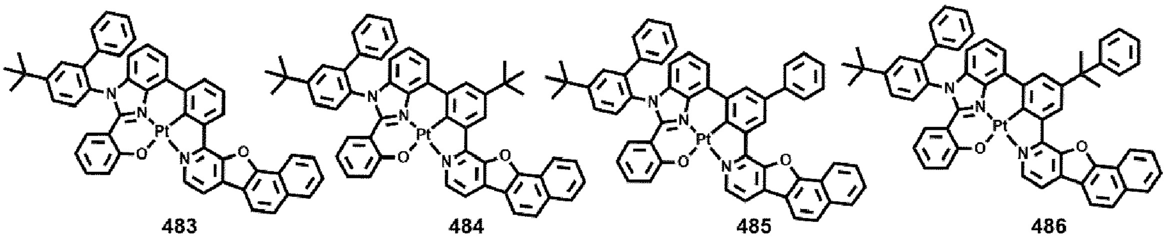

483 484 485 486

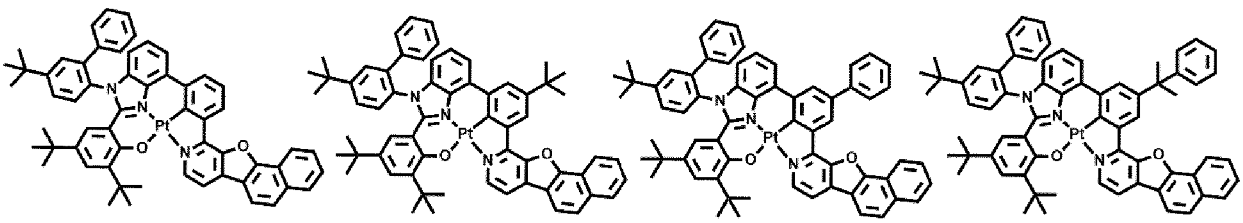

487 488 489 490

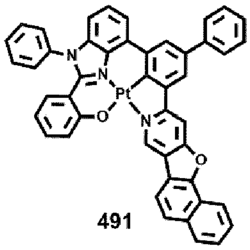
491

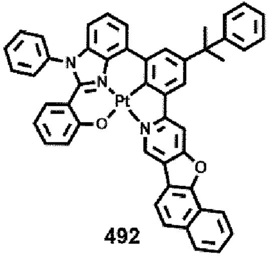
492

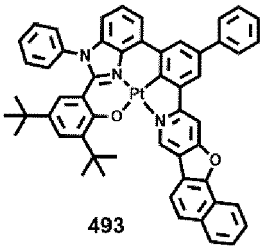
493

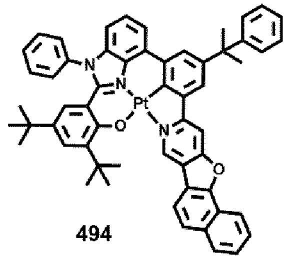
494

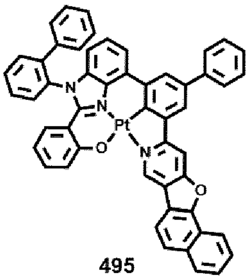
495

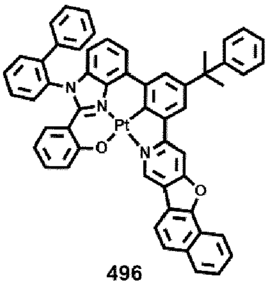
496

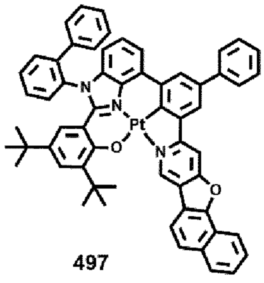
497

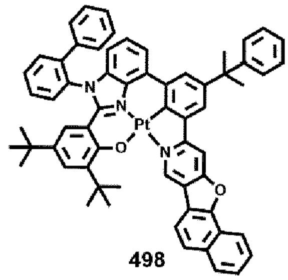
498

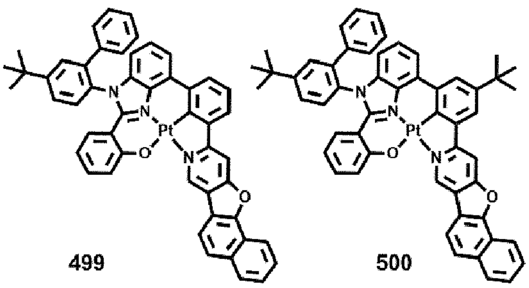
499

500

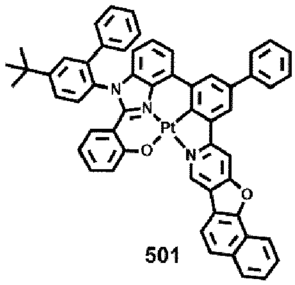
501

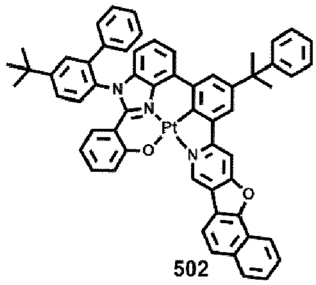
502

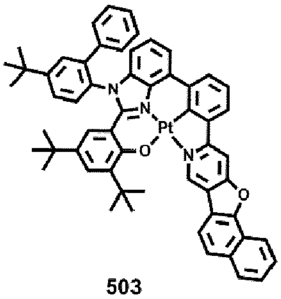
503

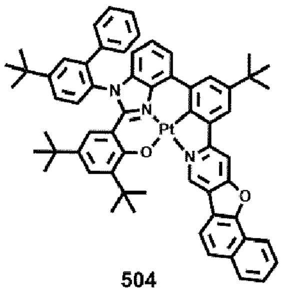
504

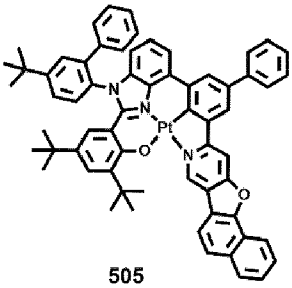
505

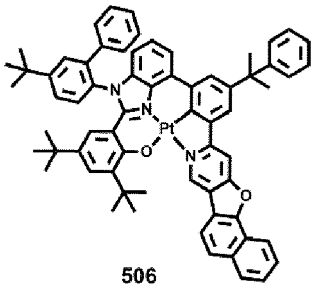
506

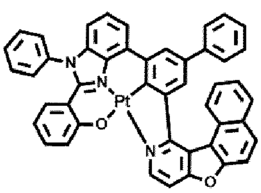
507

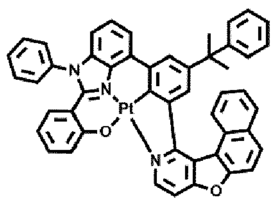
508

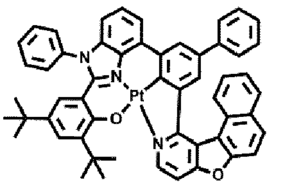
509

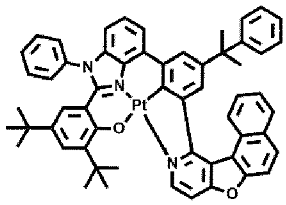
510

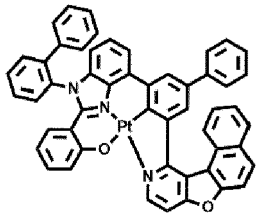

511

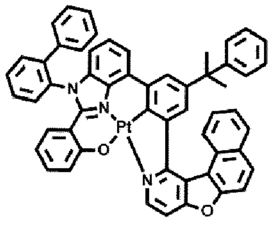

512

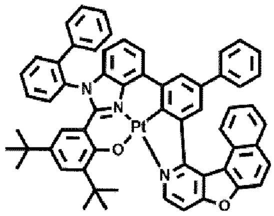

513

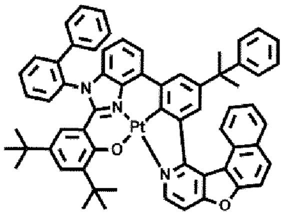

514

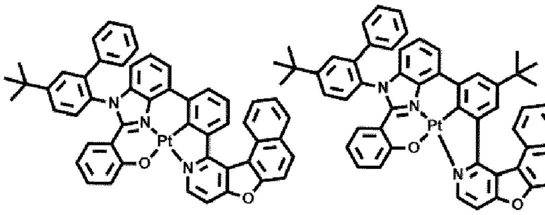

515

516

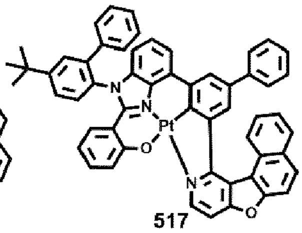

517

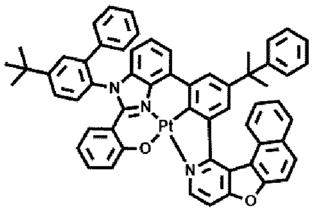

518

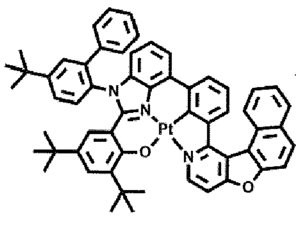

519

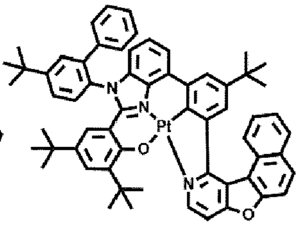

520

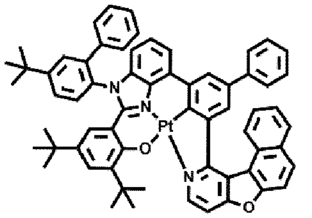

521

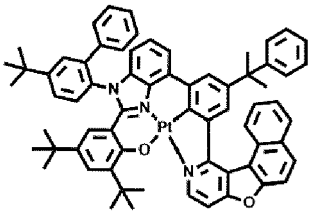

522

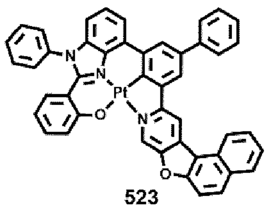

523

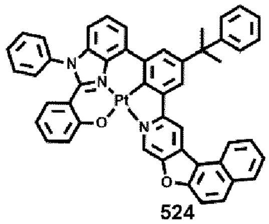

524

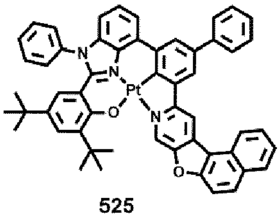

525

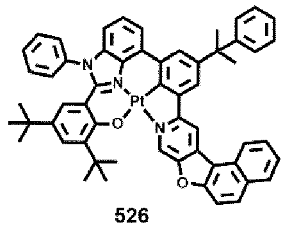

526

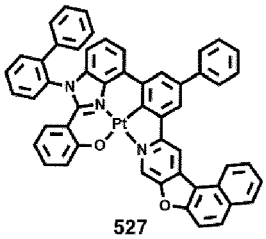

527

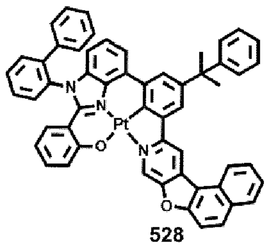

528

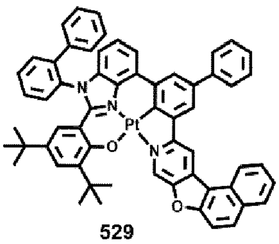

529

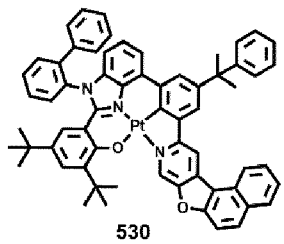

530

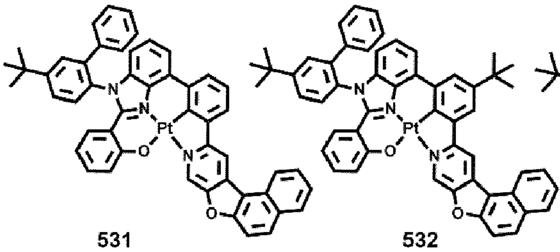

531

532

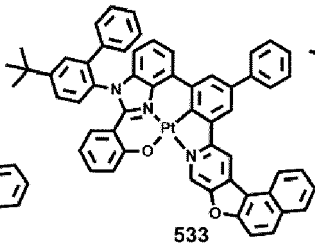

533

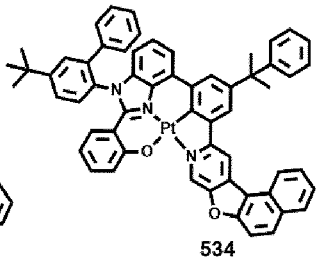

534

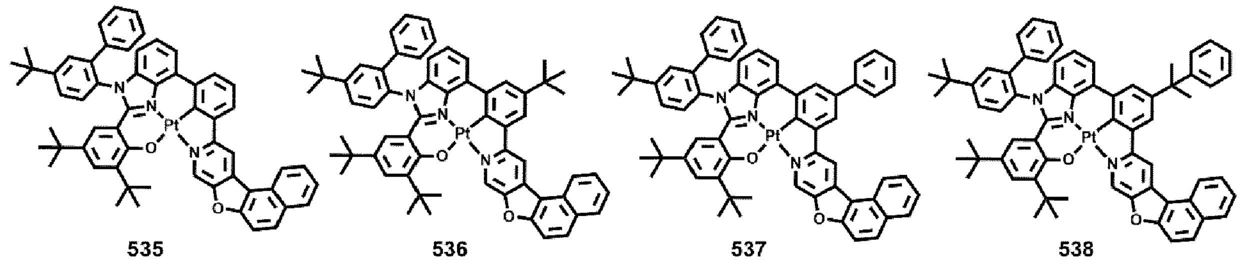

535 536 537 538

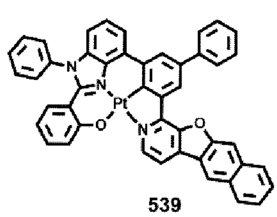

539

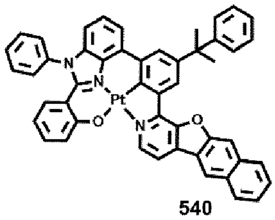

540

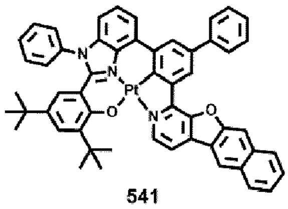

541

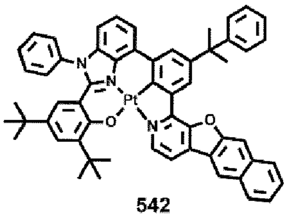

542

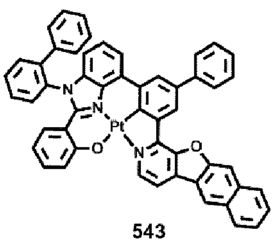

543

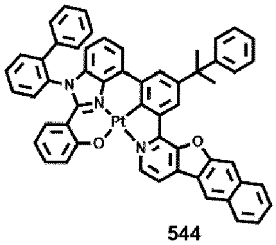

544

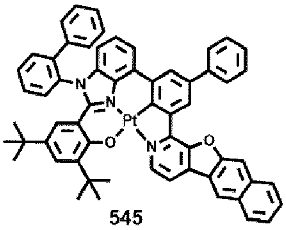

545

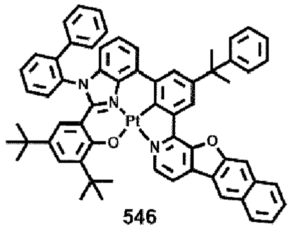

546

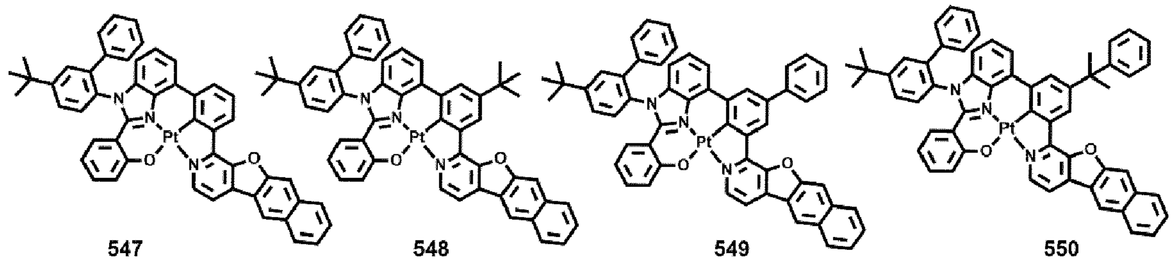

547 548 549 550

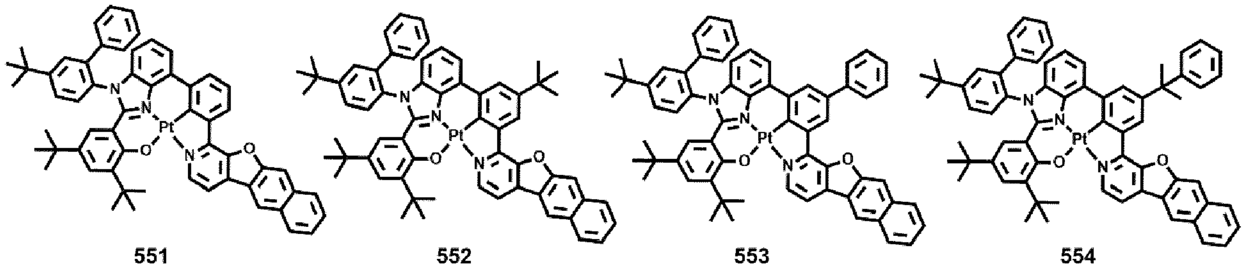

551 552 553 554

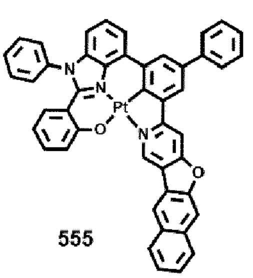

555

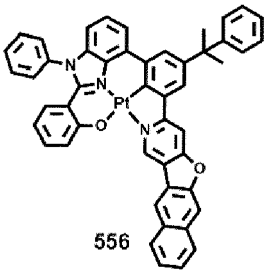

556

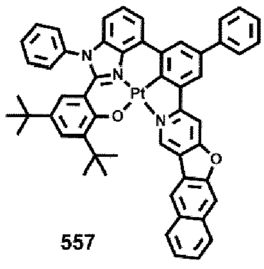

557

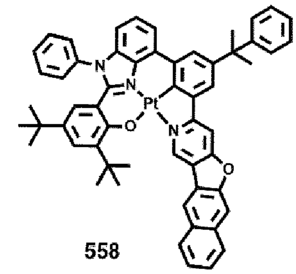

558

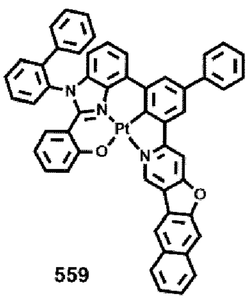
559

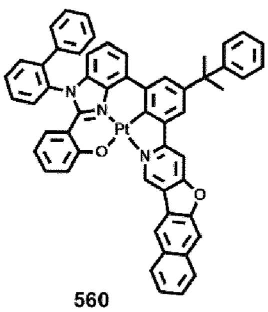
560

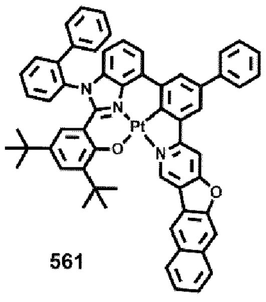
561

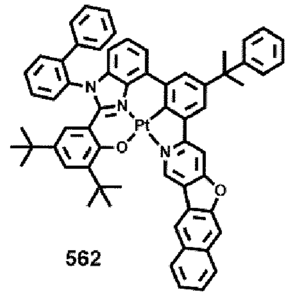
562

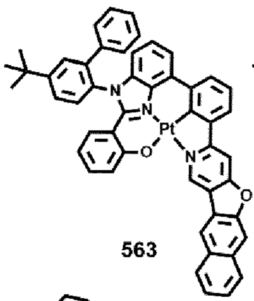
563

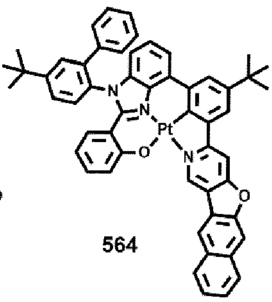
564

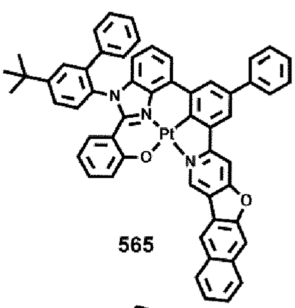
565

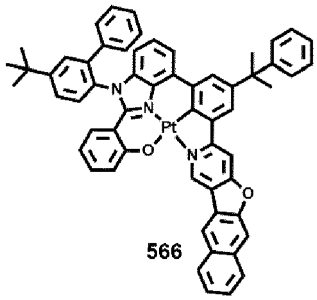
566

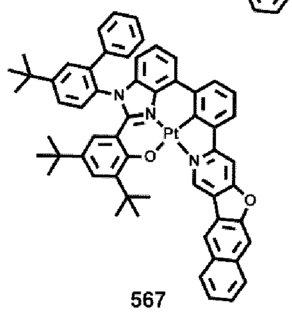
567

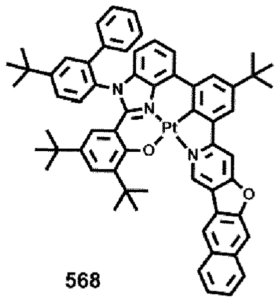
568

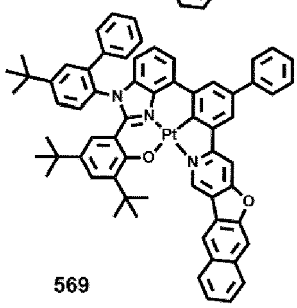
569

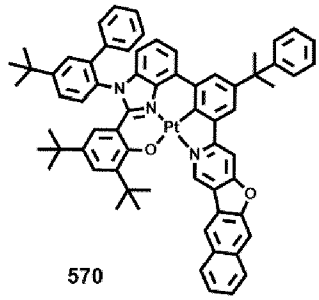
570

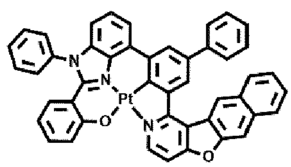
571

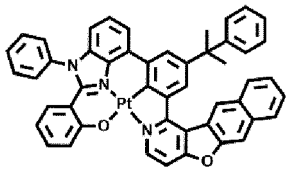
572

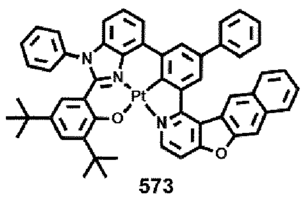
573

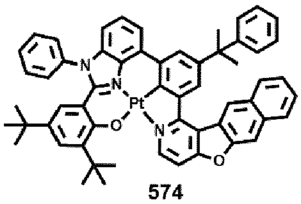
574

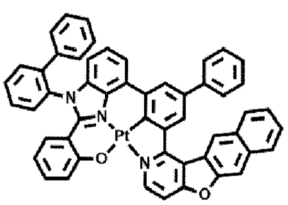
575

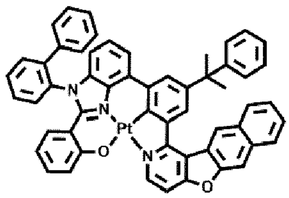
576

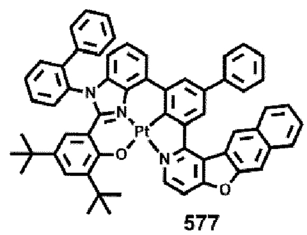
577

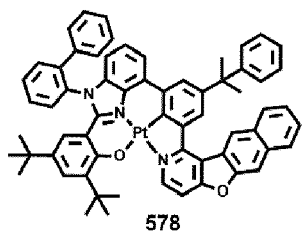
578

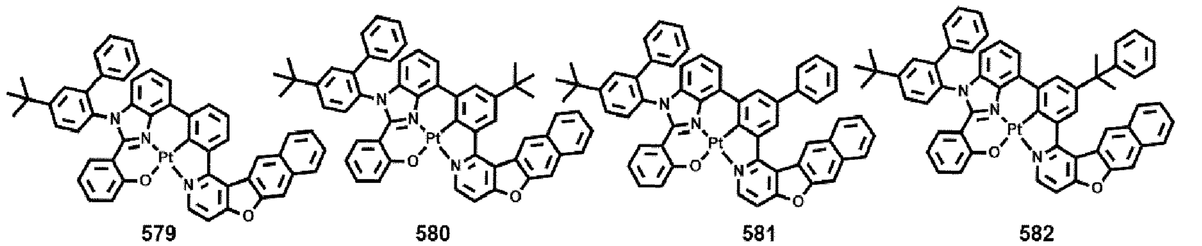
579

580

581

582

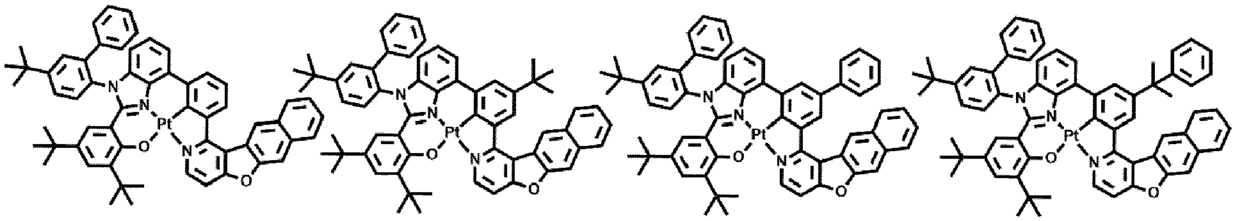

583 584 585 586

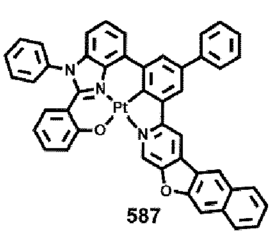

587

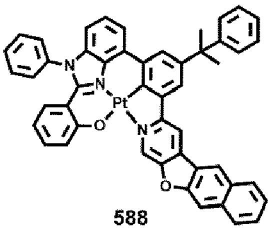

588

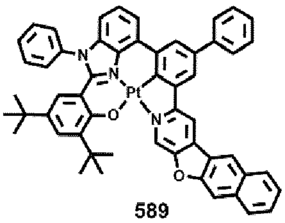

589

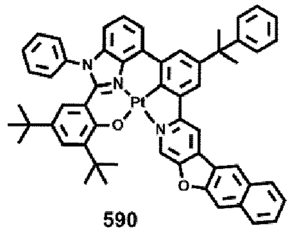

590

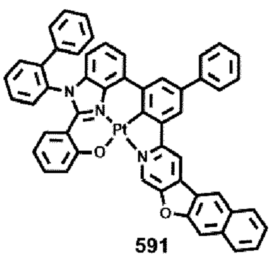

591

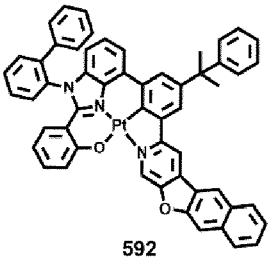

592

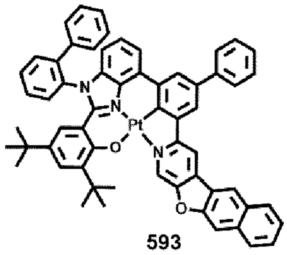

593

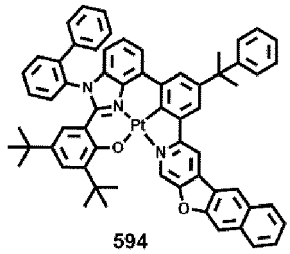

594

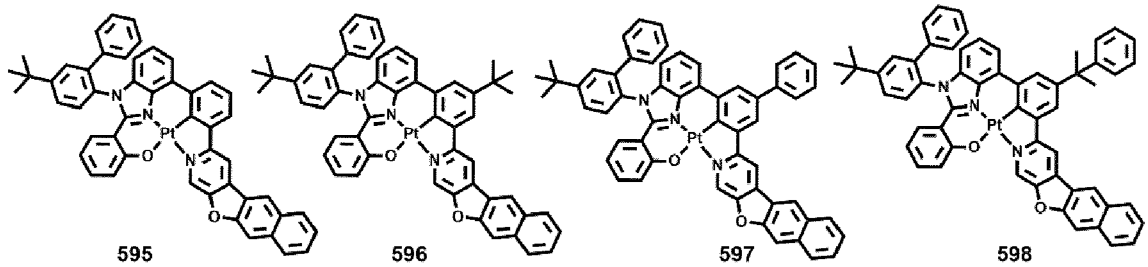

595 596 597 598

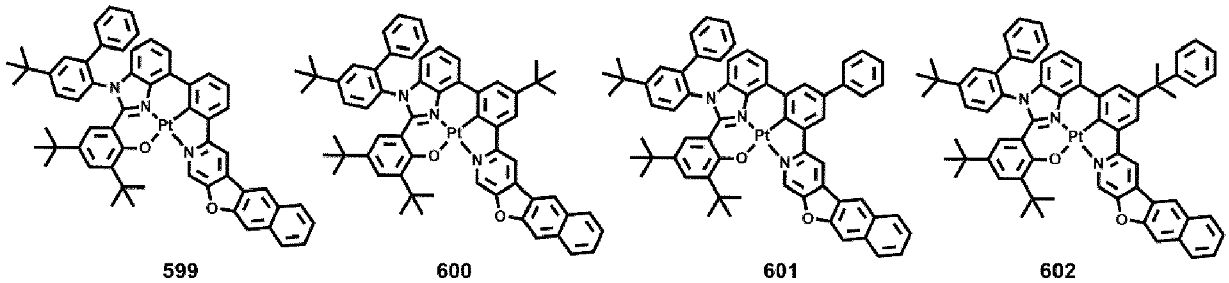

599 600 601 602

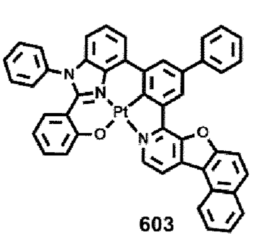

603

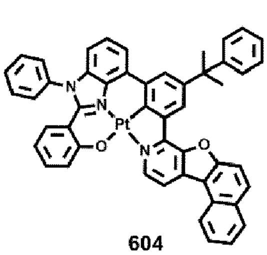

604

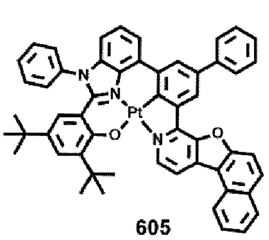

605

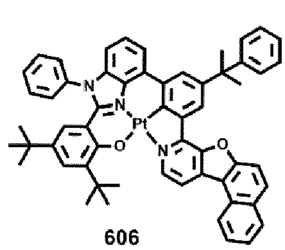

606

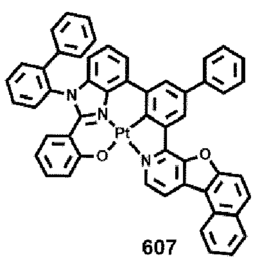
607
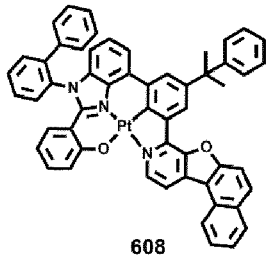
608
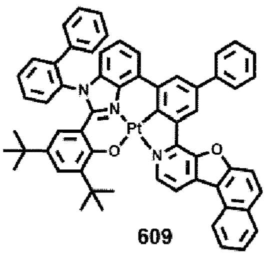
609
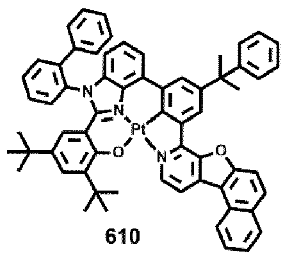
610

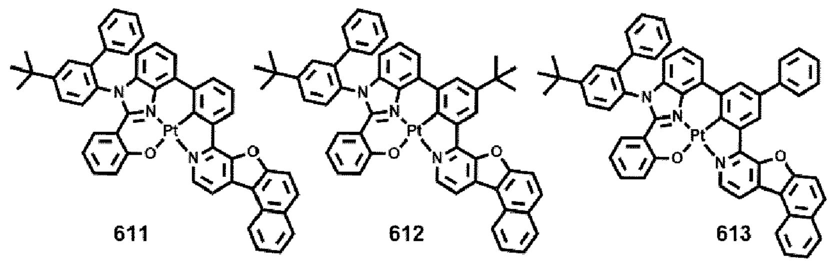
611
612
613
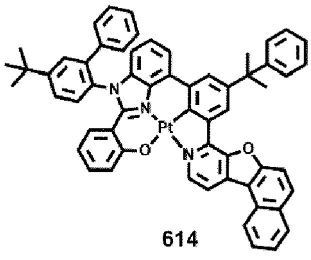
614

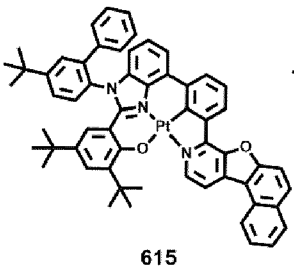
615
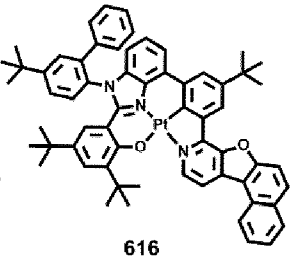
616
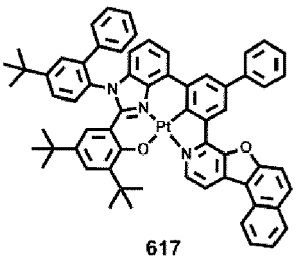
617
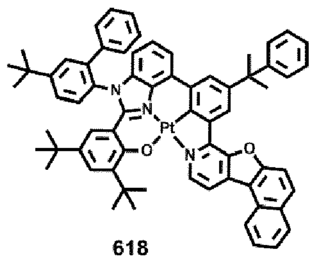
618

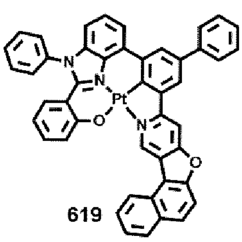
619
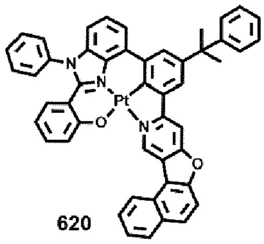
620
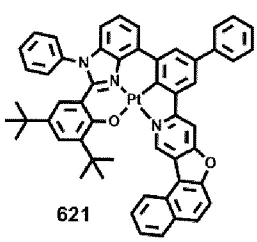
621
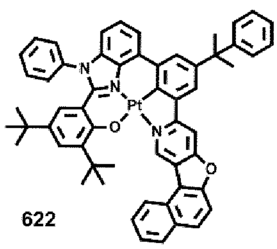
622

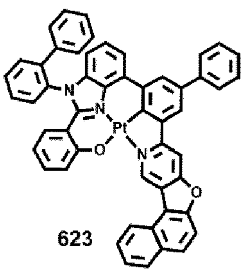
623
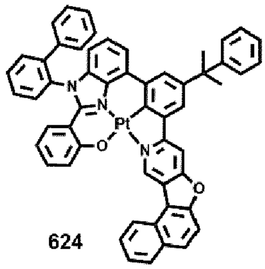
624
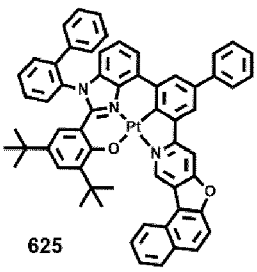
625
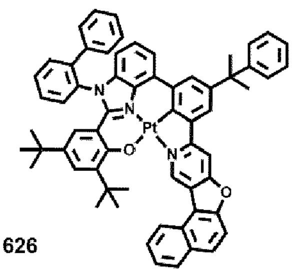
626

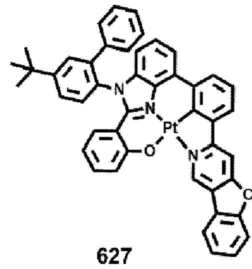
627

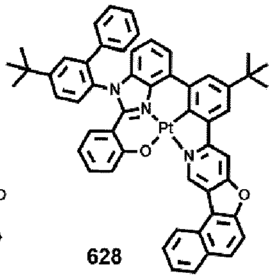
628

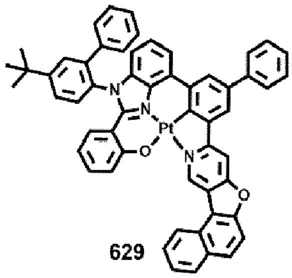
629

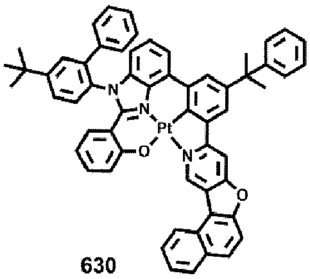
630

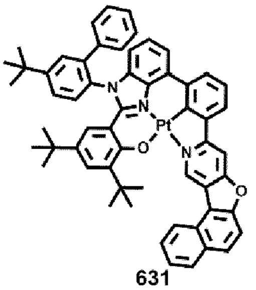
631

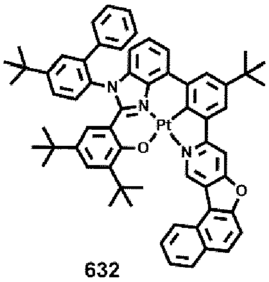
632

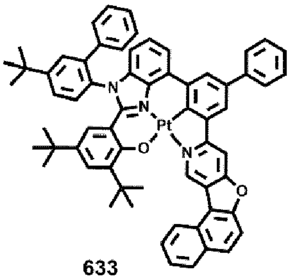
633

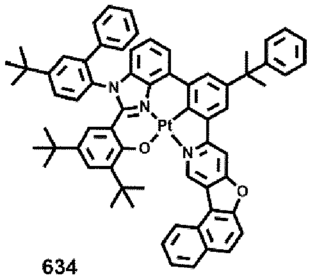
634

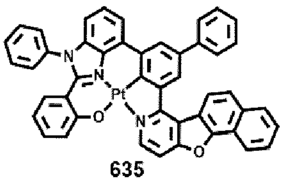
635

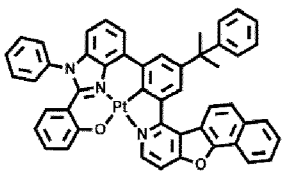
636

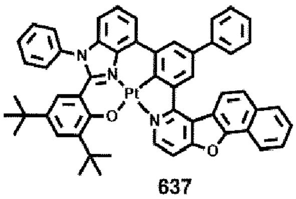
637

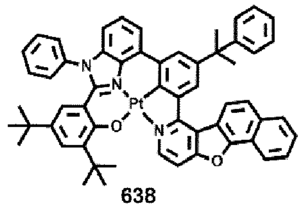
638

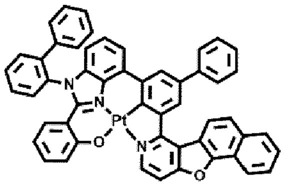
639

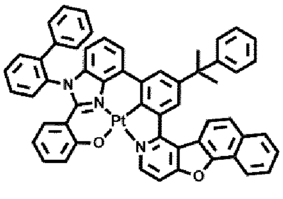
640

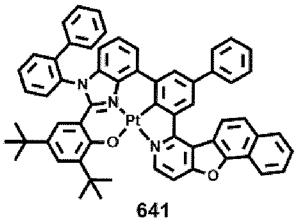
641

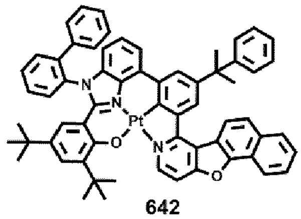
642

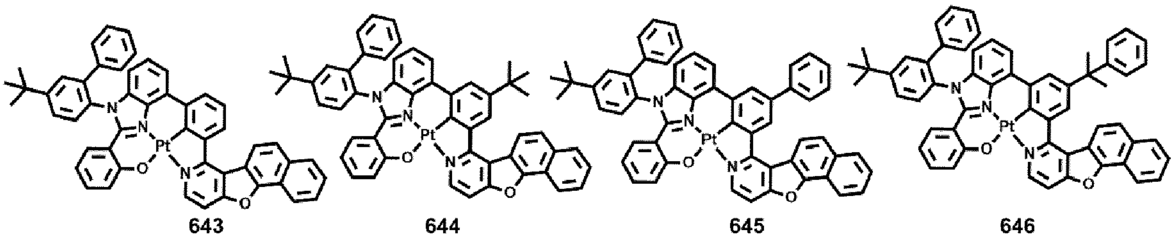
643

644

645

646

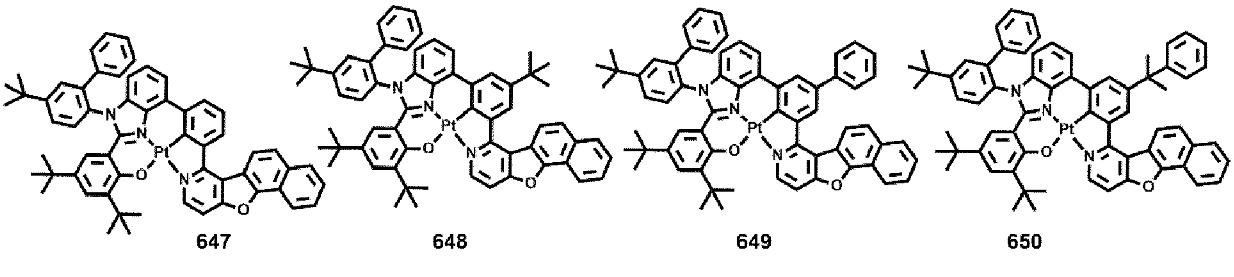
647

648

649

650

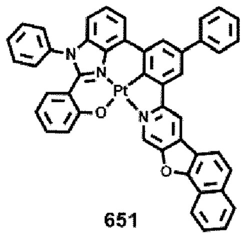
651

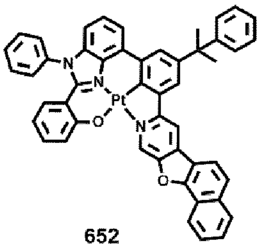
652

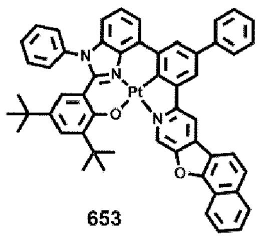
653

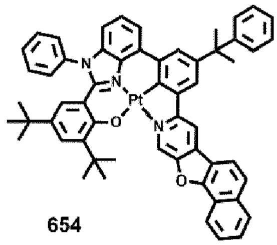
654

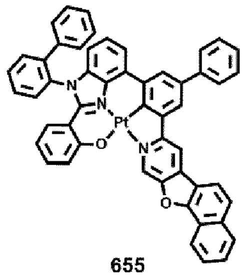
655

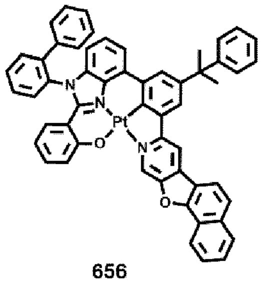
656

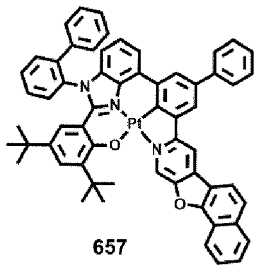
657

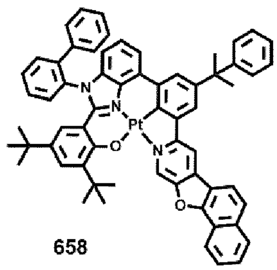
658

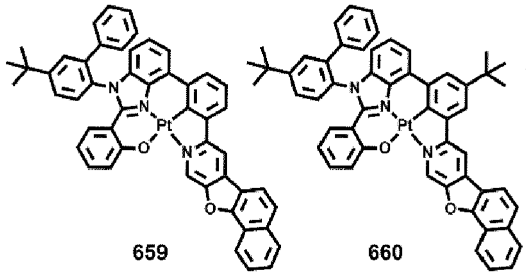
659

660

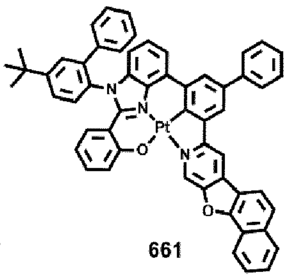
661

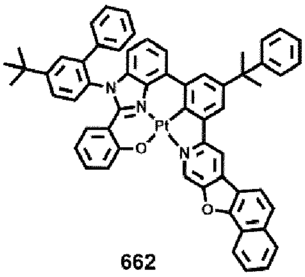
662

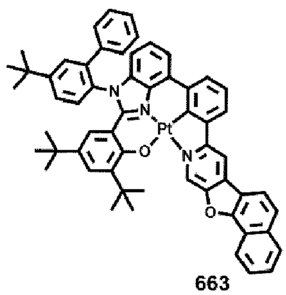
663

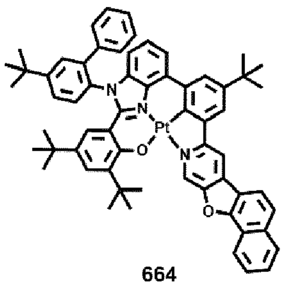
664

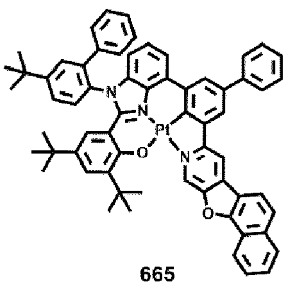
665

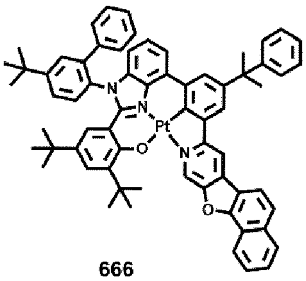
666

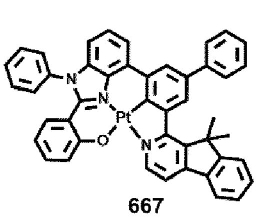
667

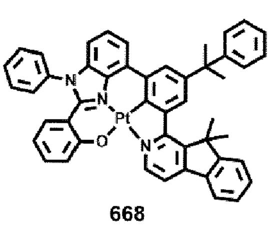
668

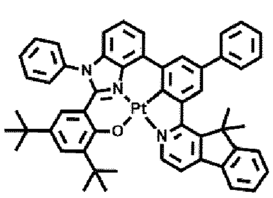
669

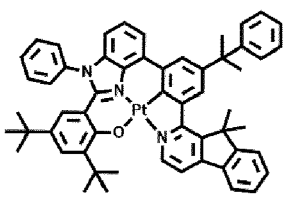
670

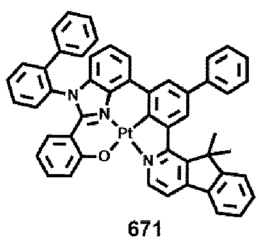
671
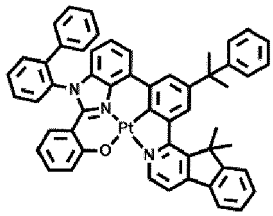
672
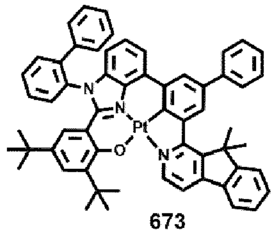
673
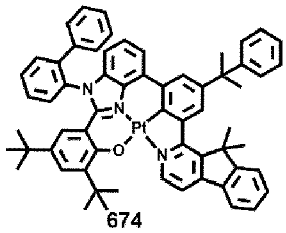
674

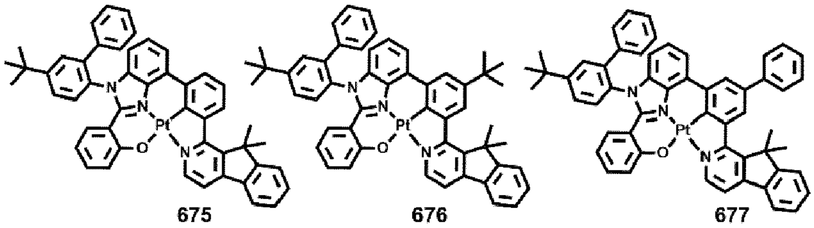
675
676
677
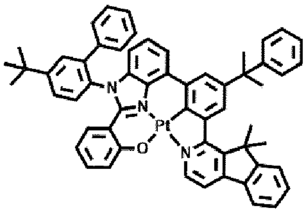
678

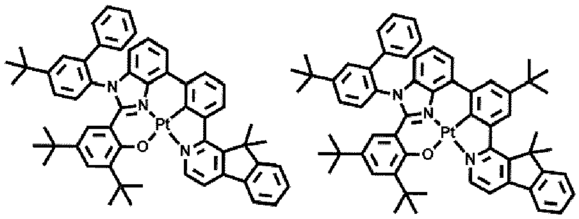
679
680
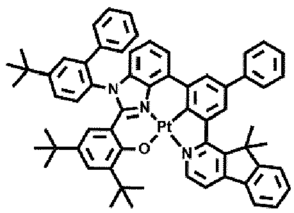
681
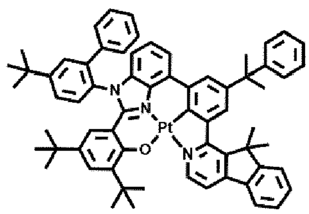
682

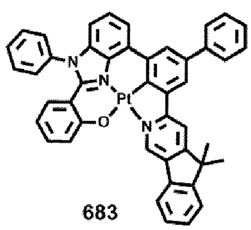
683
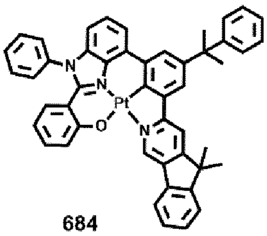
684
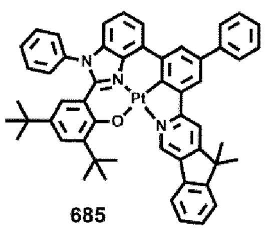
685
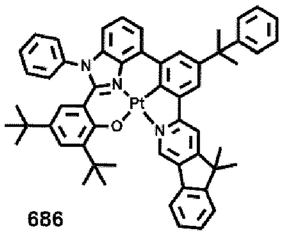
686

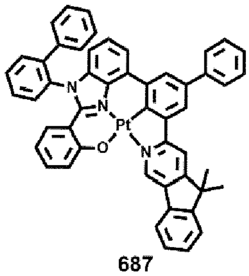
687
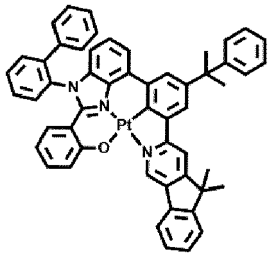
688
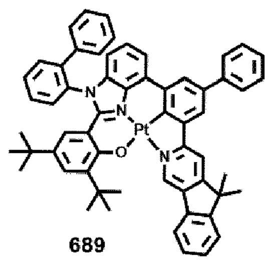
689
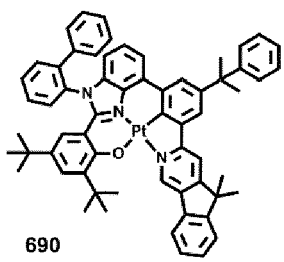
690

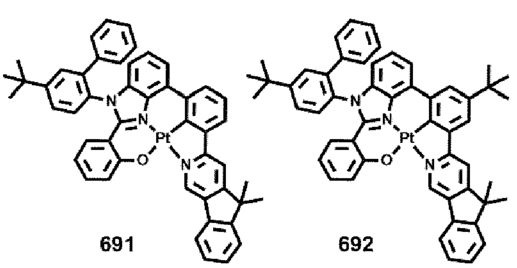
691
692
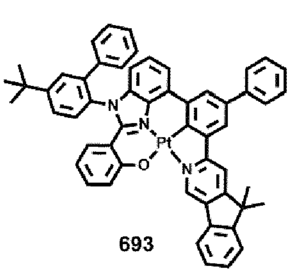
693
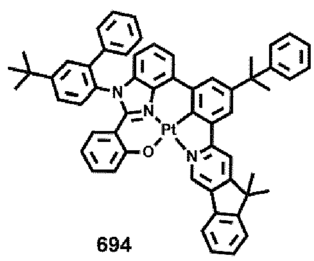
694

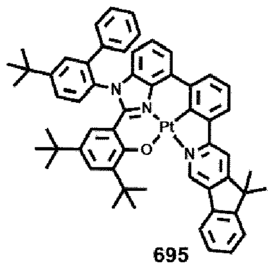
695

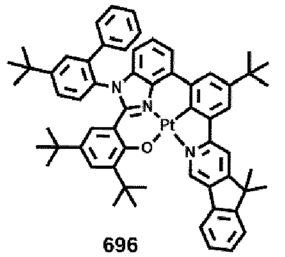
696

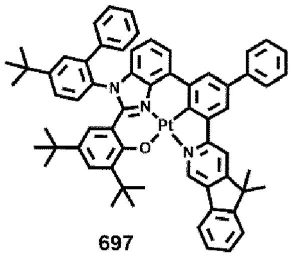
697

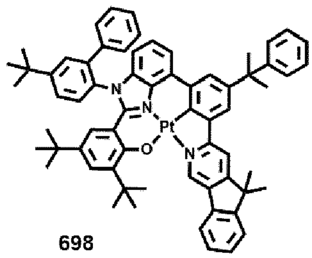
698

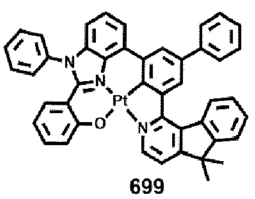
699

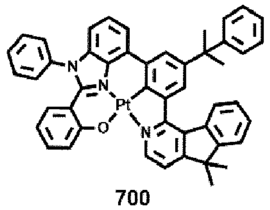
700

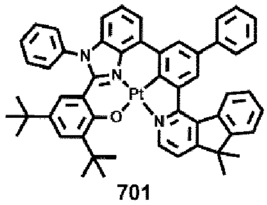
701

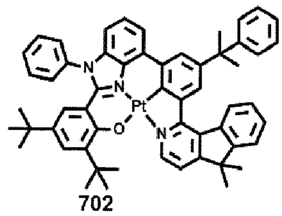
702

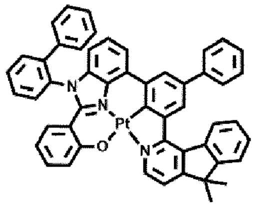
703

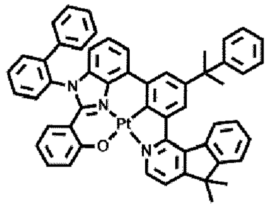
704

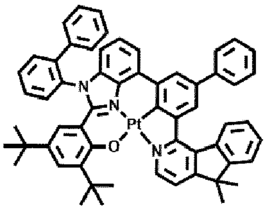
705

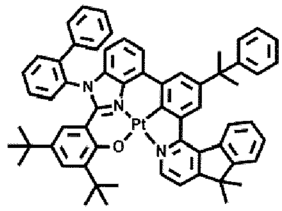
706

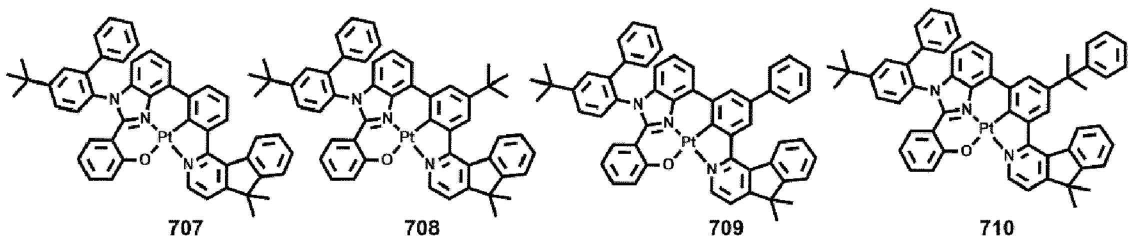
707

708

709

710

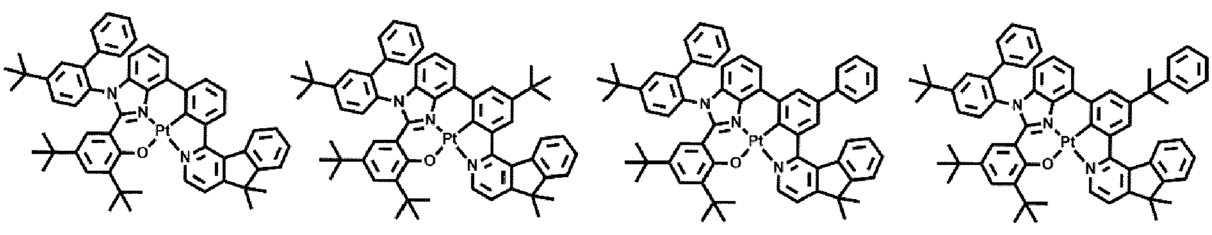
711

712

713

714

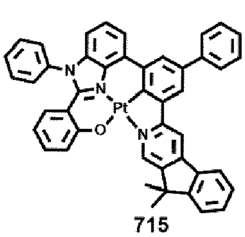
715

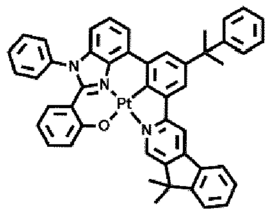
716

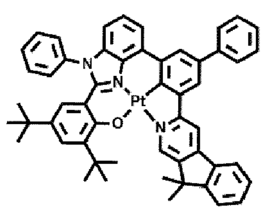
717

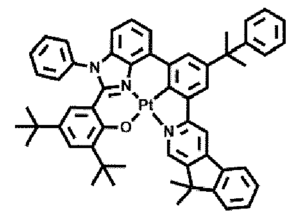
718

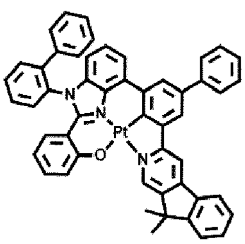
719
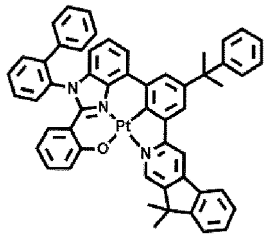
720
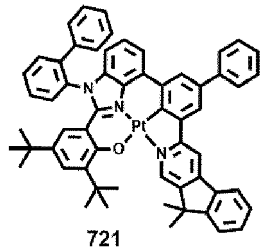
721
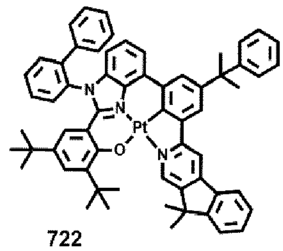
722

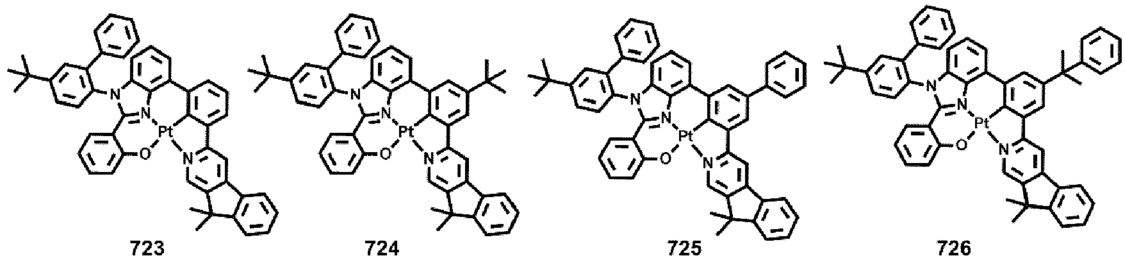
723 724 725 726

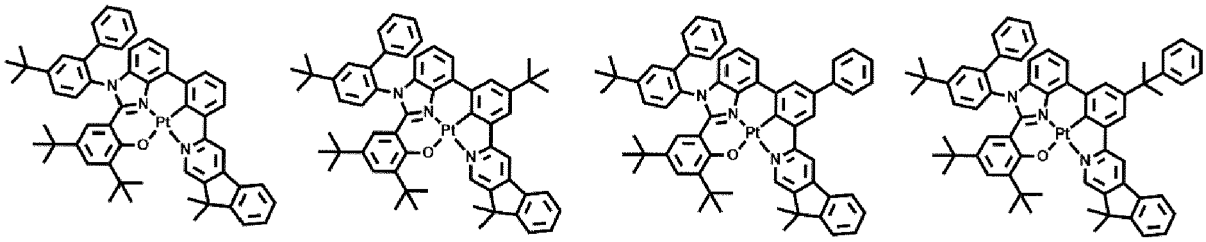
727 728 729 730

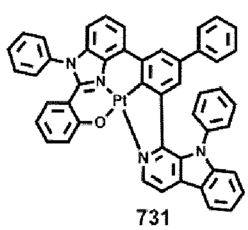
731
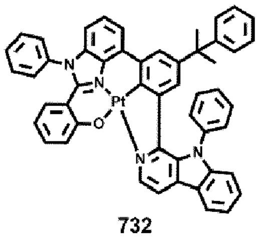
732
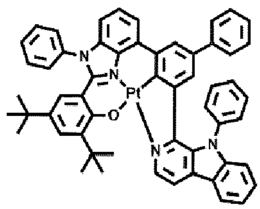
733
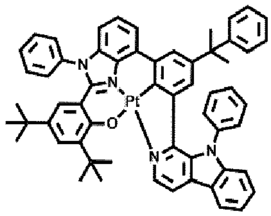
734

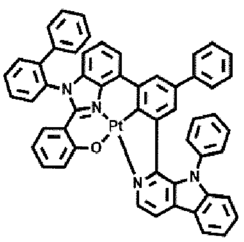
735
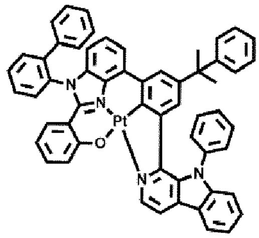
736
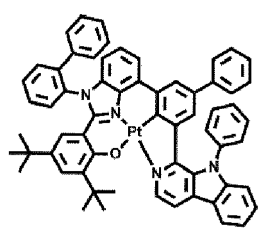
737
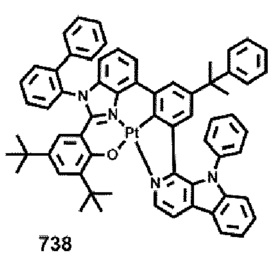
738

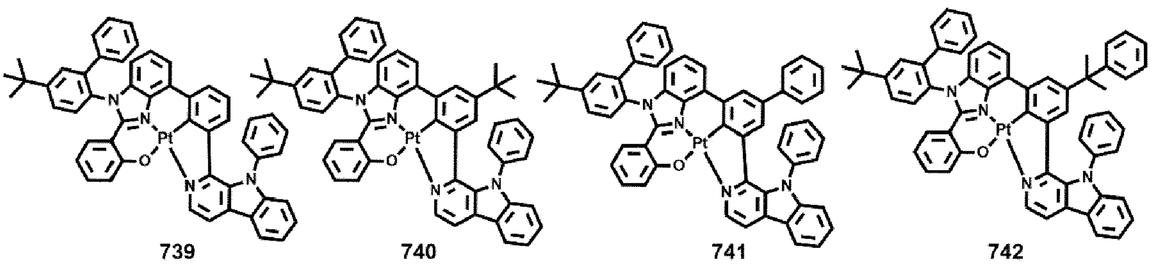
739 740 741 742

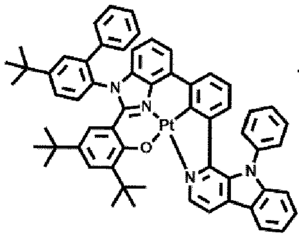
743
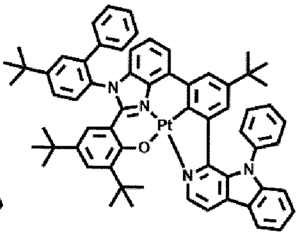
744
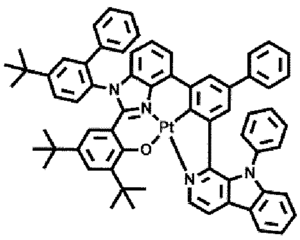
745
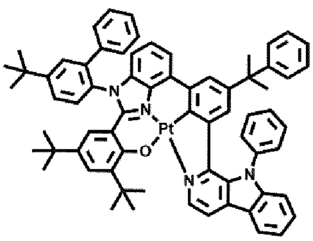
746

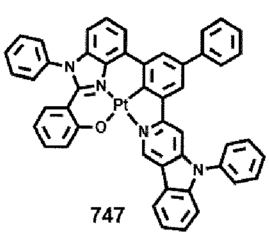
747
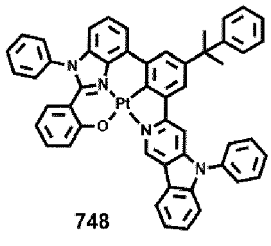
748
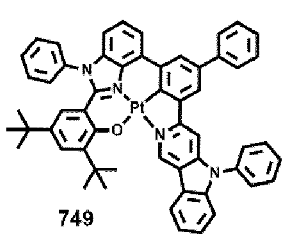
749
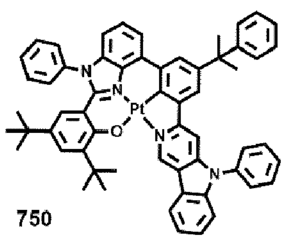
750

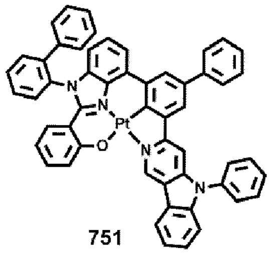
751
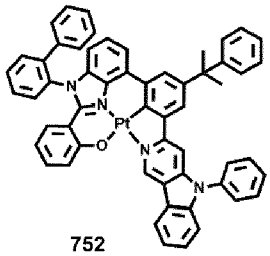
752
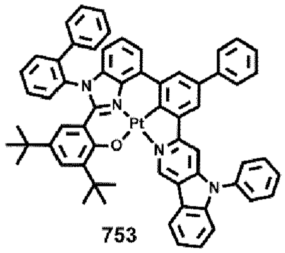
753
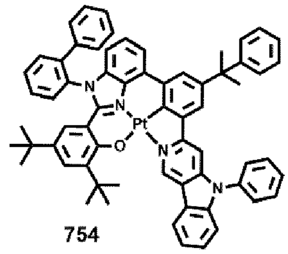
754

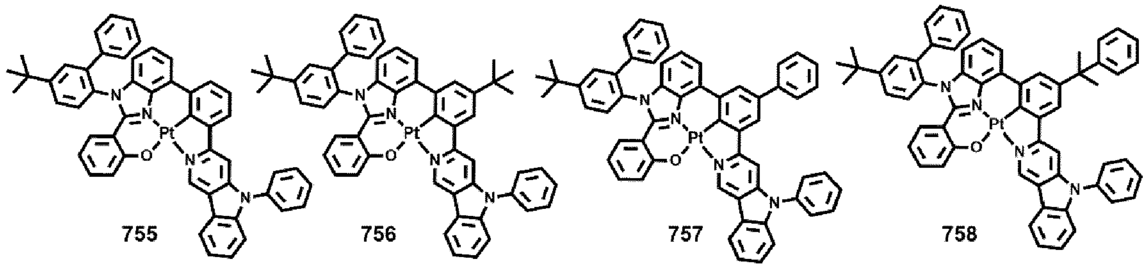
755 756 757 758

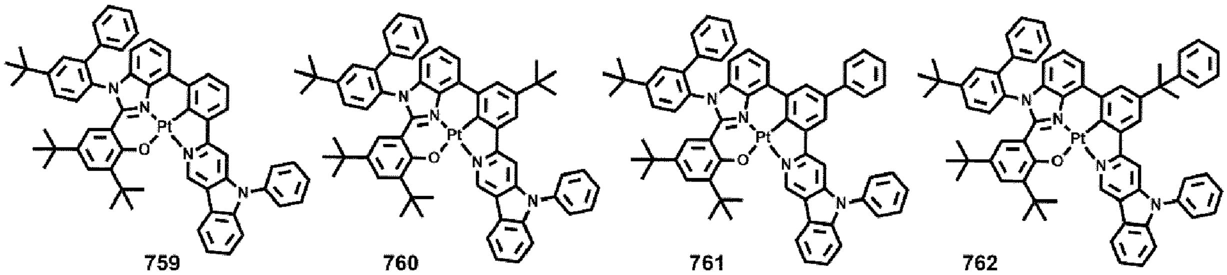
759 760 761 762

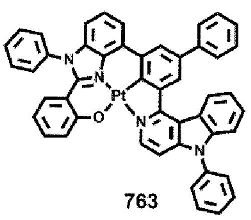
763
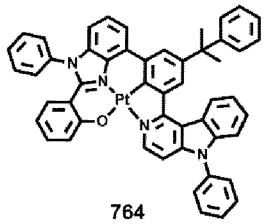
764
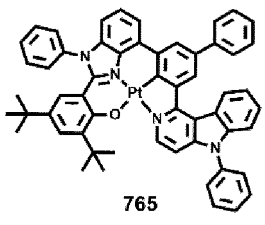
765
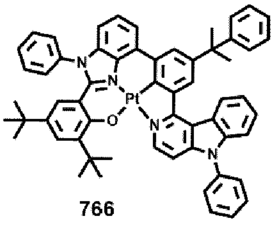
766

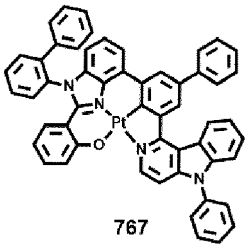
767

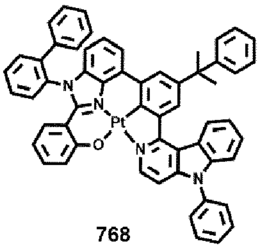
768

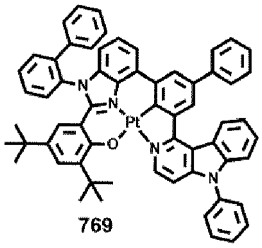
769

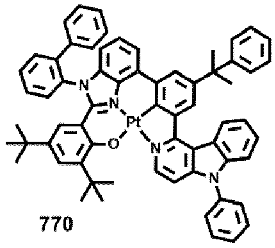
770

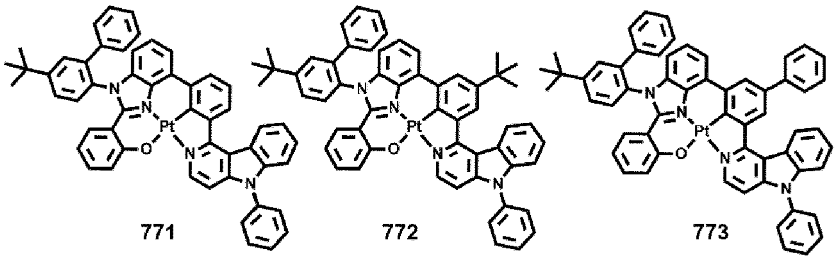
771

772

773

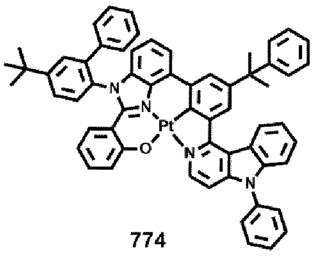
774

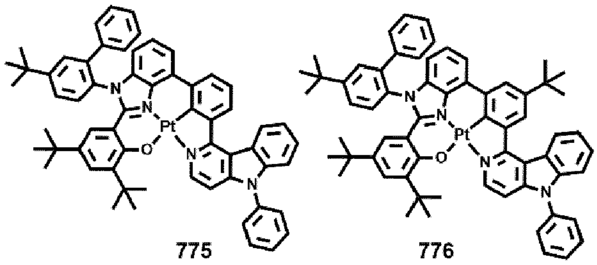
775

776

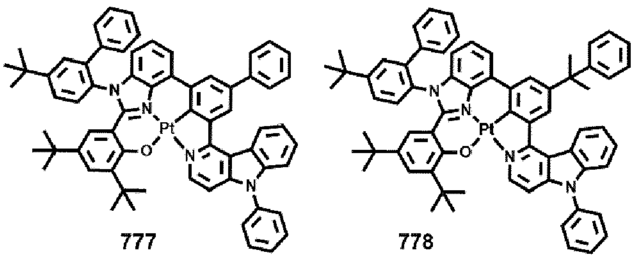
777

778

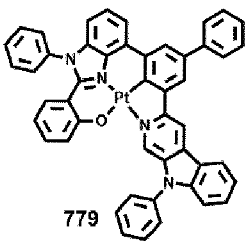
779

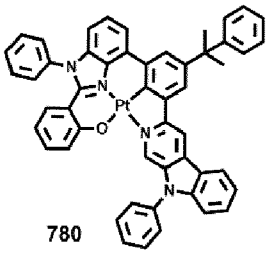
780

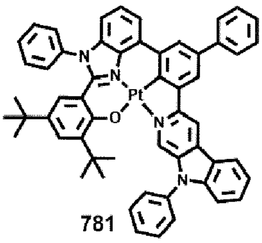
781

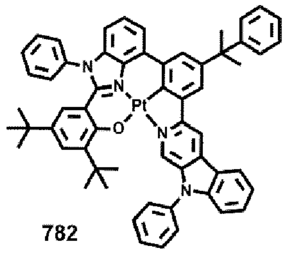
782

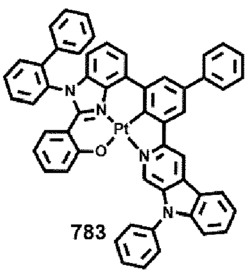
783

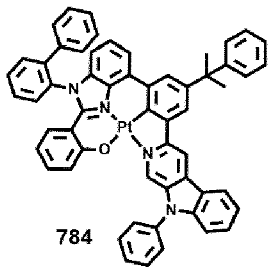
784

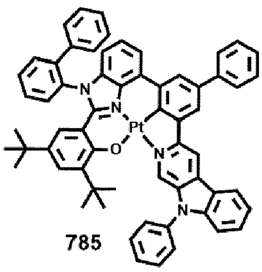
785

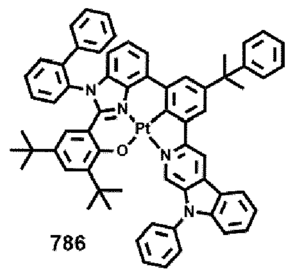
786

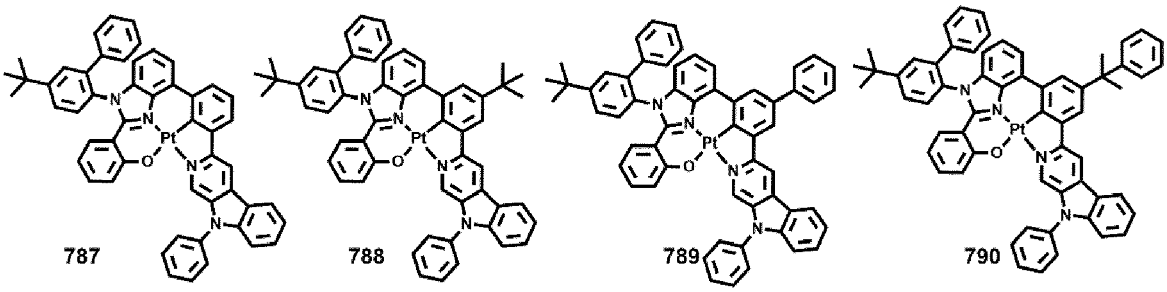

787 788 789 790

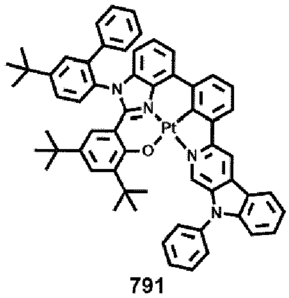

791

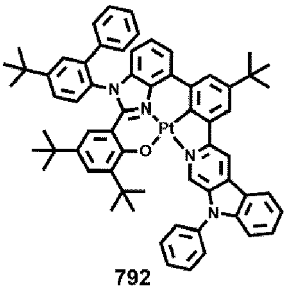

792

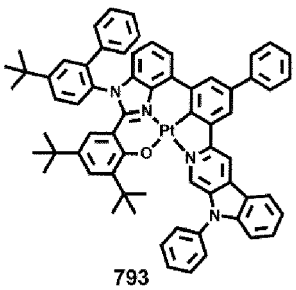

793

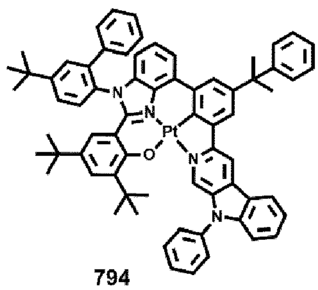

794

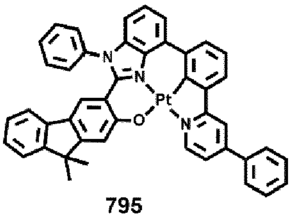

795

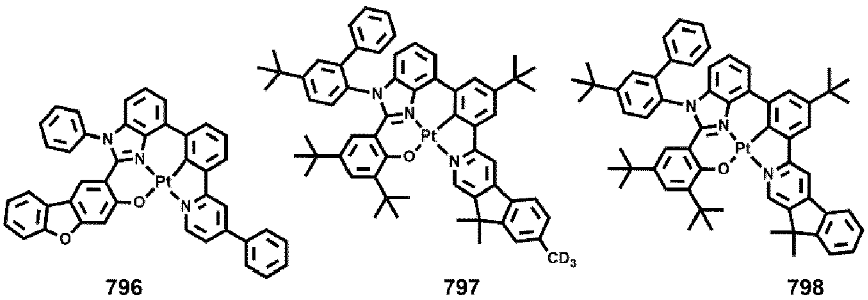

796 797 798

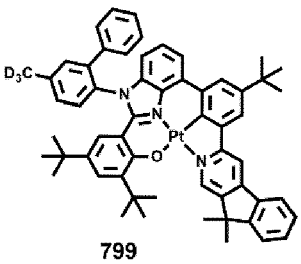

799

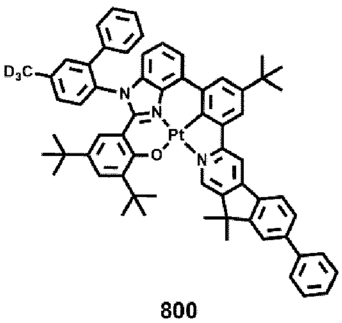

800

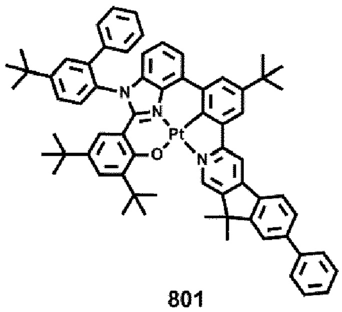

801

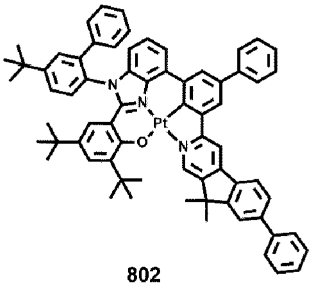

802

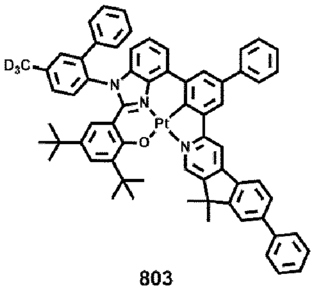

803

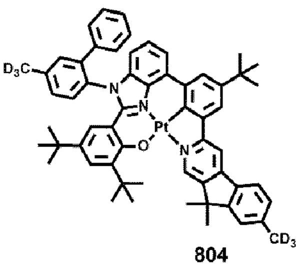

804 .

At least one of ring $CY_1$ to ring $CY_4$ of the organometallic compound represented by Formula 1 may each independently be a condensed cyclic group in which two or more rings are condensed with each other and Formula 1

may satisfy at least one of Condition A to Condition D. As a result, the rigidity of the organometallic compound is increased so that deformation of the molecular structure of the organometallic compound may be reduced. Accordingly, the full width at half maximum (FWHM) in the luminescence spectrum of the organometallic compound is improved, and tau (decay time) may be reduced due to the increase in the CT (charge transfer) characteristics of the organometallic compound.

For example, the highest occupied molecular orbital (HOMO), lowest unoccupied molecular orbital (LUMO), energy band gap, $S_1$, and $T_1$ energy levels of Compounds 1 to 6 are structure-optimized at the (B3LYP, 6-31G(d,p)) level by using the DFT method of the Gaussian program and evaluated. Results thereof are shown in Table 1 below.

Table 1

| Compound No. | HOMO (eV) | LUMO (eV) | Energy band gap (eV) | $S_1$ (eV) | $T_1$ (eV) |
|---|---|---|---|---|---|
| 1 | -4.547 | -1.638 | 2.909 | 2.465 | 2.299 |
| 2 | -4.664 | -1.653 | 3.011 | 2.541 | 2.359 |
| 3 | -4.503 | -1.604 | 2.899 | 2.438 | 2.287 |
| 4 | -4.589 | -1.621 | 2.968 | 2.481 | 2.313 |
| 5 | -4.649 | -1.651 | 2.998 | 2.507 | 2.344 |
| 6 | -4.638 | -1.687 | 2.951 | 2.499 | 2.368 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of organic light-emitting device, for example, a dopant in an emission layer of the organic layer. Thus, another aspect provides an organic light-emitting device including: a first electrode; a second electrode; and an organic layer located between the first electrode and the second electrode and including an emission layer, and the organic layer includes at least one organometallic compound represented by Formula 1.

The organic light-emitting device may have low driving voltage, high external quantum efficiency, a low roll-off ratio, and high lifespan characteristics by having the organic layer including the organometallic compound represented by Formula 1 as described above.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). In an embodiment, the emission layer may emit green light to blue light.

The expression "(an organic layer) includes at least one of organometallic compounds" used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. In this embodiment, Compound 1 may be included in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer may further include a hole transport region located between the first electrode and the emission layer and an electron transport region located between the emission layer and the second electrode, and the hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "organic layer" used herein refers to a single layer and/or a plurality of layers between the first electrode and the second electrode of the organic light-emitting device. The "organic layer" may include, in addition to an organic

compound, an organometallic complex including metal.

FIGURE is a schematic cross-sectional view of an organic light-emitting device 10 according to an embodiment. Hereinafter, the structure and manufacturing method of the organic light-emitting device 10 according to an embodiment of the present disclosure will be described in connection with FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), silver (Ag), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron-blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C.

The conditions for forming the hole transport layer and the electron-blocking layer may be the same as the conditions for forming the hole injection layer.

The hole transport region may include m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or a combination thereof:

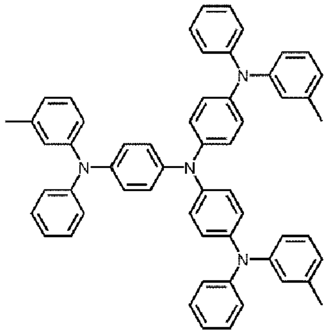

m-MTDATA

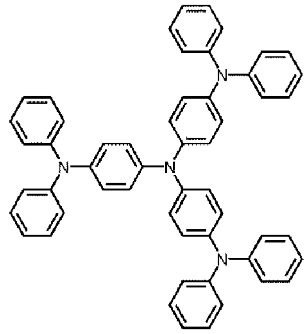

TDATA

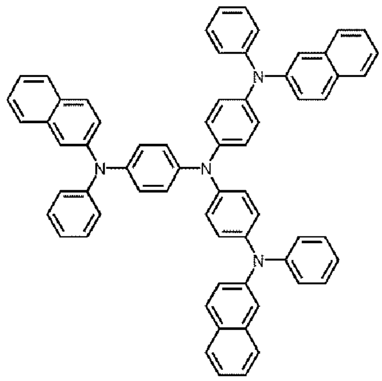

2-TNATA

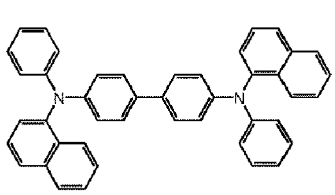

NPB

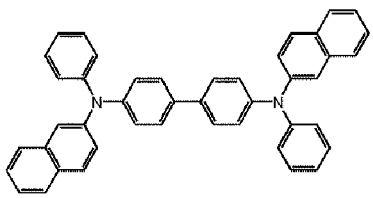

β-NPB

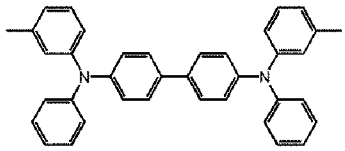

TPD

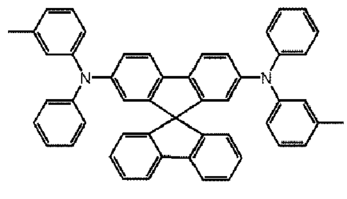

Spiro-TPD

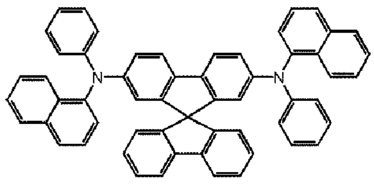

Spiro-NPB

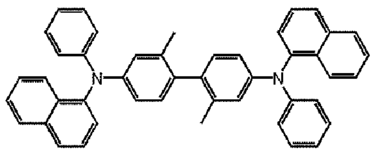

methylated NPB

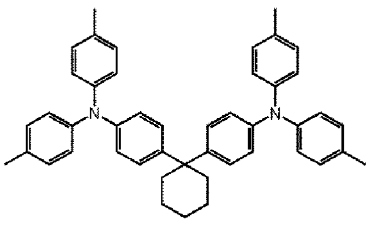

TAPC

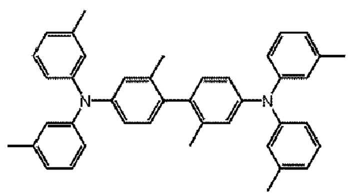

HMTPD

Formula 201

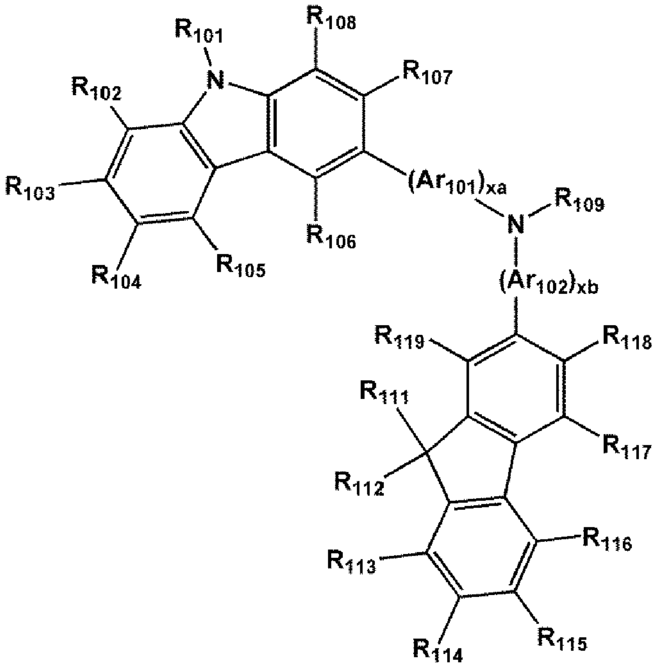

Formula 202

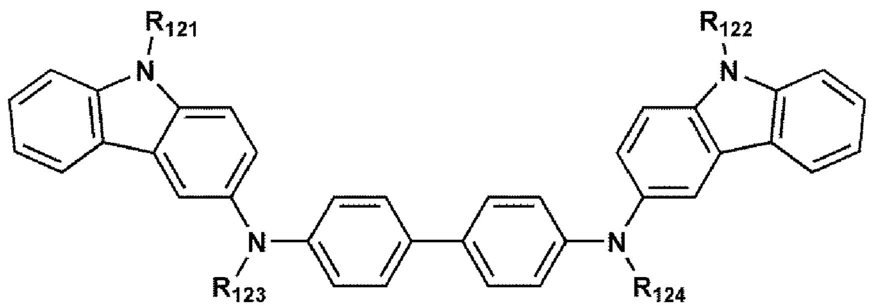

.

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

$R_{101}$ to $R_{108}$, $R_{111}$ to $R_{119}$ and $R_{121}$ to $R_{124}$ in Formulae 201 and 202 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, etc.), or a $C_1$-$C_{10}$ alkoxy group (for example, a methoxy group, an ethoxy group, a propoxy group, a butoxy group, a pentoxy group, etc.);

a $C_1$-$C_{10}$ alkyl group or a $C_1$-$C_{10}$ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or

a phenyl group, a naphthyl group, an anthracenyl group, a fluorenyl group or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or a combination thereof.

$R_{109}$ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C1-$C_{20}$ alkyl group, a $C_1$-$C_{20}$ alkoxy group, a phenyl group, a naphthyl group, an anthracenyl group, a pyridinyl group, or a combination thereof.

In an embodiment, the compound represented by Formula 201 may be represented by Formula 201A:

Formula 201A

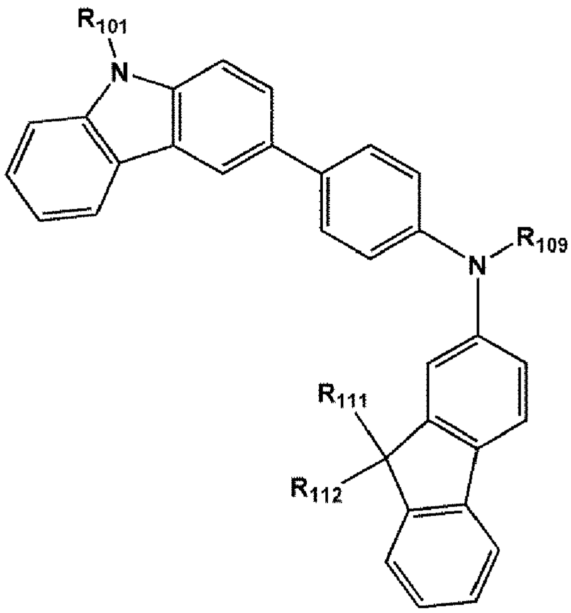

$R_{101}$, $R_{111}$, $R_{112}$, and $R_{109}$ in Formula 201A are each the same as described in the present specification.

For example, the hole transport region may include one of Compounds HT1 to HT20 or a combination thereof:

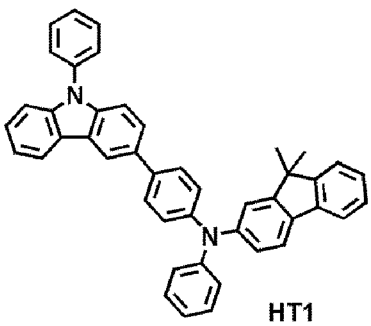

HT1

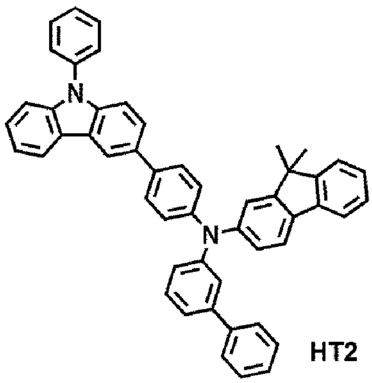

HT2

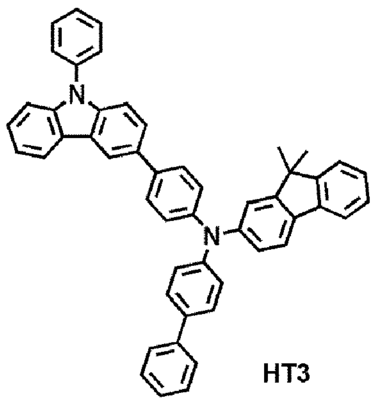

HT3

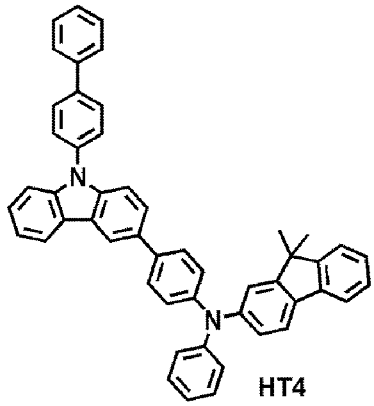

HT4

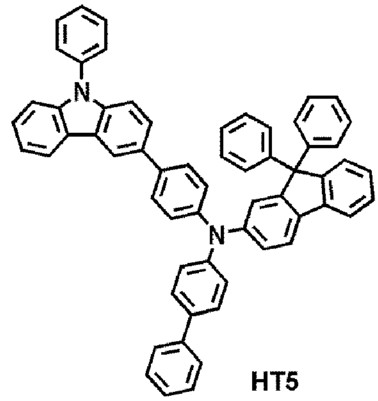

HT5

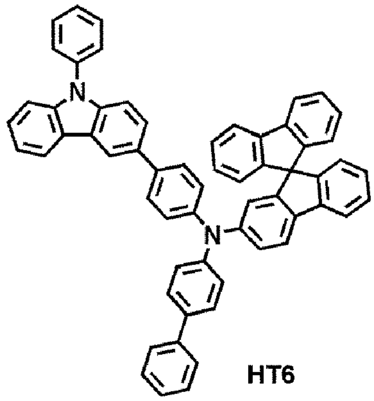

HT6

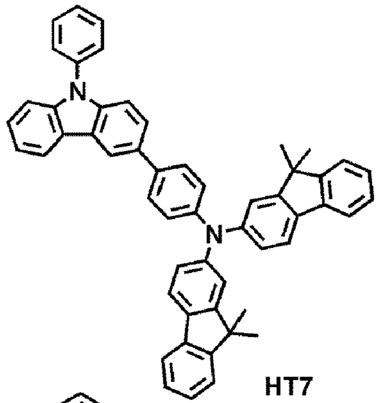

HT7

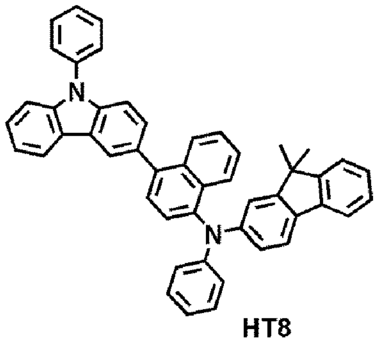

HT8

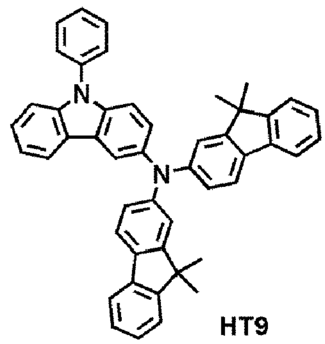

HT9

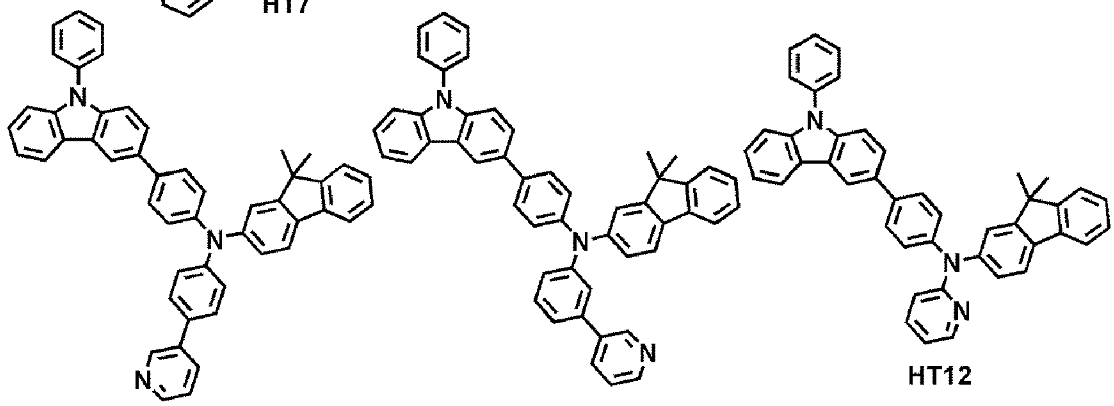

HT10

HT11

HT12

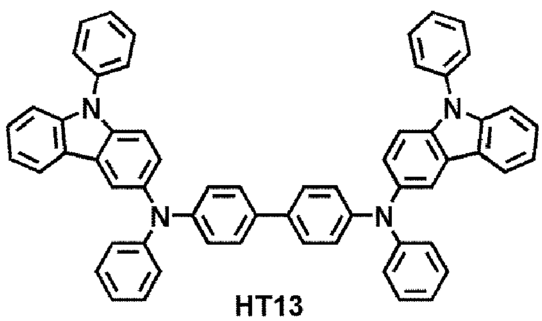

HT13

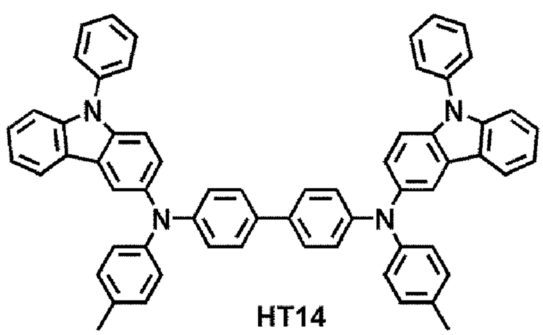

HT14

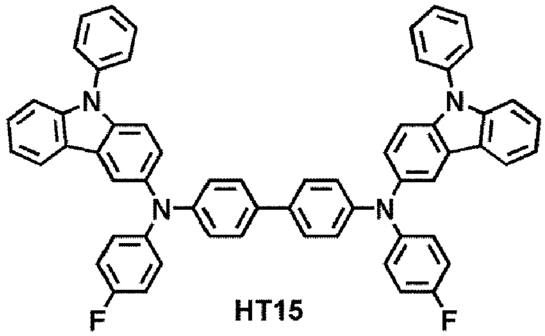
HT15

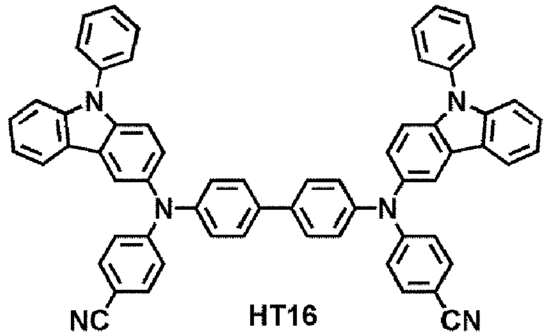
HT16

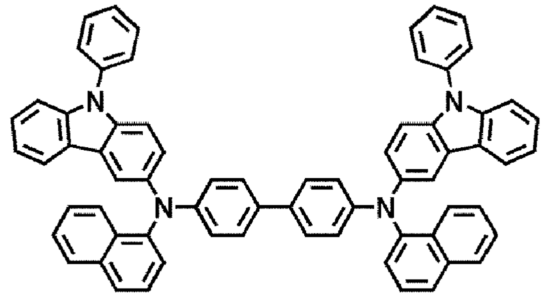
HT17

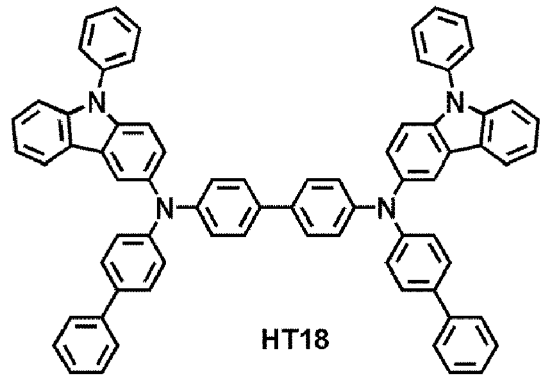
HT18

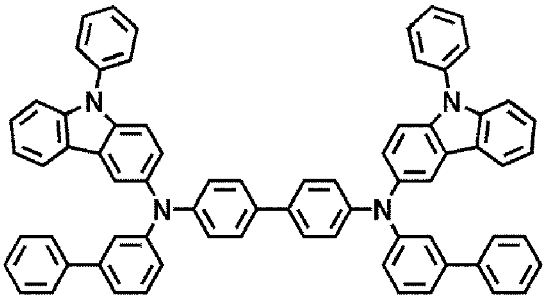
HT19

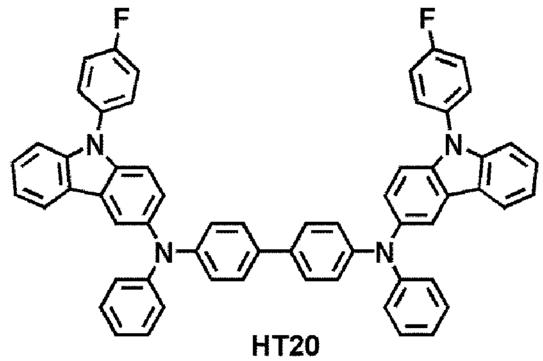
HT20

A thickness of the hole transport region may be in the range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof. For example, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or a combination thereof.

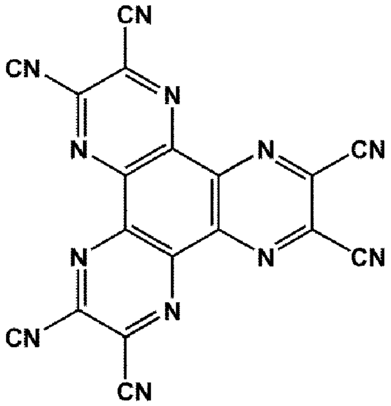

HT-D1

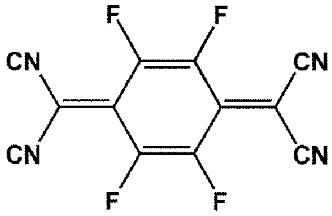

F4-TCNQ

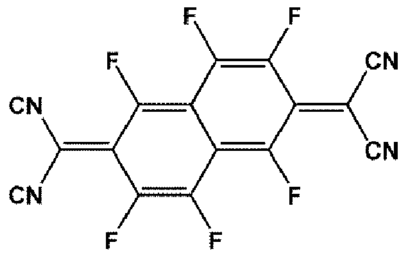

F6-TCNNQ

The hole transport region may include a buffer layer.

The buffer layer may compensate for an optical resonance distance according to a wavelength of light emitted from the emission layer, and thus, efficiency of a formed organic light-emitting device may be improved.

Meanwhile, when the hole transport region includes an electron-blocking layer, a material for forming the electron-blocking layer may include a material that is used in the hole transport region as described above, a host material described below, or a combination thereof. For example, when the hole transport region includes an electron-blocking layer, mCP, or a combination may be used as the material for forming the electron-blocking layer.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1 as described herein.

The host may include TPBi, TBADN, ADN (also referred to as "DNA"), CBP, CDBP, TCP, mCP, Compound H50, Compound H51, Compound H52, or a combination thereof:

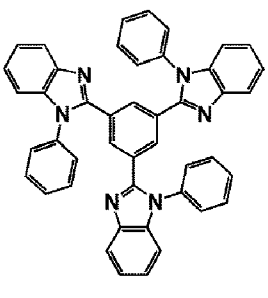

TPBi

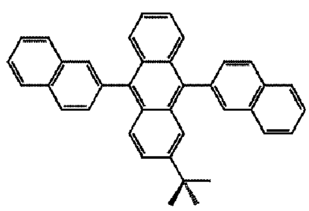

TBADN

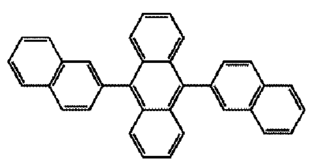

ADN

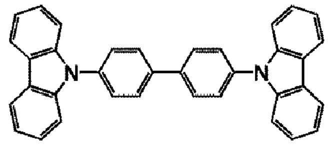
CBP

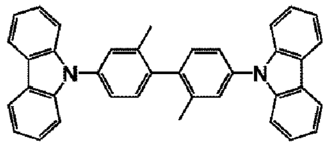
CDBP

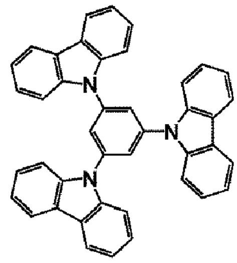
TCP

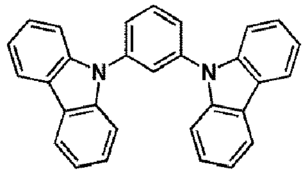
mCP

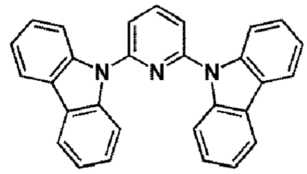
H50

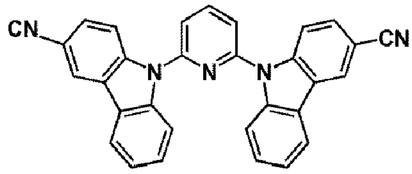
H51

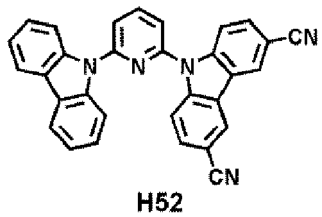
H52

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within these ranges, excellent luminescence characteristics may be obtained without a substantial increase in driving voltage.

An electron transport region may be located on the emission layer.

The electron transport region may include a hole-blocking layer, an electron transport layer, an electron injection layer, or a combination thereof.

For example, the electron transport region may have a hole-blocking layer/electron transport layer/electron injection layer structure or an electron transport layer/electron injection layer structure. The electron transport layer may have a single-layered structure or a multi-layered structure including two or more different materials.

Conditions for forming the hole-blocking layer, the electron transport layer, and the electron injection layer which constitute the electron transport region may be understood by referring to the conditions for forming the hole injection layer.

When the electron transport region includes a hole-blocking layer, the hole-blocking layer may include, for example, BCP, Bphen, BAlq, or a combination thereof:

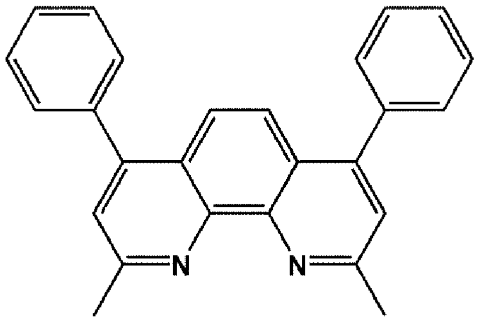

BCP

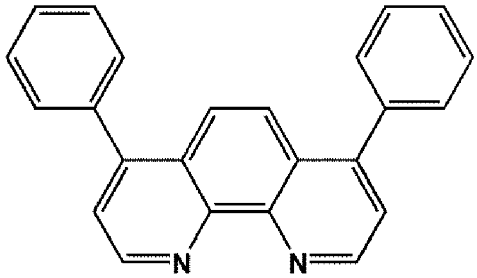

Bphen

A thickness of the hole-blocking layer may be in a range of about 20 Å to about 1,000 Å, for example, about 30 Å to about 600 Å. When the thickness of the hole-blocking layer is within these ranges, excellent hole-blocking characteristics may be obtained without a substantial increase in driving voltage.

The electron transport layer may include BCP, Bphen, TPBi, $Alq_3$, Balq, TAZ, NTAZ, or a combination thereof:

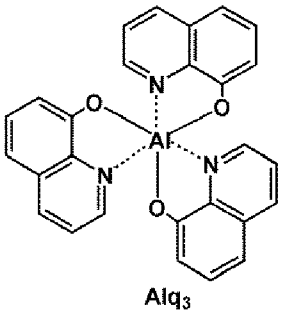

$Alq_3$

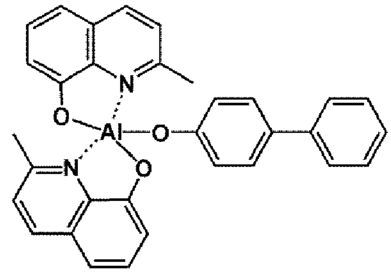

BAlq

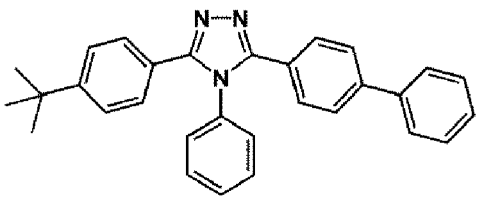

TAZ

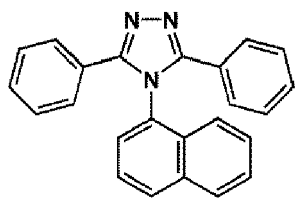

NTAZ

In one or more embodiments, the electron transport layer may include one of Compounds ET1 to ET25 or a combination thereof:

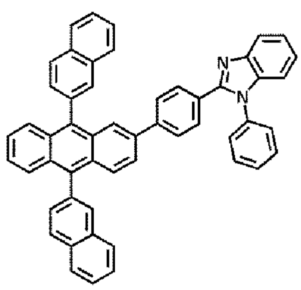

ET1

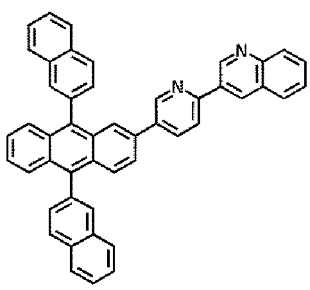

ET2

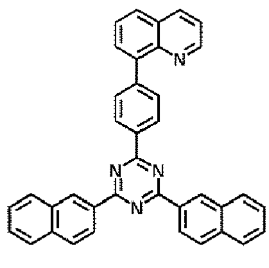

ET3

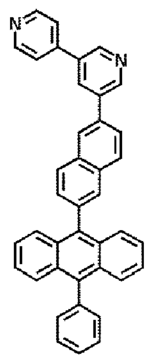

ET4

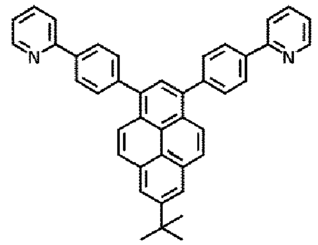

ET5

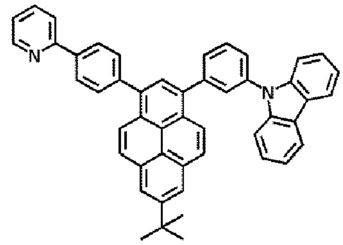

ET6

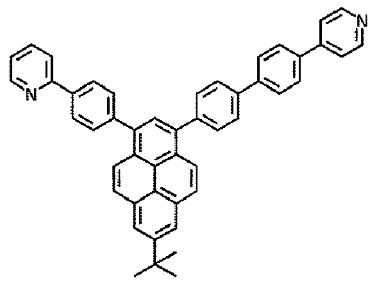

ET7

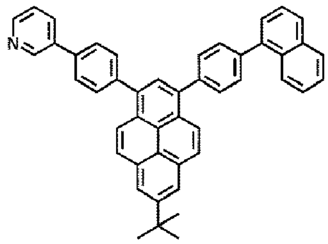

ET8

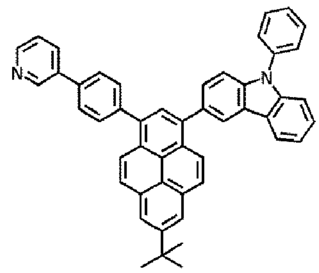

ET9

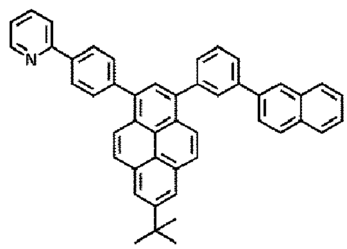

ET10

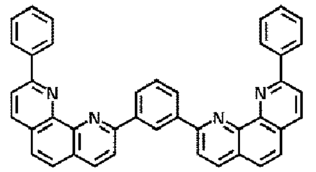

ET11

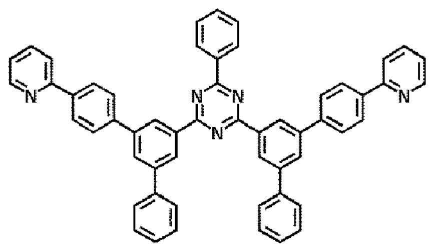

ET12

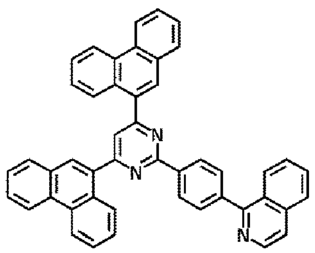

ET13

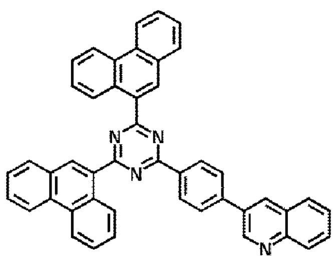

ET14

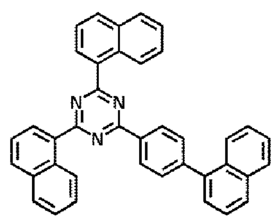

ET15

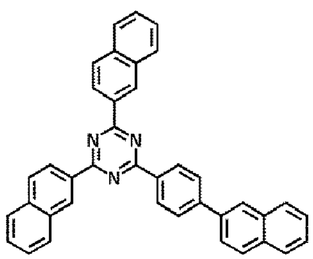

ET16

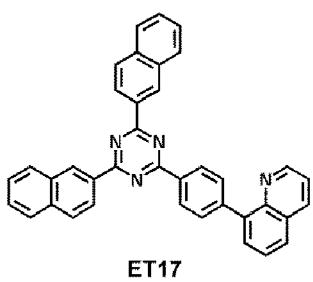

ET17

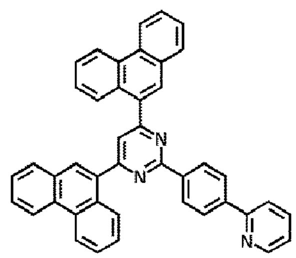

ET18

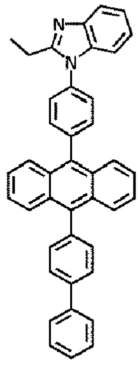
ET19

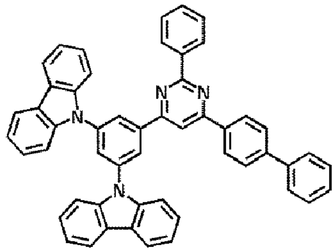
ET20

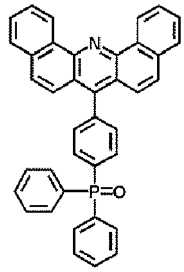
ET21

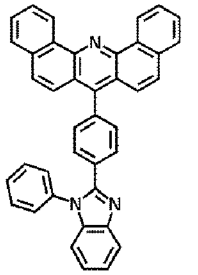
ET22

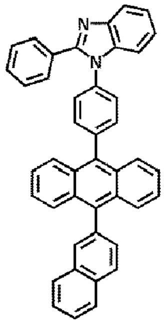
ET23

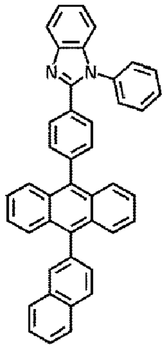
ET24

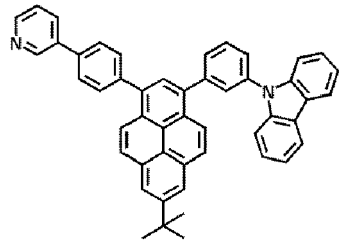
ET25

.

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described above.

The metal-containing material may include a Li complex. The Li complex may include, for example, Compound ET-D1 or ET-D2:

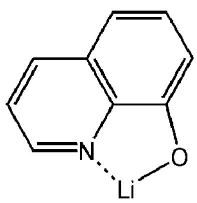
ET-D1

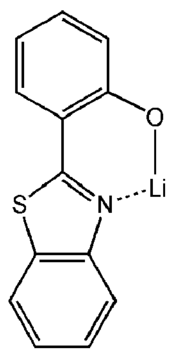
ET-D2

.

The electron transport region may include an electron injection layer that promotes the flow of electrons from the second electrode 19 thereinto.

The electron injection layer may include LiF, NaCl, CsF, $Li_2O$, BaO, or a combination thereof.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), silver (Ag), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIGURE, but embodiments of the present disclosure are not limited thereto.

According to another aspect, the organic light-emitting device may be included in an electronic apparatus. Thus, another aspect provides an electronic apparatus including the organic light-emitting device. The electronic apparatus may include, for example, a display, an illumination, a sensor, and the like.

Another aspect provides a diagnostic composition including at least one organometallic compound represented by Formula 1.

The organometallic compound represented by Formula 1 provides high luminescence efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used here refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" used herein refers to a monovalent group represented by $-OA_{101}$ (wherein $A_{101}$ is the $C_1$-$C_{60}$ alkyl group), and examples thereof are a methoxy group, an ethoxy group, a propoxy group, a butoxy group, and a pentoxy group.

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the $C_3$-$C_{10}$ cycloalkylene group is a divalent group having the same structure as the $C_3$-$C_{10}$ cycloalkyl group.

Examples of the $C_3$-$C_{10}$ cycloalkyl group are a cyclopropyl group, a cyclobutyl group, a cyclopentyl, cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a saturated cyclic group that includes at least one hetero atom selected from N, O, P, Si, S, Se, Ge, and B as a ring-forming atom and 1 to 10 carbon atoms, and the $C_1$-$C_{10}$ heterocycloalkylene group refers to a divalent group having the same structure as the $C_1$-$C_{10}$ heterocycloalkyl group.

Examples of the $C_1$-$C_{10}$ heterocycloalkyl group are a silolanyl group, a silinanyl group, tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to

10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent cyclic group that has at least one hetero atom selected from N, O, P, Si, S, Se, Ge, and B as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The $C_7$-$C_{60}$ alkylaryl group used herein refers to a $C_6$-$C_{60}$ aryl group substituted with at least one $C_1$-$C_{60}$ alkyl group.

The term "$C_1$-$C_{60}$ heteroaryl group" as used herein refers to a monovalent group having at least one hetero atom selected from N, O, P, Si, S, Se, Ge, and B as a ring-forming atom and a cyclic aromatic system having 1 to 60 carbon atoms, and the term "$C_1$-$C_{60}$ heteroarylene group" as used herein refers to a divalent group having at least one hetero atom selected from N, O, P, Si, S, Se, Ge, and B as a ring-forming atom and a carbocyclic aromatic system having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The $C_2$-$C_{60}$ alkylheteroaryl group used herein refers to a $C_1$-$C_{60}$ heteroaryl group substituted with at least one $C_1$-$C_{60}$ alkyl group.

The term "$C_6$-$C_{60}$ aryloxy group" as used herein indicates $-OA_{102}$ (wherein $A_{102}$ indicates the $C_6$-$C_{60}$ aryl group), the $C_6$-$C_{60}$ arylthio group indicates $-SA_{103}$ (wherein $A_{103}$ indicates the $C_6$-$C_{60}$ aryl group), and the $C_1$-$C_{60}$ alkylthio group indicates $-SA_{104}$ (wherein $A_{104}$ indicates the $C_1$-$C_{60}$ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, a heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as a monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, Se, Ge, B, and S other than 1 to 30 carbon atoms. The $C_1$-$C_{30}$ heterocyclic group may be a monocyclic group or a polycyclic group. The "$C_1$-$C_{30}$ heterocyclic group (unsubstituted or substituted with at least one $R_{10a}$)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an

azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (, each unsubstituted or substituted with at least one $R_{10a}$).

The terms "fluorinated $C_1$-$C_{60}$ alkyl group (or a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group (-F). For example, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or, a fluorinated $C_1$-$C_{20}$ alkyl group, or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group, or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen included therein is not substituted with a fluoro group.

The terms "deuterated $C_1$-$C_{60}$ alkyl group (or a deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, the deuterated methyl group)" may include - $CD_3$, $-CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl) 'X' group" as used herein refers to a 'X' group that is substituted with at least one $C_1$-$C_{20}$ alkyl group. For example, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of a ($C_1$ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon of ring-forming carbons is substituted with nitrogen.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkylaryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl het-

eroaryl group, the substituted monovalent non-aromatic condensed polycyclic group, and the substituted monovalent non-aromatic condensed heteropolycyclic group may each independently be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, - $N(Q_{11})(Q_{12})$, $-Si(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a C1-C60 heteroaryl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, -B(Q26)(Q27), $-P(=O)(Q_{28})(Q_{29})$, -P(Q28)(Q29), or a combination thereof;
$-N(Q_{31})(Q_{32})$, -Si(Q33)(Q34)(Q35), -B(Q36)(Q37), $-P(=O)(Q_{36})(Q_{39})$, or - $P(Q_{36})(Q_{39})$; or
a combination thereof.
$Q_1$ to $Q_9$, $Q_{11}$ to $Q_{19}$, $Q_{21}$ to $Q_{29}$, and $Q_{31}$ to $Q_{39}$ described herein may each independently be: hydrogen; deuterium; -F; -Cl; -Br; -I; a hydroxyl group; a cyano group; a nitro group; an amidino group; a hydrazine group; a hydrazone group; a carboxylic acid or a salt thereof; a sulfonic acid or a salt thereof; a phosphoric acid or a salt thereof; a $C_1$-$C_{60}$ alkyl group which is unsubstituted or substituted with deuterium, -F, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group which is unsubstituted or substituted with deuterium, -F, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$ and $Q_{31}$ to $Q_{39}$ described herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

[Examples]

Synthesis Example 1 (Compound 202)

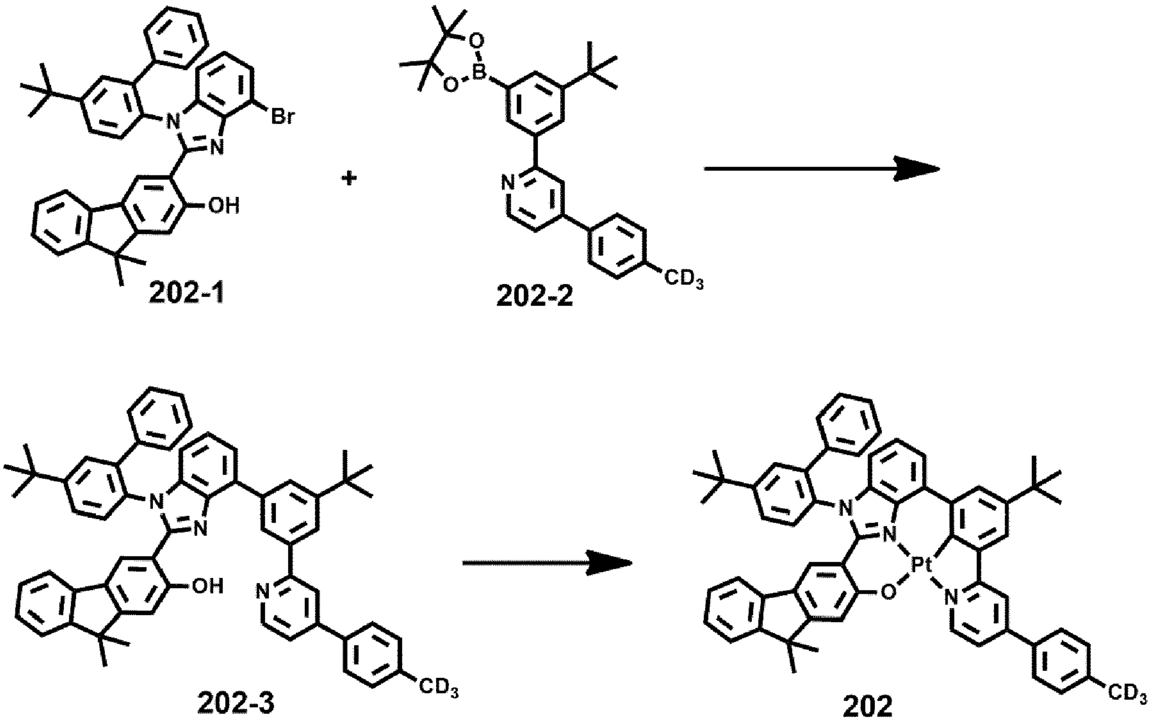

202-1 202-2 202-3 202

Synthesis of Intermediate 202-3 (3-(4-(3-(tert-butyl)-5-(4-(4-(methyl-d3)phenyl)pyridin-2-yl)phenyl)-1-(5-(tert-butyl)-[1,1'-biphenyl]-2-yl)-1H-benzo[d]imidazol-2-yl)-9,9-dimethyl-9H-fluoren-2-ol)

2.0 g (0.003 mol, 1.0 equiv.) of Intermediate 202-1 (3-(4-bromo-1-(5-(tert-butyl)-[1,1'-biphenyl]-2-yl)-1H-benzo[d]imidazol-2-yl)-9,9-dimethyl-9H-fluoren-2-ol), 1.5 g (0.004 mol, 1.1 equiv.) of Intermediate 202-2 (2-(3-(tert-butyl)-5-(4,4,5,5-tetramethyl-1,3,2-dioxaborolan-2-yl)phenyl)-4-(4-(methyl-d3)phenyl)pyridine), 0.26 g (0.00021 mol, 0.07 equiv.) of Tetrakis(triphenylphosphine)palladium (0) and 1.4 g (0.010 mol, 3 equiv.) of potassium carbonate were mixed with 40 mL of a mixture in which tetrahydrofuran (THF) and distilled water ($H_2O$) were mixed at a volumetric ratio of 3:1, and then, refluxed for 12 hours. The obtained result was cooled to room temperature, and then, the precipitate was removed therefrom to obtain a filtrate. The filtrate was washed with ethyl acetate (EA)/$H_2O$, and column chromatography (EA and hexane (Hex) were used as eluents) was performed thereon to complete the production of 2.3 g (yield of 84%) of Intermediate 202-3. The obtained material was identified through mass spectrum and HPLC analysis.

HRMS(MALDI) calcd for $C_{60}H_{52}D_3N_3O$: m/z836.4533, Found: 836.4535 Synthesis of Compound 202

2.3 g (2.75 mmol) of Intermediate 202-3 and 1.37 g (3.30 mmol, 1.2 equiv.) of $K_2PtCl_4$ were mixed with 40 mL of a mixture in which 30 mL of AcOH (acetic acid) was mixed with 10 mL of $H_2O$, and then, the resultant mixture was refluxed for 16 hours. The temperature of the resulting product was cooled to room temperature, and then, the precipitate was filtered and then the obtained precipitate was dissolved in methylene chloride (MC) and washed with $H_2O$, and then, column chromatography (10% to 35% MC, 65% to 90% Hex) was performed thereon to obtain 1.7 g (yield of 60%) of Compound 202. The obtained material was identified through mass spectrum and HPLC analysis.

HRMS(MALDI) calcd for $C_{60}H_{50}D_3N_3OPt$: m/z 1029.4025, Found: 1029.4028

Synthesis Example 2 (Compound 177)

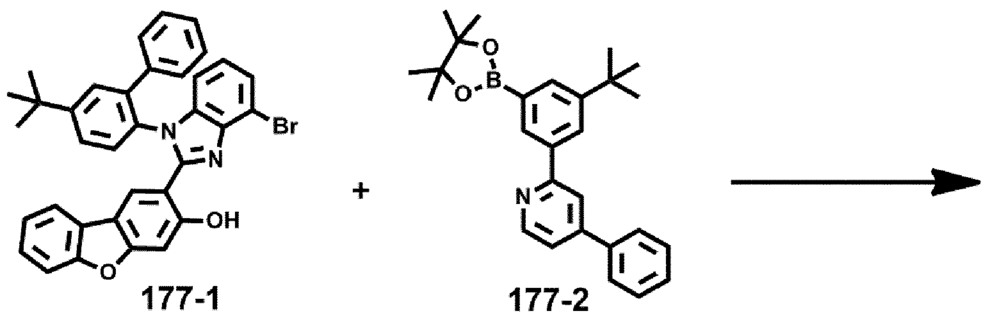

177-1 177-2

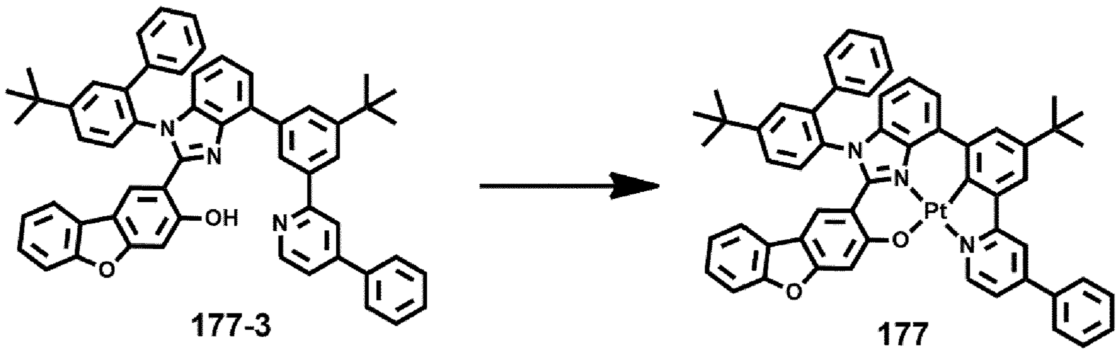

177-3 177

Synthesis of Intermediate 177-3 (2-(4-(3-(tert-butyl)-5-(4-phenylpyridin-2-yl)phenyl)-1-(5-(tert-butyl)-[1,1'-biphenyl]-2-yl)-1H-benzo[d]imidazol-2-yl)dibenzo[b,d]furan-3-ol)

2.0 g (0.003 mol, 1.0 equiv.) of Intermediate 177-1 (2-(4-bromo-1-(5-(tert-butyl)-[1,1'-biphenyl]-2-yl)-1H-benzo[d]imidazol-2-yl)dibenzo[b,d]furan-3-ol), 1.55 g (0.004 mol, 1.1 equiv.) of Intermediate 177-2 (2-(3-(tert-butyl)-5-(4,4,5,5-tetramethyl-1,3,2-dioxaborolan-2-yl)phenyl)-4-phenylpyridine), 0.28 g (0.00021 mol, 0.07 equiv.) of Tetrakis(triphenylphosphine)palladium (0) and 1.4 g (0.010 mol, 3 equiv.) of potassium carbonate were mixed with 40 mL of a mixture in which THF and distilled water ($H_2O$) were mixed at a volumetric ratio of 3:1, and then, refluxed for 12 hours. The obtained result was cooled to room temperature, and then, the precipitate was removed therefrom to obtain a filtrate. The filtrate was washed with EA/$H_2O$, and column chromatography (EA and Hex were used as eluents) was performed thereon to complete the production of 2.1 g (yield of 78%) of Intermediate 177-3. The obtained material was identified through mass spectrum and HPLC analysis.

HRMS(MALDI) calcd for $C_{56}H_{47}N_3O_2$: m/z 793.3668, Found: 793.3664 Synthesis of Compound 177

1.32 g (3.18 mmol, 1.2 equiv.) of Intermediate 177-3 and 2.1g (2.65mmol) of $K_2PtCl_4$ was mixed with 40 mL of a mixture in which 30 mL of AcOH was mixed with 10 mL of $H_2O$, and then, the resultant mixture was refluxed for 16 hours. The temperature of the resulting product was cooled to room temperature, and then, the precipitate was filtered and then the obtained precipitate was dissolved in MC and washed with $H_2O$, and then, column chromatography (10% to 35% MC, 65% to 90% Hex) was performed thereon to obtain 1.5 g (yield of 57%) of Compound 177. The obtained material was identified through mass spectrum and HPLC analysis.

HRMS(MALDI) calcd for $C_{56}H_{45}N_3O_2Pt$ : m/z 986.3160, Found: 986.3162 Synthesis Example 3 (Compound 225)

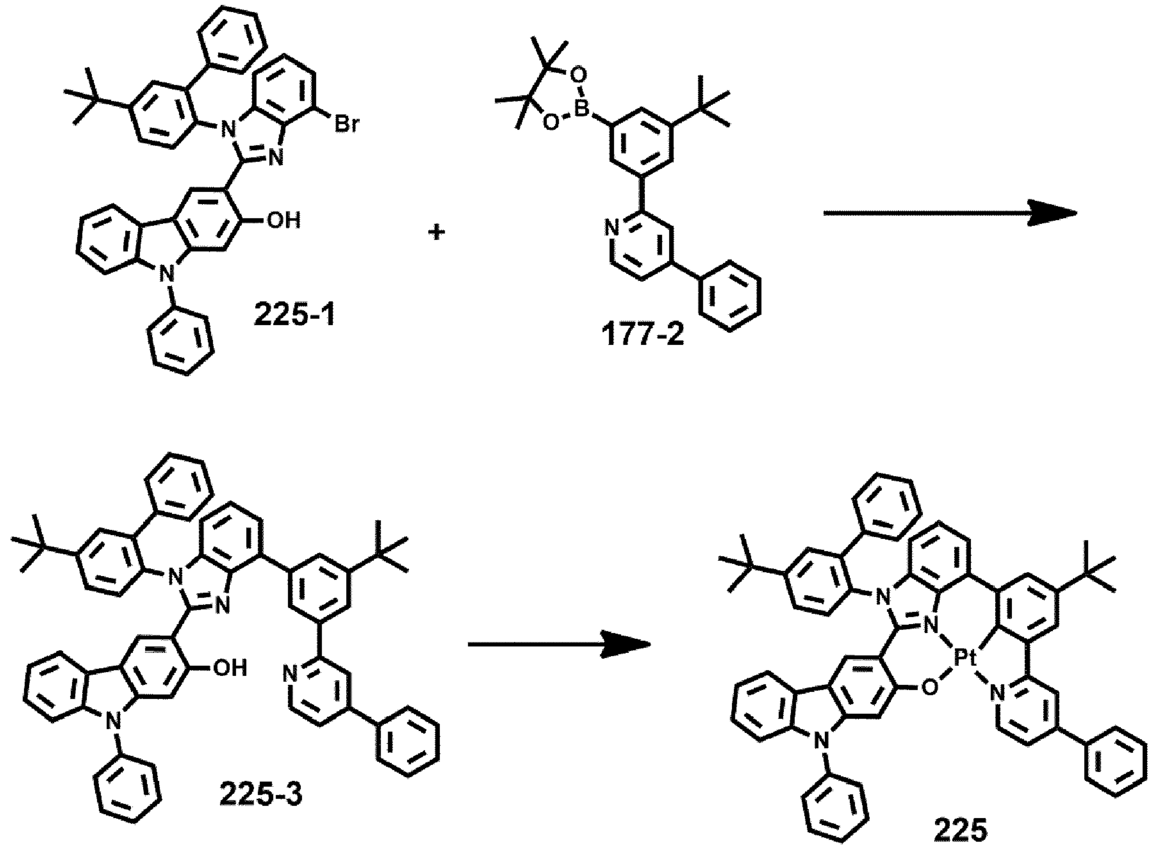

225-1 177-2 225-3 225

Synthesis of Intermediate 225-3 (3-(4-(3-(tert-butyl)-5-(4-phenylpyridin-2-yl)phenyl)-1-(5-(tert-butyl)-[1,1'-biphenyl]-2-yl)-1H-benzo[d]imidazol-2-yl)-9-phenyl-9H-carbazol-2-ol)

2.0 g (0.003 mol, 1.0 equiv.) of Intermediate 225-1 (3-(4-bromo-1-(5-(tert-butyl)-[1,1'-biphenyl]-2-yl)-1H-benzo[d]imidazol-2-yl)-9-phenyl-9H-carbazol-2-ol), 1.37 g (0.003 mol, 1.0 equiv.) of Intermediate 177-2, 0.24 g (0.00021 mol, 0.07 equiv.) of Tetrakis(triphenylphosphine)palladium (0) and 1.3 g (0.010 mol, 3 equiv.) of Potassium carbonate were mixed with 40 mL of a mixture in which THF and distilled water ($H_2O$) were mixed at a volumetric ratio of 3:1, and then, refluxed for 12 hours. The obtained result was cooled to room temperature, and then, the precipitate was removed therefrom to obtain a filtrate. The filtrate was washed with EA/$H_2O$, and column chromatography (EA and Hex were used as eluents) was performed thereon to complete the production of 2.1 g (yield of 80%) of Intermediate 225-3. The obtained material was identified through mass spectrum and HPLC analysis.

HRMS(MALDI) calcd for $C_{62}H_{52}N_4O$: m/z 868.4141, Found: 868.4143 Synthesis of Compound 225

2.1 g (2.42 mmol) of Intermediate 225-3 and 1.2 g (2.90 mmol, 1.2 equiv.) of $K_2PtCl_4$ was mixed with 40 mL of a mixture in which 30 mL of AcOH was mixed with 10 mL of $H_2O$, and then, the resultant mixture was refluxed for 16 hours. The temperature of the resulting product was cooled to room temperature, and then, the precipitate was filtered and then the obtained precipitate was dissolved in MC and washed with $H_2O$, and then, column chromatography (10% to 35% MC, 65% to 90% Hex) was performed thereon to obtain 1.3 g (yield of 51%) of Compound 225. The obtained material was identified through mass spectrum and HPLC analysis.

HRMS(MALDI) calcd for $C_{62}H_{50}N_4OPt$ : m/z 1061.3632, Found: 1061.3635 Synthesis Example 4 (Compound 17)

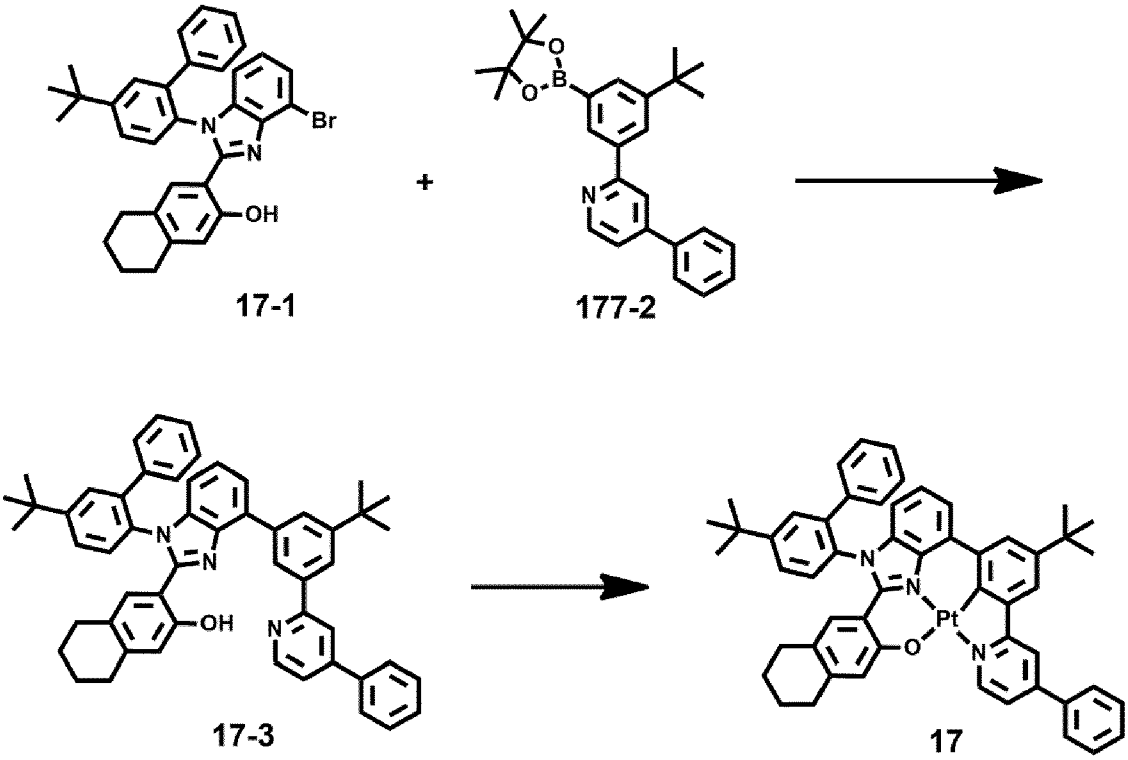

17-1 + 177-2

17-3

17

Synthesis of Intermediate 17-3 (3-(4-(3-(tert-butyl)-5-(4-phenylpyridin-2-yl)phenyl)-1-(5-(tert-butyl)-[1,1'-biphenyl]-2-yl)-1H-benzo[d]imidazol-2-yl)-5,6,7,8-tetrahydronaphthalen-2-ol)

Intermediate 17-3 (1.8 g, yield of 78%) was synthesized in the same manner as used to obtain Intermediate 177-3 of the Synthesis Example 2, except that Intermediate 17-1 ((3-(4-bromo-1-(5-(tert-butyl)-[1,1'-biphenyl]-2-yl)-1H-benzo[d]imidazol-2-yl)-5,6,7,8-tetrahydronaphthalen-2-ol) was used instead of Intermediate 177-1. The obtained material was identified through mass spectrum and HPLC analysis.

HRMS(MALDI) calcd for $C_{54}H_{51}N_3O$: m/z 757.4032, Found: 757.4033 Synthesis of Compound 17

Compound 17 (1.4 g, yield of 56%) was synthesized in the same manner as used to obtain Compound 177 of Synthesis Example 2, except that Intermediate 17-3 was used instead of Intermediate 177-3. The obtained material was identified through mass spectrum and HPLC analysis.

HRMS(MALDI) calcd for $C_{54}H_{49}N_3OPt$ : m/z 950.3523, Found: 950.3521 Synthesis Example 5 (Compound 69)

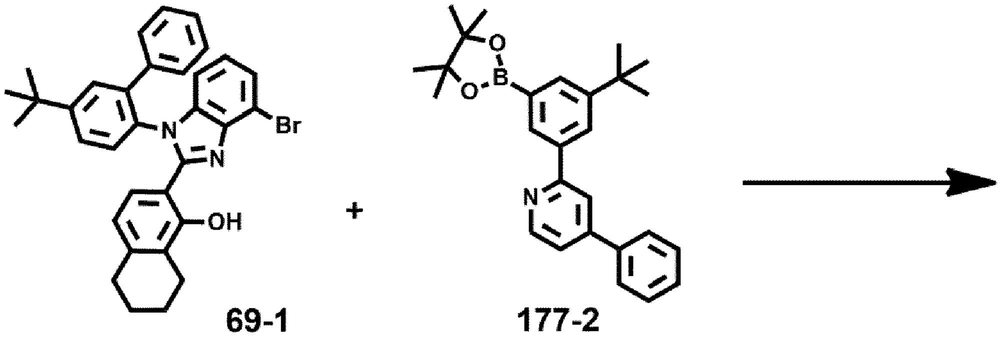

69-1 + 177-2

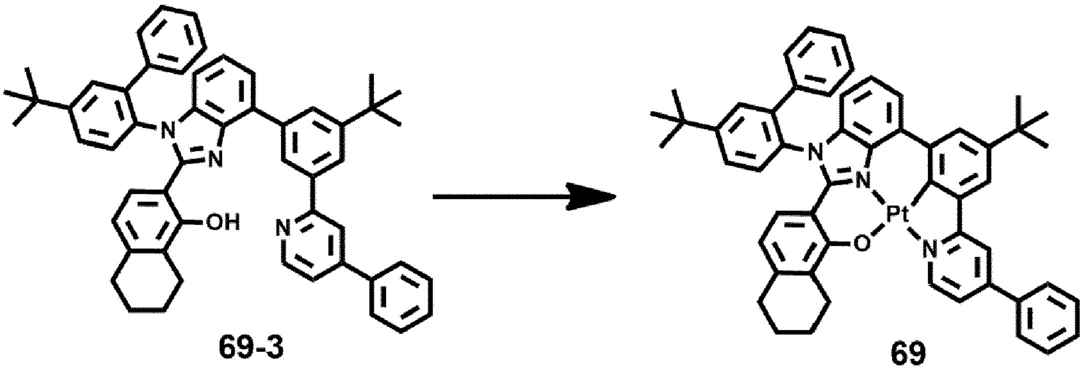

69-3 69

Synthesis of Intermediate 69-3 (2-(4-(3-(tert-butyl)-5-(4-phenylpyridin-2-yl)phenyl)-1-(5-(tert-butyl)-[1,1'-biphenyl]-2-yl)-1H-benzo[d]imidazol-2-yl)-5,6,7,8-tetrahydronaphthalen-1-ol)

Intermediate 69-3 (1.6 g, yield of 81%) was synthesized in the same manner as used to obtain Intermediate 177-3 of Synthesis Example 2, except that Intermediate 69-1 (2-(4-bromo-1-(5-(tert-butyl)-[1,1'-biphenyl]-2-yl)-1H-benzo[d]imidazol-2-yl)-5,6,7,8-tetrahydronaphthalen-1-ol) was used instead of Intermediate 177-1. The obtained material was identified through mass spectrum and HPLC analysis.

HRMS(MALDI) calcd for $C_{54}H_{51}N_3O$: m/z 757.4032, Found: 757.4031 Synthesis of Compound 69

Compound 69 (1.2 g, yield of 54%) was synthesized in the same manner as used to obtain Compound 177 of Synthesis Example 2, except that Intermediate 69-3 was used instead of Intermediate 177-3. The obtained material was identified through mass spectrum and HPLC analysis.

HRMS(MALDI) calcd for $C_{54}H_{49}N_3OPt$ : m/z 950.3523, Found: 950.3525 Synthesis Example 6 (Compound 154)

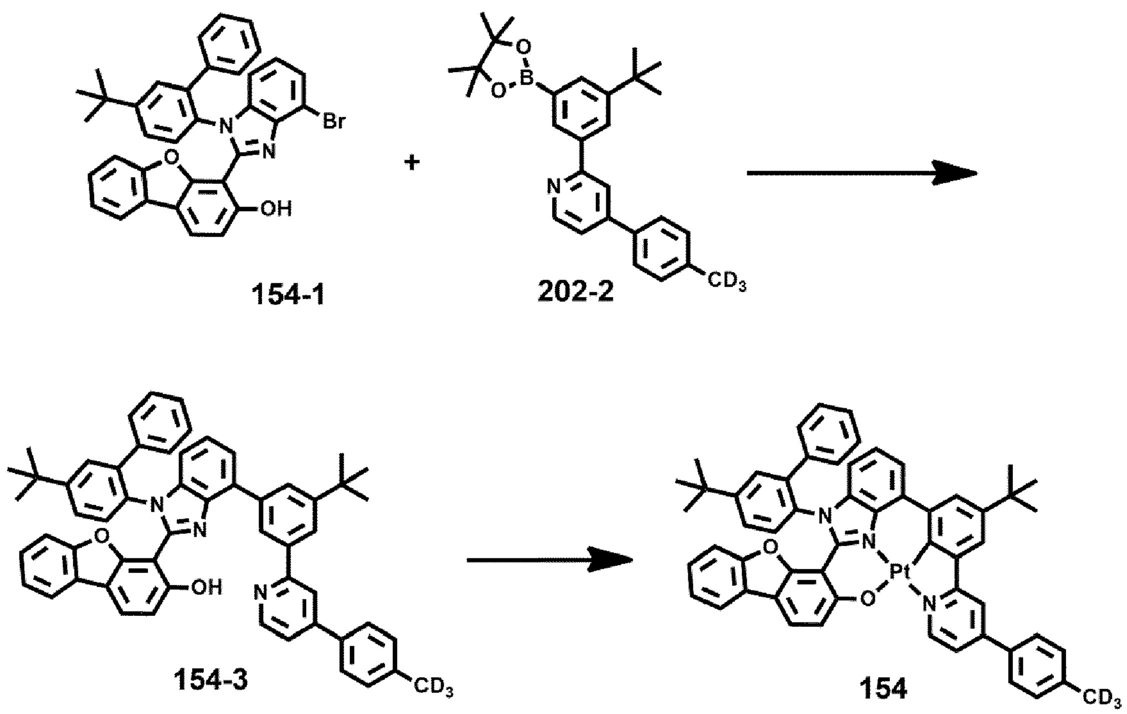

154-1 202-2

154-3 154

Synthesis of Intermediate 154-3 (4-(4-(3-(tert-butyl)-5-(4-phenylpyridin-2-yl)phenyl)-1-(5-(tert-butyl)-[1,1'-biphenyl]-2-yl)-1H-benzo[d]imidazol-2-yl)dibenzo[b,d]furan-3-ol)

Intermediate 154-3 (2.1 g, yield of 83%) was synthesized in the same manner as used to obtain Intermediate 202-3 of Synthesis Example 1, except that Intermediate 154-1 (4-(4-bromo-1-(5-(tert-butyl)-[1,1'-biphenyl]-2-yl)-1H-benzo[d]imidazol-2-yl)dibenzo[b,d]furan-3-ol) was used instead of Intermediate 202-1. The obtained material was identified through mass spectrum and HPLC analysis.

HRMS(MALDI) calcd for $C_{56}H_{47}N_3O_2$: m/z 793.3668, Found: 793.3669 Synthesis of Compound 154

Compound 154 (1.5 g, yield of 53%) was synthesized in the same manner as used to obtain Compound 202 of Synthesis Example 1, except that Intermediate 154-3 (2.11 mmol) was used instead of Intermediate 202-3. The obtained material was identified through mass spectrum and HPLC analysis.

HRMS(MALDI) calcd for $C_{57}H_{44}D_3N_3O_2Pt$ : m/z 1003.3504, Found: 1003.3507 Synthesis Example 7 (Compound 796)

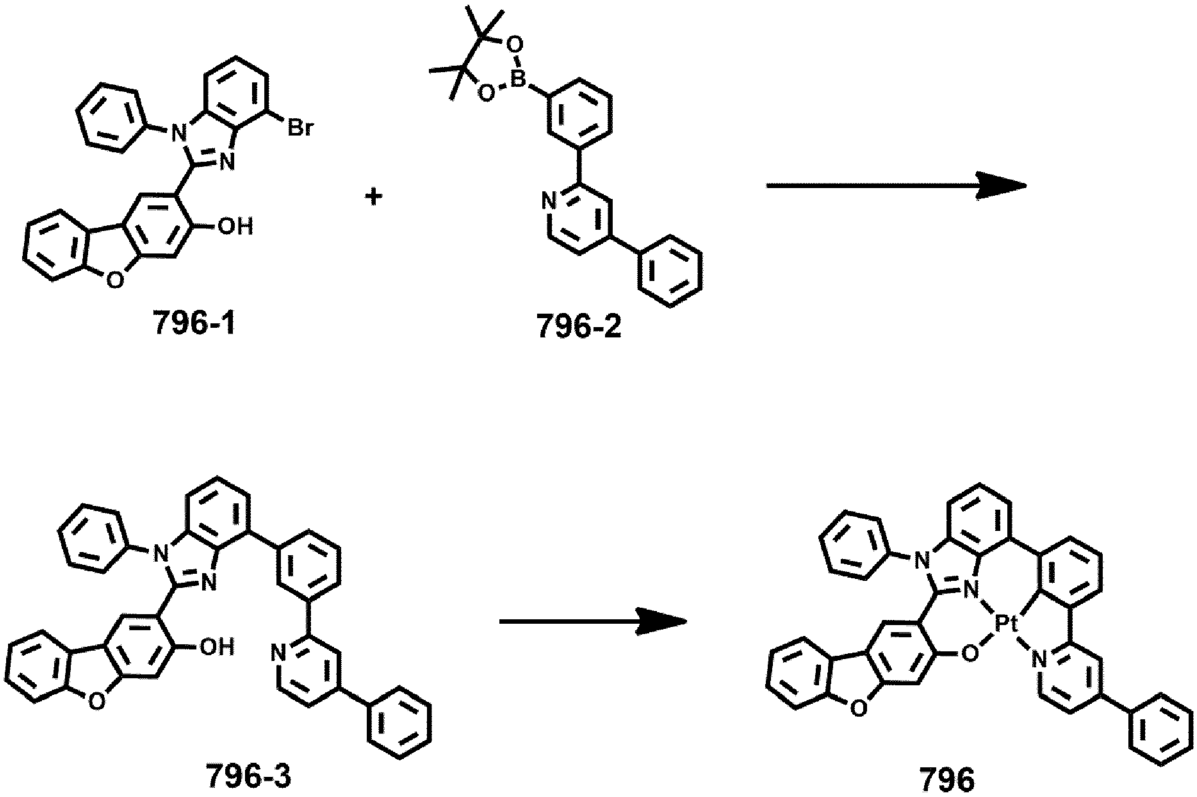

796-1 796-2 796-3 796

Synthesis of Intermediate 796-3

Intermediate 796-3 (2.34 g, yield of 88%) was synthesized in the same manner as used to obtain Intermediate 202-3 of Synthesis Example 1, except that Intermediate 796-1 and Intermediate 796-2 were used instead of Intermediate 202-1 and Intermediate 202-2, respectively. The obtained material was identified through mass spectrum and HPLC analysis.

HRMS(MALDI) calcd for $C_{42}H_{27}N_3O_2$: m/z 605.2103, Found: 605.2105

Synthesis of Compound 796

Compound 796 (1.20 g, yield of 39%) was synthesized in the same manner as used to obtain Compound 202 of Synthesis Example 1, except that Intermediate 796-3 was used instead of Intermediate 202-3. The obtained material was identified through mass spectrum and HPLC analysis.

HRMS(MALDI) calcd for $C_{42}H_{25}N_3O_2Pt$: m/z 798.1595, Found: 798.1596 Synthesis Example 8 (Compound 3)

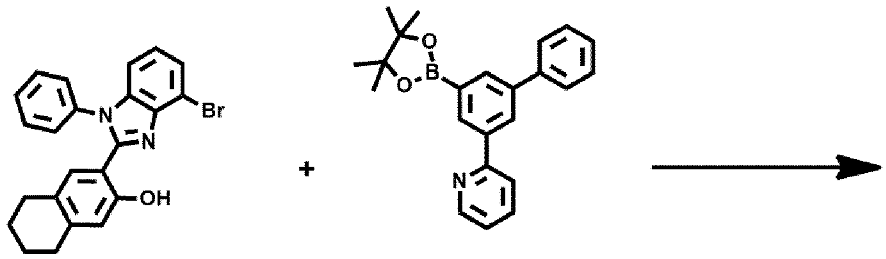

3-1 3-2

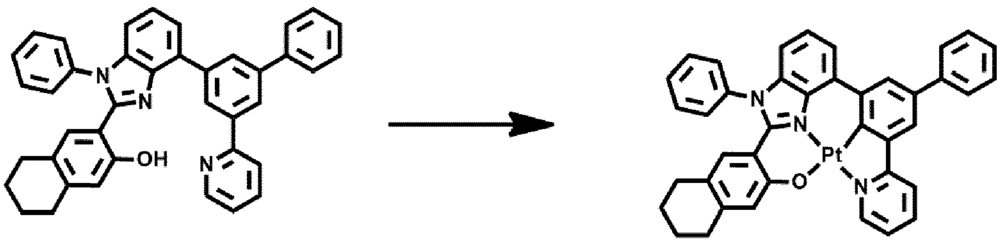

3-3 3

Synthesis of Intermediate 3-3

Intermediate 3-3 (2.42 g, yield of 89%) was synthesized in the same manner as used to obtain Intermediate 202-3 of Synthesis Example 1, except that Intermediate 3-1 and Intermediate 3-2 were used instead of Intermediate 202-1 and Intermediate 202-2, respectively. The obtained material was identified through mass spectrum and HPLC analysis.

HRMS(MALDI) calcd for $C_{40}H_{31}N_3O$: m/z 569.2467, Found: 569.2465 Synthesis of Compound 3

Compound 3 (1.36 g, yield of 42%) was synthesized in the same manner as used to obtain Compound 202 of Synthesis Example 1, except that Intermediate 3-3 was used instead of Intermediate 202-3. The obtained material was identified through mass spectrum and HPLC analysis.

HRMS(MALDI) calcd for $C_{40}H_{29}N_3OPt$: m/z 762.1958, Found: 762.1955

Synthesis Example 9 (Compound 797)

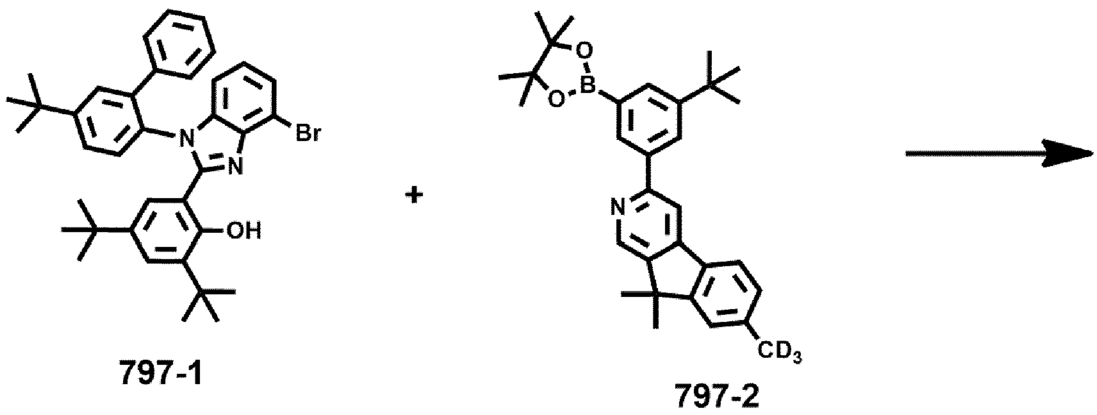

797-1 + 797-2

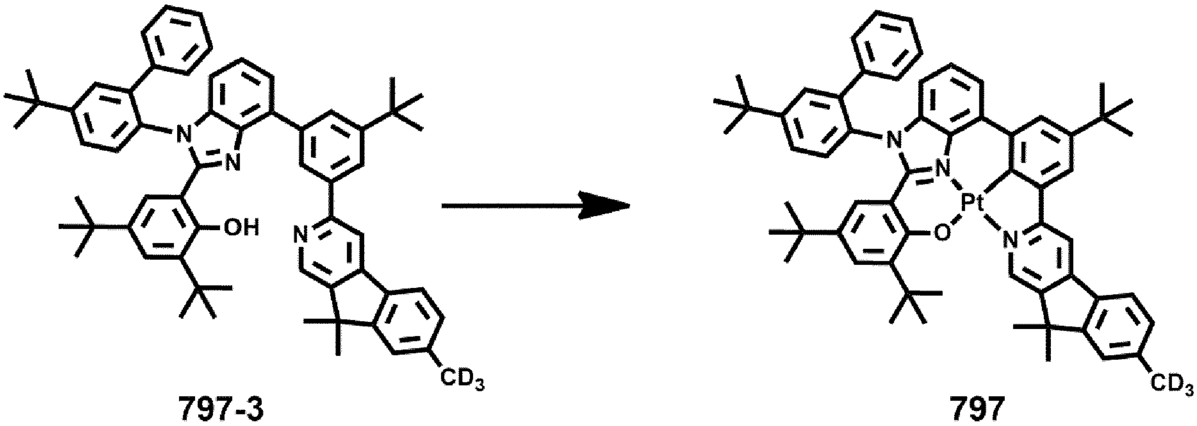

797-3 797

Synthesis of Intermediate 797-3

Intermediate 797-3 was synthesized in the same manner as used to obtain Intermediate 202-3 of Synthesis Example 1, except that Intermediate 797-1 and Intermediate 797-2 were used instead of Intermediate 202-1 and Intermediate 202-2, respectively. The obtained material was identified through mass spectrum and HPLC analysis.

Synthesis of Compound 797

Compound 797 (1.0 g, yield of 48%) was synthesized in the same manner as used to obtain Compound 202 of Synthesis Example 1, except that Intermediate 797-3 was used instead of Intermediate 202-3. The obtained material was identified through mass spectrum and HPLC analysis.

HRMS(MALDI) calcd for $C_{62}H_{62}D_3N_3OPt$ : m/z 1065.4964, Found: 1065.4967 Evaluation Example 1: Evaluation of luminescence quantum efficiency (PLQY) and radiative decay rate.

CBP and Compound 202 were co-deposited at a vacuum of $10^{-7}$ torr at a weight ratio of 9:1 to produce a film with a thickness of 40 nm.

The PLQY of the film was evaluated by using a Hamamatsu Photonics absolute PL quantum yield measurement system equipped with a xenon light source, a monochromator, a photonic multichannel analyzer, and an integrating sphere, and using PLQY measurement software (Hamamatsu Photonics, Ltd., Shizuoka, Japan) to identify the PLQY in film of Compound 202. Results thereof are shown in Table 2.

Next, the PL spectrum of the film was evaluated at room temperature using FluoTime 300, a TRPL measurement system of PicoQuant, and PLS340, a pumping source of PicoQuant (excitation wavelength = 340 nanometers, spectral width = 20 nanometers), and then, the wavelength of the main peak of the spectrum was determined. Then, the number of photons emitted from the film at the wavelength of the main peak by the photon pulse (pulse width = 500 picosecond) which was applied to the film by the PLS340, was repeatedly measured over time based on time-correlated single photon counting (TCSPC), so as to obtain a TRPL curve that was sufficiently suitable for fitting. The obtained result was fitted with one or more exponential decay functions to obtain $T_{decay}$ (Ex), that is, the decay time of the film, and then the

radiative decay rate thereof, which is the inverse value thereof, was calculated. Results obtained therefrom were shown in Table 2. A function for fitting is as shown in <Equation 20>, and from among $T_{decay}$ values obtained from each exponential decay function used for fitting, the largest $T_{decay}$ was obtained as $T_{decay}$ (Ex). In this regard, the same measurement was performed during the same measurement time as that for obtaining TRPL curve in the dark state (in which pumping signals entering a film are blocked) to obtain a baseline or a background signal curve for use as a baseline for fitting.

<Equation 20>

$$f(t) = \sum_{i=1}^{n} A_i \, exp(-t/T_{decay,i})$$

The PLQY and radiative decay rate measurements were performed for Compounds 177, 225, 17, 69, 154, 796, 3, and 797 and results thereof are shown in Table 2.

Table 2

| Compound No. | PLQY | Radiative decay rate ($s^{-1}$) |
|---|---|---|
| 202 | 0.999 | $2.87 \times 10^5$ |
| 177 | 0.999 | $3.11 \times 10^5$ |
| 225 | 0.943 | $2.95 \times 10^5$ |
| 17 | 0.999 | $3.92 \times 10^5$ |
| 69 | 0.997 | $3.81 \times 10^5$ |
| 154 | 0.999 | $8.16 \times 10^4$ |
| 796 | 0.997 | $3.30 \times 10^5$ |
| 3 | 0.999 | $3.83 \times 10^5$ |
| 797 | 0.951 | $2.97 \times 10^5$ |

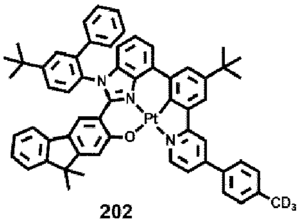
202

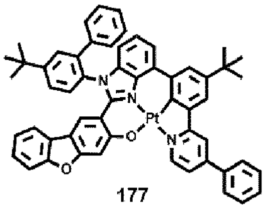
177

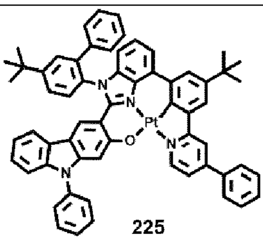
225

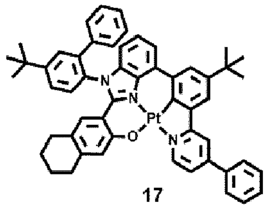
17

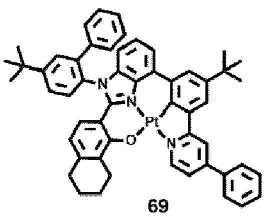
69

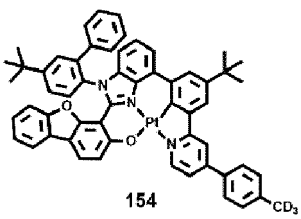
154

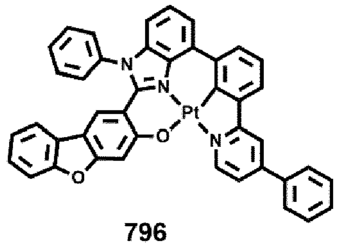

796

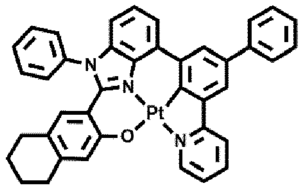

3

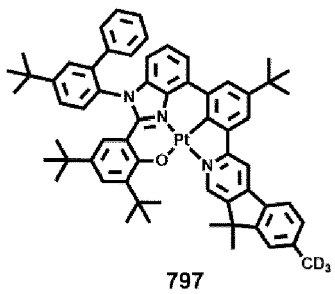

797

From Table 2, it can be seen that Compounds 202, 177, 225, 17, 69, 154, 796, 3, and 797 have high PLQY and high radiative decay rates.

Evaluation Example 2: Evaluation of horizontal orientation ratio

In a vacuum deposition apparatus having a vacuum degree of $1\times10^{-7}$ torr, mCP and Compound 202 were co-deposited on a fused silica base layer (thickness of 1 mm) at a weight ratio of 92:8 to form Sample 1 having a thickness of 30 nm, followed by sealing using glass and glue under a nitrogen atmosphere. This experiment was repeated for each of the compounds shown in Table 3 below to prepare Samples 2 to 7.

Meanwhile, an angle-dependent PL measurement apparatus having the same structure as that shown in FIG. 3 of Korean Patent Application Publication No. 2013-0150834 was prepared. Detailed specifications are as follows:

- Excitation-light wavelength: 325 nm
- Source of excitation-light: He-Cd laser of Melles Griot Inc.
- Excitation-light irradiation member: optical fiber having a diameter of 1 mm of Thorlabs Inc.
- Semi-cylindrical prism: a fused silica having a diameter of 100 mm and a length of 30 mm
- Emitted-light detection member: photomultiplier tube of Acton Inc.
- Polarizer mounted on emitted-light detection member: linear polarizer of Thorlabs Inc.
- Recoder: SpectraSense of Acton Inc.
- Incidence angle of excitation light: θP = 45°, θH = 0°
- Distance from a sample to the emitted-light detection member (or a radius of a movement path of the emitted-light detection member): 900 mm

Subsequently, Samples 1 to 7 were fixed on a semi-cylindrical lens and irradiated with 325 nm laser to emit light. The emitted light was allowed to pass through a polarization film, and then, in order to measure a p-polarized photoluminescence intensity with respect to light having the wavelength of 530 nm in a range of 90 degree to 0 degree, the semi-cylindrical lens, on which the sample was fixed, was rotated by 1 degree with respect to an axis of the semi-cylindrical lens by using a charge-coupled device (CCD).

The p-polarized photoluminescence intensity (a first p-polarized photoluminescence intensity) in a case where each compound is vertically aligned and the p-polarized photoluminescence intensity (a second p-polarized photoluminescence intensity) in a case where each compound is horizontally aligned were each calculated within a range of 0 degree to 90 degrees. A weight value at which the p-polarized photoluminescence intensity obtained by multiplying the first p-polarized photoluminescence intensity and the second p-polarized photoluminescence intensity by a weight value matches with found p-polarization photoluminescence intensity, was obtained. Then, the horizontal orientation ratio of each compound shown in Table 3 was measured and results thereof are shown in Table 3. Here, the angle-dependent photoluminescence spectrum was analyzed using a classical dipole model which regards light emitted from excitons as dissipated power consumed by an oscillating dipole.

Table 3

| Sample No. | Co-deposition material | Horizontal orientation ratio (%) |
|---|---|---|
| 1 | mCP : Compound 202(8wt%) | 86 |
| 2 | mCP : Compound 177(8wt%) | 86 |
| 3 | mCP : Compound 225(8wt%) | 86 |
| 4 | mCP : Compound 17(8wt%) | 87 |

(continued)

| Sample No. | Co-deposition material | Horizontal orientation ratio (%) |
|---|---|---|
| 5 | mCP : Compound 69(8wt%) | 86 |
| 6 | mCP : Compound 154(8wt%) | 89 |
| 7 | mCP : Compound 797(8wt%) | 90 |

From Table 3, it can be seen that Compounds 202, 177, 225, 17, 69, 154, and 1007 have an excellent horizontal orientation ratio, that is, optical orientation in the horizontal direction.

Example 1

As an anode, a glass substrate with ITO/Ag/ITO (70 Å /1000 Å /70 Å) deposited thereon was cut to a size of 50 mm x 50 mm x 0.7 mm, sonicated with isopropyl alcohol and pure water each for 5 minutes, and then cleaned by exposure to ultraviolet rays and ozone for 30 minutes. The ITO glass substrate was provided to a vacuum deposition apparatus.

2-TNATA was vacuum-deposited on the anode on the substrate to form a hole injection layer having a thickness of 600 Å, and 4,4'-bis[N-(1-naphthyl)-N-phenylamino] biphenyl (NPB) was vacuum-deposited on the hole injection layer to form a hole transport layer having a thickness of 1350 Å.

Subsequently, CBP (host) and Compound 202 (dopant) were co-deposited at a weight ratio of 94:6 on the hole transport layer to form an emission layer having a thickness of 400 Å.

Subsequently, BCP was deposited on the emission layer to form a hole-blocking layer having a thickness of 50 Å, $Alq_3$ was vacuum-deposited on the hole-blocking layer to form an electron transport layer having a thickness of 350 Å, LiF was deposited on the electron transport layer to form an electron injection layer having a thickness of 10 Å, and Mg and Ag were vacuum deposited at the weight ratio of 90:10 on the electron injection layer to form a cathode having a thickness of 120 Å, thereby completing manufacturing of an organic light-emitting device having a structure of anode/2-TNATA (600 Å)/NPB (1350 Å)/CBP + Compound 202(6 wt%) (400

Å)/BCP(50 Å)/$Alq_3$(350 Å)/LiF(10 Å)/MgAg(120 Å).

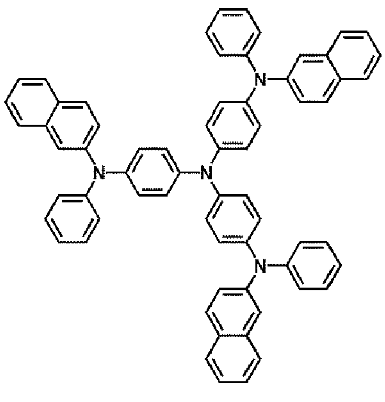

**2-TNATA**

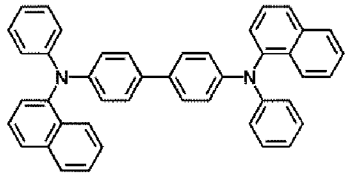

**NPB**

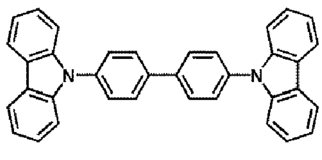

**CBP**

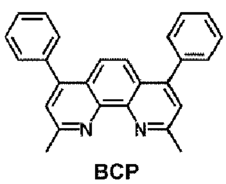

**BCP**

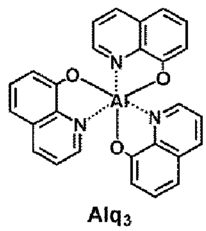

**$Alq_3$**

Examples 2 to 7

Organic light-emitting devices were manufactured in the same manner as in Example 1, except that the compounds shown in Table 4 were each used instead of Compound 202 as a dopant in forming an emission layer.

Evaluation Example 3: Evaluation on characteristics of organic light-emitting devices.

The driving voltage, current density, maximum external quantum efficiency (EQE), roll-off ratio, FWHM, the peak emission wavelength, and lifespan of the organic light-emitting devices manufactured in Examples 1 to 7 were evaluated, and results thereof are shown in Tables 4 and 5. The roll-off ratio was calculated by <Equation 30>. Lifespan (LT99, at 6000nit) is a measure of the hour at which luminance becomes 99% of the initial luminance, which is 100%. The maximum EQE and the lifespan were described as a relative value (%).

<Equation 30>

Roll off ratio = {1- (luminescence efficiency (at 6000 nit) / maximum luminescence efficiency)} X 100%

Table 4

| | Dopant Compound No. | Driving Voltage (V) | Current Density ($mA/cm^2$) | Maximum EQE (Relative value, %) | Roll-off ratio (%) | FWHM (nm) |
|---|---|---|---|---|---|---|
| Example 1 | 202 | 4.18 | 10 | 113 | 10 | 67 |
| Example 2 | 177 | 3.70 | 10 | 107 | 8 | 64 |
| Example 3 | 225 | 4.36 | 10 | 109 | 10 | 67 |
| Example 4 | 17 | 3.87 | 10 | 118 | 8 | 68 |
| Example 5 | 69 | 3.81 | 10 | 114 | 10 | 69 |
| Example 6 | 154 | 4.11 | 10 | 119 | 30 | 56 |
| Example 7 | 797 | 3.96 | 10 | 110 | 7 | 56 |

Table 5

| | Dopant Compound No. | Peak emission wavelength (nm) | Lifespan ($LT_{99}$) (at 6000 nit) (Relative value, %) |
|---|---|---|---|
| Example 1 | 202 | 524 | 105 |
| Example 2 | 177 | 522 | 103 |
| Example 3 | 225 | 531 | 63 |
| Example 4 | 17 | 525 | 97 |
| Example 5 | 69 | 524 | 95 |
| Example 6 | 154 | 569 | 113 |
| Example 7 | 797 | 516 | 87 |

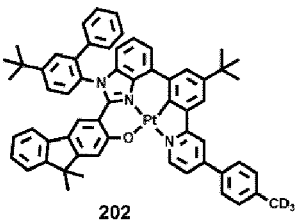
202

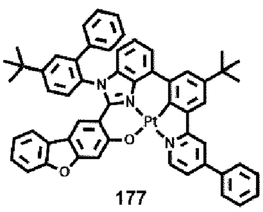
177

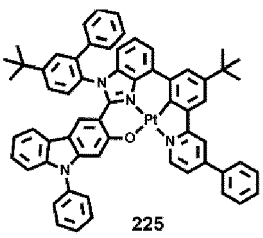
225

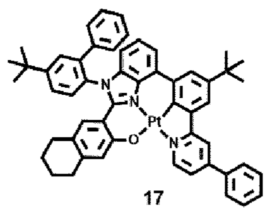
17

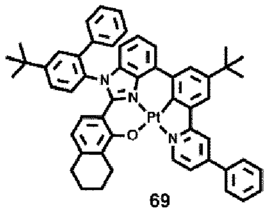
69

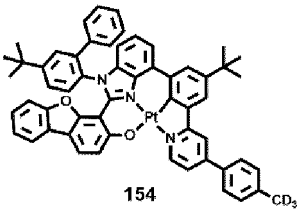
154

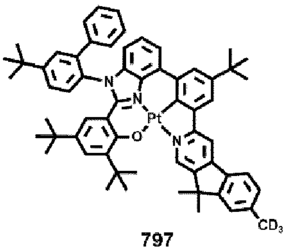
797

From Tables 4 and 5, it can be seen that the organic light-emitting devices of Examples 1 to 7 have excellent driving voltage, excellent EQE, excellent roll-off ratio, excellent lifespan characteristics, and relatively small FWHM.

Example 8, Comparative Example A1 and Comparative Example A3

Organic light-emitting devices were manufactured in the same manner as in Example 1, except that the compounds shown in Tables 6 and 7 were each used instead of Compound 202 as a dopant in forming an emission layer.
Evaluation Example 4: Evaluation on characteristics of organic light-emitting devices.

The driving voltage, current density, maximum EQE, roll-off ratio, FWHM, the peak emission wavelength, and lifespan of the organic light-emitting devices manufactured in Example 8, Comparative Example A1 and Comparative Example A3 were evaluated in the same manner described in Evaluation Example 3, and results thereof are shown in Tables 6 and 7.

Table 6

| | Dopant Compound No. | Driving Voltage (V) | Current Density ($mA/cm^2$) | Maximum EQE (Relative value, %) | roll-off ratio (%) | FWHM (nm) |
|---|---|---|---|---|---|---|
| Example 8 | 796 | 3.50 | 10 | 100 | 8 | 59.2 |
| Comparative Example A1 | A1 | 4.10 | 10 | 102 | 8 | 68 |
| Comparative Example A3 | A3 | 4.57 | 10 | 88 | 16 | 63 |

Table 7

| | Dopant Compound No. | Peak emission wavelength (nm) | Lifespan ($LT_{99}$) (at 6000 nit) (Relative value, %) |
|---|---|---|---|
| Example 8 | 796 | 519 | 75 |
| Comparative Example A1 | A1 | 516 | 27 |
| Comparative Example A3 | A3 | 520 | 17 |

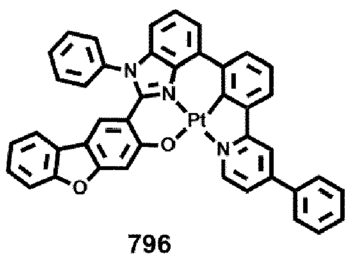
796

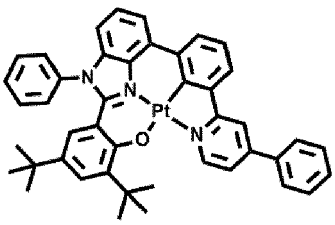
A1

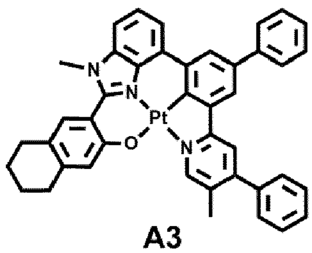
A3

From Tables 6 and 7, it can be seen that the organic light-emitting device of Example 8 has excellent driving voltage, excellent or similar EQE, excellent roll-off ratio, and excellent lifespan characteristics, compared with the organic light-emitting devices of Comparative Examples A1 and A3.

Example 9 and Comparative Example A2

Organic light-emitting devices were manufactured in the same manner as in Example 1, except that the compounds shown in Tables 8 and 9 were each used instead of Compound 202 as a dopant in forming an emission layer.

Evaluation Example 5: Evaluation on characteristics of organic light-emitting devices.

The driving voltage, current density, maximum EQE, roll-off ratio, FWHM, the peak emission wavelength, and lifespan of the organic light-emitting devices manufactured in Example 9 and Comparative Example A2 were evaluated in the same manner described in Evaluation Example 3, and results thereof are shown in Tables 8 and 9, with results of Comparative Example A3.

Table 8

| | Dopant Compound No. | Driving Voltage (V) | Current Density ($mA/cm^2$) | Maximum EQE (Relative value, %) | roll-off ratio (%) | FWHM (nm) |
|---|---|---|---|---|---|---|
| Example 9 | 3 | 4.35 | 10 | 89 | 16 | 62.6 |
| Comparative Example A2 | A2 | 3.87 | 10 | 85 | 26 | 66 |
| Comparative Example A3 | A3 | 4.57 | 10 | 88 | 16 | 63 |

Table 9

| | Dopant Compound No. | Peak emission wavelength (nm) | Lifespan ($LT_{99}$) (at 6000 nit) (Relative value, %) |
|---|---|---|---|
| Example 9 | 3 | 517 | 65 |
| Comparative Example A2 | A2 | 519 | 39 |
| Comparative Example A3 | A3 | 520 | 17 |

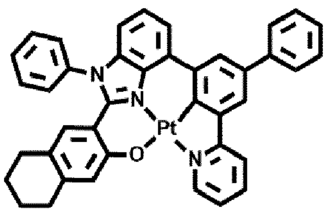

3

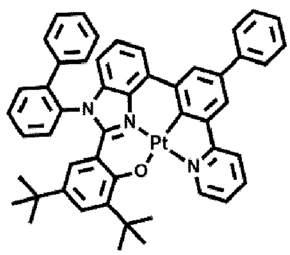

A2

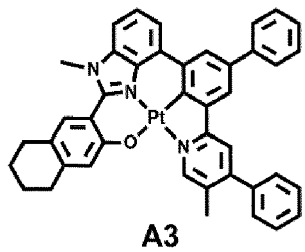

A3

From Tables 8 and 9, it can be seen that the organic light-emitting device of Example 9 has excellent EQE, excellent roll-off ratio, and excellent lifespan characteristics, and relatively small FWHM, compared with the organic light-emitting devices of Comparative Examples A2 and A3.

The organometallic compound emits light with a relatively small FWHM, and has excellent EQE, excellent radiative decay rate, and excellent horizontal orientation ratio. Accordingly, since an organic light-emitting device using the organometallic compound may have improved characteristics in terms of driving voltage, external quantum efficiency, roll-off ratio and/or lifespan, and thus, a high-quality electronic apparatus can be manufactured by using the organometallic compound.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. An organometallic compound represented by Formula 1:

Formula 1

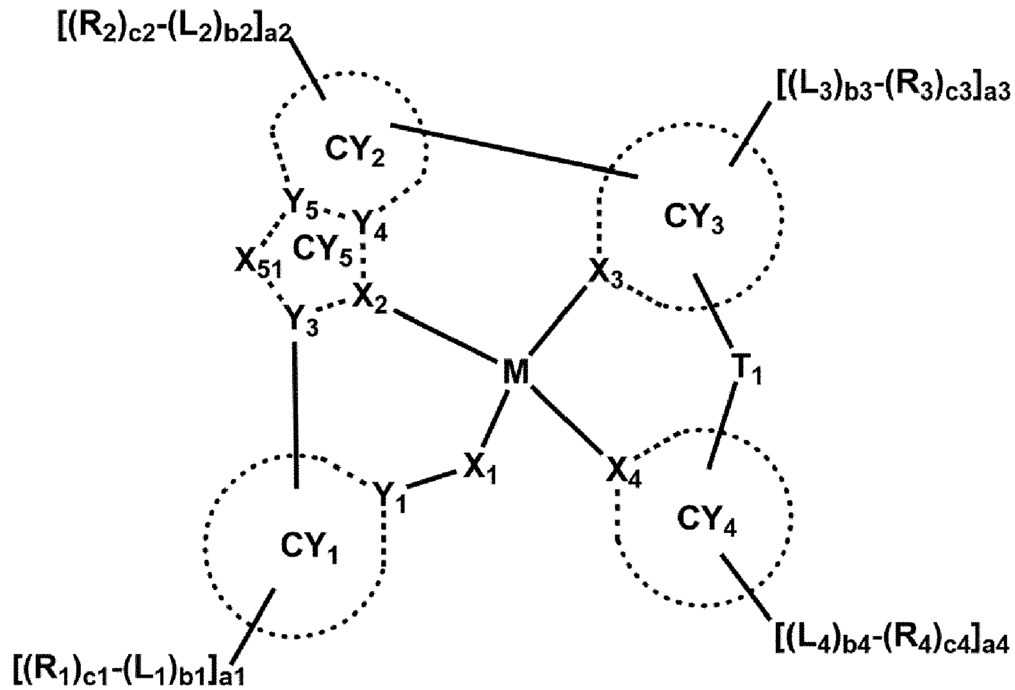

wherein, in Formula 1,

M is a transition metal,
$X_1$ is a chemical bond, O, S, N(R'), P(R'), B(R'), C(R')(R"), or Si(R')(R"), and when $X_1$ is a chemical bond, $Y_1$ is directly bonded to M,
$X_2$ to $X_4$ are each independently C or N,
a bond between $X_1$ or $Y_1$ and M is a covalent bond, one bond selected from a bond between $X_2$ and M, a bond between $X_3$ and M, and a bond between $X_4$ and M is a covalent bond, and the remaining two bonds are coordinate bonds,
$Y_1$ and $Y_3$ to $Y_5$ are each independently C or N,
among pairs of $X_2$ and $Y_3$, $X_2$ and $Y_4$, $Y_4$ and $Y_5$, $X_{51}$ and $Y_3$, and $X_{51}$ and $Y_5$, components of each pair are connected to each other via a chemical bond,
ring $CY_1$ to ring $CY_4$ are each independently a $C_5$-$C_{30}$ carbocyclic group or a $C_1$-$C_{30}$ heterocyclic group, and at least one of ring $CY_1$ to ring $CY_4$ are each independently a condensed cyclic group in which two or more rings are condensed with each other,
a cyclometallated ring formed by ring $CY_5$, ring $CY_2$, ring $CY_3$, and M is a 6-membered ring,
$T_1$ is a single bond, a double bond, *-N($R_5$)-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*' *-C(=O)-*', *-S(=O)-*', *-S(=O)$_2$-*', *-C($R_5$)=*', *=C($R_5$)-*', *-C($R_5$)=C($R_6$)-*', *-C(=S)-*', or *-C≡C-*', and each of * and *' is a binding site to a neighboring atom,
$X_{51}$ is N-[($L_7$)$_{b7}$-($R_7$)$_{c7}$],
$L_1$ to $L_4$ and $L_7$ are each independently a single bond, a $C_5$-$C_{30}$ carbocyclic group that is unsubstituted or substituted with at least one $R_{10a}$, or a $C_1$-$C_{30}$ heterocyclic group that is unsubstituted or substituted with at

least one $R_{10a}$,

b1 to b4 and b7 are each independently 1, 2, 3, 4, or 5,

$R_1$ to $R_7$, R', and R" are each independently hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, - $Ge(Q_3)(Q_4)(Q_5)$, -$B(Q_6)(Q_7)$, -$P(=O)(Q_8)(Q_9)$, or -$P(Q_8)(Q_9)$,

c1 to c4 and c7 are each independently 1, 2, 3, 4, or 5,

at least one of $R_7$ in number of c7 is a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

a1 to a4 are each independently 0, 1, 2, 3, 4, or 5,

two or more of a plurality of $R_1$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of a plurality of $R_2$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of a plurality of $R_3$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of a plurality of $R_4$(s) are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two or more of $R_1$ to $R_4$ are optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

$R_{10a}$ is the same as explained in connection with $R_1$, and

the substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group is:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a C1-C10 heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, - $N(Q_{11})(Q_{12})$, -$Si(Q_{13})(Q_{14})(Q_{15})$, -$Ge(Q_{13})(Q_{14})(Q_{15})$, -$B(Q_{16})(Q_{17})$, -$P(=O)(Q_{18})(Q_{19})$, - $P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$

heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$,-B(Q26)(Q27), $-P(=O)(Q_{26})(Q_{29})$, -P(Q28)(Q29), or a combination thereof; $-N(Q_{31})(Q_{32})$, $-Si(Q_{33})(Q_{34})(Q_{35})$, $-Ge(Q_{33})(Q_{34})(Q_{35})$, -B(Q36)(Q37),$-P(=O)(Q_{36})(Q_{39})$, or $-P(Q_{36})(Q_{39})$; or a combination thereof,

wherein $Q_1$ to Q9, $Q_{11}$ to Q19, Q21 to Q29, and $Q_{31}$ to Q39 are each independently hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group which is unsubstituted or substituted with deuterium, -F, a $C_1$-$C_{60}$ alkyl group, a $C_6$-$C_{60}$ aryl group, or a combination thereof, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group which is unsubstituted or substituted with deuterium, -F, a $C_1$-$C_{60}$ alkyl group, a $C_6$-$C_{60}$ aryl group, or a combination thereof, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, and
wherein Formula 1 satisfies at least one of Condition A, Condition B, Condition C and Condition D:

Condition A
a group represented by $*-[(L_7)_{b7}-(R_7)_{c7}]$ in $N-[(L_7)_{b7}-(R_7)_{c7}]$ is a group represented by Formula N51:

Formula N51

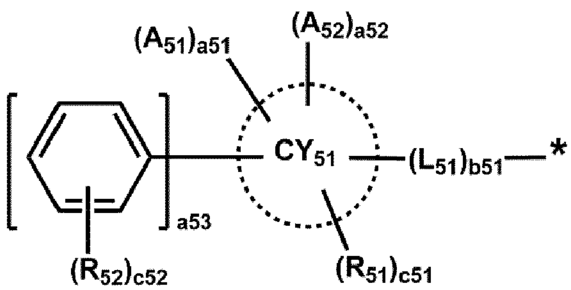

wherein, in Formula N51,

ring $CY_{51}$ is a $C_5$-$C_{30}$ carbocyclic group or a $C_1$-$C_{30}$ heterocyclic group, $L_{51}$, b51, $R_{51}$, and c51 are each as described in connection with $L_7$, $b_7$, $R_7$, and c7,
$R_{52}$ and c52 are each as described in connection with $R_7$ and c7,
$A_{51}$ is a $C_1$-$C_{60}$ alkyl group,
$A_{52}$ is a deuterated $C_1$-$C_{60}$ alkyl group,
a51 and a52 are each independently an integer from 0 to 10, and the sum of a51 and a52 is an integer of 1 or more,
a53 is an integer from 1 to 10, and
* indicates a binding site to a neighboring nitrogen atom,

Condition B
the ring $CY_1$ is a condensed cyclic group wherein two or more rings are condensed with each other,
Condition C

the ring $CY_3$ is a condensed cyclic group wherein two or more rings are condensed with each other,

a4 is 1, 2, 3, 4, or 5, and

at least one of $R_4$ in number of c4 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

Condition D

the ring $CY_4$ is a condensed cyclic group wherein two or more rings are condensed with each other,

a3 is 1, 2, 3, 4, or 5, and

at least one of $R_3$ in number of c3 is a $C_1$-$C_{60}$ alkyl group substituted with at least one $C_6$-$C_{60}$ aryl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

**2.** The organometallic compound of claim 1, wherein ring $CY_1$ to ring $CY_4$ are each independently selected from, i) a first ring, ii) a second ring, iii) a condensed ring in which two or more first rings are condensed with each other, iv) a condensed ring in which two or more second rings are condensed with each other, and v) a condensed ring in which one or more first rings and one or more second rings are condensed with each other,

at least one of ring $CY_1$ to ring $CY_4$ are each independently iii) a condensed cyclic group in which two or more first rings are condensed with each other, iv) a condensed cyclic group in which two or more second rings are condensed with each other, or v) a condensed cyclic group in which at least one first ring is condensed with at least one second ring,

the first ring is a cyclopentane group, a cyclopentadiene group, a furan group, a thiophene group, a pyrrole group, a silole group, a germole group, a borole group, a phosphole group, a selenophene group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaphosphole group, or an azaselenophene group, and

the second ring is an adamantane group, a norbornane group, a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

**3.** The organometallic compound of claim 1, wherein,

ring $CY_1$ is a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,

ring $CY_3$ is a benzene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and

ring $CY_4$ is a pyridine group, an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group;

or

ring $CY_1$ is a benzene group, a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,

ring $CY_3$ is a fluorene group, a carbazole group, a dibenzofuran group, a dibenzothiophene group, a dibenzosilole

group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and

ring $CY_4$ is a pyridine group, an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group;

or

ring $CY_1$ is a benzene group, a naphthalene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, a dinaphthosilole group, a benzene group condensed with a cyclohexane group, a benzene group condensed with an adamantane group, or a benzene group condensed with a norbornane group,

ring $CY_3$ is a benzene group, a fluorene group, a carbazole group, a dibenzofuran group, a dibenzothiophene group, a dibenzosilole group, a benzofluorene group, a benzocarbazole group, a naphthobenzofuran group, a naphthobenzothiophene group, a naphthobenzosilole group, a dibenzofluorene group, a dibenzocarbazole group, a dinaphthofuran group, a dinaphthothiophene group, or a dinaphthosilole group, and

ring $CY_4$ is an azafluorene group, an azacarbazole group, an azadibenzofuran group, an azadibenzothiophene group, an azadibenzosilole group, an azabenzofluorene group, an azabenzocarbazole group, an azanaphthobenzofuran group, an azanaphthobenzothiophene group, an azanaphthobenbenzosilole group, an azadibenzofluorene group, an azadibenzocarbazole group, an azadinaphthofuran group, an azadinaphthothiophene group, or an azadinaphthosilole group.

**4.** The organometallic compound of any of claims 1-3, wherein Formula 1 satisfies Condition A.

**5.** The organometallic compound of any of claims 1-4,

wherein $A_{51}$ in Formula N51 is a $C_4$-$C_{20}$ alkyl group; and/or
wherein a group represented by

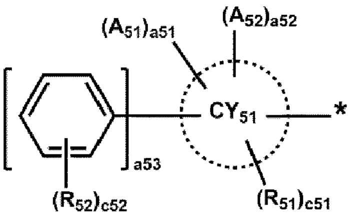

in Formula N51 is a group represented by one of Formulae 51-1 to 51-20:

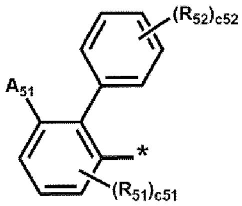

51-1

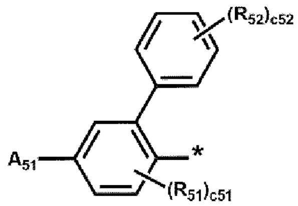

51-2

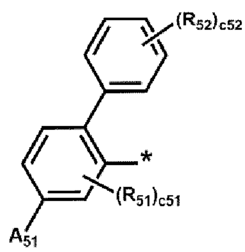

51-3

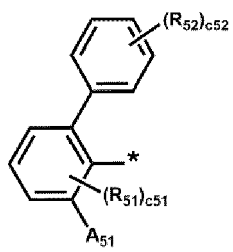

51-4

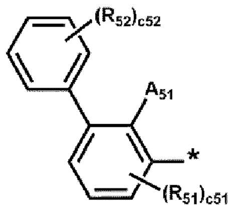

51-5

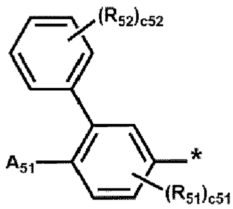

51-6

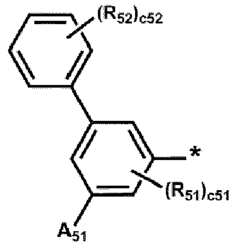

51-7

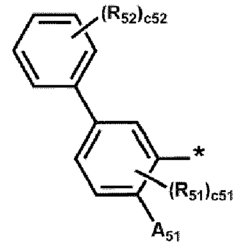

51-8

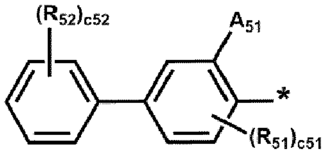

51-9

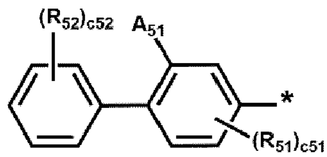

51-10

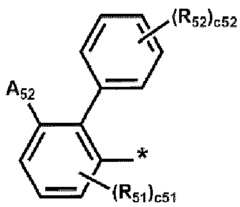

51-11

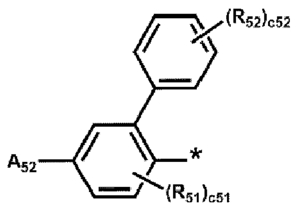

51-12

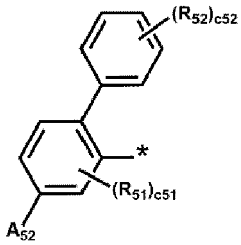

51-13

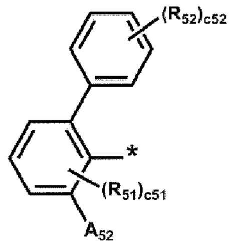

51-14

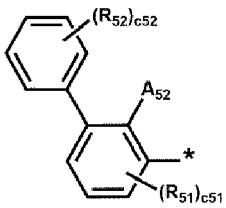

51-15

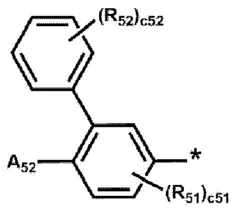

51-16

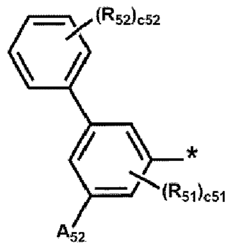

51-17

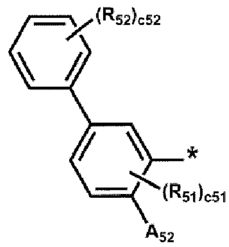

51-18

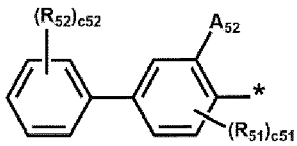

51-19

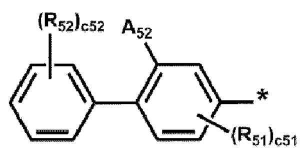

51-20

$R_{51}$, $R_{52}$, c51, c52, $A_{51}$ and $A_{52}$ in Formulae 51-1 to 51-20 are the same as described in claim 1, and * indicates a binding site to $L_{51}$.

**6.** The organometallic compound of any of claims 1-5, wherein Formula 1 satisfies Condition B.

**7.** The organometallic compound of any of claims 1-5, wherein Formula 1 satisfies Condition C.

**8.** The organometallic compound of any of claims 1-5, wherein Formula 1 satisfies Condition D.

**9.** The organometallic compound of any of claims 1-8, wherein a group represented by

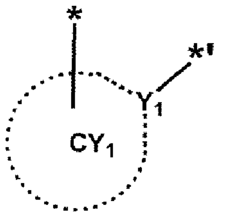

in Formula 1 is a group represented by one of Formulae CY1-1 to CY1-48:

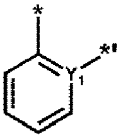
CY1-1

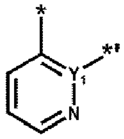
CY1-2

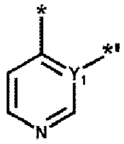
CY1-3

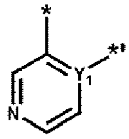
CY1-4

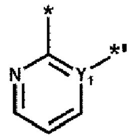
CY1-5

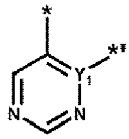
CY1-6

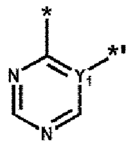
CY1-7

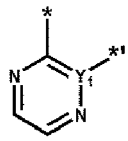
CY1-8

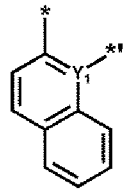
CY1-9

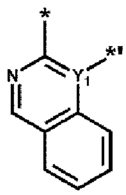
CY1-10

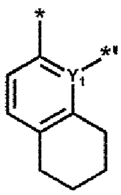
CY1-11

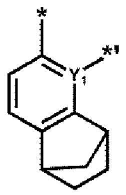
CY1-12

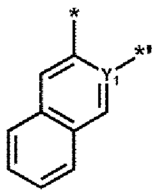
CY1-13

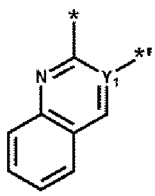
CY1-14

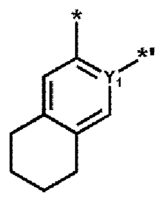
CY1-15

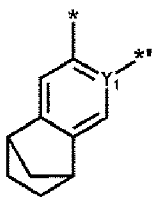
CY1-16

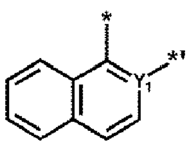
CY1-17

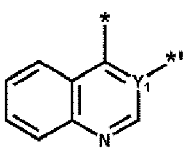
CY1-18

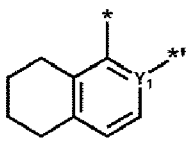
CY1-19

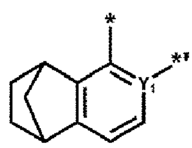
CY1-20

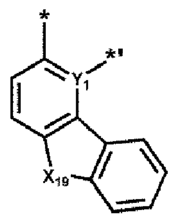
CY1-21

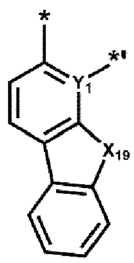
CY1-22

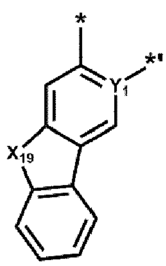
CY1-23

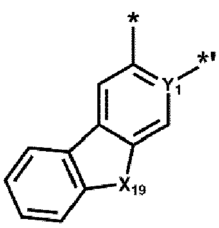
CY1-24

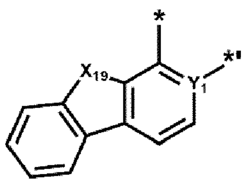
CY1-25

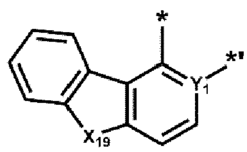
CY1-26

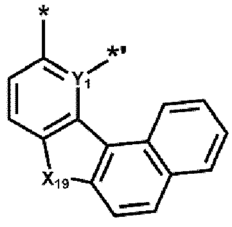
CY1-27

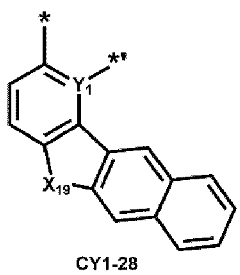
CY1-28

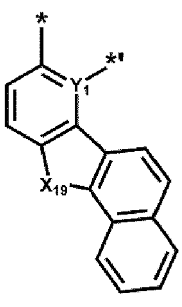
CY1-29

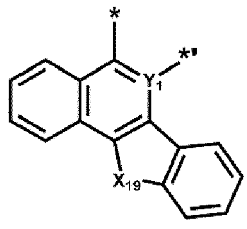
CY1-30

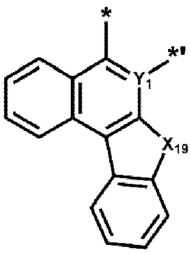
CY1-31

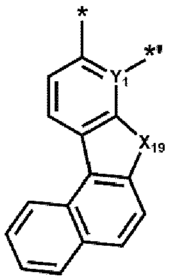
CY1-32

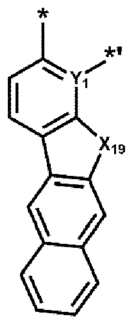
CY1-33

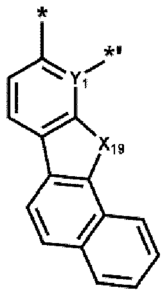
CY1-34

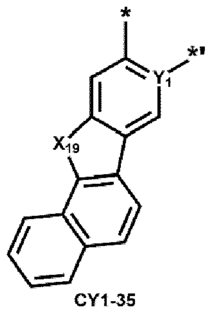
CY1-35

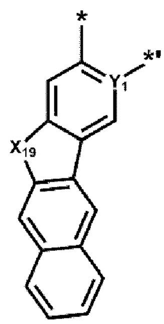
CY1-36

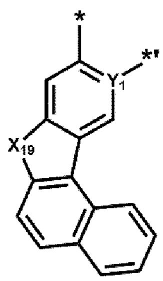
CY1-37

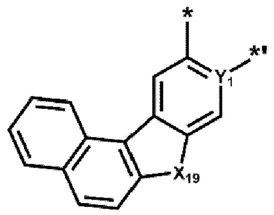
CY1-38

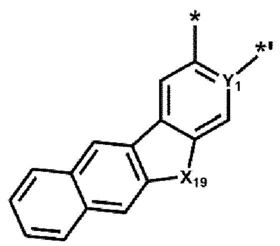
CY1-39

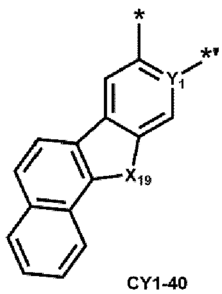
CY1-40

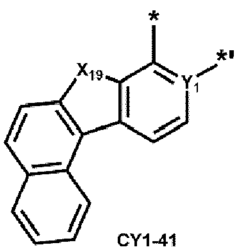
CY1-41

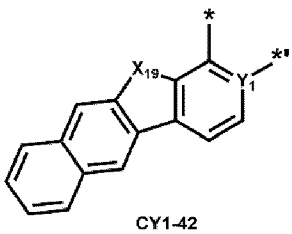
CY1-42

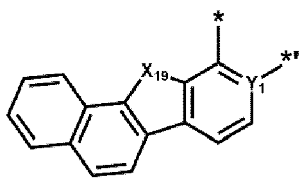
CY1-43

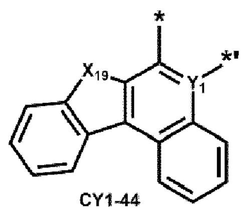
CY1-44

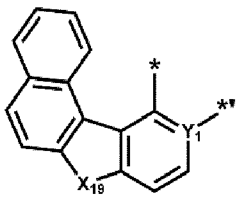
CY1-45

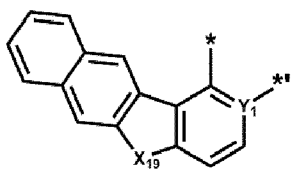
CY1-46

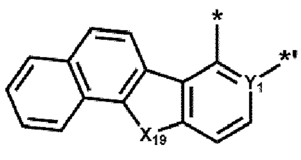
CY1-47

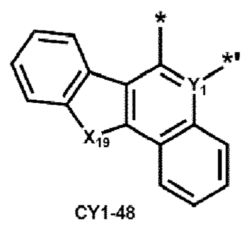
CY1-48

wherein, in Formulae CY1-1 to CY1-48,

$Y_1$ is the same as described in connection with claim 1,
$X_{19}$ is $C(R_{19a})(R_{19b})$, $N[(L_{19})_{b19}\text{-}(R_{19})_{c19}]$, O, S, or $Si(R_{19a})(R_{19b})$,
$L_{19}$ is the same as described in connection with $L_1$ in claim 1,
b19 and c19 are the same as described in connection with b1 and c1 in claim 1, respectively,
$R_{19}$, $R_{19a}$, and $R_{19b}$ are the same as described in connection with $R_1$ in claim 1,
*' indicates a binding site to $X_1$ or M in Formula 1, and
* indicates a binding site to ring $CY_5$ in Formula 1.

**10.** The organometallic compound of any of claims 1-9, wherein a group represented by

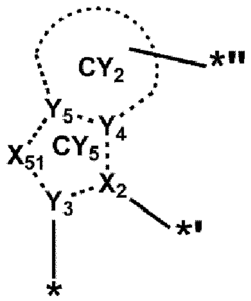

in Formula 1 is a group represented by one of Formulae CY2-1 to CY2-20:

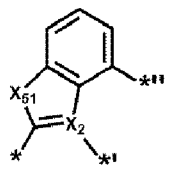
CY2-1

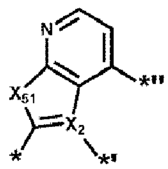
CY2-2

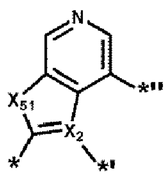
CY2-3

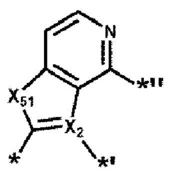
CY2-4

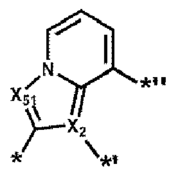
CY2-5

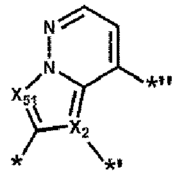
CY2-6

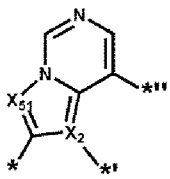
CY2-7

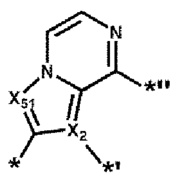
CY2-8

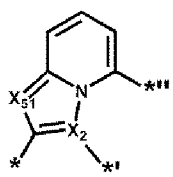
CY2-9

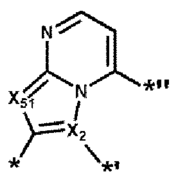
CY2-10

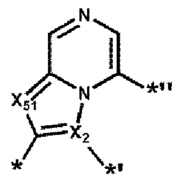
CY2-11

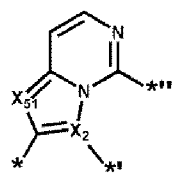
CY2-12

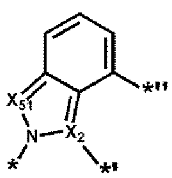
CY2-13

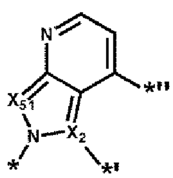
CY2-14

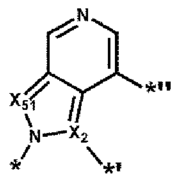
CY2-15

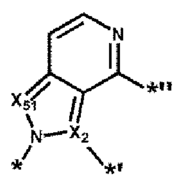
CY2-16

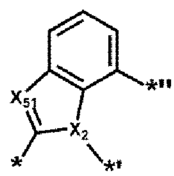
CY2-17

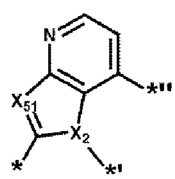
CY2-18

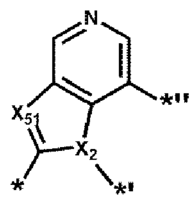
CY2-19

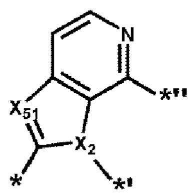
CY2-20

wherein, in Formulae CY2-1 to CY2-20,

$X_2$ and $X_{51}$ are each the same as described in connection with claim 1,
* indicates a binding site to ring $CY_1$ in Formula 1,
*' indicates a binding site to M in Formula 1, and
*'' indicates a binding site to ring $CY_3$ in Formula 1.

**11.** The organometallic compound of any of claims 1-10, wherein a group represented by

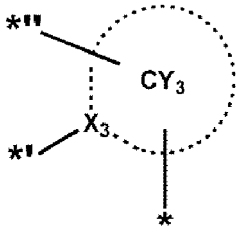

in Formula 1 is a group represented by one of Formulae CY3-1 to CY3-26:

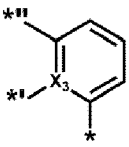
CY3-1

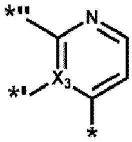
CY3-2

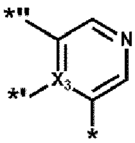
CY3-3

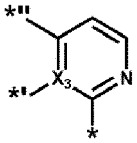
CY3-4

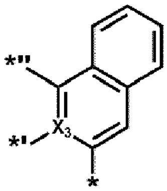
CY3-5

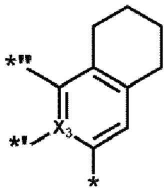
CY3-6

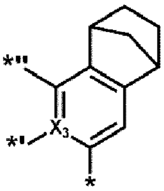
CY3-7

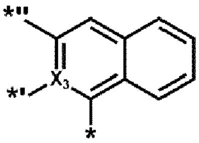
CY3-8

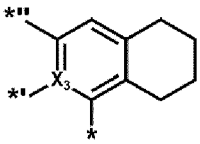
CY3-9

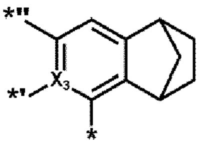
CY3-10

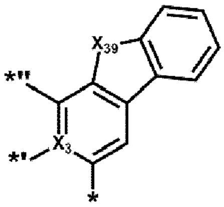
CY3-11

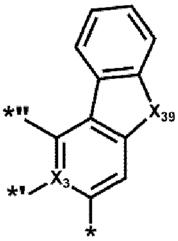
CY3-12

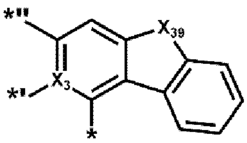
CY3-13

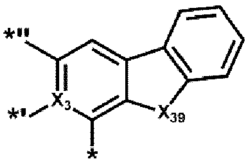
CY3-14

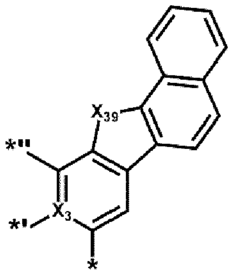
CY3-15

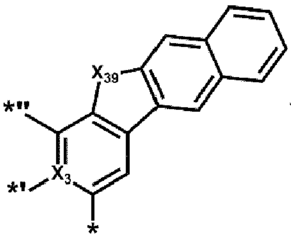
CY3-16

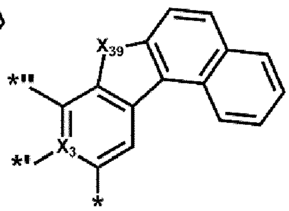
CY3-17

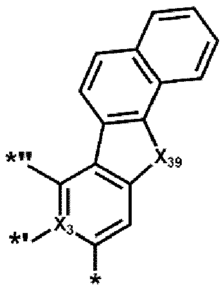
CY3-18

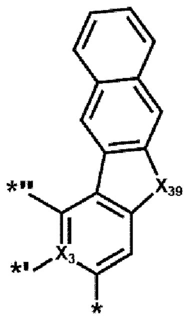
CY3-19

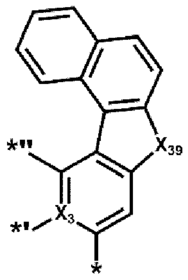
CY3-20

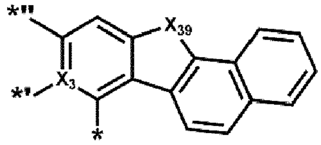
CY3-21

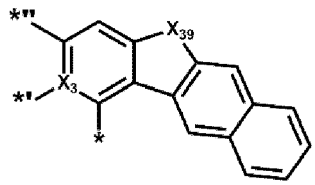
CY3-22

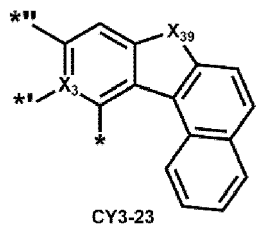
CY3-23

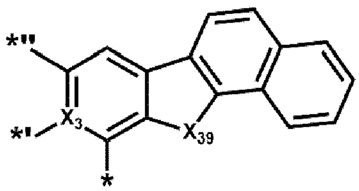
CY3-24

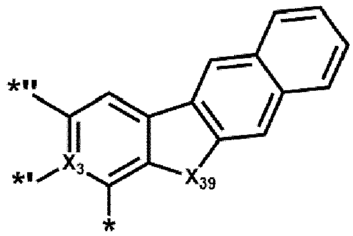
CY3-25

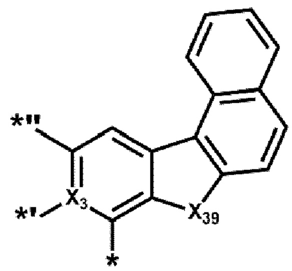
CY3-26

wherein, in Formulae CY3-1 to 3-26,

$X_3$ is the same as described in claim 1,
$X_{39}$ is $C(R_{39a})(R_{39b})$, $N[(L_{39})_{b39}-(R_{39})_{c39}]$, O, S, or $Si(R_{39a})(R_{39b})$,
$L_{39}$ is the same as described in connection with $L_3$ in claim 1,
b39 and c39 are the same as described in connection with b3 and c3 in claim 1, respectively, and
$R_{39}$, $R_{39a}$, and $R_{39b}$ are each the same as described in connection with $R_3$ in claim 1,
* indicates a binding site to $T_1$ in Formula 1,
*' indicates a binding site to M in Formula 1, and
*" indicates a binding site to ring $CY_2$ in Formula 1.

**12.** The organometallic compound of any of claims 1-11, wherein a group represented by

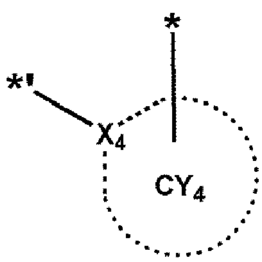

in Formula 1 is a group represented by one of Formulae CY4-1 to CY4-48:

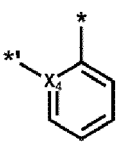
CY4-1

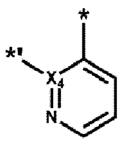
CY4-2

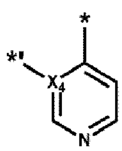
CY4-3

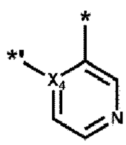
CY4-4

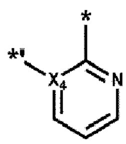
CY4-5

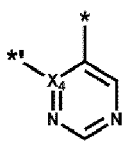
CY4-6

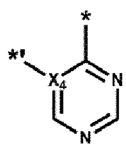
CY4-7

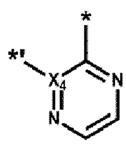
CY4-8

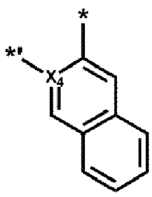
CY4-9

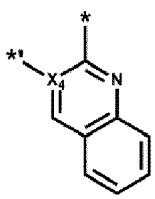
CY4-10

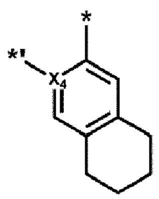
CY4-11

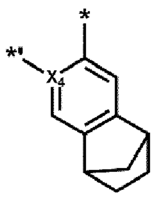
CY4-12

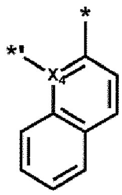
CY4-13

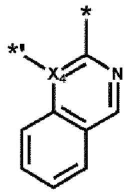
CY4-14

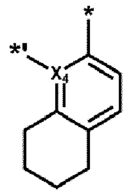
CY4-15

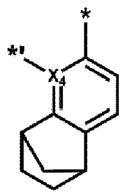
CY4-16

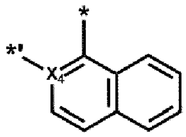
CY4-17

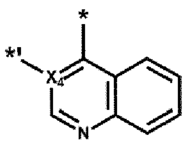
CY4-18

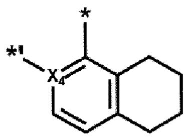
CY4-19

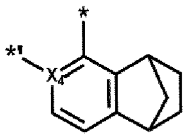
CY4-20

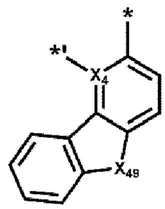
CY4-21

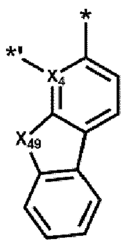
CY4-22

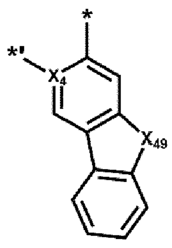
CY4-23

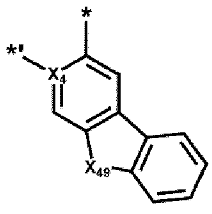
CY4-24

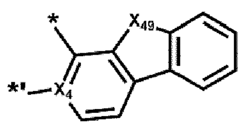
CY4-25

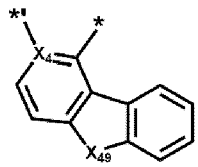
CY4-26

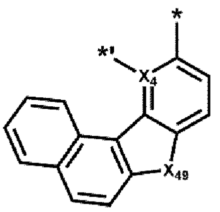
CY4-27

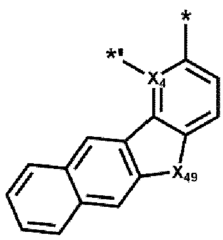
CY4-28

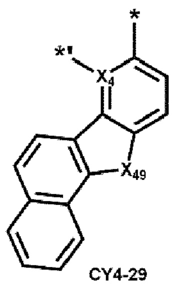
CY4-29

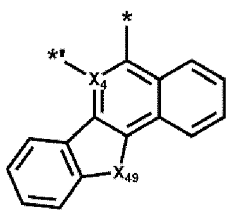
CY4-30

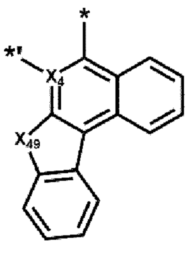
CY4-31

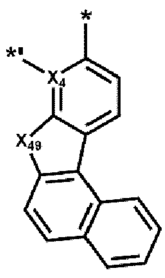
CY4-32

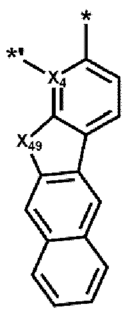
CY4-33

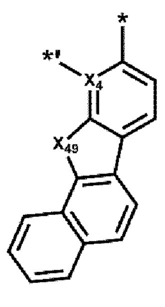
CY4-34

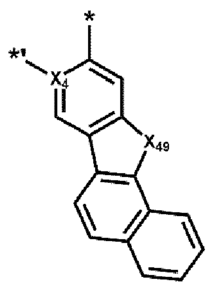
CY4-35

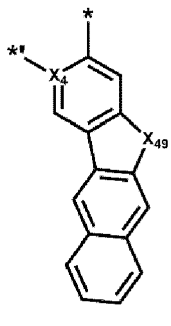
CY4-36

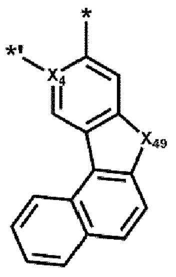
CY4-37

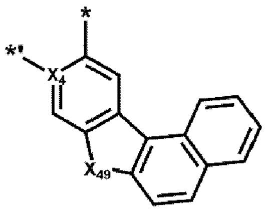
CY4-38

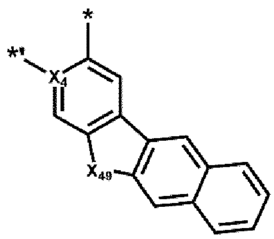
CY4-39

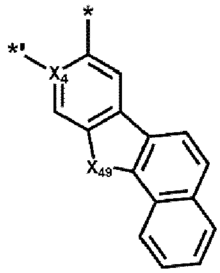
CY4-40

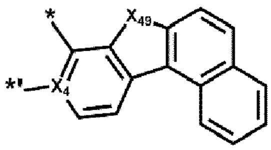
CY4-41

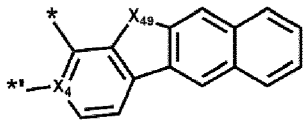
CY4-42

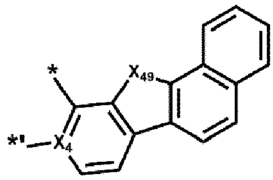
CY4-43

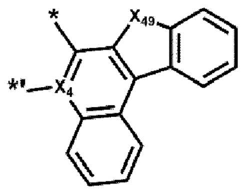
CY4-44

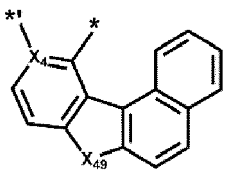
CY4-45

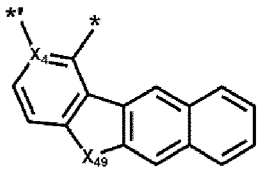
CY4-46

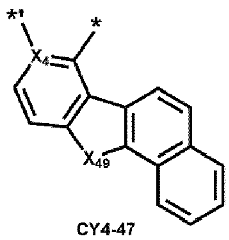
CY4-47

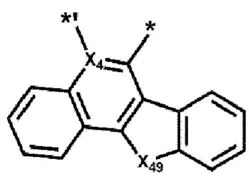
CY4-48

wherein, in Formulae CY4-1 to 4-48,

$X_4$ is the same as described in claim 1,
$X_{49}$ is $C(R_{49a})(R_{49b})$, $N[(L_{49})_{b49}-(R_{49})_{c49}]$, O, S, or $Si(R_{49a})(R_{49b})$,
$L_{49}$ is the same as described in connection with $L_4$ in claim 1,
b49 and c49 are the same as described in connection with b4 and c4 in claim 1, respectively,
$R_{49}$, $R_{49a}$, and $R_{49b}$ are each the same as described in connection with $R_4$ in claim 1,
* indicates a binding site to $T_1$ in Formula 1, and
*' indicates a binding site to M in Formula 1.

**13.** An organic light-emitting device comprising:

a first electrode,
a second electrode, and
an organic layer located between the first electrode and the second electrode and comprising an emission layer, wherein
the organic layer comprises at least one of the organometallic compound of any of claims 1-12;
preferably wherein the first electrode is an anode,
the second electrode is a cathode,
the organic layer further comprises a hole transport region located between the first electrode and the emission layer and an electron transport region located between the emission layer and the second electrode, wherein the hole transport region comprises a hole injection layer, a hole transport layer, an electron-blocking layer, a buffer layer, or a combination thereof, and
the electron transport region comprises a hole-blocking layer, an electron transport layer, an electron injection layer, or a combination thereof.

**14.** The organic light-emitting device of claim 13, wherein the organometallic compound is included in the emission layer; preferably wherein the emission layer further comprises a host, and the amount of the host is greater than the

amount of the organometallic compound.

**15.** An electronic apparatus comprising the organic light-emitting device of claims 13 or 14.

# FIGURE

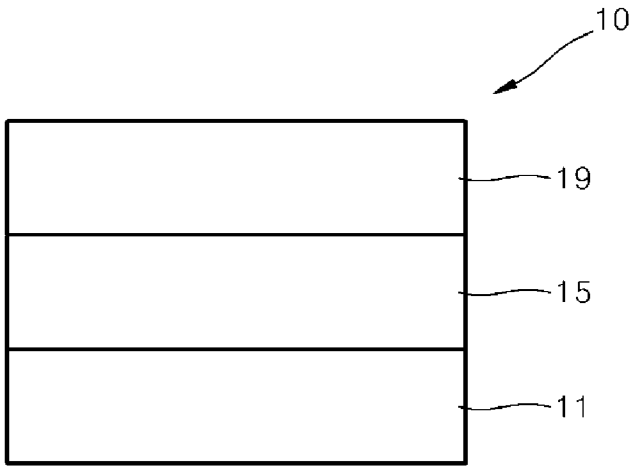

Europäisches Patentamt
European Patent Office
Office européen des brevets

# EUROPEAN SEARCH REPORT

Application Number
EP 21 19 2189

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 266 790 A1 (SAMSUNG ELECTRONICS CO LTD [KR]) 10 January 2018 (2018-01-10)<br>* claims 12-15 *<br>* CAS RN 2171474-31-8 *<br>-& LEE J: "Organometallic compound, organic light-emitting device including the same, and diagnostic composition including the organometallic compound", EP3266790 A1,<br>1 January 2018 (2018-01-01), pages 1-2, XP055876937,<br>----- | 1-15 | INV.<br>C09K11/00<br>H01L51/50<br>C07F15/00 |
| X | US 2020/006676 A1 (KWAK SEUNGYEON [KR] ET AL) 2 January 2020 (2020-01-02)<br>* paragraph [0335] *<br>* abstract *<br>----- | 1-15 | |
| X | US 2019/036045 A1 (HWANG KYUYOUNG [KR] ET AL) 31 January 2019 (2019-01-31)<br>* compounds 31-40,77-80,106-110,116-120,124,125 *<br>* compounds 129,130,134,135,139,140,144,145,149,150 *<br>* compounds 154,155,159,160,174,175,179,180,184,185,189,190 *<br>* claims 15-20 *<br>----- | 1-15 | TECHNICAL FIELDS SEARCHED (IPC)<br>H05B<br>C09K<br>H01L |
| X | EP 3 508 491 A1 (SAMSUNG ELECTRONICS CO LTD [KR]) 10 July 2019 (2019-07-10)<br>* page 94, paragraph 220 - page 95 *<br>----- | 1-15 | |
| X | EP 3 637 489 A1 (SAMSUNG ELECTRONICS CO LTD [KR]) 15 April 2020 (2020-04-15)<br>* paragraph [0574] *<br>* table 7 *<br>* compounds PT-1,Pt-2 *<br>-----<br>-/-- | 1-15 | |

1 The present search report has been drawn up for all claims

| Place of search | Date of completion of the search | Examiner |
|---|---|---|
| The Hague | 10 January 2022 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 21 19 2189

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2020 037550 A (SAMSUNG ELECTRONICS CO LTD) 12 March 2020 (2020-03-12) * paragraph [0134]; compounds 1-3599 * * abstract * ----- | 1-15 | |
| X | EP 3 617 215 A1 (SAMSUNG ELECTRONICS CO LTD [KR]) 4 March 2020 (2020-03-04) * paragraph [0275] * ----- | 1-15 | |
| X,P | EP 3 858 945 A1 (UNIVERSAL DISPLAY CORP [US]) 4 August 2021 (2021-08-04) * page 182, line 35 * * abstract * ----- | 1-6,9-15 | |
| E | EP 3 896 073 A1 (SAMSUNG ELECTRONICS CO LTD [KR]) 20 October 2021 (2021-10-20) * paragraph [0247] * * abstract * ----- | 1-5,9-15 | |

TECHNICAL FIELDS SEARCHED (IPC)

1 The present search report has been drawn up for all claims

| Place of search | Date of completion of the search | Examiner |
|---|---|---|
| The Hague | 10 January 2022 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 21 19 2189

This annex lists the patent family members relating to the patent documents cited in the above-mentioned European search report. The members are as contained in the European Patent Office EDP file on
The European Patent Office is in no way liable for these particulars which are merely given for the purpose of information.

10-01-2022

| Patent document cited in search report | Publication date | Patent family member(s) | Publication date |
|---|---|---|---|
| EP 3266790 A1 | 10-01-2018 | CN 107573383 A | 12-01-2018 |
| | | EP 3266790 A1 | 10-01-2018 |
| | | EP 3620461 A1 | 11-03-2020 |
| | | JP 6966244 B2 | 10-11-2021 |
| | | JP 2018002722 A | 11-01-2018 |
| | | KR 20180005128 A | 15-01-2018 |
| | | KR 20190084015 A | 15-07-2019 |
| | | TW 201808977 A | 16-03-2018 |
| | | US 2018013078 A1 | 11-01-2018 |
| | | US 2021119153 A1 | 22-04-2021 |
| | | US 2021159431 A1 | 27-05-2021 |
| US 2020006676 A1 | 02-01-2020 | KR 20190143282 A | 30-12-2019 |
| | | US 2020006676 A1 | 02-01-2020 |
| US 2019036045 A1 | 31-01-2019 | KR 20190012063 A | 08-02-2019 |
| | | US 2019036045 A1 | 31-01-2019 |
| EP 3508491 A1 | 10-07-2019 | CN 110003281 A | 12-07-2019 |
| | | EP 3508491 A1 | 10-07-2019 |
| | | US 2019211042 A1 | 11-07-2019 |
| EP 3637489 A1 | 15-04-2020 | CN 111004287 A | 14-04-2020 |
| | | EP 3637489 A1 | 15-04-2020 |
| | | JP 2020059709 A | 16-04-2020 |
| | | US 2020111977 A1 | 09-04-2020 |
| JP 2020037550 A | 12-03-2020 | CN 110872326 A | 10-03-2020 |
| | | JP 2020037550 A | 12-03-2020 |
| EP 3617215 A1 | 04-03-2020 | EP 3617215 A1 | 04-03-2020 |
| | | KR 20200026093 A | 10-03-2020 |
| | | US 2020115406 A1 | 16-04-2020 |
| EP 3858945 A1 | 04-08-2021 | CN 113248544 A | 13-08-2021 |
| | | EP 3858945 A1 | 04-08-2021 |
| | | JP 2021121586 A | 26-08-2021 |
| | | KR 20210097051 A | 06-08-2021 |
| EP 3896073 A1 | 20-10-2021 | EP 3896073 A1 | 20-10-2021 |
| | | KR 20210127624 A | 22-10-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20130150834